# EUROPÄISCHE PATENTSCHRIFT

(11) **EP 3 247 766 B1**
(45) Veröffentlichungstag und Bekanntmachung des Hinweises auf die Patenterteilung: **26.09.2018**
(21) Anmeldenummer: 16702345.6
(22) Anmeldetag: 20.01.2016
(51) Int. Cl.: C09K 11/06, H01L 51/50, H01L 51/00

(54) **ORGANISCHE MOLEKÜLE ZUR VERWENDUNG IN OPTOELEKTRONISCHEN BAUELEMENTEN**
ORGANIC MOLECULES FOR USE IN OPTOELECTRONIC COMPONENTS
MOLÉCULES ORGANIQUES À UTILISER DANS DES COMPOSANTS OPTOÉLECTRONIQUES

(30) Priorität: 20.01.2015 EP 15151870; 20.05.2015 DE 102015108021
(43) Veröffentlichungstag der Anmeldung: 29.11.2017
(73) Patentinhaber: cynora GmbH, 76646 Bruchsal (DE)
(72) Erfinder: AMBROSEK, David, 10437 Berlin (DE); DANZ, Michael, 76344 Eggenstein-Leopoldshafen (DE); FLÜGGE, Harald, 76135 Karlsruhe (DE); FRIEDRICHS, Jana, 76137 Karlsruhe (DE); GEORGIOS, Liaptsis, 68161 Mannheim (DE); GRAB, Tobias, 76133 Karlsruhe (DE); JACOB, Andreas, 30449 Hannover (DE); SEIFERMANN, Stefan, 77815 Bühl (DE); VOLZ, Daniel, 76137 Karlsruhe (DE)
(74) Vertreter: Hoppe, Georg Johannes
(86) Internationale Anmeldenummer: PCT/EP2016/051091
(87) Internationale Veröffentlichungsnummer: WO 2016/116487

(56) Entgegenhaltungen:
- EP-A1- 1 515 192
- JP-A- 2006 301 399
- US-B1- 6 444 333
- CHIL WON LEE ET AL: "Comparison of Tetraphenylmethane and Tetraphenylsilane as Core Structures of High-Triplet-Energy Hole- and Electron-Transport Materials", CHEMISTRY - A EUROPEAN JOURNAL., Bd. 18, Nr. 21, 18. April 2012 (2012-04-18), Seiten 6457-6461, XP055264751, WEINHEIM, DE ISSN: 0947-6539, DOI: 10.1002/chem.201103640
- DONG-REN BAI ET AL: "Comparative Study on Tetrahedral and Tripodal Luminescent Silane and Methane Compounds with a 2,2'-Dipyridylamino Group", ORGANOMETALLICS, Bd. 23, Nr. 25, 1. Dezember 2004 (2004-12-01), Seiten 5958-5966, XP055264753, US ISSN: 0276-7333, DOI: 10.1021/om049382y
- ZHAO H ET AL: "Design and synthesis of stable triarylamines for hole-transport applications", TETRAHEDRON LETTERS, PERGAMON, GB, Bd. 42, Nr. 27, 2. Juli 2001 (2001-07-02), Seiten 4421-4424, XP004245709, ISSN: 0040-4039, DOI: 10.1016/S0040-4039(01)00702-X

## Beschreibung

Die Erfindung betrifft rein organische Moleküle und deren Verwendung in organischen lichtemittierenden Dioden (OLEDs) und in anderen optoelektronischen Bauelementen.

### Stand der Technik

In den letzten Jahren hat sich die auf OLED (organische lichtemittierende Dioden) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik. Aus diesem Grund wird bezüglich der Entwicklung neuer Materialien intensive Forschung betrieben.

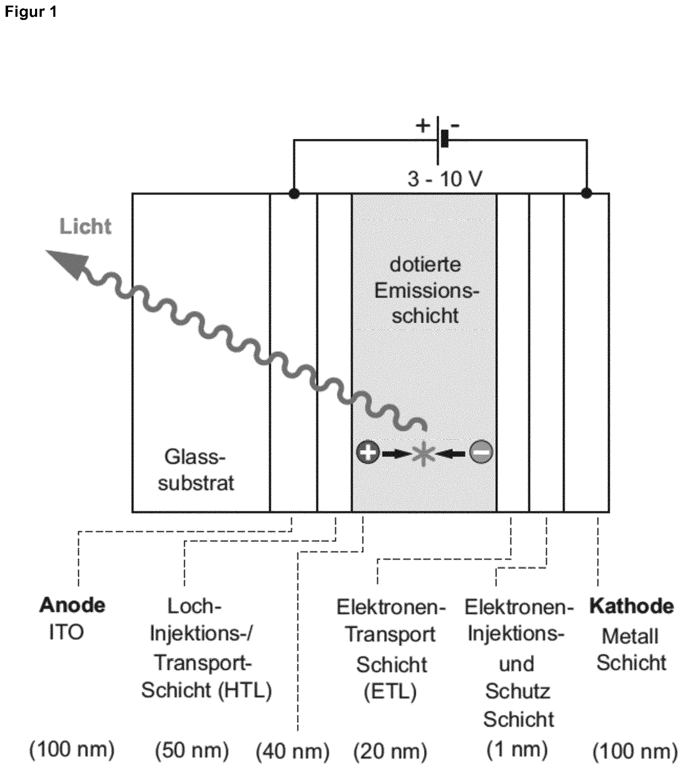

OLEDs sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass zumindest theoretisch alle Exzitonen in Licht umgewandelt werden können. Bei diesen Materialien handelt es sich in der Regel um Übergangsmetall-Komplexverbindungen, in denen das Metall aus der dritten Periode der Übergangsmetalle gewählt wird. Hierbei werden vorwiegend sehr teure Edelmetalle wie Iridium, Platin oder auch Gold eingesetzt. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Neben den Kosten ist auch die Stabilität der Materialien zum Teil nachteilig für die Verwendung.

Eine neue Generation von OLEDs basiert auf der Ausnutzung von verzögerter Fluoreszenz (TADF: thermally activated delayed fluorescence oder auch singlet harvesting). Hierbei können beispielsweise Cu(I)-Komplexe verwendet werden, die aufgrund eines geringen Energieabstandes zwischen dem untersten Triplett-Zustand T₁ und dem darüberliegenden Singulett-Zustand S₁ (ΔE(S₁-T₁) Triplett-Exitonen thermisch in einen Singulett-Zustand rückbesetzen können. Neben der Verwendung von Übergangsmetallkomplexen können auch rein organische Moleküle (ohne Metallion) diesen Effekt ausnutzen.

### Beschreibung

Die Erfindung betrifft in einem Aspekt rein organische Moleküle, die in optoelektronischen Bauelementen verwendet werden können. Diese Tetraarylmethan-Derivate eignen sich insbesondere auf Grund niedriger Singulett-Triplett-Abstände, hoher Quanteneffizienzen sowie kurzer Lumineszenzabklingdauern als Emittermaterialien für die Verwendung in optoelektronischen Bauteilen. Ähnliche Moleküle sind bekannt aus US6444333 B1, EP1515192 A1, JP2006301399 A.

Derartige erfindungsgemäße organische Moleküle weisen eine Struktur der Formel 1 auf oder haben eine Struktur der Formel 1:

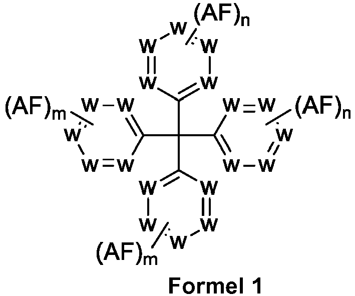

In Formel 1 bedeutet:
m kann bei jedem Auftreten unabhängig voneinander die Werte 1, 2, 3, 4 oder 5 annehmen;
n kann bei jedem Auftreten unabhängig voneinander die Werte 0, 1, 2, 3, 4 oder 5 annehmen;
wobei gilt
w ist ein sp2-hybridisiertes Kohlenstoffatom CR**;
R** ist entweder ein Rest R* oder kennzeichnet die Stelle, über die ein Rest AF an die Tetraarylmethaneinheit gebunden ist;
R* ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, bzw. eine benachbarte CH₂-Gruppe durch -Si(R⁴)₂-, -Ge(R⁴)₂-, -Sn(R⁴)₂-, -C(=O)-, -C(=S)-, -C(=Se)-,-C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder-S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R* auch miteinander ein mono- oder polycyclisches, aliphatisches, aromatisches und/oder benzoannelliertes Ringsystem bilden. In einer Ausführungsform ist das Ringsystem, dass gebildet werden kann auf ein monozyklisches aliphatisches Ringsystem mit insgesamt fünf oder sechs Ringgliedern beschränkt.
R² ist bei jedem Auftreten unabhängig voneinander ausgewählt aus der Gruppe bestehend aus H, Deuterium, Phenyl, Naphthyl, CF₃, C(=O)OR³, C(=O)N(R²)₂, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, bzw. eine benachbarte CH₂-Gruppe durch -Si(R⁴)₂-,-Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ ist bei jedem Auftreten unabhängig voneinander ausgewählt aus der Gruppe bestehend aus H, Deuterium, Phenyl, Naphthyl, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden.
R⁴ ist bei jedem Auftreten unabhängig voneinander ausgewählt aus der Gruppe bestehend aus H, Deuterium, Phenyl, Naphthyl, N(R²)₂, CN, CF₃, OH, C(=O)OR³, C(=O)N(R³)₂, C(=O)R³, P(=O)(R⁷)₂, As(=O)(R⁷)₂, P(=S)(R⁷)₂, As(=S)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch -Si(R⁴)₂-, -Ge(R⁴)₂-, -Sn(R⁴)₂-,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁴ auch miteinander ein mono- oder polycyclisches, aliphatisches, aromatisches und/oder benzoannelliertes Ringsystem bilden;
R⁵ ist bei jedem Auftreten unabhängig voneinander ausgewählt aus der Gruppe bestehend aus Phenyl, Naphthyl, CF₃, C(=O)R³, P(=O)(R⁷)₂, As(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch -Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁵ auch miteinander ein mono- oder polycyclisches, aliphatisches, aromatisches und/oder benzoannelliertes Ringsystem bilden;
R⁶ ist bei jedem Auftreten unabhängig voneinander ausgewählt aus der Gruppe bestehend aus Phenyl, Naphthyl, CF₃, Si(R⁴)₃, C(=O)R³, P(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch-Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁶ auch miteinander ein mono- oder polycyclisches, aliphatisches, aromatisches und/oder benzoannelliertes Ringsystem bilden;
R⁷ ist bei jedem Auftreten unabhängig voneinander ausgewählt aus der Gruppe bestehend aus H, Deuterium, Phenyl, Naphthyl, N(R²)₂, CN, CF₃, C(=O)OR³, C(=O)N(R³)₂, Si(R⁴)₃, C(=O)R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-, -C=N-, -C(=O)O-,-C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-,-O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R⁷ auch miteinander ein mono- oder polycyclisches, aliphatisches, aromatisches und/oder benzoannelliertes Ringsystem bilden;
R⁸ ist bei jedem Auftreten unabhängig voneinander ausgewählt aus der Gruppe bestehend aus H, Deuterium, Phenyl, Naphthyl, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R⁸ auch miteinander ein mono- oder polycyclisches, aliphatisches Ringsystem bilden;
R⁹ ist bei jedem Auftreten unabhängig voneinander ausgewählt aus der Gruppe bestehend aus H, Deuterium, Phenyl, Naphthyl, N(R²)₂, CN, CF₃, NO₂, OH, COOH, C(=O)OR³, C(=O)N(R³)₂, Si(R⁴)₃, B(OR⁵)₂, C(=O)R³, P(=O)(R⁷)₂, P(=S)(R⁷)₂, As(=O)(R⁷)₂, P(=S)(R⁷)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch -R³C=CR³-, -C≡C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-,-C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann, oder eine Kombination dieser Systeme; dabei können zwei oder mehrere dieser Substituenten R⁹ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind insbesondere N, O, und S. Werden in der Beschreibung der vorliegenden Erfindung andere Definitionen angegeben, beispielsweise bezüglich der Zahl der aromatischen Ringatome oder der enthaltenen Heteroatome, so gelten diese anderen Definitionen.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind insbesondere ausgewählt aus, N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nichtaromatische Einheit (insbesondere weniger als 10% der verschiedenen Atome), wie z.B. ein sp3-hybridisiertes C-, Si-, oder N-Atom, ein sp2-hybridisiertes C-, N- oder O-Atom oder ein sp-hybridisiertes C-Atom, verbunden sein können. So sollen beispielsweise auch System wie 9,9'-Diarylfluoren, Triarylamin, Diarylether, Stilben etc als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppen oder durch eine Silylgruppe verbunden sind. Weiterhin werden auch Systeme, in denen zwei oder mehr Aryl- oder Heteroyraylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.
AF: Organische chemische Einheit (Rest). Es sind mindestens zwei unterschiedliche chemische Einheiten AF1 und AF2 enthalten, die an jeweils unterschiedlichen Ringen angebunden sind;
AF1: eine erste chemische Einheit, aufweisend ein konjugiertes System, insbesondere mindestens sechs in Konjugation stehende π-Elektronen (z. B. in Form mindestens eines aromatischen Systems);
AF2: eine zweite chemische Einheit, aufweisend ein konjugiertes System, insbesondere mindestens sechs in Konjugation stehende π-Elektronen (z. B. in Form mindestens eines aromatischen Systems); Definitionsgemäß weist AF2 im Vergleich zu AF1 immer einen niedrigeren (mathematischen) HOMO-Zahlenwert auf (und damit auch entsprechend einen niedrigeren LUMO-Zahlenwert als AF1).

AF1 und AF2 kommen je mindestens einmal im Molekül vor, wobei sie auch mehrfach vorhanden sein können, wobei jeweils alle enthaltenen Einheiten AF1 dieselbe Struktur haben und wobei jeweils alle enthaltenen Einheiten AF2 dieselbe Struktur haben.

In einer Ausführungsform zeichnen sich die erfindungsgemäßen organischen Moleküle dadurch aus, dass
- die Differenz der Energie des HOMO der zweiten chemischen Einheit AF2 und der Energie des HOMO der ersten chemischen Einheit AF1 > 0,8 eV ist (Δ HOMO = HOMO(AF2) - HOMO(AF1) > 0,8 eV);
- die Differenz der Energie des LUMO der zweiten chemischen Einheit AF2 und der Energie des LUMO der ersten chemischen Einheit AF1 > 0,8 eV ist (Δ LUMO = LUMO(AF2) - LUMO(AF1) > 0,8 eV); und/oder
- die Differenz der Energie des LUMO der ersten chemischen Einheit AF1 und der Energie des HOMO der zweiten chemischen Einheit AF2 > 0,9 eV ist (Δ Gap = LUMO (AF1) - HOMO(AF2)> 0,9 eV).

Dabei werden die Energiewerte HOMO(AF1), HOMO(AF2), LUMO(AF1), LUMO(AF2) mithilfe der Dichtefunktionaltheorie (DFT) berechnet, wobei die Anknüpfungspositionen der ambifunktionalen Einheiten und der Separatoren mit einem Wasserstoffatom entsprechend ihrer chemischen Valenzen abgesättigt werden. Die angegeben Grenzen beziehen sich auf Orbitalenergien in eV, die mit dem BP86-Funktional berechnet werden (Becke, A. D. Phys. Rev. A1988, 38, 3098-3100; Perdew, J. P. Phys. Rev. B1986, 33, 8822-8827).

In einer Ausführungsform weisen die organischen Moleküle eine Struktur der Formel 2a bis 2d auf oder haben eine Struktur der Formel 2a bis 2d, wobei die bei Formel 1 angegebenen Definitionen gelten und das organische Molekül mindestens zwei verschiedene AF aufweist, die an jeweils unterschiedlichen Ringen angebracht sind.

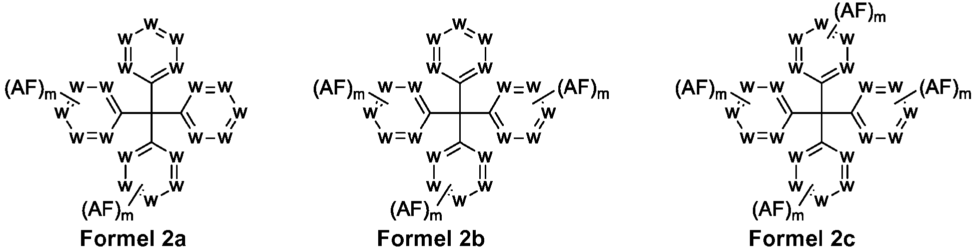

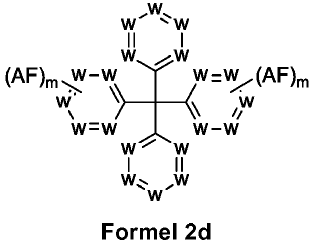

In einer Ausführungsform sind die organischen Moleküle ausgewählt aus den Formeln 2-1 bis 2-1 wobei m bei jedem Auftreten unabhängig voneinander die Werte 1, 2, 3, 4 oder 5 annehmen kann und wobei n bei jedem Auftreten unabhängig voneinander die Werte 1, 2, 3, 4 oder 5 annehmen kann und im Übrigen die bei Formel 1 angegebenen Definitionen gelten:

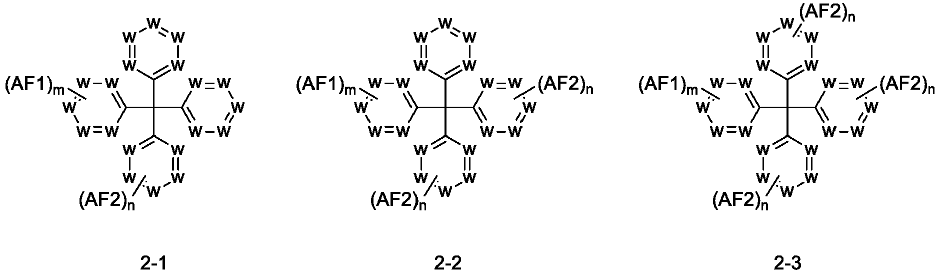

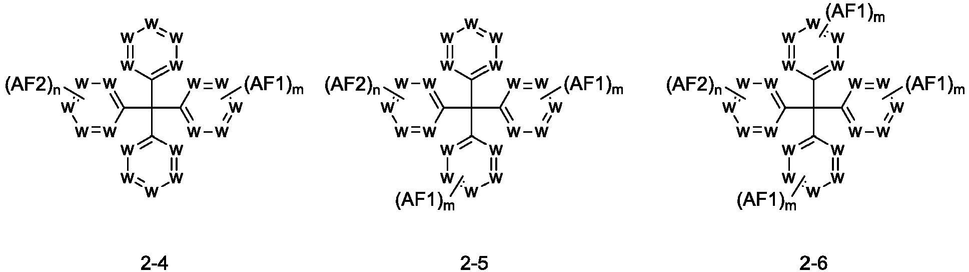

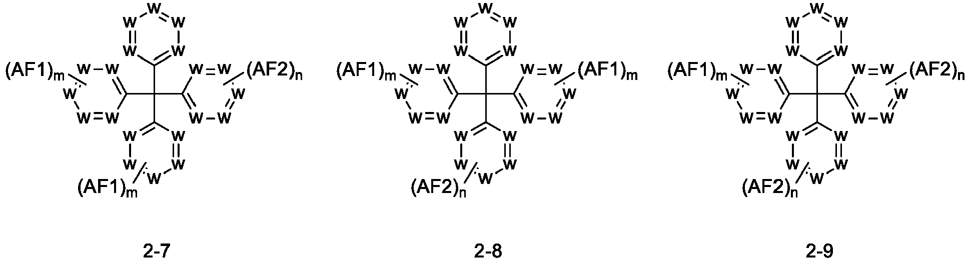

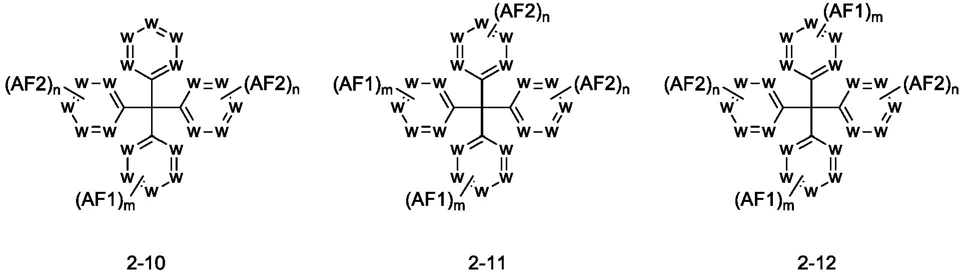

Die Anordnung der Substituenten in Formeln 2-1 bis 2-12 ist im Folgenden exemplarisch für eine chemische Einheit AF gezeigt. AF steht stellvertretend für die chemischen Einheiten AF1 oder AF2. Die gewellte Linie gibt die Verbindung zu dem im Molekül enthaltenen zentralen sp3-Kohlenstoffatom an.

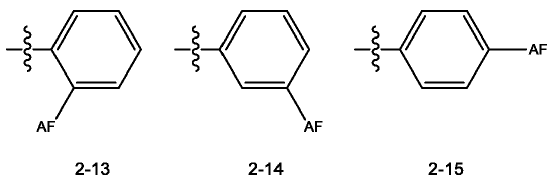

Des Weiteren sind Mehrfachsubstitutionen möglich:

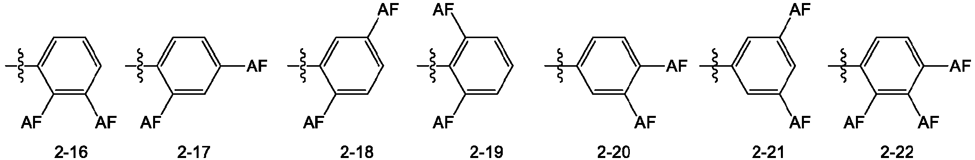

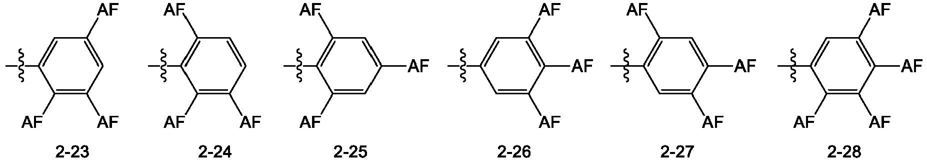

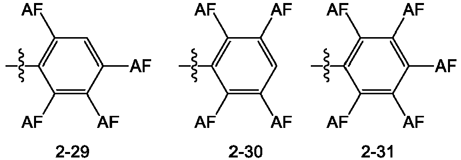

Analog hierzu lassen sich die Substitutionsmuster auch auf heterozyklische Systeme übertragen. Für heteroaromatische Systeme ist dies exemplarisch anhand des monosubstituierten Pyridins gezeigt:

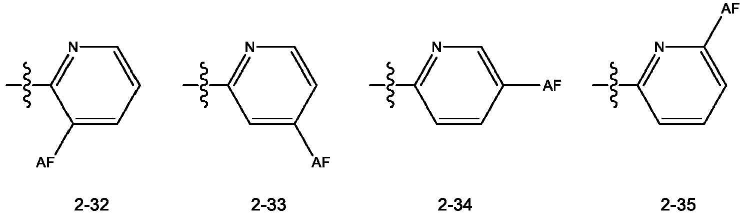

Es sind aber auch Mehrfachsubstitutionen, wie in Formeln 2-23 bis 2-32 dargestellt, erlaubt. Ferner können auch die Position und die Anzahl des Heteroatoms variieren. In den Formeln 2-36 bis 2-41 ist dies exemplarisch für Pyrdin und Pyridin-verwandte Systeme gezeigt. Zudem sind auch potentiell Aromaten mit zwei verschiedenen Heteroatomen denkbar.

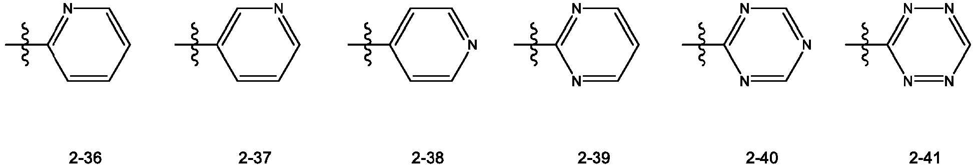

Durch Kombination der Formeln 2-1 bis 2-12 mit den möglichen Substitutionsmustern, welche exemplarisch in den Formeln 2-13 bis 2-41 dargestellt sind, können so die erfindungsgemäßen Moleküle realisiert werden.

Der Teil des organischen Moleküls gemäß Formel 1 oder Formel 2a bis Formel 2d, der nicht chemische Einheiten AF darstellt, also das Tetraarylmethangerüst, wird auch als Separator S bezeichnet.

In einer Ausführungsform sind die chemischen Einheiten AF2 ausgewählt aus den durch die Formel 3a beschriebenen Strukturen; 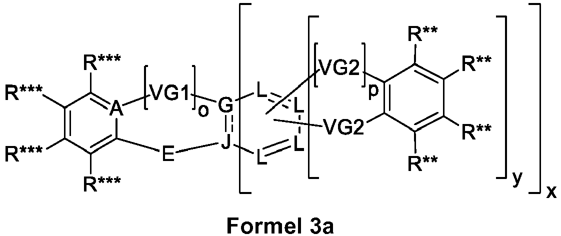 wobei gilt:
x ist 0 oder 1;
y ist 0 oder 1, wobei bei x = 0 immer auch y = 0 ist;
o ist 0 oder 1;
p ist 0 oder 1;
A ist CR*** wenn o = 0, ansonsten C;
VG1 ist eine verbrückende Gruppe ausgewählt aus der Gruppe bestehend aus
   - NR**, CR**₂, O, Sund einer C-C-Einfachbindung; oder
   - NR**, CR**₂, O, S, einer C-C-Einfachbindung, BR**, AsR**, SiR**₂, GeR**₂, 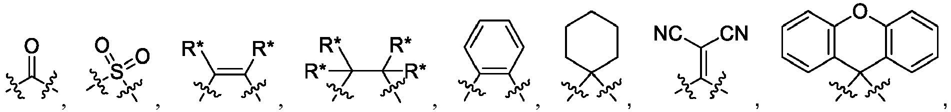 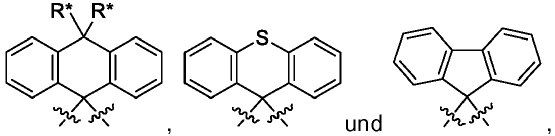 wenn x = 1 und gleichzeitig y = 0;
VG2 ist eine verbrückende Gruppe bei jedem Auftreten unabhängig voneinander ausgewählt aus der Gruppe bestehend aus CR**₂, NR**, O, S und einer C-C-Einfachbindung, wobei nicht zwei Einheiten VG2 gleichzeitig gleich eine C-C-Einfachbindung sind;
E ist NR**, 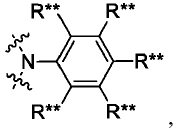 O oder S;
G ist C wenn o = 1 und gleichzeitig x = 1; G ist CR** wenn o = 0 und gleichzeitig x = 1; G ist CR** oder CR**₂, wenn o = 1 und gleichzeitig x = 0;G ist R* wenn o = 0 und gleichzeitig x = 0; G ist CR**, CR**₂, N oder NR* wenn x = 0 und gleichzeitig VG1 eine C-C-Einfachbindung ist;
J ist C wenn x = 1; J ist CR**, CR**₂ oder NR** wenn x = 0;
L ist CR*** wenn y = 0;L ist CR** oder C (bei kovalenter Bindung zu VG2) wenn y = 1;
R*** ist R** oder ist ausgewählt aus den folgenden Einheiten, wobei maximal zwei der Reste R*** gleichzeitig gleich einer der folgenden Einheiten sind: 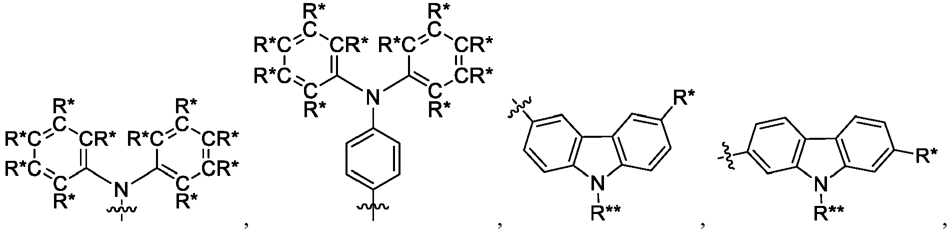 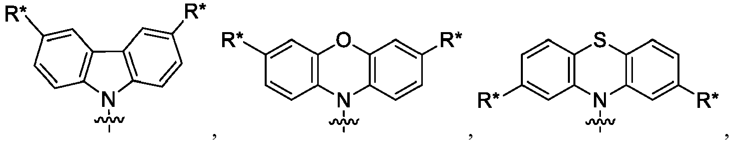 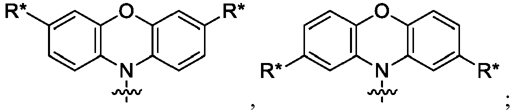
R** ist bei jedem Auftreten unabhängig voneinander ein Rest R* und/oder markiert die Anknüpfungsstelle für den Separator S (s. Formel 3);
   R* ist wie bei Formel 1 definiert.
und wobei die chemischen Einheiten AF1 ausgewählt sind aus den durch die Formel 3b beschriebenen Strukturen. 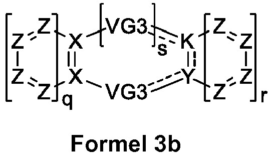 wobei gilt:
q ist 0 oder 1; r ist 0 oder 1; s ist 0 oder 1;
VG3 = verbrückende Gruppe ist bei jedem Auftreten unabhängig voneinander ausgewählt aus der Gruppe bestehend aus
   - N, O, S, CR**, eine Element-Element-Einfachbindung zwischen X und Y oder zwischen X und K, wobei nicht 2 Einheiten VG3 gleichzeitig eine Element-Element-Einfachbindung zwischen X und Y und zwischen X und K sind;
   - BR**, NR**, GeR**₂, AsR**₂, SiR**₂, wobei nicht zwei Einheiten VG3 gleichzeitig gleich BR**, NR**, GeR**₂, AsR**₂, SiR**₂ sind; 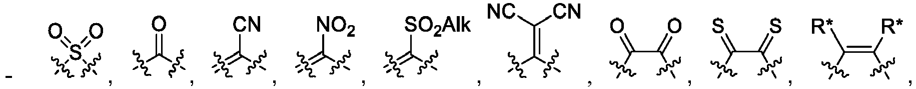 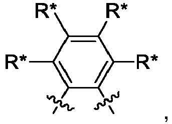 wobei nicht zwei Einheiten VG3 gleichzeitig gleich 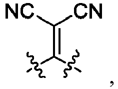 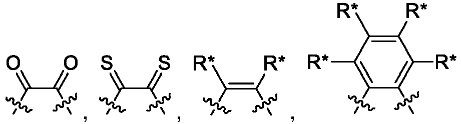 sind;
X ist bei jedem Auftreten unabhängig voneinander C; oder X ist CR**, N wenn q = 0;
Y ist C; oder Y ist CR**, CR**₂, N, NR*, O oder S wenn r = 0;
K ist Y; oder K ist R* wenn r = 0 und gleichzeitig s = 0;
Z ist bei jedem Auftreten unabhängig voneinander CR** oder N;
und wobei maximal 4 der Einheiten VG3, K, X, Y, Z gleichzeitig gleich N sind;
und wobei mindestens 1 der Einheiten VG3, K, X, Y, Z gleich einer von C-H verschiedenen Gruppe ist, die mindestens 1 Stickstoff- oder ein Sauerstoff- oder ein Schwefelatom enthält;
und wobei im Falle von r = 0 auch zwei benachbarte Gruppen Z miteinander oder eine Gruppe VG3 mit der ihr am nächsten gelegenen Gruppe Z über die folgenden Einheiten verbrückt sein können: 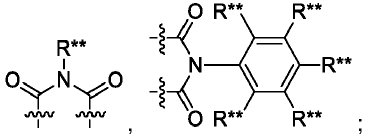
und wobei im Falle von r = 0 und gleichzeitig q = 0 auch eine Gruppe VG3 mit der ihr benachbarten Gruppe X über die Einheiten 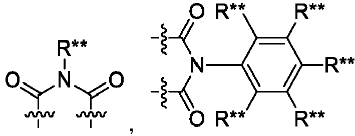 verbrückt sein kann;
wobei maximal drei dieser Einheiten enthalten sind.
R** ist bei jedem Auftreten unabhängig voneinander ein Rest R* und/oder markiert die Anknüpfungsstelle für den Separator S.
R* ist wie bei Formel 1 definiert.

In einer weiteren Ausführungsform werden die in erfindungsgemäßen Molekülen enthaltenen Einheiten AF1 durch die Formeln 3b.1 bis 3b.36 beschrieben: 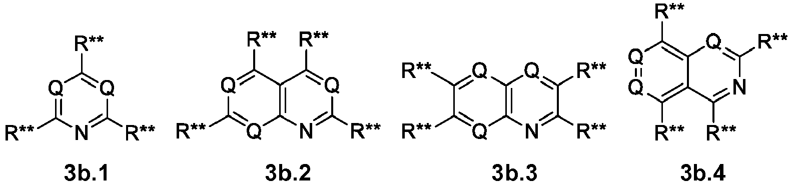 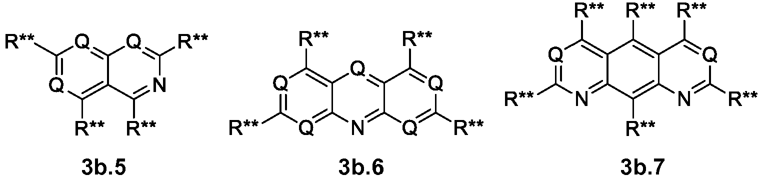 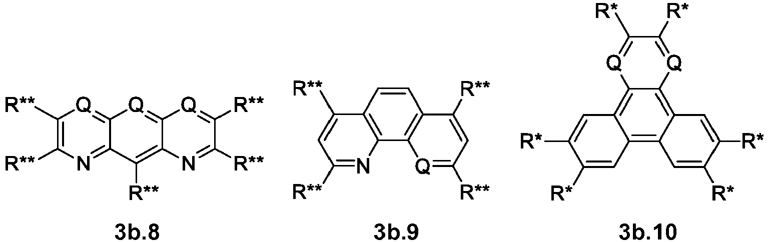 und wobei gilt:
Q ist N oder CR**, wobei nicht zwei direkt benachbarte Einheiten Q gleichzeitig gleich N sind; 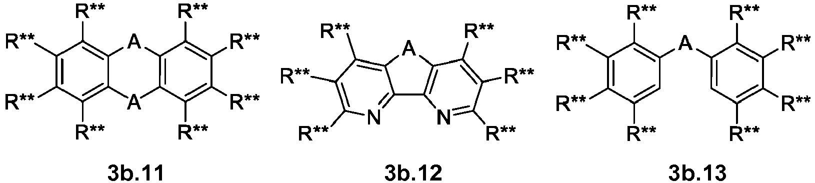
und wobei gilt:
   A ist 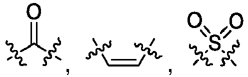 oder eine Element-Element-Einfachbindung, wobei nicht zwei Einheiten A gleichzeitig eine Element-Element-Einfachbindung sind; oder A ist NR**, wobei nicht zwei Einheiten A gleichzeitig gleich NR** sind; 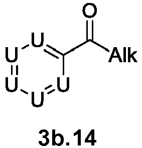
und wobei gilt:
   U ist CR** oder N, wobei maximal 3 Einheiten U gleichzeitig gleich N sind und wobei keine benachbarten Einheiten U gleichzeitig gleich N sind;
   Alk ist ausgewählt aus der Gruppe bestehend aus Methyl, Ethyl, Propyl *iso*-Propyl, Butyl, *tert*-Butyl, Pentyl, Hexyl, 2-Ethylhexyl, Cyclohexyl, Heptyl Octyl, Nonyl, Decyl, Undecyl und Dodecyl; 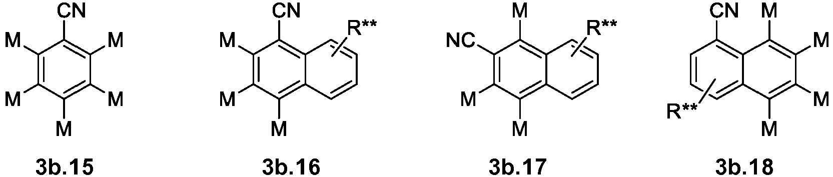 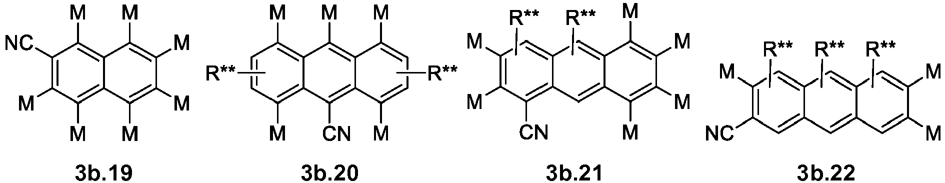
und wobei gilt:
   M ist H, Deuterium, ALK, Phenyl, Pyridyl, R**, CN, wobei maximal 4 Einheiten M gleichzeitig gleich CN sind; 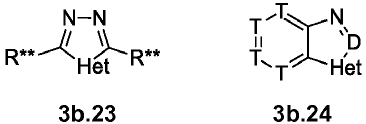
und wobei gilt: Het ist NR**, O, S oder SO₂;
D ist N oder CR**;
T ist N oder CR**, wobei maximal 2 Einheiten T gleich N sind und wobei keine benachbarten Einheiten T gleich N sind; 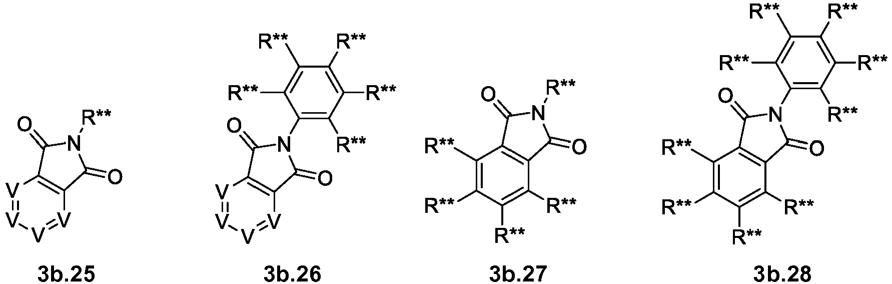 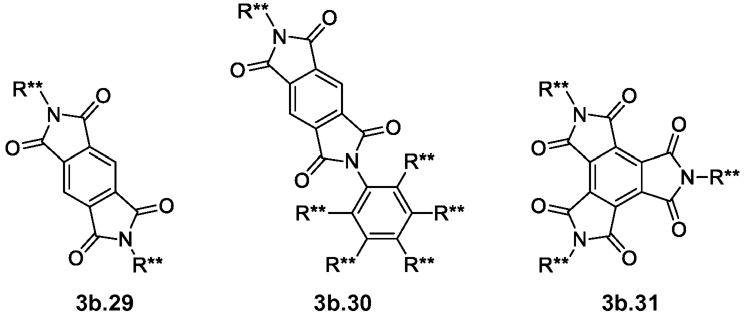 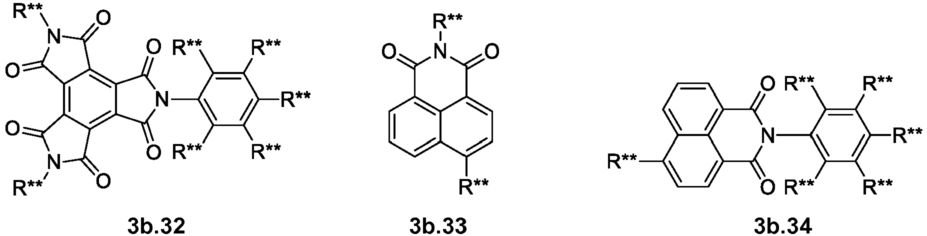 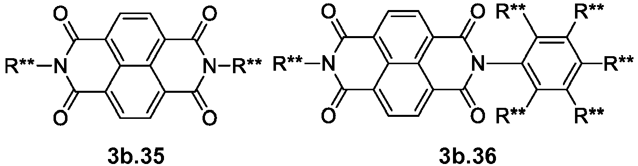
und wobei gilt: V ist bei jedem Auftreten CR** oder N, wobei mindestens eine Einheit V gleich N ist; und wobei maximal zwei Einheiten V gleichzeitig gleich N sind; und wobei nicht zwei einander benachbarte Einheiten V gleichzeitig gleich N sind.
R** und R* sind in den Formeln 3b.1 bis 3b.36 wie in Formel 3b definiert.

In einer Ausführungsform der Erfindung sind die chemischen Einheiten AF2 ausgewählt aus der in Tabelle 1 angegebenen Gruppe von Verbindungen, wobei die chemischen Einheiten AF1 ausgewählt sind aus den Verbindungen der Tabelle 2.

**Tabelle 1: Auflistung von chemischen Einheiten AF2. Mögliche Anknüpfungspunkte der chemischen Einheit AF an einen Separator S sind mit Kleinbuchstaben bezeichnet.**

| | | | |
|---|---|---|---|
| 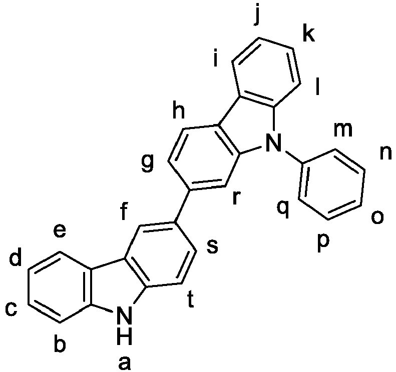 | 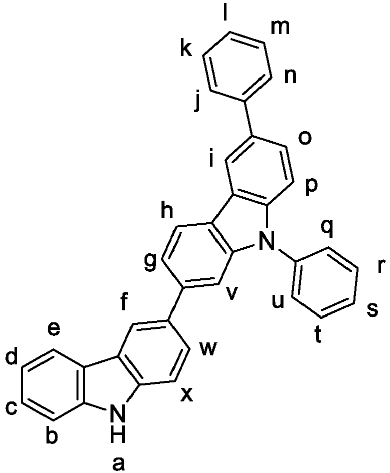 | | |
| 1 | 2 | | |
| 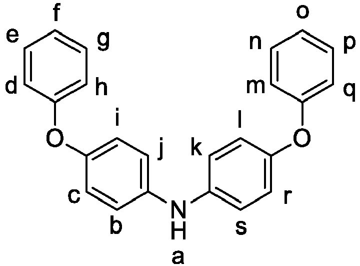 | 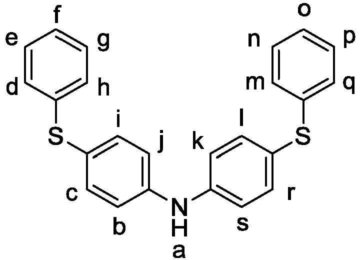 | | |
| 3 | 4 | | |
| 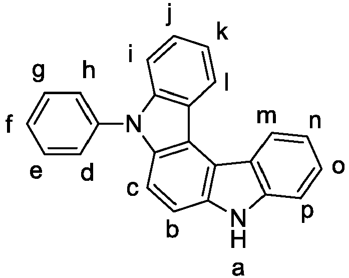 | 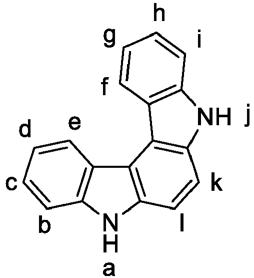 | | |
| 6 | 7 | | |
| 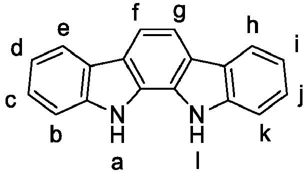 | 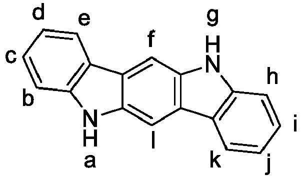 | 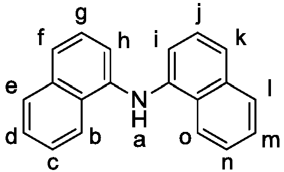 | |
| 8 | 10 | 12 | |
| 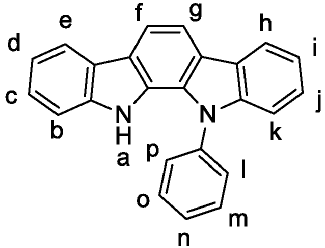 | 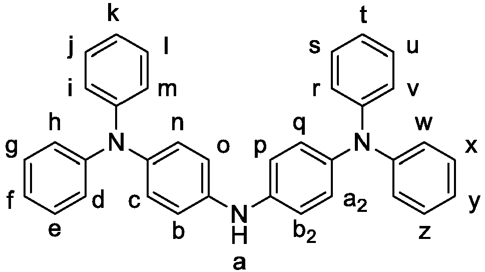 | | |
| 21 | 22 | | |
| 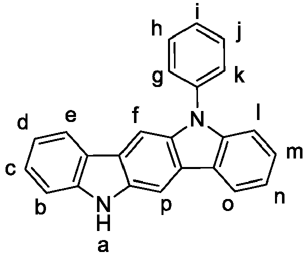 | 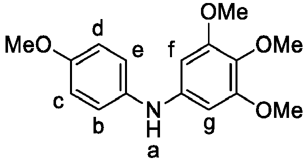 | 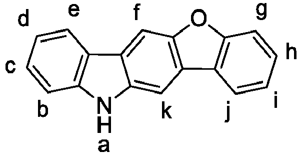 | |
| 24 | 26 | 30 | |
| 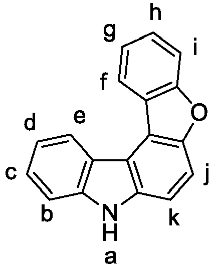 | 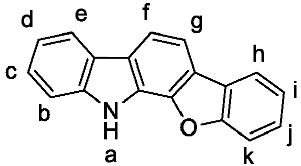 | 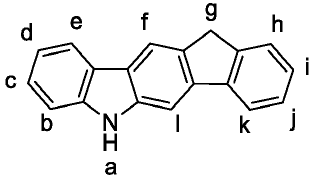 | |
| 31 | 32 | 33 | |
| 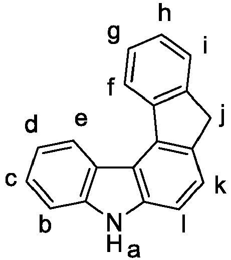 | 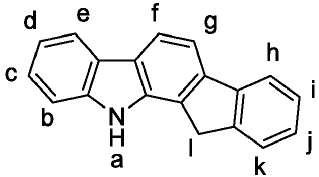 | 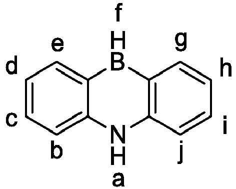 | |
| 34 | 35 | 38 | |
| 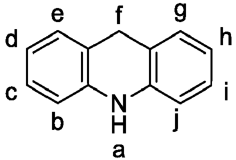 | 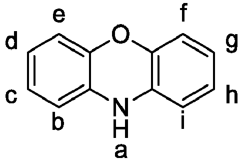 | 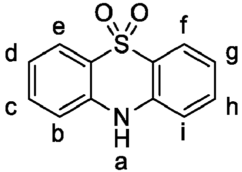 | |
| 39 | 41 | 44 | |
| 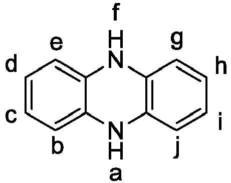 | 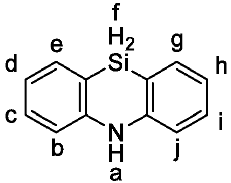 | 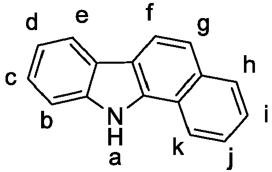 | |
| 49 | 53 | 54 | |
| 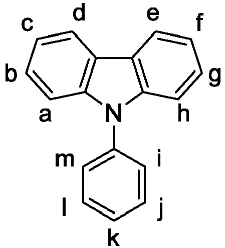 | 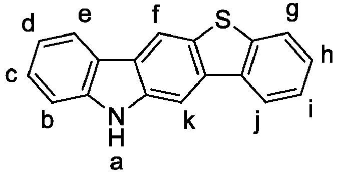 | 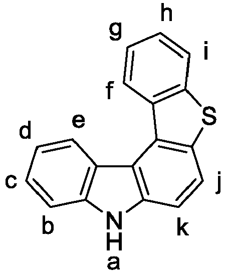 | |
| 55 | 58 | 59 | |
| 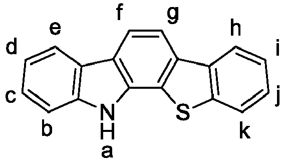 | 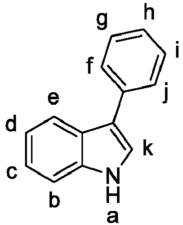 | 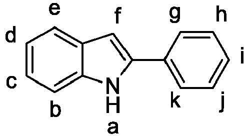 | |
| 60 | 63 | 64 | |
| 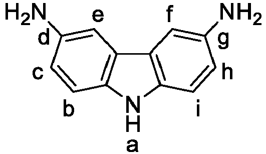 | 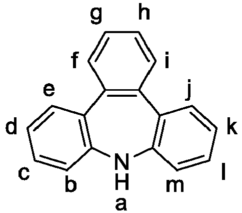 | | 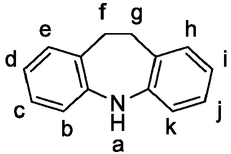 |
| 66 | 71 | | 72 |
| 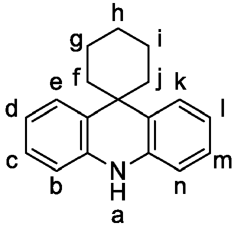 | | 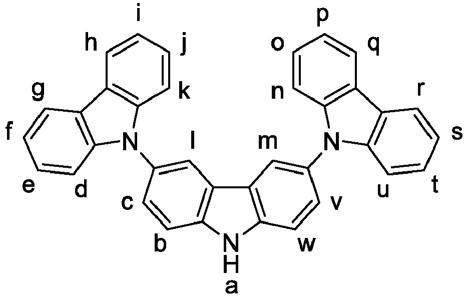 | |
| 73 | | 74 | |
| 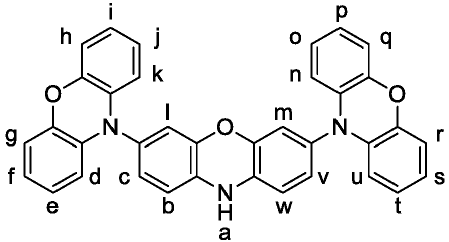 | | 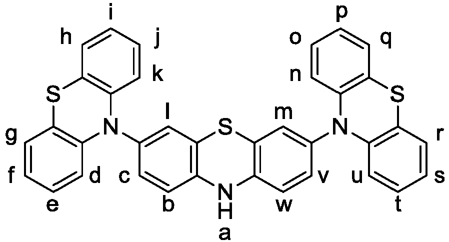 | |
| 75 | | | 76 |
| 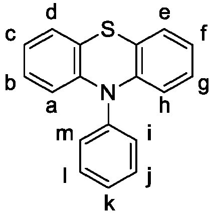 | 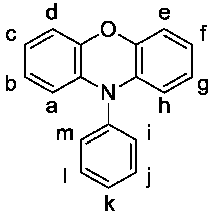 | 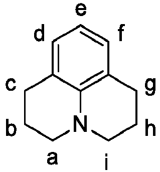 | 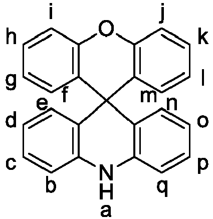 |
| 77 | 78 | 91 | 94 |
| 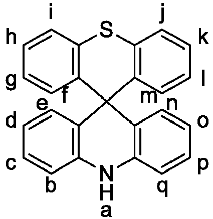 | 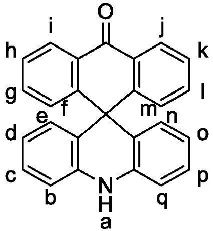 | 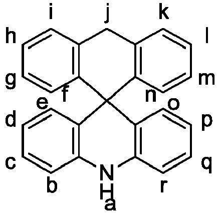 | 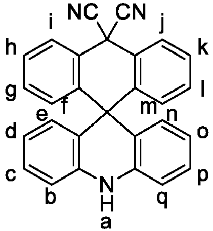 |
| 95 | 96 | 97 | 98 |
| 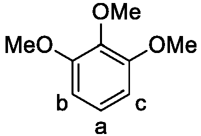 | 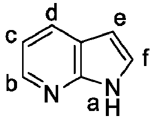 | 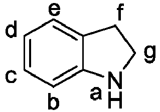 | 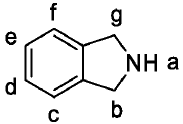 |
| 120 | 127 | 128 | 129 |
| 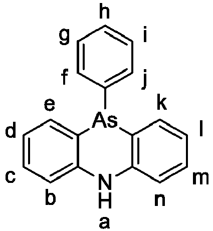 | 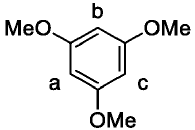 | 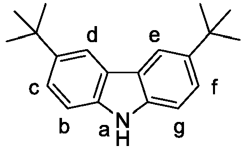 | 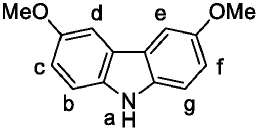 |
| 149 | 156 | 200 | 199 |
| 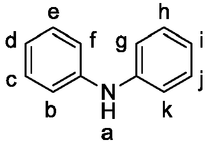 | 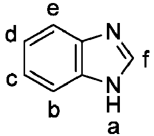 | 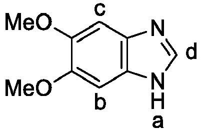 | 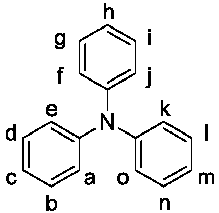 |
| 223 | 239 | 242 | 317 |
| 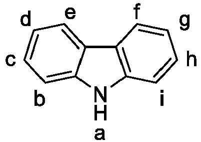 | 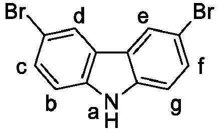 | 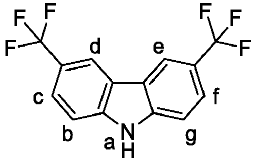 | 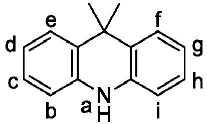 |
| 328 | 330 | 331 | 337 |
| 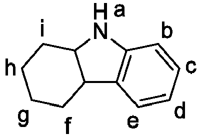 | 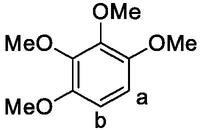 | 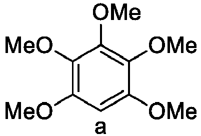 | 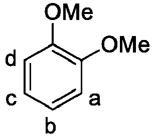 |
| 339 | 344 | 345 | 346 |
| 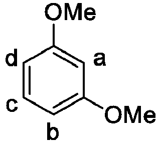 | 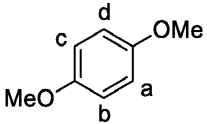 | 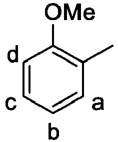 | 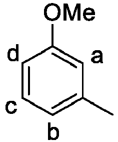 |
| 347 | 348 | 349 | 350 |
| 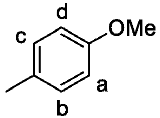 | 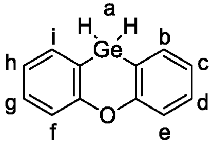 | 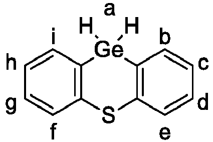 | 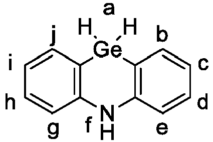 |
| 351 | 352 | 353 | 354 |
| 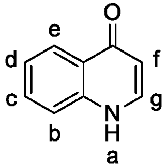 | 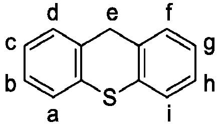 | 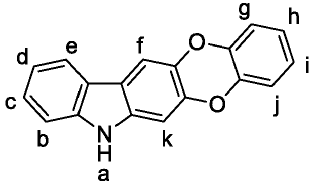 | 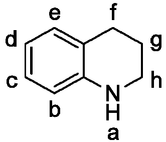 |
| 360 | 366 | 377 | 383 |
| 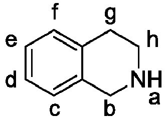 | 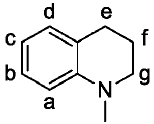 | 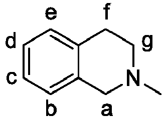 | 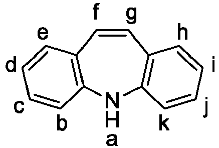 |
| 384 | 387 | 388 | 400 |
| 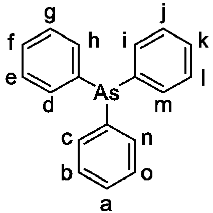 | 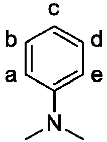 | 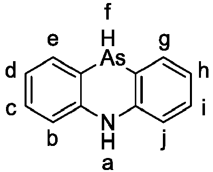 | 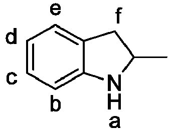 |
| 401 | 404 | 405 | 406 |
| | 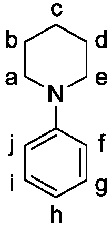 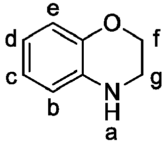 | 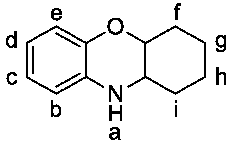 | 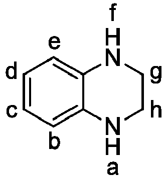 |
| 407 | 410 | 411 | 413 |
| 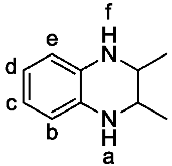 | 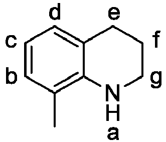 | 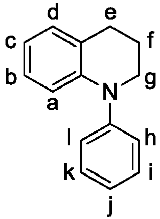 | 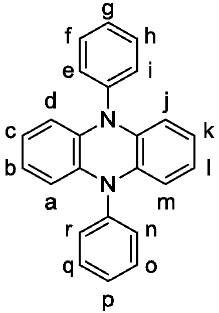 |
| 414 | 417 | 418 | 425 |
| 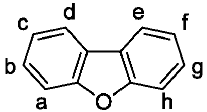 | 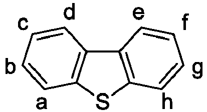 | 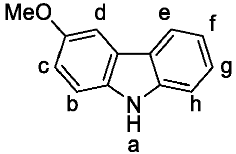 | 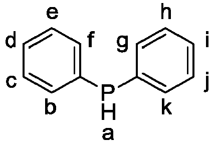 |
| 432 | 433 | 436 | 444 |
| 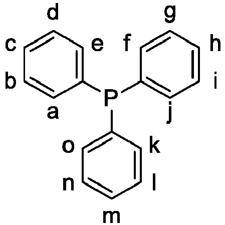 | 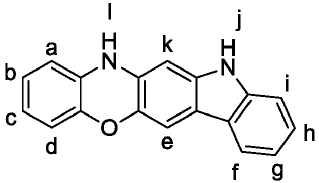 | | 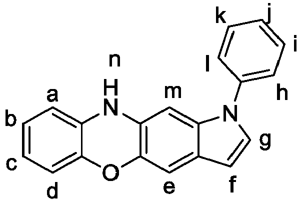 |
| 445 | 477 | | 478 |
| 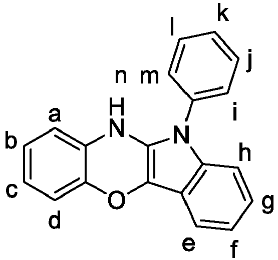 | 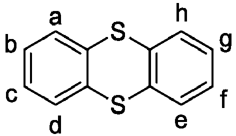 | | 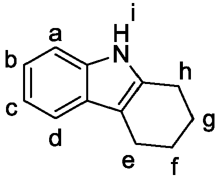 |
| 479 | 480 | | 481 |

**Tabelle 2: Auflistung der chemischen Einheiten AF1. Mögliche Anknüpfungspunkte der chemischen Einheit AF1 an einen Separator S sind mit Kleinbuchstaben bezeichnet.**

| | | | |
|---|---|---|---|
| 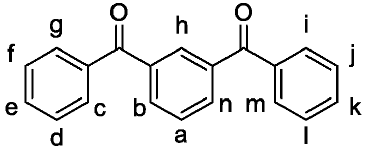 | 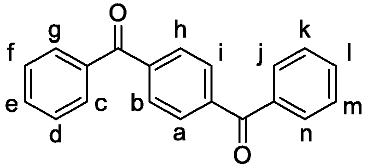 | | |
| 27 | 28 | | |
| 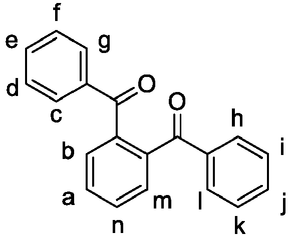 | 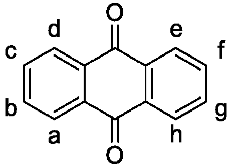 | 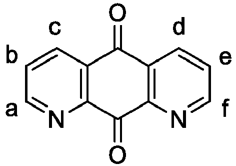 | |
| 29 | 36 | 37 | |
| 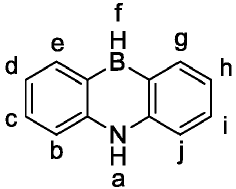 | 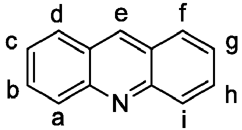 | 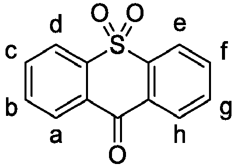 | |
| 38 | 40 | 43 | |
| 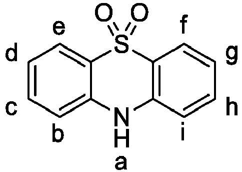 | 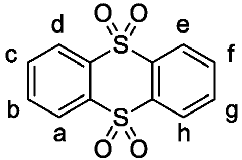 | 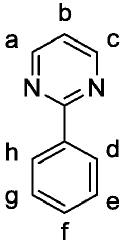 | |
| 44 | 46 | 56 | |
| 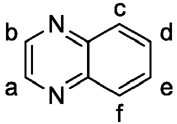 | 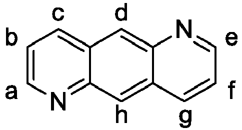 | 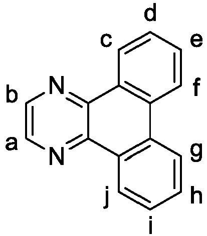 | |
| 61 | 62 | 65 | |
| 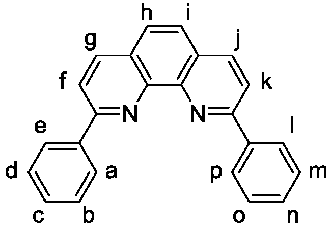 | 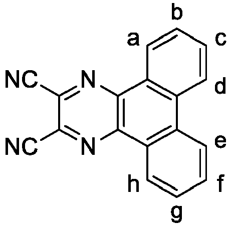 | | 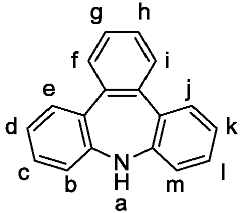 |
| 68 | 70 | | 71 |
| 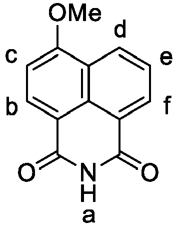 | 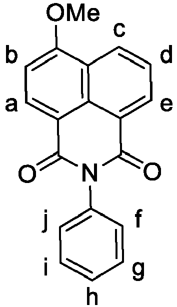 | | 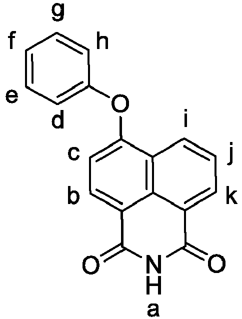 |
| 79 | 80 | | 81 |
| 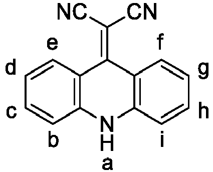 | 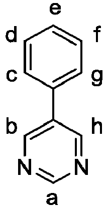 | 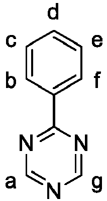 | 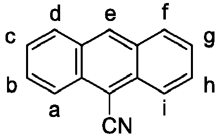 |
| 82 | 83 | 85 | 86 |
| 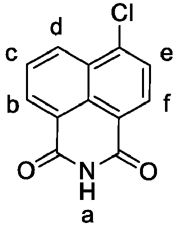 | 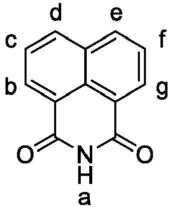 | | 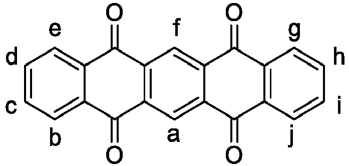 |
| 89 | 90 | | 93 |
| 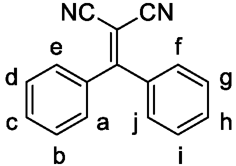 | 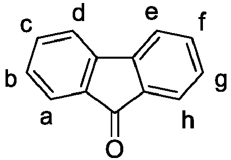 | | 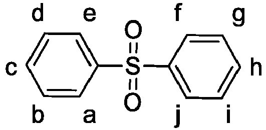 |
| 109 | 110 | | 111 |
| 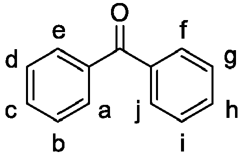 | 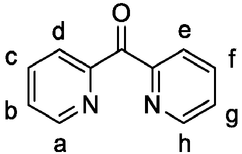 | | |
| 112 | 113 | | |
| 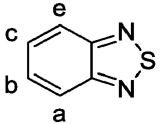 | 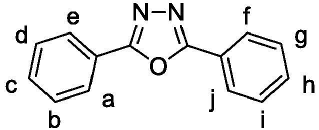 | | 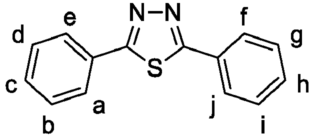 |
| 115 | 118 | | 119 |
| 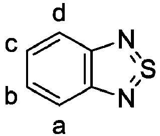 | 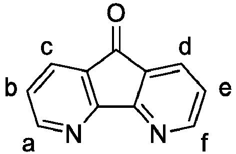 | | 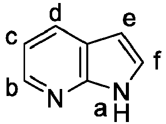 |
| 121 | 123 | | 127 |
| 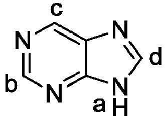 | 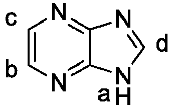 | 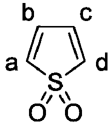 | 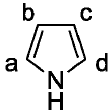 |
| 131 | 132 | 133 | 134 |
| 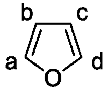 | 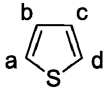 | 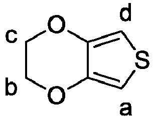 | 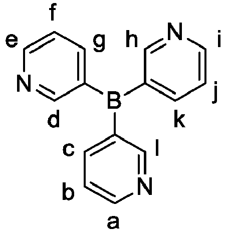 |
| 135 | 136 | 140 | 144 |
| 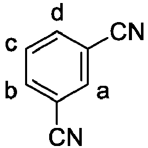 | 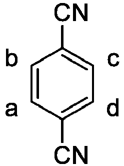 | 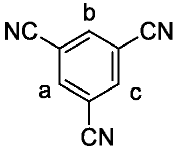 | 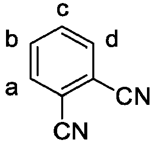 |
| 150 | 151 | 152 | 153 |
| 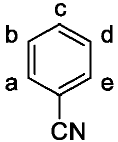 | 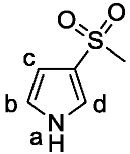 | 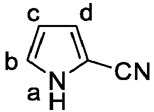 | 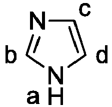 |
| 154 | 157 | 158 | 159 |
| 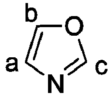 | 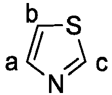 | 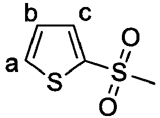 | 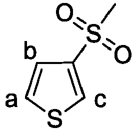 |
| 160 | 161 | 166 | 167 |
| 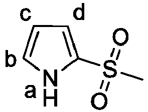 | 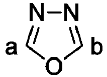 | 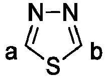 | |
| 168 | 170 | 171 | |
| 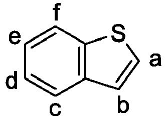 | 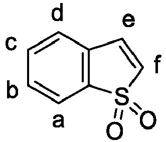 | 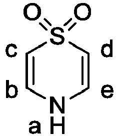 | 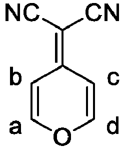 |
| 176 | 177 | 182 | 183 |
| 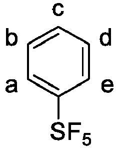 | 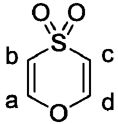 | 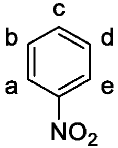 | 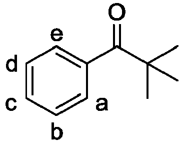 |
| 184 | 187 | 192 | 193 |
| 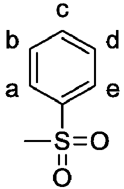 | 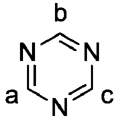 | 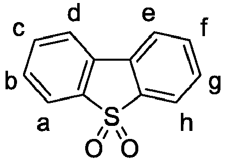 | |
| 194 | 195 | | 198 |
| 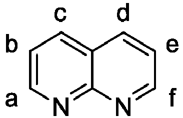 | 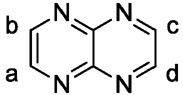 | | 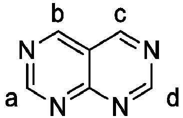 |
| 205 | 206 | | 207 |
| 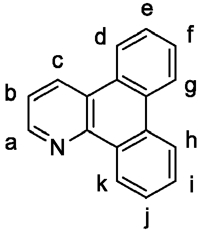 | 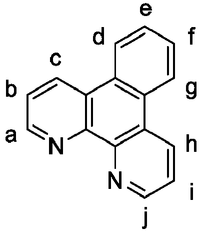 | 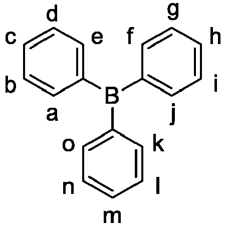 | 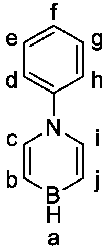 |
| 208 | 209 | 213 | 214 |
| 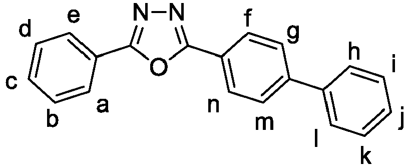 | | 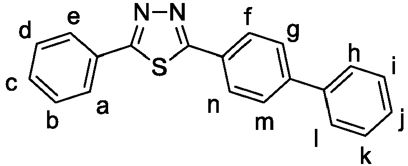 | |
| 217 | | 218 | |
| 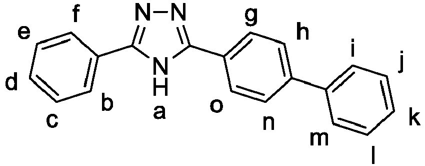 | | 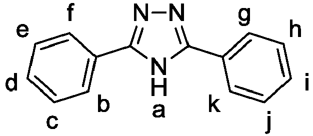 | |
| 219 | | 222 | |
| 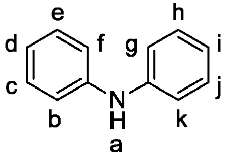 | 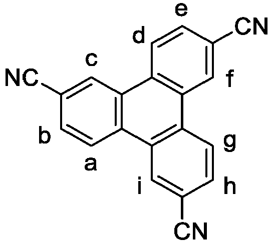 | 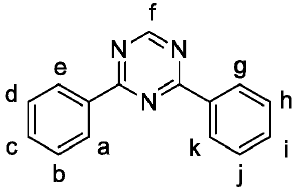 | |
| 223 | 231 | 233 | |
| 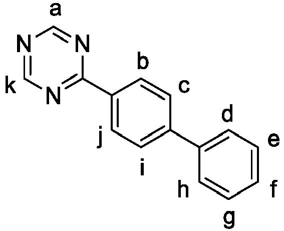 | 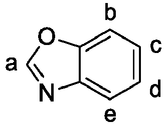 | 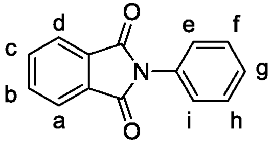 | |
| 234 | 236 | 237 | |
| 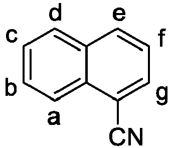 | 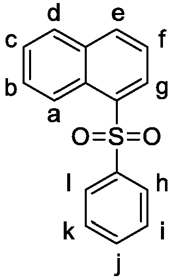 | 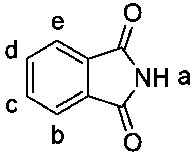 | |
| 244 | 245 | 246 | |
| 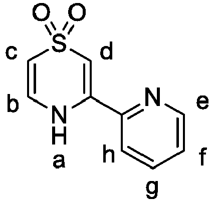 | 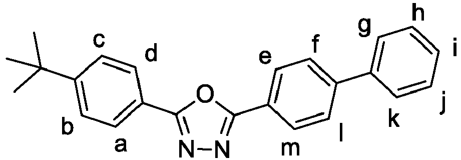 | | |
| 275 | 285 | | |
| 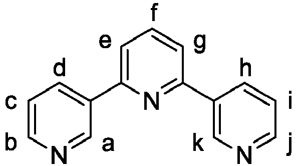 | 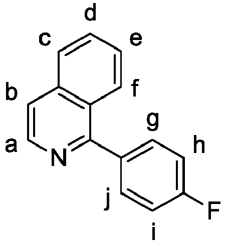 | 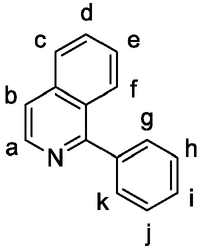 | |
| 286 | 287 | 288 | |
| 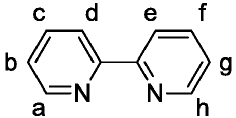 | 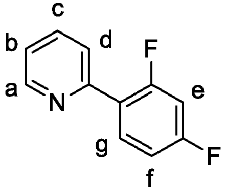 | 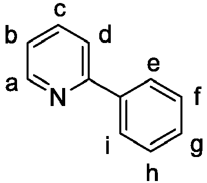 | |
| 297 | 300 | 303 | |
| 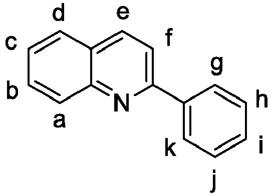 | 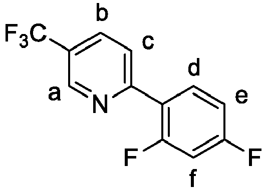 | 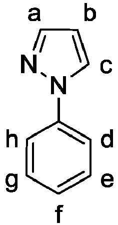 | |
| 304 | 305 | 308 | |
| 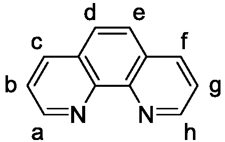 | 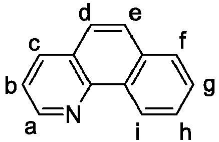 | 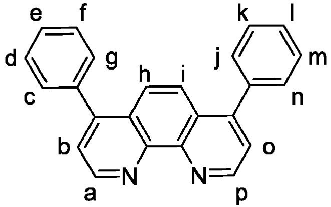 | |
| 311 | 312 | 313 | |
| 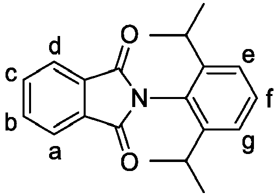 | 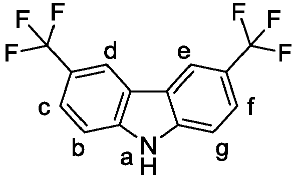 | 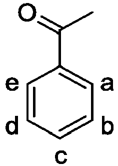 | |
| 327 | 331 | 332 | |
| 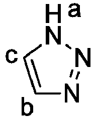 | 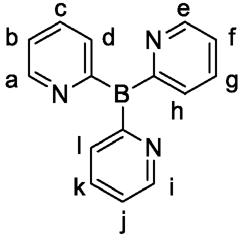 | 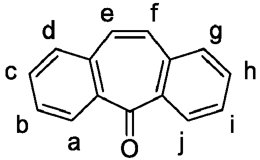 | |
| 338 | 341 | 358 | |
| 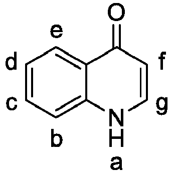 | 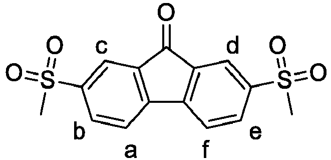 | 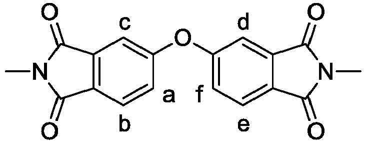 | |
| 360 | 364 | 367 | |
| 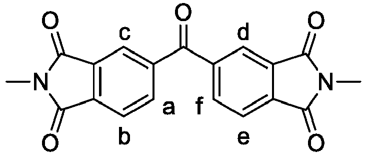 | 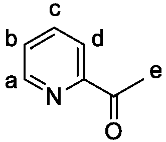 | 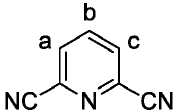 | |
| 368 | 370 | 371 | |
| 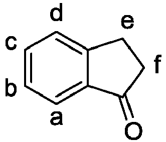 | 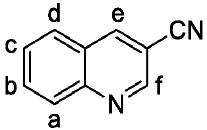 | 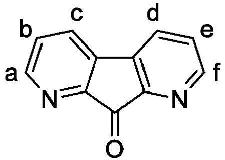 | |
| 391 | 395 | 420 | |
| 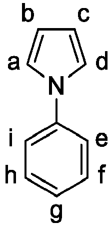 | 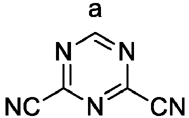 | 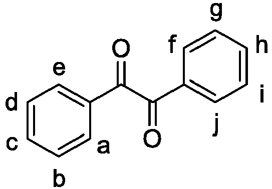 | |
| 421 | 429 | 430 | |
| 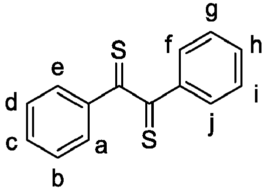 | 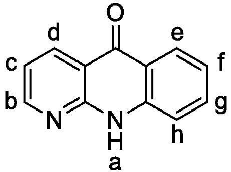 | | |
| 431 | 434 | | |
| 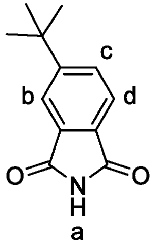 | 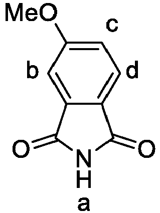 | 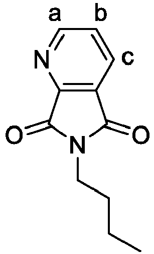 | |
| 440 | 441 | 473 | |

In Tabelle 1 bzw. in Tabelle 2 sind mögliche Anknüpfungspositionen der chemischen Einheit AF zur Verknüpfung mit einem Separator S des erfindungsgemäßen Moleküls mit Kleinbuchstaben a bis z bezeichnet. Jede aromatische C-H und N-H Bindung ist optional mit einem löslichkeitsvermittelnden und/oder einem die Polymerisierbarkeit ermöglichenden Rest R substituiert.

Beispiele erfindungsgemäßer Moleküle nach Formel 1, die unter den oben genannten Voraussetzungen mindestens Einheit AF2 nach Formel 3a bzw. ausgewählt aus Tabelle 1 und die mindestens eine Einheit AF1 nach Formel 3b bzw. ausgewählt aus Tabelle 2 enthalten, sind in Tabelle 3 aufgeführt.

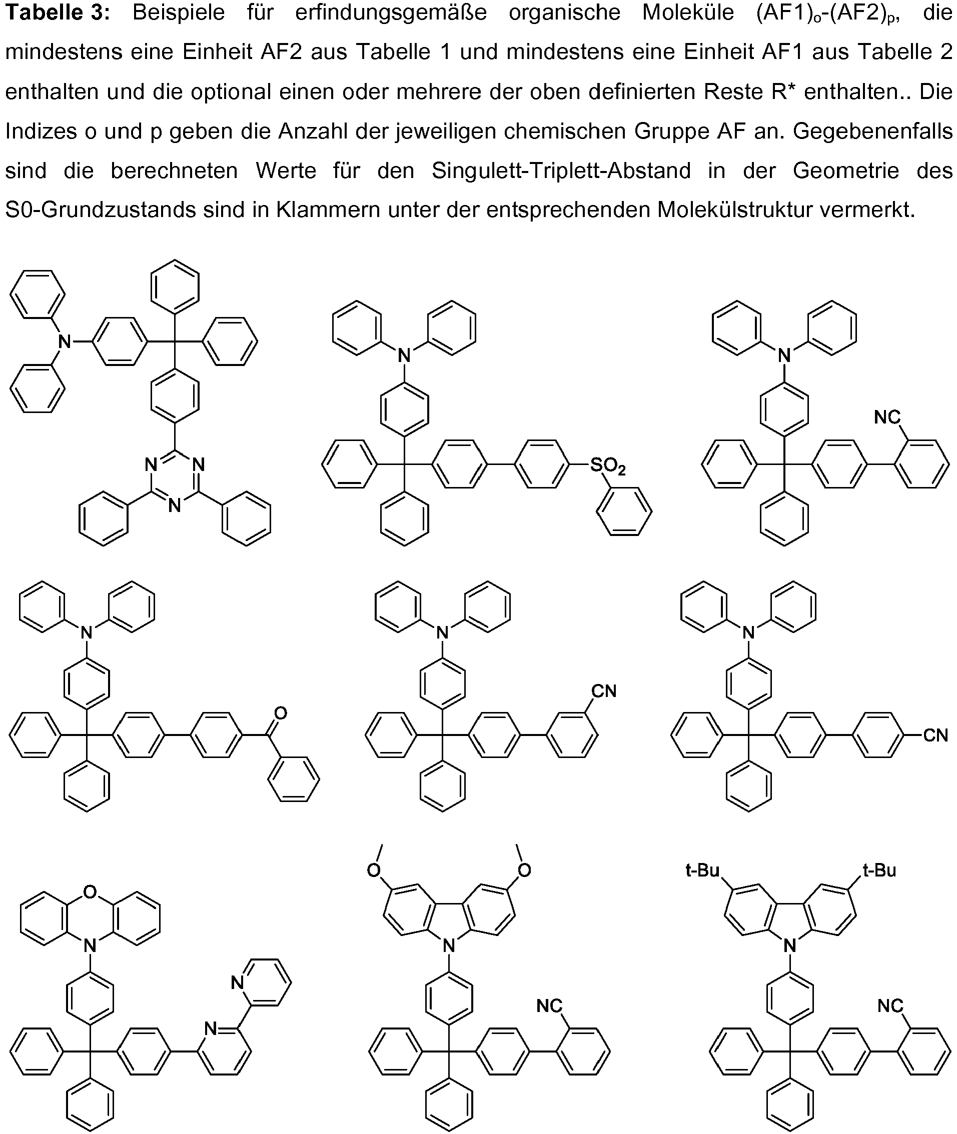

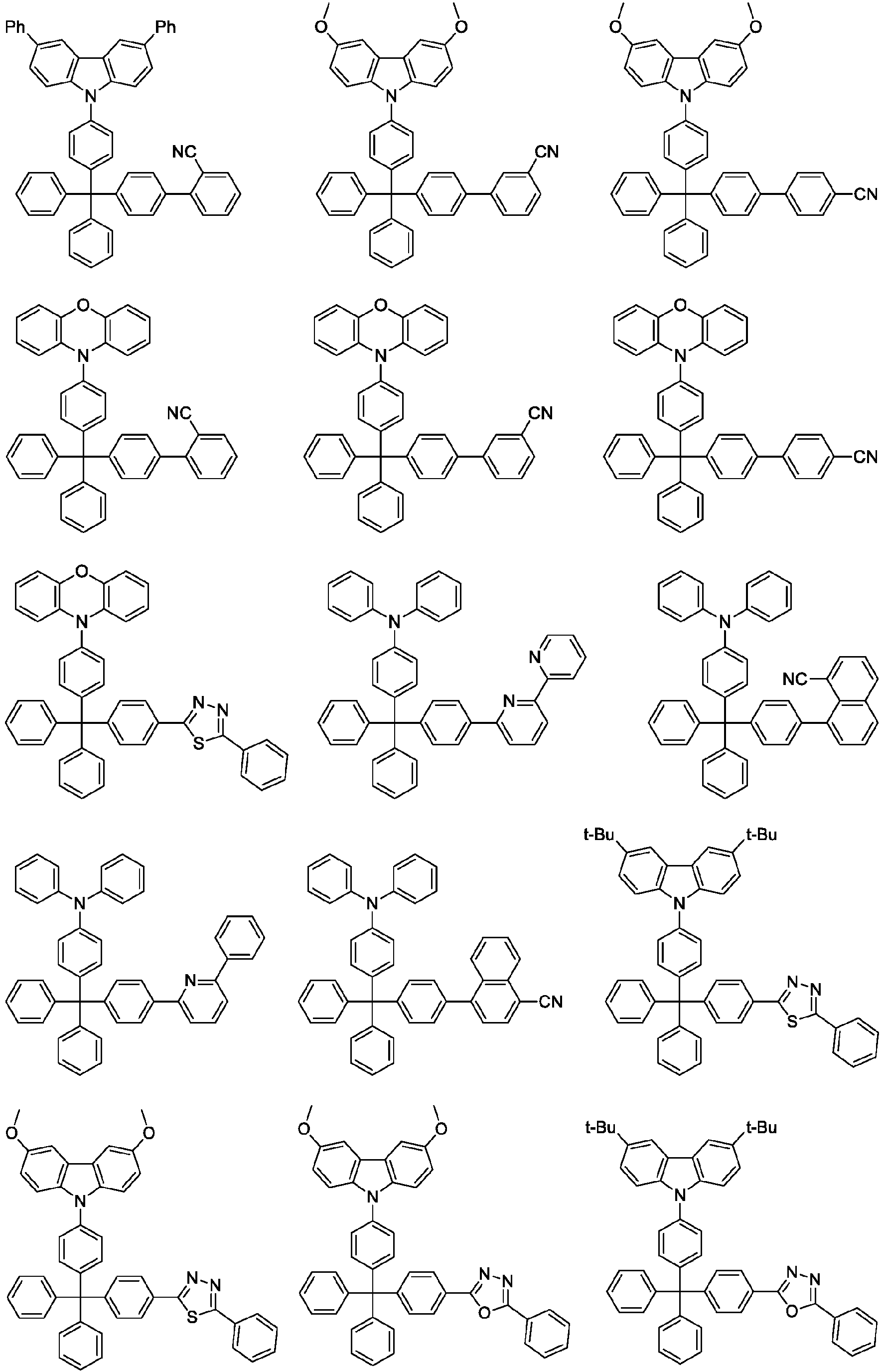

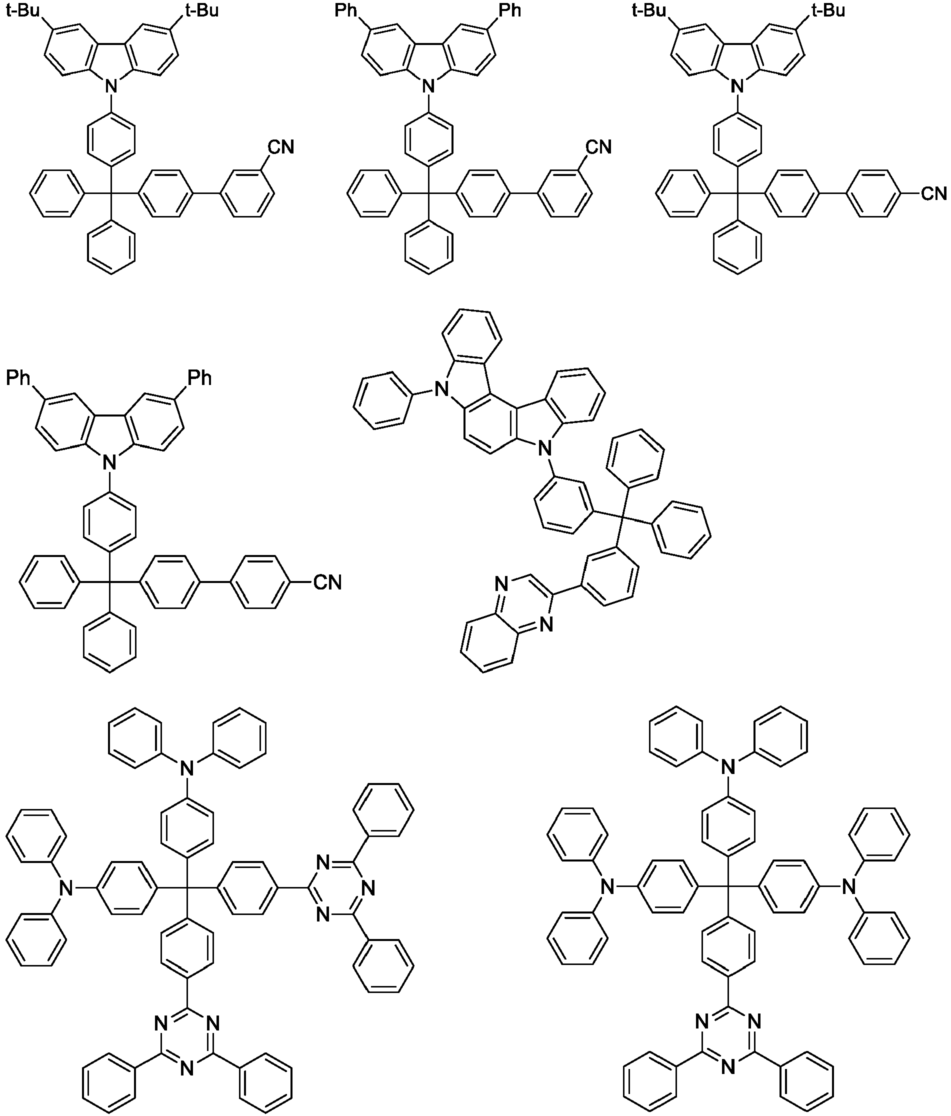

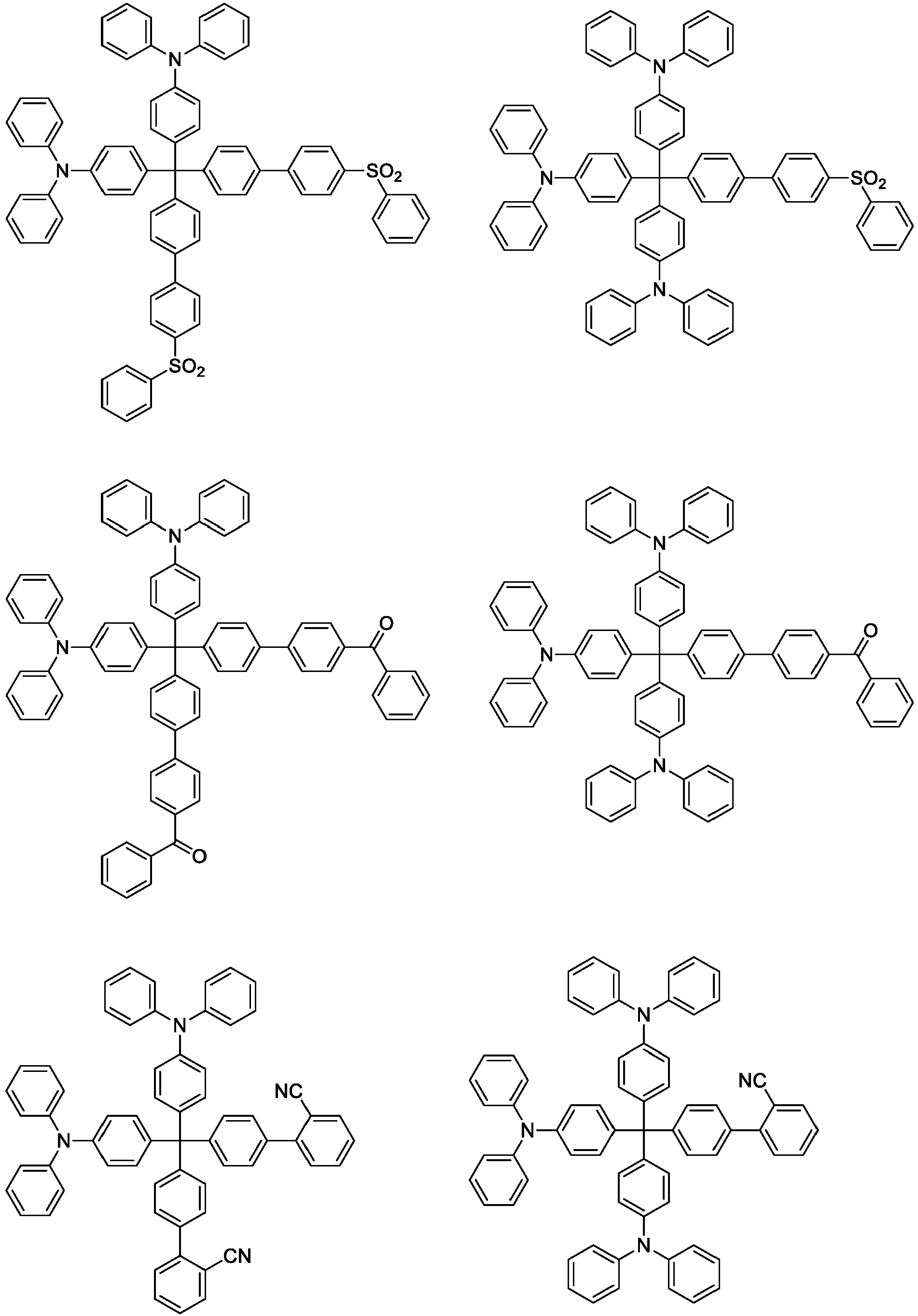

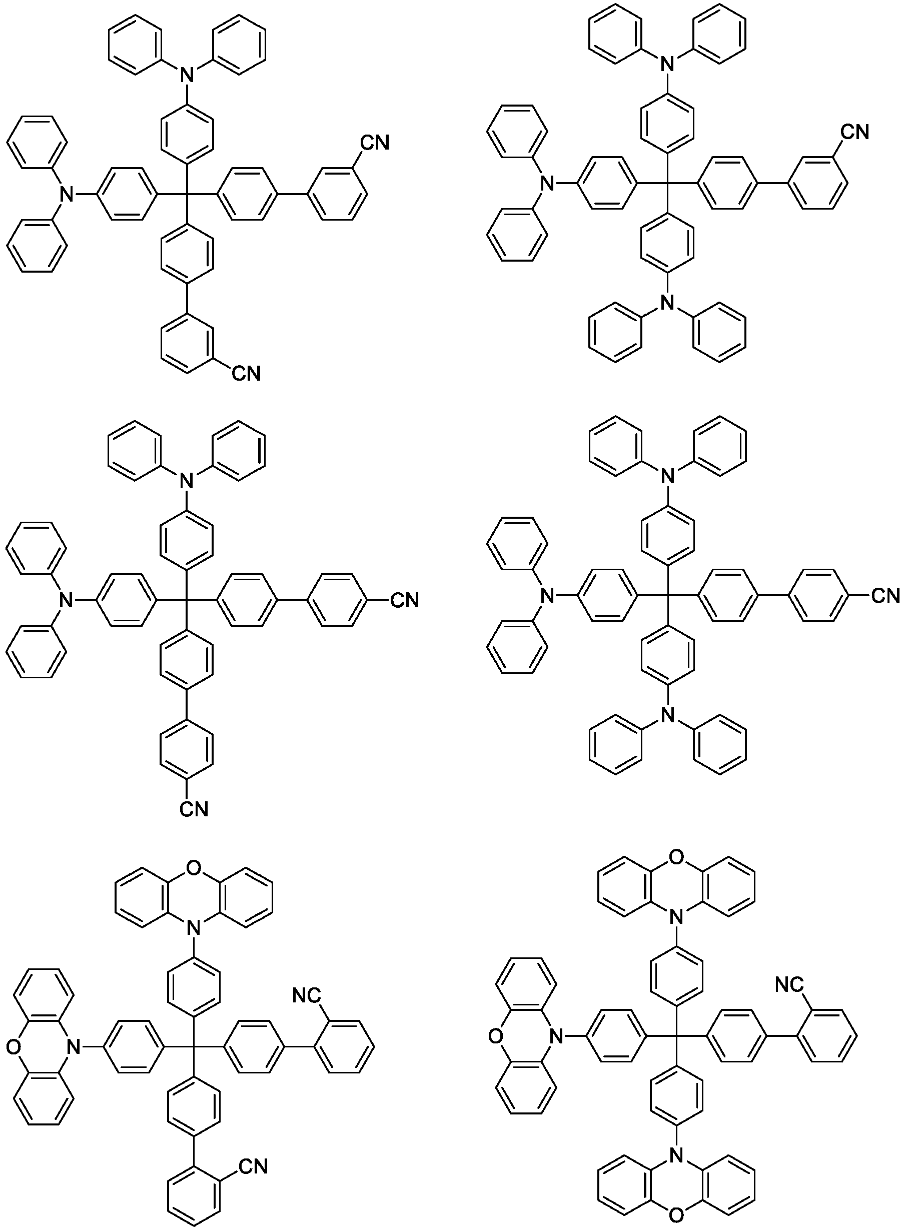

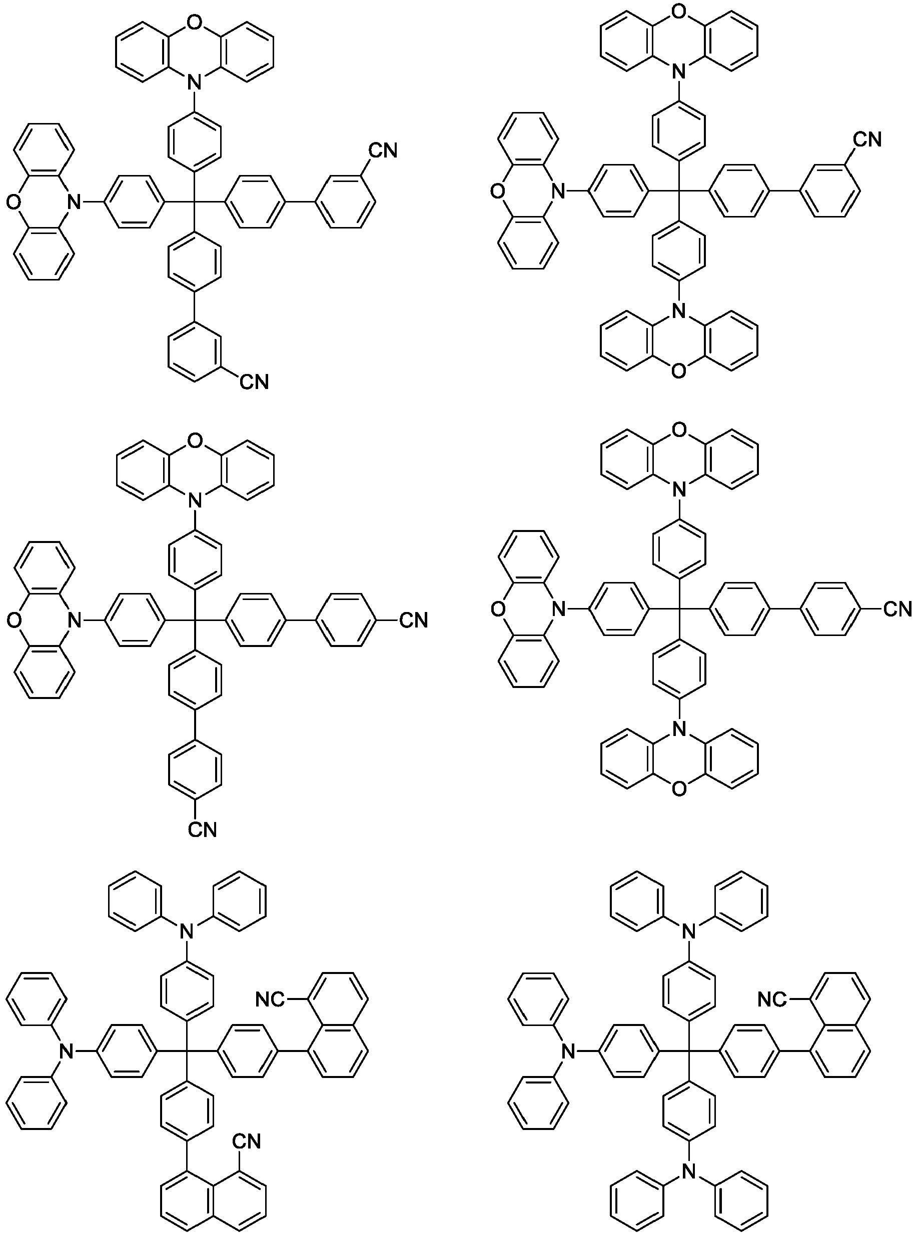

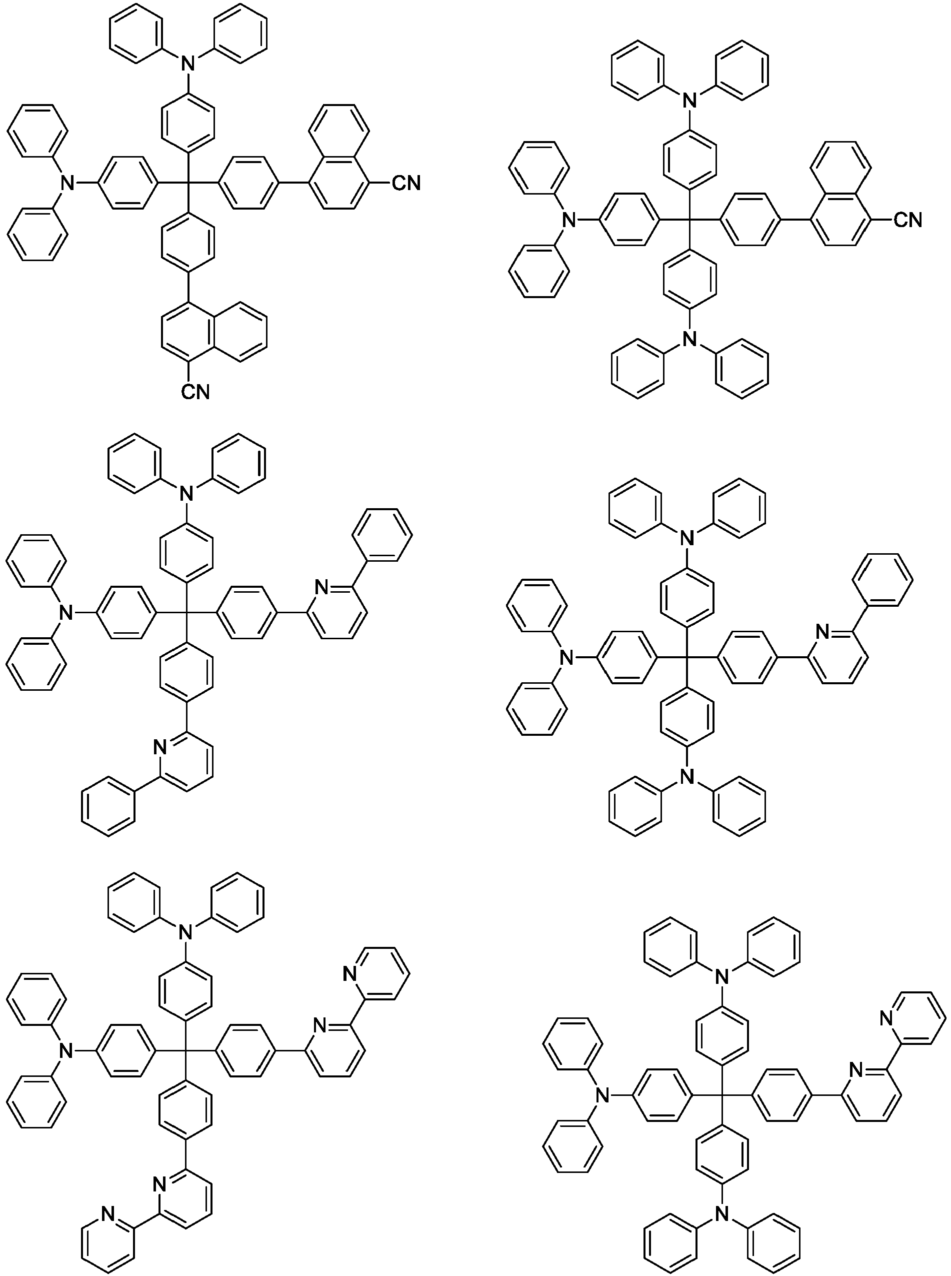

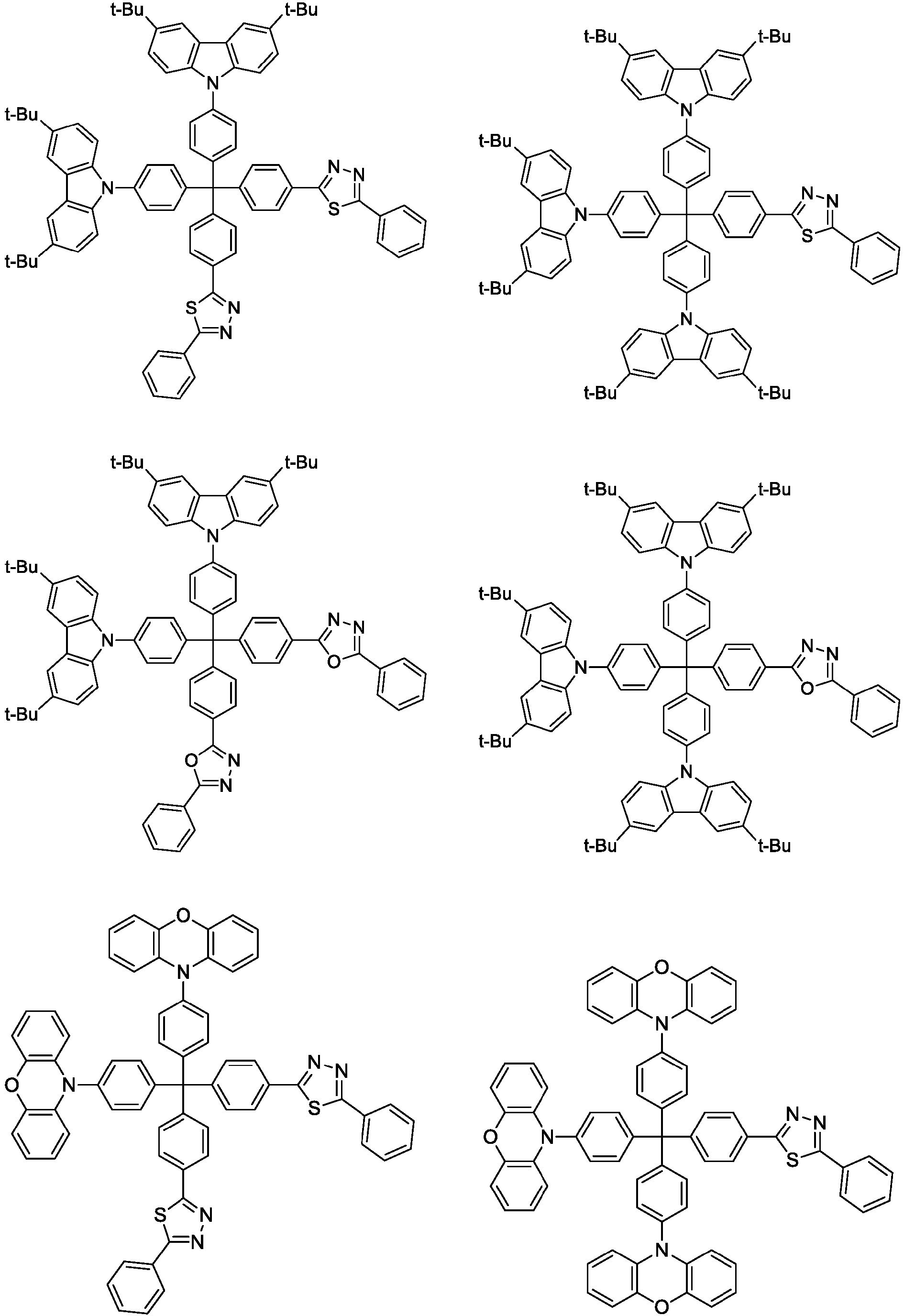

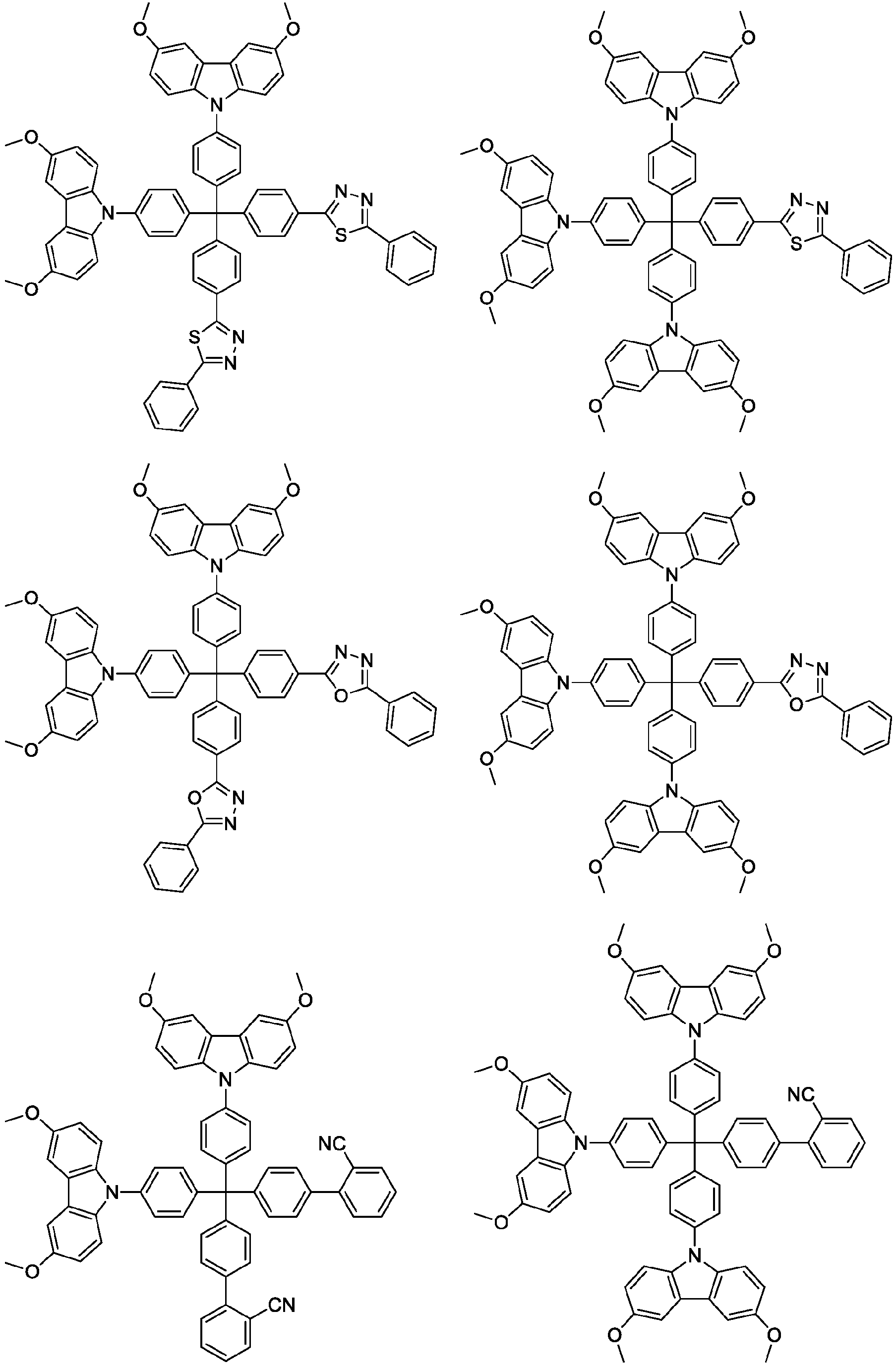

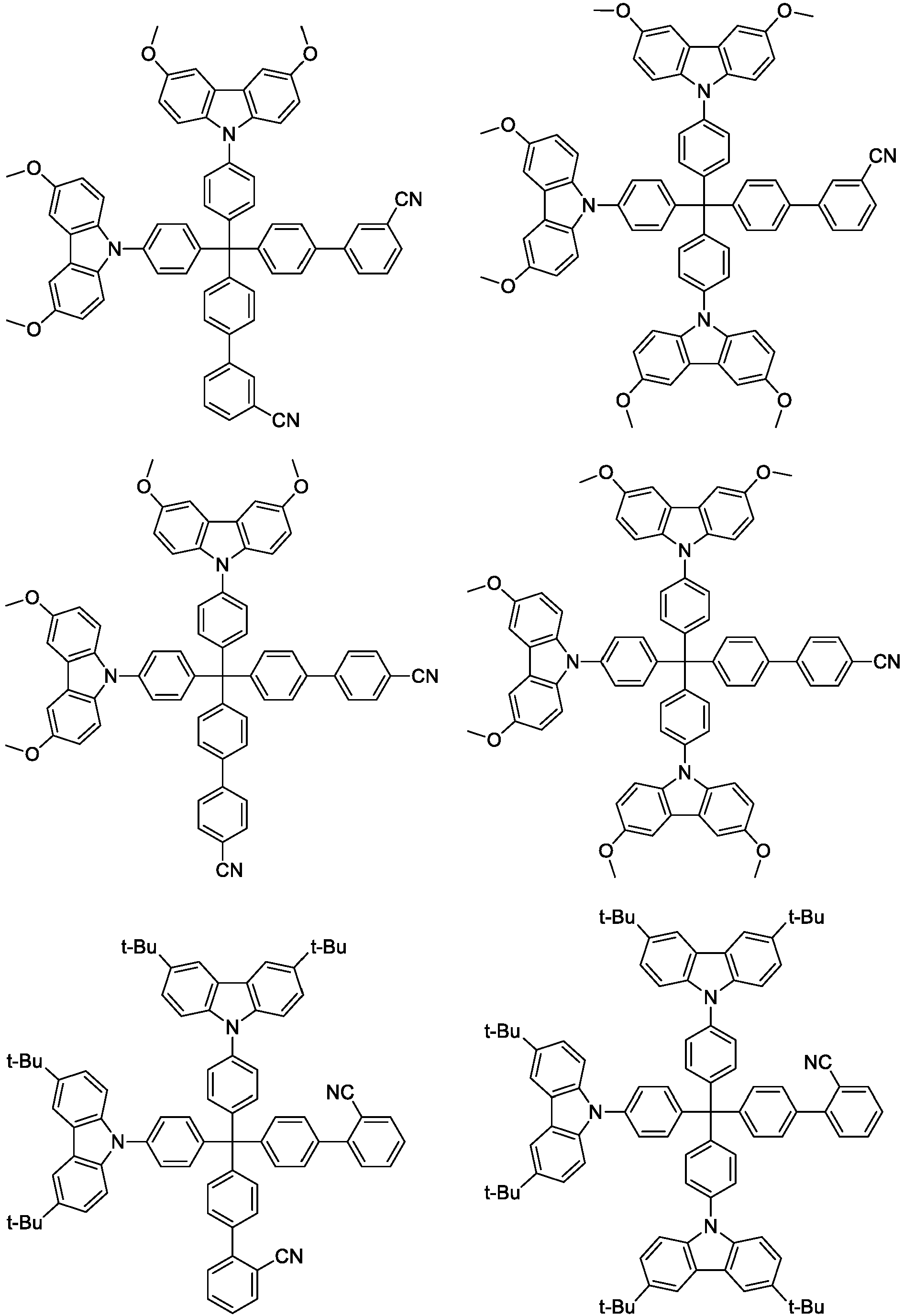

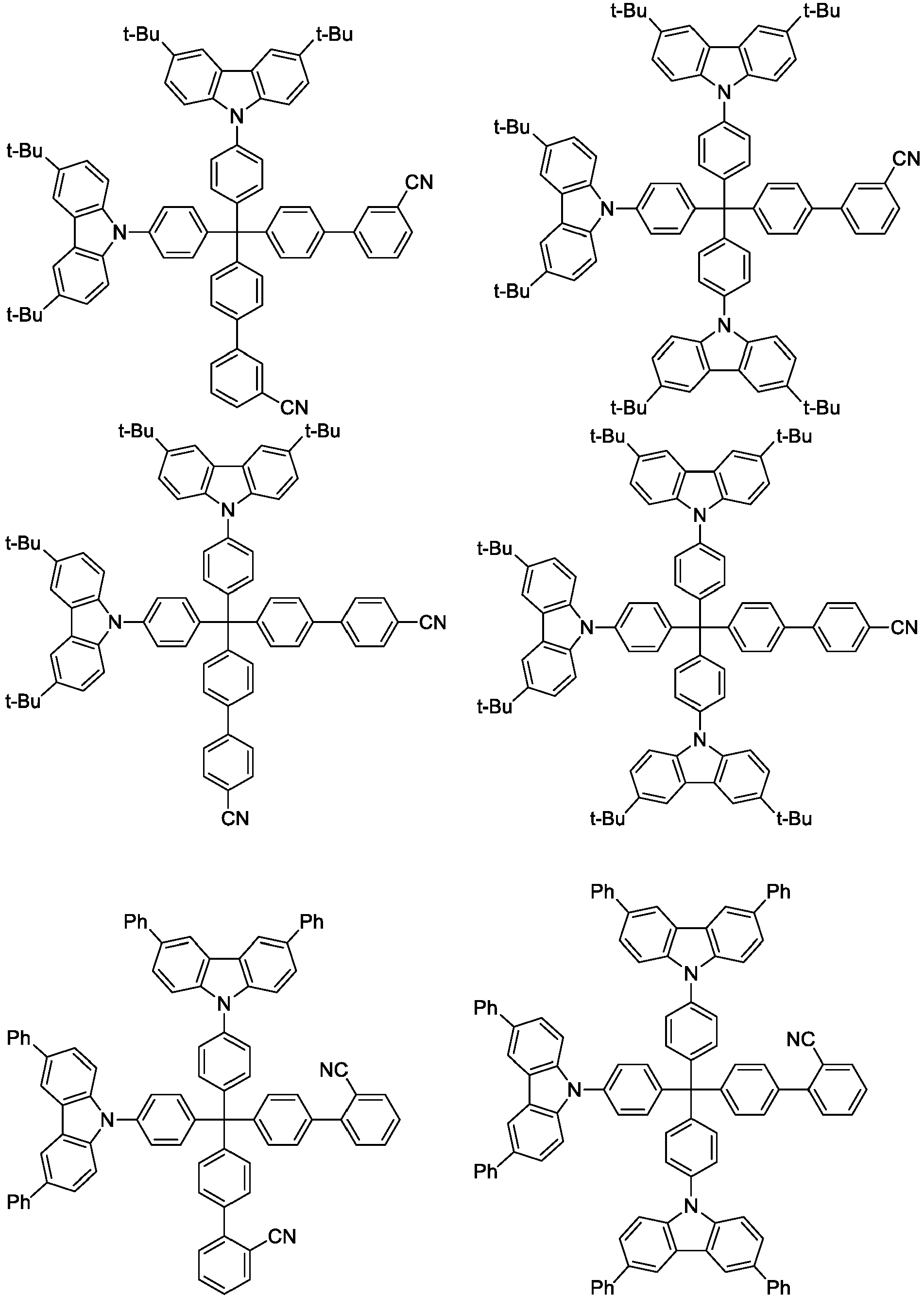

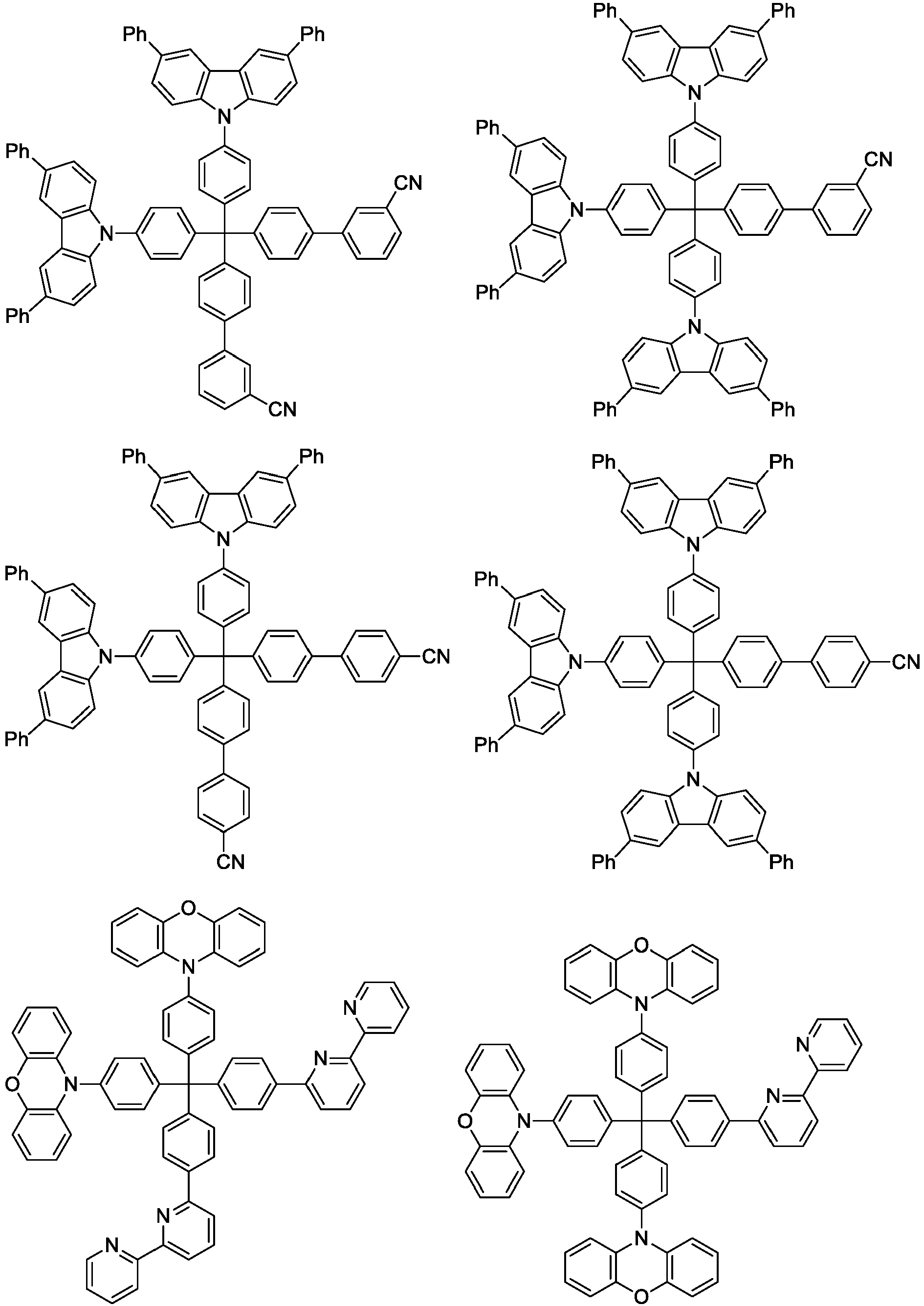

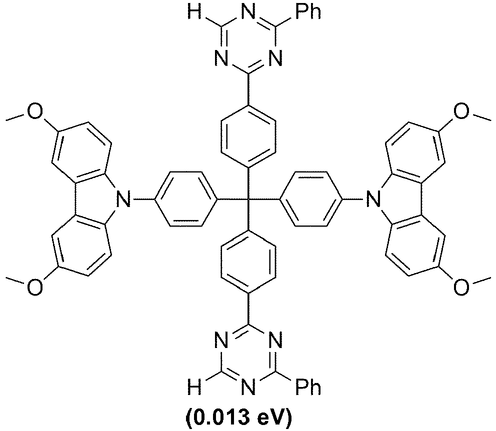

Streicht man in Formeln 1 und 2a bis 2d die AF, so verbleiben die Tetraarylmethan-Fragmente, die, wie oben erwähnt, als Separator S bezeichnet werden.

In einer Ausführungsform handelt es sich bei dem Separator um ein Molekülfragment mit einer der nachfolgenden Strukturen, wobei # die Stelle kennzeichnet, an denen die AF an den Separator gebunden werden und im Übrigen die bei Formel 1 angegebenen Definitionen gelten:

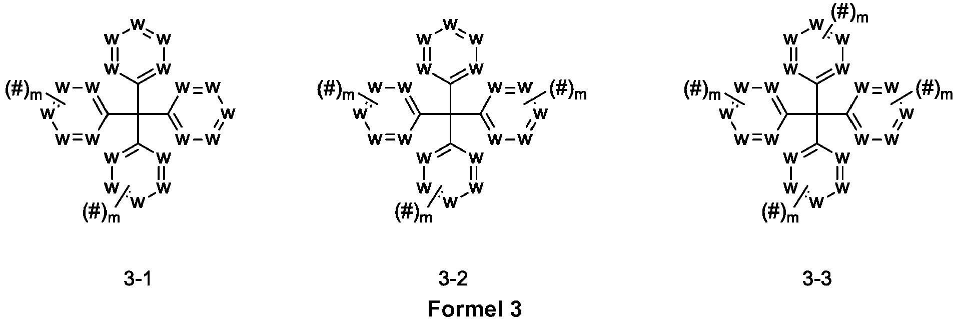

Der Separator S unterscheidet die organischen Moleküle funktionell von Molekülen gemäß dem Stand der Technik, da die hier gezeigte Art der Trennung von AFs (oder Donoren und Akzeptoren) bisher noch nicht bekannt ist. Bekannte organische Emitter bestehen in der Regel aus direkt verknüpften chemischen Einheiten. Eine Trennung der konjugierten aromatischen Systeme fand bisher nicht statt, insbesondere in Verbindung mit der Lokalisierung von HOMO und LUMO auf separaten Molekülteilen. Separatoren im Sinne dieser Erfindung verändern die Lage des HOMO bzw. LUMO der in Tabelle 1 und Tabelle 2 gezeigten AFs nicht signifikant. Als nicht signifikant gilt im Rahmen dieser Erfindung eine Veränderung von nicht mehr als +/- 0,4 eV. Die Berechnung derartiger Energien ist bekannt und funktioniert nach der oben beschriebenen Weise per DFT-Rechnung.

Anhand spektroskopischer Auswahlregeln (symmetrische Moleküle) oder durch Messung des Extinktionskoeffizienten (UV/VIS-Spektroskopie) oder quantenchemische Berechnung der Oszillatorstärke kann vorhergesagt werden, ob ein quantenmechanischer Übergang erlaubt ist. Je größer die Oszillatorstärke, desto eher ist ein Übergang erlaubt und desto schneller ist der damit verbundene Prozess (Abklingdauer). Angestrebt sind Abklingdauern von < 50 µs. Bei einer langen Abklingdauer des (organischen) Emitters kommt es bei hohen Stromstärken schnell zu Sättigungseffekten, was die Bauteillebensdauer negativ beeinflusst und die Erreichung hoher Helligkeiten verhindert.
Ein Maß für die Abklingdauer ist der ΔE(S₁-T₁)-Abstand. Dieser wird durch die Überlappung von HOMO und LUMO beeinflusst. Die Größe des quantenmechanischen Überlappungsintegrals, welche nach oben genannter DFT-Methode berechenbar ist, kann durch Wahl des Separators gezielt gesteuert werden. Kommt es zur völligen Trennung von HOMO und LUMO hat dieses einen Wert von 0. Die Wahrscheinlichkeit einer effizienten Emission des organischen Moleküls sinkt drastisch. Bei einem Wert von 1 liegt nicht mehr verzögerte Fluoreszenz (TADF) sondern spontane Emission vor. Die gewünschte Überlappung wird durch die geeignete Wahl eines erfindungsgemäßen Separators S erreicht.

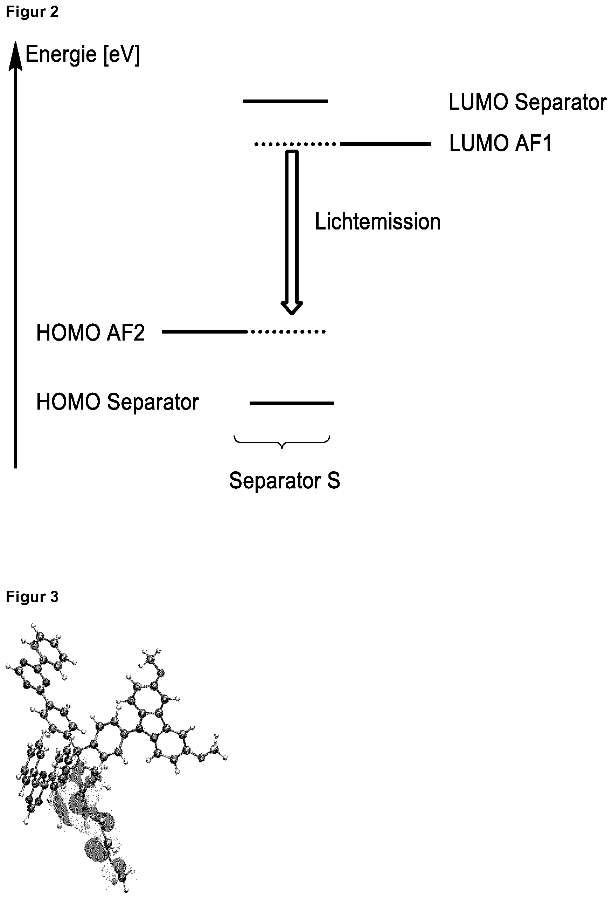

In einer Ausführungsform erfüllen dabei die gezeigten Separatoren S die folgenden zwei Merkmale (s. Figur 2):
- die HOMO-Energie ist niedriger als die HOMO-Energie der als Donor fungierenden chemischen Einheit AF und
- die LUMO-Energie ist höher als die LUMO-Energie der als Akzeptor fungierenden chemischen Einheit AF.

Die Eigenschaft des Separators S die Konjugation zwischen AF1 und AF2 zu unterbinden und dadurch die räumliche Trennung der Grenzorbitale HOMO und LUMO zu gewährleisten wird anhand der nachfolgend gezeigten Beispielverbindungen bzw. deren berechneter Grenzorbital-Darstellungen deutlich. Mindestens eines der Grenzorbitale HOMO und LUMO liegt nicht auf dem sp³-Kohlenstoffatom der Tetraarylmethaneinheit.

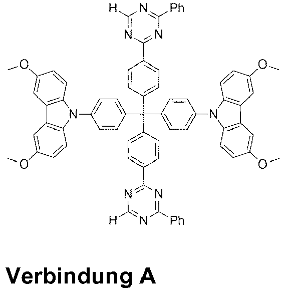

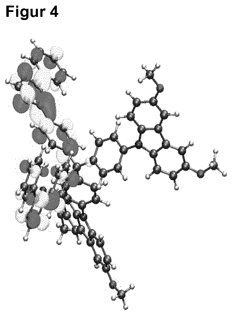

Das HOMO der Verbindung A ist in Figur 3 und das LUMO der Verbindung A in Figur 4 dargestellt.

Weitere Beispiele erfindungsgemäßer organischer Moleküle sind in Tabelle 4 dargestellt, die sich durch Kombination der oben definierten Paare aus chemischen Einheiten AF1 und AF2, dem Separator S und der Festlegung der Verknüpfung ergeben. Weitere organische Moleküle können durch Kombination der genannten Moleküleinheiten erhalten werden, wobei mindestens zwei chemische Einheiten AF im Molekül vorhanden sind. Die Benennung der Moleküle erfolgt nach dem Schema AF-S-AF, wobei hinsichtlich der Benennung der chemischen Einheit AF auf Tabelle 1 und Tabelle 2 verweisen wird, da die dort verwendeten Nummern auch in Tabelle 4 verwendet werden.

**Tabelle 4: Erfindungsgemäße organische Moleküle nach dem Schema AF-S-AF. In einem Molekül sind mindestens zwei verschiedene AFs enthalten. Ab 3 oder mehr AF in einem Molekül müssen diese identisch sein, sodass insgesamt nie mehr als zwei unterschiedliche Arten von AF verwendet werden. S steht jeweils für einen Spacer S, ausgewählt aus der Formel 3. In Klammern sind die Werte für ΔHOMO, ΔLUMO und Gap angegeben.**

| | | | |
|---|---|---|---|
| 1-S-27 (0.89 1.14 1.85) | 1-S-28 (0.95 1.40 1.59) | 1-S-36 (1.11 1.92 1.07) | 1-S-43 (1.53 1.77 1.22) |
| 1-S-46 (2.12 1.29 1.70) | 1-S-61 (0.86 1.11 1.88) | 1-S-65 (0.87 0.91 2.08) | 1-S-70 (1.59 1.98 1.01) |
| 1-S-79 (0.86 1.28 1.71) | 1-S-80 (0.81 1.24 1.75) | 1-S-81 (0.89 1.36 1.63) | 1-S-85 (1.37 1.09 1.90) |
| 1-S-89 (1.34 1.72 1.27) | 1-S-90 (1.25 1.57 1.42) | 1-S-109 (1.43 1.78 1.21) | 1-S-110 (0.92 1.42 1.57) |
| 1-S-112 (0.82 0.92 2.07) | 1-S-113 (1.03 1.84 1.15) | 1-S-115 (1.30 1.39 1.60) | 1-S-118 (0.91 0.82 2.17) |
| 1-S-119 (0.88 1.03 1.96) | 1-S-133 (1.63 1.55 1.44) | 1-S-144 (0.97 1.46 1.53) | 1-S-150 (2.45 1.42 1.57) |
| 1-S-151 (2.36 1.68 1.31) | 1-S-152 (3.01 1.98 1.01) | 1-S-153 (2.39 1.52 1.47) | 1-S-177 (1.47 1.20 1.79) |
| 1-S-183 (1.11 1.54 1.45) | 1-S-184 (2.20 1.01 1.98) | 1-S-192 (1.81 1.53 1.46) | 1-S-195 (1.63 0.86 2.13) |
| 1-S-198 (1.34 0.92 2.07) | 1-S-205 (0.86 0.98 2.01) | 1-S-206 (0.86 1.89 1.10) | 1-S-207 (1.38 1.84 1.15) |
| 1-S-213 (1.31 0.87 2.12) | 1-S-231 (1.85 1.64 1.35) | 1-S-233 (1.24 1.07 1.92) | 1-S-234 (1.06 1.15 1.84) |
| 1-S-237 (1.07 1.45 1.54) | 1-S-244 (1.12 1.06 1.93) | 1-S-245 (1.04 0.84 2.16) | 1-S-246 (1.38 1.40 1.59) |
| 1-S-305 (1.33 0.96 2.03) | 1-S-327 (1.10 1.37 1.62) | 1-S-367 (1.38 1.52 1.47) | 1-S-368 (1.49 2.06 0.93) |
| 1-S-371 (2.54 1.67 1.33) | 1-S-395 (1.57 1.37 1.62) | 1-S-440 (1.26 1.27 1.72) | 1-S-441 (1.19 1.20 1.79) |
| 1-S-473 (1.41 1.55 1.44) | 2-S-27 (0.88 1.06 1.86) | 2-S-28 (0.94 1.32 1.59) | 2-S-36 (1.10 1.84 1.08) |
| 2-S-43 (1.52 1.69 1.23) | 2-S-46 (2.11 1.21 1.71) | 2-S-61 (0.85 1.03 1.89) | 2-S-65 (0.86 0.83 2.09) |
| 2-S-70 (1.58 1.90 1.02) | 2-S-79 (0.85 1.20 1.72) | 2-S-80 (0.80 1.16 1.76) | 2-S-81 (0.88 1.28 1.64) |
| 2-S-85 (1.36 1.01 1.91) | 2-S-89 (1.34 1.64 1.28) | 2-S-90 (1.25 1.49 1.43) | 2-S-109 (1.42 1.70 1.22) |
| 2-S-110 (0.91 1.34 1.58) | 2-S-112 (0.81 0.84 2.08) | 2-S-113 (1.02 1.76 1.16) | 2-S-115 (1.29 1.31 1.60) |
| 2-S-119 (0.87 0.95 1.97) | 2-S-133 (1.62 1.47 1.45) | 2-S-144 (0.96 1.38 1.54) | 2-S-150 (2.44 1.34 1.58) |
| 2-S-151 (2.35 1.60 1.32) | 2-S-152 (3.00 1.90 1.02) | 2-S-153 (2.38 1.44 1.48) | 2-S-177 (1.46 1.12 1.80) |
| 2-S-183 (1.11 1.46 1.46) | 2-S-184 (2.19 0.93 1.99) | 2-S-192 (1.80 1.45 1.47) | 2-S-198 (1.34 0.84 2.08) |
| 2-S-205 (0.86 0.90 2.02) | 2-S-206 (0.85 1.81 1.11) | 2-S-207 (1.37 1.76 1.16) | 2-S-231 (1.84 1.56 1.35) |
| 2-S-233 (1.23 0.99 1.93) | 2-S-234 (1.05 1.07 1.85) | 2-S-237 (1.06 1.37 1.55) | 2-S- 244 (1.11 0.98 1.94) |
| 2-S-246 (1.37 1.32 1.60) | 2-S-305 (1.32 0.88 2.03) | 2-S-327 (1.09 1.29 1.63) | 2-S-367 (1.37 1.44 1.48) |
| 2-S-368 (1.49 1.98 0.94) | 2-S-371 (2.54 1.59 1.33) | 2-S-395 (1.57 1.29 1.63) | 2-S-440 (1.25 1.19 1.72) |
| 2-S-441 (1.18 1.12 1.80) | 2-S-473 (1.40 1.47 1.45) | 3-S-27 (1.14 1.51 1.61) | 3-S-28 (1.20 1.78 1.34) |
| 3-S-29 (0.96 1.50 1.61) | 3-S-43 (1.77 2.15 0.97) | 3-S-46 (2.37 1.67 1.45) | 3-S-56 (1.13 0.97 2.14) |
| 3-S-61 (1.11 1.49 1.63) | 3-S-62 (0.99 1.68 1.43) | 3-S-65 (1.12 1.28 1.83) | 3-S-68 (0.83 1.24 1.87) |
| 3-S-79 (1.11 1.66 1.46) | 3-S-80 (1.06 1.61 1.50) | 3-S-81 (1.13 1.74 1.38) | 3-S-82 (0.87 1.92 1.19) |
| 3-S-3 (1.17 0.91 2.20) | 3-S-85 (1.62 1.47 1.65) | 3-S-86 (0.84 1.84 1.28) | 3-S-89 (1.59 2.09 1.02) |
| 3-S-90 (1.50 1.94 1.17) | 3-S-109 (1.68 2.16 0.96) | 3-S-110 (1.17 1.80 1.32) | 3-S-111 (1.87 0.92 2.20) |
| 3-S-112 (1.07 1.29 1.82) | 3-S-113 (1.28 2.21 0.91) | 3-S-115 (1.55 1.77 1.35) | 3-S-118 (1.16 1.19 1.92) |
| 3-S-119 (1.13 1.41 1.71) | 3-S-131 (1.180.872.25) | 3-S-132 (1.09 1.11 2.00) | 3-S-133 (1.88 1.92 1.19) |
| 3-S-144 (1.22 1.83 1.28) | 3-S-150 (2.70 1.79 1.32) | 3-S-151 (2.61 2.05 1.06) | 3-S-153 (2.64 1.89 1.22) |
| 3-S-154 (2.17 1.02 2.09) | 3-S-166 (1.89 0.85 2.27) | 3-S-171 (1.66 0.85 2.27) | 3-S-177 (1.72 1.57 1.54) |
| 3-S-183 (1.36 1.91 1.21) | 3-S-184 (2.45 1.39 1.73) | 3-S-192 (2.06 1.91 1.21) | 3-S-193 (0.98 1.07 2.05) |
| 3-S-195 (1.88 1.23 1.88) | 3-S-198 (1.59 1.29 1.82) | 3-S-205 (1.11 1.35 1.76) | 3-S-207 (1.63 2.21 0.90) |
| 3-S-208 (1.08 0.82 2.29) | 3-S-209 (0.82 0.90 2.21) | 3-S-213 (1.56 1.25 1.87) | 3-S-217 (0.98 1.28 1.84) |
| 3-S-218 (0.95 1.46 1.66) | 3-S-222 (0.87 0.86 2.25) | 3-S-231 (2.10 2.02 1.10) | 3-S-233 (1.49 1.44 1.67) |
| 3-S-234 (1.31 1.53 1.59) | 3-S-237 (1.32 1.82 1.29) | 3-S-244 (1.37 1.44 1.68) | 3-S-245 (1.29 1.21 1.91) |
| 3-S-246 (1.63 1.78 1.34) | 3-S- 285 (0.89 1.21 1.91) | 3-S-286 (1.14 1.11 2.00) | 3-S-287 (0.95 1.12 1.99) |
| 3-S-288 (0.94 1.06 2.05) | 3-S-297 (1.00 0.80 2.31) | 3-S-304 (1.06 1.12 1.99) | 3-S-305 (1.58 1.34 1.78) |
| 3-S-311 (0.90 1.01 210) | 3-S-312 (1.00 0.88 2.23) | 3-S-327 (1.35 1.74 1.37) | 3-S-331 (1.21 0.92 2.20) |
| 3-S-332 (1.06 1.09 2.02) | 3-S-358 (1.01 1.26 1.86) | 3-S-367 (1.63 1.89 1.22) | 3-S-370 (0.98 1.32 1.79) |
| 3-S-371 (2.79 2.04 1.08) | 3-S-391 (0.90 1.01 2.11) | 3-S-395 (1.82 1.74 1.38) | 3-S-430 (0.84 1.84 1.28) |
| 3-S-434 (0.90 1.31 1.80) | 3-S-440 (1.51 1.65 1.47) | 3-S-441 (1.44 1.58 1.54) | 3-S-473 (1.66 1.92 1.19) |
| 4-S-28 (0.82 1.24 1.71) | 4-S-36 (0.98 1.76 1.20) | 4-S-37 (0.98 2.06 0.90) | 4-S-43 (1.40 1.61 1.35) |
| 4-S-46 (1.99 1.13 1.83) | 4-S-70 (1.46 1.82 1.14) | 4-S-85 (1.24 0.93 2.02) | 4-S-89 (1.22 1.56 1.40) |
| 4-S-90 (1.13 1.41 1.55) | 4-S-109 (1.30 1.62 1.34) | 4-S-113 (0.90 1.68 1.28) | 4-S-115 (1.17 1.23 1.72) |
| 4-S-133 (1.51 1.39 1.57) | 4-S-144 (0.84 1.30 1.66) | 4-S-150 (2.33 1.26 1.70) | 4-S-151 (2.23 1.52 1.44) |
| 4-S-152 (2.88 1.82 1.14) | 4-S-153 (2.26 1.36 1.60) | 4-S-177 (1.34 1.04 1.92) | 4-S-183 (0.99 1.37 1.58) |
| 4-S-184 (2.08 0.85 2.11) | 4-S-192 (1.68 1.37 1.59) | 4-S-207 (1.25 1.68 1.28) | 4-S-231 (1.73 1.48 1.47) |
| 4-S-233 (111 0.91 2.05) | 4-S-234 (0.93 0.99 1.97) | 4-S-237 (0.94 1.29 1.67) | 4-S-244 (1.00 0.90 2.06) |
| 4-S-246 (1.25 1.24 1.72) | 4-S-305 (1.20 0.80 2.15) | 4-S-327 (0.97 1.21 1.75) | 4-S-364 (1.44 2.04 0.92) |
| 4-S-367 (1.26 1.36 1.60) | 4-S-368 (1.37 1.90 1.06) | 4-S-371 (2.42 1.50 1.45) | 4-S-395 (1.45 1.21 1.75) |
| 4-S-440 (1.13 1.11 1.84) | 4-S-441 (1.06 1.04 1.92) | 4-S-473 (1.29 1.39 1.57) | 6-S-27 (1.13 1.04 1.61) |
| 6-S-28 (1.19 1.31 1.34) | 6-S-29 (0.96 1.03 1.62) | 6-S-43 (1.77 1.68 0.98) | 6-S-46 (2.36 1.20 1.45) |
| 6-S-61 (1.10 1.02 1.64) | 6-S-62 (0.98 1.22 1.44) | 6-S-65 (1.12 0.81 1.84) | 6-S-79 (1.10 1.19 1.46) |
| 6-S-80 (1.05 1.15 1.51) | 6-S-81 (1.13 1.27 1.38) | 6-S-82 (0.86 1.46 1.20) | 6-S-85 (1.61 1.00 1.65) |
| 6-S-86 (0.83 1.37 1.28) | 6-S-89 (1.59 1.63 1.03) | 6-S-90 (1.50 1.48 1.18) | 6-S-109 (1.67 1.69 0.97) |
| 6-S-110 (1.17 1.33 1.33) | 6-S-112 (1.06 0.82 1.83) | 6-S-113 (1.27 1.74 0.91) | 6-S-115 (1.54 1.30 1.35) |
| 6-S-119 (1.12 0.94 1.72) | 6-S-133 (1.88 1.45 1.20) | 6-S-144 (1.21 1.36 1.29) | 6-S-150 (2.70 1.33 1.33) |
| 6-S-151 (2.61 1.58 1.07) | 6-S-153 (2.63 1.43 1.23) | 6-S-177 (1.71 1.11 1.55) | 6-S-183 (1.36 1.44 1.21) |
| 6-S-184 (2.45 0.92 1.74) | 6-S-192 (2.05 1.44 1.22) | 6-S-198 (1.59 0.82 1.83) | 6-S-205 (1.11 0.88 1.77) |
| 6-S-207 (1.62 1.74 0.91) | 6-S-217 (0.98 0.81 1.84) | 6-S-218 (0.95 0.99 1.67) | 6-S-231 (2.10 1.55 1.10) |
| 6-S-233 (1.48 0.98 1.68) | 6-S-234 (1.30 1.06 1.60) | 6-S-237 (1.31 1.35 1.30) | 6-S-244 (1.37 0.97 1.69) |
| 6-S-246 (1.62 1.31 1.35) | 6-S-305 (1.57 0.87 1.78) | 6-S- 327 (1.34 1.27 1.38) | 6-S-367 (1.63 1.43 1.23) |
| 6-S- 370 (0.97 0.86 1.80) | 6-S-371 (2.79 1.57 1.08) | 6-S-395 (1.82 1.27 1.38) | 6-S-420 (1.00 1.75 0.90) |
| 6-S-430 (0.83 1.37 1.28) | 6-S-434 (0.89 0.85 1.81) | 6-S-440 (1.50 1.18 1.47) | 6-S-441 (1.43 1.11 1.55) |
| 6-S-473 (1.66 1.45 1.20) | 7-S-27 (1.12 1.06 1.62) | 7-S-28 (1.19 1.32 1.35) | 7-S-29 (0.95 1.05 1.63) |
| 7-S-43 (1.76 1.69 0.98) | 7-S-46 (2.36 1.21 1.46) | 7-S-61 (1.10 1.03 1.64) | 7-S-62 (0.98 1.23 1.44) |
| 7-S-65 (1.11 0.83 1.85) | 7-S-79 (1.09 1.20 1.47) | 7-S-80 (1.04 1.16 1.51) | 7-S-81 (1.12 1.28 1.39) |
| 7-S-82 (0.85 1.47 1.20) | 7-S-85 (1.61 1.01 1.66) | 7-S-86 (0.82 1.38 1.29) | 7-S-89 (1.58 1.64 1.03) |
| 7-S-90 (1.49 1.49 1.19) | 7-S-109 (1.66 1.70 0.97) | 7-S-110 (1.16 1.34 1.33) | 7-S-112 (1.05 0.84 1.84) |
| 7-S-113 (1.26 1.76 0.92) | 7-S-115 (1.53 1.31 1.36) | 7-S-119 (1.12 0.95 1.72) | 7-S-133 (1.87 1.47 1.21) |
| 7-S-144 (1.20 1.38 1.30) | 7-S-150 (2.69 1.34 1.34) | 7-S-151 (2.60 1.60 1.08) | 7-S-153 (2.62 1.44 1.23) |
| 7-S-177 (1.70 1.12 1.56) | 7-S-183 (1.35 1.46 1.22) | 7-S-184 (2.44 0.93 1.74) | 7-S-192 (2.05 1.45 1.22) |
| 7-S-198 (1.58 0.84 1.84) | 7-S-205 (1.10 0.90 1.78) | 7-S-207 (1.61 1.76 0.92) | 7-S-217 (0.97 0.82 1.85) |
| 7-S-218 (0.94 1.00 1.67) | 7-S-231 (2.09 1.56 1.11) | 7-S-233 (1.47 0.99 1.69) | 7-S-234 (1.29 1.07 1.60) |
| 7-S-237 (1.30 1.37 1.31) | 7-S-244 (1.36 0.98 1.69) | 7-S-246 (1.61 1.32 1.35) | 7-S-305 (1.56 0.88 1.79) |
| 7-S-327 (1.34 1.29 1.39) | 7-S-358 (0.99 0.80 1.87) | 7-S-367 (1.62 1.44 1.23) | 7-S-370 (0.96 0.87 1.80) |
| 7-S-371 (2.78 1.58 1.09) | 7-S-395 (1.81 1.29 1.39) | 7-S-420 (0.99 1.76 0.91) | 7-S-430 (0.82 1.39 1.29) |
| 7-S-434 (0.89 0.86 1.82) | 7-S-440 (1.50 1.19 1.48) | 7-S-441 (1.43 1.12 1.55) | 7-S-473 (1.65 1.47 1.21) |
| 8-S-27 (0.98 1.18 1.76) | 8-S-28 (1.05 1.45 1.49) | 8-S-29 (0.81 1.17 1.77) | 8-S-36(1.21196098) |
| 8-S-43 (1.62 1.82 1.12) | 8-S-46 (2.22 1.34 1.60) | 8-S-61 (0.96 1.16 1.78) | 8-S-62 (0.83 1.35 1.59) |
| 8-S-65 (0.97 0.95 1.99) | 8-S-70 (1.68 2.03 0.91) | 8-S-79 (0.95 1.33 1.61) | 8-S-80 (0.90 1.28 1.66) |
| 8-S-81 (0.98 1.41 1.53) | 8-S-85 (1.47 1.14 1.80) | 8-S-89 (1.44 1.76 1.18) | 8-S-90 (1.35 1.61 1.33) |
| 8-S-109 (1.52 1.83 1.11) | 8-S-110 (1.02 1.47 1.47) | 8-S-112 (0.91 0.96 1.98) | 8-S-113 (1.12 1.88 1.06) |
| 8-S-115 (1.39 1.44 1.50) | 8-S-118 (1.00 0.86 2.08) | 8-S-119 (0.97 1.08 1.86) | 8-S-133 (1.73 1.59 1.35) |
| 8-S-144 (1.06 1.50 1.44) | 8-S-150 (2.55 1.46 1.48) | 8-S-151 (2.46 1.72 1.22) | 8-S-152 (3.10 2.02 0.92) |
| 8-S-153 (2.48 1.56 1.38) | 8-S-177 (1.56 1.24 1.70) | 8-S-183 (1.21 1.58 1.36) | 8-S-184 (2.30 1.06 1.88) |
| 8-S-192 (1.90 1.58 1.36) | 8-S-195 (1.73 0.90 2.04) | 8-S-198 (1.44 0.96 1.98) | 8-S-205 (0.96 1.02 1.92) |
| 8-S-206 (0.95 1.93 1.01) | 8-S-207 (1.47 1.88 1.06) | 8-S-213 (1.41 0.92 2.02) | 8-S-217 (0.83 0.95 1.99) |
| 8-S-231 (1.95 1.69 1.25) | 8-S-233 (1.33 1.11 1.83) | 8-S-234 (1.15 1.20 1.75) | 8-S-237 (1.16 1.49 1.45) |
| 8-S-244 (1.22 1.11 1.83) | 8-S-245 (1.14 0.88 2.06) | 8-S-246 (1.47 1.45 1.49) | 8-S-305 (1.42 1.01 1.93) |
| 8-S-327 (1.20 1.41 1.53) | 8-S-358 (0.85 0.93 2.01) | 8-S-367 (1.48 1.56 1.38) | 8-S-370 (0.82 0.99 1.95) |
| 8-S-371 (2.64 1.71 1.23) | 8-S-395 (1.67 1.41 1.53) | 8-S-420 (0.85 1.89 1.05) | 8-S-440 (1.36 1.32 1.62) |
| 8-S-441 (1.29 1.25 1.69) | 8-S-473 (1.51 1.59 1.35) | 10-S-27 (1.16 0.99 1.59) | 10-S-28 (1.22 1.25 1.32) |
| 10-S-29 (0.98 0.98 1.60) | 10-S-40 (0.80 0.98 1.60) | 10-S-43 (1.79 1.62 0.95) | 10-S-46 (2.39 1.14 1.43) |
| 10-S-61 (1.13 0.96 1.61) | 10-S-62 (1.01 1.16 1.41) | 10-S-79 (1.12 1.13 1.44) | 10-S-80 (1.08 1.09 1.48) |
| 10-S-81 (1.15 1.21 1.36) | 10-S-82 (0.89 1.40 1.17) | 10-S-85 (1.64 0.94 1.63) | 10-S-86 (0.86 1.31 1.26) |
| 10-S-89 (1.61 1.57 1.00) | 10-S-90 (1.52 1.42 1.15) | 10-S-109 (1.69 1.63 0.94) | 10-S-110 (1.19 1.27 1.30) |
| 10-S-115 (1.56 1.25 1.33) | 10-S-119 (1.15 0.88 1.69) | 10-S-133 (1.90 1.40 1.18) | 10-S-144 (1.24 1.31 1.27) |
| 10-S-150 (2.72 1.27 1.30) | 10-S-151 (2.63 1.53 1.05) | 10-S-153 (2.65 1.37 1.20) | 10-S-177 (1.73 1.05 1.52) |
| 10-S-183 (1.38 1.39 1.19) | 10-S-184 (2.47 0.86 1.71) | 10-S-192 (2.08 1.38 1.19) | 10-S-205 (1.13 0.83 1.75) |
| 10-S-218 (0.97 0.93 1.64) | 10-S-231 (2.12 1.49 1.08) | 10-S-233 (1.51 0.92 1.65) | 10-S-234 (1.33 1.00 1.57) |
| 10-S-237 (1.34 1.30 1.28) | 10-S-244 (1.39 0.91 1.66) | 10-S-246 (1.64 1.25 1.32) | 10-S-305 (1.59 0.82 1.76) |
| 10-S-327 (1.37 1.22 1.36) | 10-S-367 (1.65 1.37 1.20) | 10-S-370 (0.99 0.80 1.77) | 10-S-371 (2.81 1.52 1.06) |
| 10-S-395 (1.84 1.22 1.36) | 10-S-430 (0.85 1.32 1.26) | 10-S-440 (1.53 1.12 1.45) | 10-S-441 (1.46 1.05 1.52) |
| 10-S-473 (1.68 1.40 1.18) | 12-S-28 (1.22 1.01 1.32) | 12-S-43 (1.79 1.38 0.95) | 12-S-46 (2.39 0.90 1.43) |
| 12-S-62 (1.01 0.92 1.41) | 12-S-79 (1.12 0.89 1.44) | 12-S-80 (1.08 0.85 1.48) | 12-S-81 (1.15 0.97 1.36) |
| 12-S-82 (0.89 1.15 1.17) | 12-S-86 (0.86 1.07 1.26) | 12-S-89 (1.61 1.32 1.00) | 12-S-90 (1.52 1.17 1.15) |
| 12-S-109 (1.70 1.39 0.94) | 12-S-110 (1.19 1.03 1.30) | 12-S-115 (1.56 1.00 1.33) | 12-S-133 (1.90 1.15 1.18) |
| 12-S-144 (1.24 1.06 1.27) | 12-S-150 (2.72 1.02 1.30) | 12-S-151 (2.63 1.28 1.05) | 12-S-153 (2.65 1.12 1.20) |
| 12-S-177 (1.73 0.80 1.52) | 12-S-183 (1.38 1.14 1.19) | 12-S-192 (2.08 1.14 1.19) | 12-S-231 (2.12 1.25 1.08) |
| 12-S-237 (1.34 1.05 1.28) | 12-S-246 (1.64 1.01 1.32) | 12-S-327 (1.37 0.97 1.36) | 12-S-367 (1.65 1.13 1.20) |
| 12-S-371 (2.81 1.27 1.06) | 12-S-395 (1.84 0.97 1.36) | 12-S-430 (0.85 1.07 1.26) | 12-S-440 (1.53 0.88 1.45) |
| 12-S-441 (1.46 0.81 1.52) | 12-S-473 (1.68 1.15 1.18) | 21-S-27 (1.01 1.08 1.74) | 21-S-28 (1.07 1.35 1.47) |
| 21-S-29 (0.83 1.07 1.74) | 21-S-36 (1.23 1.86 0.95) | 21-S-43 (1.65 1.71 1.10) | 21-S-46 (2.24 1.23 1.58) |
| 21-S-61 (0.98 1.05 1.76) | 21-S-62 (0.86 1.25 1.56) | 21-S-65 (0.99 0.85 1.96) | 21-S-79 (0.98 1.22 1.59) |
| 21-S-80 (0.93 1.18 1.63) | 21-S-81 (1.00 1.30 1.51) | 21-S-85 (1.49 1.03 1.78) | 21-S-89 (1.46 1.66 1.15) |
| 21-S-90 (1.37 1.51 1.30) | 21-S-109 (1.55 1.72 1.09) | 21-S-110 (1.04 1.36 1.45) | 21-S-112 (0.94 0.86 1.95) |
| 21-S-113 (1.15 1.78 1.04) | 21-S-115 (1.42 1.34 1.48) | 21-S-119 (1.00 0.97 1.84) | 21-S-133 (1.75 1.49 1.32) |
| 21-S-144 (1.09 1.40 1.41) | 21-S-150 (2.57 1.36 1.45) | 21-S-151 (2.48 1.62 1.19) | 21-S-153 (2.51 1.46 1.35) |
| 21-S-177 (1.59 1.14 1.67) | 21-S-183 (1.23 1.48 1.34) | 21-S-184 (2.32 0.95 1.86) | 21-S-192 (1.93 1.47 1.34) |
| 21-S-198 (1.46 0.86 1.95) | 21-S-205 (0.98 0.92 1.89) | 21-S-206 (0.98 1.83 0.98) | 21-S-207 (1.50 1.78 1.03) |
| 21-S-213 (1.43 0.81 2.00) | 21-S-217 (0.85 0.85 1.97) | 21-S-218 (0.82 1.02 1.79) | 21-S-231 (1.97 1.59 1.23) |
| 21-S-233 (1.36 1.01 1.80) | 21-S-234 (1.18 1.09 1.72) | 21-S-237 (1.19 1.39 1.42) | 21-S-244 (1.24 1.00 1.81) |
| 21-S-246 (1.50 1.34 1.47) | 21-S-305 (1.45 0.91 1.91) | 21-S-327 (1.22 1.31 1.50) | 21-S-358 (0.88 0.82 1.99) |
| 21-S-367 (1.50 1.46 1.35) | 21-S-370 (0.85 0.89 1.92) | 21-S-371 (2.66 1.61 1.21) | 21-S-395 (1.69 1.31 1.51) |
| 21-S-420 (0.87 1.79 1.03) | 21-S-440 (1.38 1.22 1.60) | 21-S-441 (1.31 1.14 1.67) | 21-S-473 (1.53 1.49 1.32) |
| 22-S-27 (1.53 1.42 1.21) | 22-S-28 (1.60 1.68 0.94) | 22-S-29 (1.36 1.41 1.22) | 22-S-38 (0.98 0.84 1.78) |
| 22-S-40 (1.18 1.41 1.22) | 22-S-46 (2.77 1.57 1.05) | 22-S-56 (1.52 0.88 1.75) | 22-S-61 (1.51 1.39 1.23) |
| 22-S-62 (1.39 1.59 1.04) | 22-S-65 (1.52 1.19 1.44) | 22-S-68 (1.23 1.15 1.48) | 22-S-79 (1.50 1.56 1.06) |
| 22-S-80 (1.45 1.52 1.11) | 22-S-81 (1.53 1.64 0.98) | 22-S-83 (1.56 0.82 1.81) | 22-S-85 (2.02 1.37 1.25) |
| 22-S-110 (1.57 1.70 0.92) | 22-S-111 (2.27 0.82 1.80) | 22-S-112 (1.46 1.20 1.43) | 22-S-115 (1.94 1.67 0.95) |
| 22-S-118 (1.55 1.10 1.53) | 22-S-119 (1.53 1.31 1.31) | 22-S-123 (1.16 1.44 1.18) | 22-S-132 (1.49 1.02 1.61) |
| 22-S-150 (3.10 1.70 0.93) | 22-S-154 (2.56 0.93 1.70) | 22-S-177 (2.11 1.48 1.15) | 22-S-184 (2.85 1.29 1.33) |
| 22-S-193 (1.37 0.97 1.65) | 22-S-195 (2.28 1.14 1.49) | 22-S-198 (1.99 1.20 1.43) | 22-S-205 (1.51 1.26 1.37) |
| 22-S-209 (1.22 0.81 1.82) | 22-S-213 (1.96 1.15 1.47) | 22-S-217 (1.38 1.18 1.44) | 22-S-218 (1.35 1.36 1.26) |
| 22-S-219 (1.15 0.92 1.71) | 22-S-233 (1.88 1.35 1.28) | 22-S-234 (1.70 1.43 1.19) | 22-S-244 (1.77 1.34 1.28) |
| 22-S-245 (1.69 1.11 1.51) | 22-S-246 (2.02 1.68 0.94) | 22-S-275 (1.10 1.32 1.30) | 22-S-285 (1.29 1.11 1.51) |
| 22-S-286 (1.54 1.02 1.61) | 22-S-287 (1.35 1.03 1.60) | 22-S-288 (1.33 0.97 1.66) | 22-S-304 (1.46 1.03 1.60) |
| 22-S-305 (1.97 1.24 1.38) | 22-S-311 (1.29 0.92 1.71) | 22-S-313 (1.17 0.96 1.67) | 22-S-327 (1.75 1.65 0.98) |
| 22-S-331 (1.61 0.82 1.80) | 22-S-332 (1.46 1.00 1.63) | 22-S-341 (1.06 1.52 1.11) | 22-S-358 (1.40 1.16 1.46) |
| 22-S-370 (1.37 1.23 1.40) | 22-S-391 (1.29 0.91 1.71) | 22-S-395 (2.22 1.65 0.98) | 22-S-434 (1.30 1.22 1.41) |
| 22-S-440 (1.91 1.55 1.07) | 22-S-441 (1.84 1.48 1.14) | 24-S-27(1.16 0.97 1.58) | 24-S-28 (1.23 1.24 1.31) |
| 24-S-29 (0.99 0.96 1.59) | 24-S-40 (0.81 0.96 1.59) | 24-S-43 (1.80 1.60 0.94) | 24-S-46 (2.40 1.13 1.42) |
| 24-S-61 (1.14 0.94 1.60) | 24-S-62 (1.01 1.14 1.41) | 24-S-79 (1.13 1.12 1.43) | 24-S-80 (1.08 1.07 1.48) |
| 24-S-81 (1.16 1.20 1.35) | 24-S-82 (0.89 1.38 1.17) | 24-S-85(1.65 0.93 1.62) | 24-S-86 (0.86 1.30 1.25) |
| 24-S-89 (1.62 1.55 1.00) | 24-S-90 (1.53 1.40 1.15) | 24-S-109 (1.70 1.62 0.93) | 24-S-110 (1.20 1.25 1.29) |
| 24-S-115 (1.57 1.23 1.32) | 24-S-119 (1.15 0.86 1.68) | 24-S-133 (1.91 1.38 1.17) | 24-S-144 (1.24 1.29 1.26) |
| 24-S-150 (2.73 1.25 1.30) | 24-S-151 (2.64 1.51 1.04) | 24-S-153 (2.66 1.35 1.20) | 24-S-177 (1.74 1.03 1.52) |
| 24-S-183 (1.39 1.37 1.18) | 24-S-184 (2.48 0.84 1.70) | 24-S-192 (2.08 1.36 1.18) | 24-S-205 (1.14 0.81 1.74) |
| 24-S-218 (0.98 0.91 1.63) | 24-S-231 (2.13 1.48 1.07) | 24-S-233 (1.51 0.90 1.65) | 24-S-234 (1.33 0.98 1.57) |
| 24-S-237 (1.34 1.28 1.27) | 24-S-244 (1.40 0.89 1.65) | 24-S-246 (1.65 1.23 1.31) | 24-S-327 (1.38 1.20 1.35) |
| 24-S-367 (1.66 1.35 1.20) | 24-S-371 (2.82 1.50 1.05) | 24-S-395 (1.85 1.20 1.35) | 24-S-430 (0.86 1.30 1.25) |
| 24-S-440 (1.54 1.11 1.44) | 24-S-441 (1.47 1.03 1.51) | 24-S-473 (1.69 1.38 1.17) | 26-S-27 (1.53 1.88 1.22) |
| 26-S-28 (1.59 2.14 0.95) | 26-S-29 (1.35 1.87 1.23) | 26-S-38 (0.97 1.30 1.79) | 26-S-40 (1.17 1.87 1.23) |
| 26-S-44 (1.24 1.02 2.07) | 26-S-46 (2.76 2.03 1.06) | 26-S-56 (1.51 1.34 1.76) | 26-S-61 (1.50 1.85 1.24) |
| 26-S-62 (1.38 2.05 1.04) | 26-S-65 (1.51 1.65 1.45) | 26-S-68 (1.22 1.61 1.48) | 26-S-79 (1.49 2.02 1.07) |
| 26-S-80 (1.45 1.98 1.11) | 26-S-81 (1.52 2.10 0.99) | 26-S-83 (1.55 1.28 1.82) | 26-S-85 (2.01 1.83 1.26) |
| 26-S-110 (1.56 2.16 0.93) | 26-S-111 (2.26 1.28 1.81) | 26-S-112 (1.46 1.66 1.43) | 26-S-115 (1.93 2.13 0.96) |
| 26-S-118 (1.55 1.56 1.54) | 26-S-119 (1.52 1.77 1.32) | 26-S-123 (1.16 1.90 1.19) | 26-S-131 (1.57 1.23 1.86) |
| 26-S-132 (1.48 1.48 1.61) | 26-S-150 (3.09 2.16 0.93) | 26-S-154 (2.56 1.39 1.70) | 26-S-166 (2.28 1.21 1.88) |
| 26-S-167 (2.14 0.90 2.19) | 26-S-171 (2.05 1.21 1.88) | 26-S-177 (2.10 1.94 1.15) | 26-S-184 (2.84 1.75 1.34) |
| 26-S-187 (1.99 1.12 1.97) | 26-S-193 (1.36 1.43 1.66) | 26-S-194 (2.22 0.88 2.22) | 26-S-195 (2.27 1.60 1.50) |
| 26-S-198 (1.98 1.66 1.44) | 26-S-205 (1.50 1.72 1.38) | 26-S-208 (1.47 1.19 1.90) | 26-S-209 (1.21 1.27 1.83) |
| 26-S-213 (1.95 1.61 1.48) | 26-S-214 (1.51 0.85 2.25) | 26-S-217 (1.37 1.64 1.45) | 26-S-218 (1.34 1.82 1.27) |
| 26-S-219 (1.14 1.38 1.71) | 26-S-222 (1.26 1.23 1.87) | 26-S-233 (1.88 1.81 1.28) | 26-S-234 (1.70 1.89 1.20) |
| 26-S-237 (1.71 2.19 0.91) | 26-S-244 (1.76 1.80 1.29) | 26-S-245 (1.68 1.57 1.52) | 26-S-246 (2.02 2.14 0.95) |
| 26-S-275 (1.09 1.78 1.31) | 26-S-285 (1.28 1.57 1.52) | 26-S-286 (1.53 1.48 1.62) | 26-S-287 (1.34 1.49 1.61) |
| 26-S-288 (1.32 1.43 1.67) | 26-S-297 (1.39 1.17 1.92) | 26-S-300 (1.65 1.04 2.05) | 26-S-303 (1.41 1.01 2.08) |
| 26-S-304 (1.45 1.49 1.60) | 26-S-305 (1.97 1.70 1.39) | 26-S-311 (1.29 1.38 1.72) | 26-S-312 (1.39 1.25 1.84) |
| 26-S-313 (1.16 1.42 1.68) | 26-S-327 (1.74 2.11 0.99) | 26-S-331 (1.60 1.28 1.81) | 26-S-332 (1.45 1.46 1.63) |
| 26-S-341 (1.05 1.98 1.12) | 26-S-358 (1.39 1.62 1.47) | 26-S-360 (0.84 1.02 2.07) | 26-S-370 (1.36 1.69 1.40) |
| 26-S-391 (1.28 1.37 1.72) | 26-S-395 (2.21 2.11 0.99) | 26-S-434 (1.29 1.68 1.41) | 26-S-440 (1.90 2.01 1.08) |
| 26-S-441 (1.83 1.94 1.15) | 30-S-28 (0.83 1.06 1.71) | 30-S-36 (0.99 1.57 1.20) | 30-S-43 (1.40 1.43 1.34) |
| 30-S-46 (2.00 0.95 1.82) | 30-S-70 (1.47 1.64 1.13) | 30-S-89 (1.22 1.37 1.39) | 30-S-90 (1.13 1.22 1.54) |
| 30-S-109 (130 1.44 133) | 30-S-113 (0.90 1.49 1.28) | 30-S-115 (1.17 1.05 1.72) | 30-S-133 (1.51 1.20 1.57) |
| 30-S-144 (0.84 1.11 1.66) | 30-S-150 (2.33 1.07 1.69) | 30-S-151 (2.24 1.33 1.44) | 30-S-152 (2.88 1.63 1.14) |
| 30-S-153 (2.26 1.18 1.59) | 30-S-177 (1.34 0.85 1.91) | 30-S-183 (0.99 1.19 1.58) | 30-S-192 (1.69 1.19 1.58) |
| 30-S-207 (1.26 1.49 1.28) | 30-S-231 (1.73 1.30 1.47) | 30-S-234 (0.94 0.81 1.96) | 30-S-237 (0.95 1.10 1.67) |
| 30-S-246 (1.25 1.06 1.71) | 30-S-327 (0.98 1.02 1.75) | 30-S-364 (1.44 1.85 0.92) | 30-S-367 (1.26 1.18 1.59) |
| 30-S-368 (1.37 1.72 1.05) | 30-S-371 (2.42 1.32 1.45) | 30-S-395 (1.45 1.02 1.75) | 30-S-440 (1.14 0.93 1.84) |
| 30-S-441 (1.07 0.86 1.91) | 30-S-473 (1.29 1.20 1.57) | 31-S-28 (0.81 1.11 1.73) | 31-S-36 (0.97 1.62 1.21) |
| 31-S-37 (0.97 1.92 0.91) | 31-S-43 (1.39 1.47 1.36) | 31-S-46 (1.98 0.99 1.84) | 31-S-70 (1.45 1.68 1.15) |
| 31-S-89 (1.20 1.42 1.41) | 31-S-90 (1.11 1.27 1.56) | 31-S-109 (1.29 1.48 1.35) | 31-S-113 (0.89 1.54 1.29) |
| 31-S-115 (1.16 1.10 1.73) | 31-S-133 (1.49 1.25 1.58) | 31-S-144 (0.83 1.16 1.67) | 31-S-150 (2.31 1.12 1.71) |
| 31-S-151 (2.22 1.38 1.45) | 31-S-152 (2.87 1.68 1.15) | 31-S-153 (2.25 1.22 1.61) | 31-S-177 (1.33 0.90 1.93) |
| 31-S-183 (0.98 1.24 1.59) | 31-S-192 (1.67 1.23 1.60) | 31-S-207 (1.24 1.54 1.29) | 31-S-231 (1.71 1.35 1.49) |
| 31-S-234 (0.92 0.85 1.98) | 31-S-237 (0.93 1.15 1.68) | 31-S-246 (1.24 1.10 1.73) | 31-S-327 (0.96 1.07 1.76) |
| 31-S-364 (1.43 1.90 0.93) | 31-S-367 (1.24 1.22 1.61) | 31-S-368 (1.36 1.76 1.07) | 31-S-371 (2.40 1.37 1.46) |
| 31-S-395 (1.44 1.07 1.76) | 31-S-440 (1.12 0.98 1.86) | 31-S-441 (1.05 0.90 1.93) | 31-S-473 (1.27 1.25 1.58) |
| 32-S-36 (0.88 1.77 1.30) | 32-S-37 (0.88 2.07 1.00) | 32-S-43 (1.30 1.62 1.45) | 32-S-46 (1.89 1.14 1.93) |
| 32-S-70 (1.36 1.83 1.24) | 32-S-85 (1.14 0.94 2.13) | 32-S-89 (1.12 1.57 1.50) | 32-S-90 (1.03 1.42 1.65) |
| 32-S-109 (1.20 163 1.44) | 32-S-115 (1.07 1.25 1.82) | 32-S-133 (1.41 1.40 1.67) | 32-S-150 (2.23 1.27 1.80) |
| 32-S-151 (2.13 1.53 1.54) | 32-S-152 (2.78 1.83 1.24) | 32-S-153 (2.16 1.37 1.70) | 32-S-177 (1.24 1.05 2.02) |
| 32-S-183 (0.89 1.39 1.68) | 32-S-184 (1.97 0.86 2.21) | 32-S-192 (1.58 1.38 1.69) | 32-S-207 (1.15 1.69 1.38) |
| 32-S-231 (1.62 1.50 1.57) | 32-S-233 (1.01 0.92 2.15) | 32-S-234 (0.83 1.00 2.07) | 32-S-237 (0.84 1.30 1.77) |
| 32-S-244 (0.90 0.91 2.16) | 32-S-246 (1.15 1.25 1.82) | 32-S-305 (1.10 0.82 2.25) | 32-S-327 (0.87 1.22 1.85) |
| 32-S-364 (1.34 2.05 1.02) | 32-S-367 (1.15 1.37 1.70) | 32-S-368 (1.27 1.91 1.16) | 32-S-371 (2.32 1.52 1.55) |
| 32-S-395 (1351.22185) | 32-S-440 (1.03 1.13 1.94) | 32-S-441 (0.96 1.05 2.02) | 32-S-473 (1.18 1.40 1.67) |
| 33-S-36 (0.94 1.73 1.25) | 33-S-37 (0.93 2.03 0.95) | 33-S-43 (1.35 1.59 1.39) | 33-S-46 (1.95 1.11 1.87) |
| 33-S-70 (1.42 1.80 1.18) | 33-S-85 (1.20 0.91 2.07) | 33-S-89 (1.17 1.54 1.44) | 33-S-90 (1.08 1.39 1.59) |
| 33-S-109 (1.25 1.60 1.38) | 33-S-113 (0.85 1.65 1.33) | 33-S-115 (1.12 1.21 1.77) | 33-S-133 (1.46 1.36 1.62) |
| 33-S-150 (2.28 1.24 1.74) | 33-S-151 (2.19 1.49 1.49) | 33-S-152 (2.83 1.79 1.19) | 33-S-153 (2.21 1.34 1.64) |
| 33-S-177 (1.29 1.02 1.96) | 33-S-183 (0.94 1.35 1.63) | 33-S-184 (2.03 0.83 2.15) | 33-S-192 (1.64 1.35 1.63) |
| 33-S-207 (1.21 1.65 1.33) | 33-S-231 (1.68 1.46 1.52) | 33-S-233 (1.07 0.89 2.09) | 33-S-234 (0.89 0.97 2.01) |
| 33-S-237 (0.90 1.26 1.72) | 33-S-244 (0.95 0.88 2.10) | 33-S-246 (1.20 1.22 1.76) | 33-S-327 (0.93 1.18 1.80) |
| 33-S-364 (1.39 2.01 0.97) | 33-S-367 (1.21 1.34 1.64) | 33-S-368 (1.32 1.88 1.10) | 33-S-371 (2.37 1.48 1.50) |
| 33-S-395 (1.40 1.18 1.80) | 33-S-440 (1.09 1.09 1.89) | 33-S-441 (1.02 1.02 1.96) | 33-S-473 (1.24 1.36 1.62) |
| 34-S-27 (0.84 0.96 1.91) | 34-S-28 (0.90 1.23 1.64) | 34-S-36 (1.06 1.74 1.12) | 34-S-43 (1.48 1.60 1.27) |
| 34-S-46 (2.07 1.12 1.75) | 34-S-61 (0.81 0.94 1.93) | 34-S-70 (1.54 1.81 1.06) | 34-S-79 (0.81 1.11 1.76) |
| 34-S-81 (0.83 1.19 1.68) | 34-S-85 (1.32 0.92 1.95) | 34-S-89 (1.29 1.54 1.32) | 34-S-90 (1.20 1.39 1.47) |
| 34-S-109 (1.38 1.61 1.26) | 34-S-110 (0.87 1.25 1.62) | 34-S-113 (0.98 1.66 1.20) | 34-S-115 (1.25 1.22 1.65) |
| 34-S-119 (0.83 0.86 2.01) | 34-S-133 (1.58 1.37 1.49) | 34-S-144 (0.92 1.28 1.58) | 34-S-150 (2.40 1.24 1.62) |
| 34-S-151 (2.31 1.50 1.36) | 34-S-152 (2.96 1.80 1.06) | 34-S-153 (2.34 1.34 1.52) | 34-S-177 (1.42 1.02 1.84) |
| 34-S-183 (1.06 1.36 1.51) | 34-S-184 (2.15 0.84 2.03) | 34-S-192 (1.76 1.36 1.51) | 34-S-205 (0.81 0.80 2.06) |
| 34-S-206 (0.81 1.71 1.15) | 34-S-207 (1.33 1.66 1.20) | 34-S-231 (1.80 1.47 1.40) | 34-S-233 (1.19 0.89 1.97) |
| 34-S-234 (1.01 0.98 1.89) | 34-S-237 (1.02 1.27 1.59) | 34-S-244 (1.07 0.89 1.98) | 34-S-246 (1.33 1.23 1.64) |
| 34-S-327 (1.05 1.19 1.67) | 34-S-367 (1.33 1.34 1.52) | 34-S-368 (1.44 1.89 0.98) | 34-S-371 (2.49 1.49 1.38) |
| 34-S-395 (1.52 1.19 1.68) | 34-S-440 (1.21 1.10 1.77) | 34-S-441 (1.14 1.03 1.84) | 34-S-473 (1.36 1.37 1.49) |
| 35-S-36 (0.92 1.79 1.26) | 35-S-37 (0.92 2.09 0.96) | 35-S-43 (1.34 1.64 1.41) | 35-S-46 (1.93 1.16 1.89) |
| 35-S-70 (1.40 1.85 1.20) | 35-S-85 (1.18 0.97 2.08) | 35-S-89 (1.16 1.59 1.46) | 35-S-90 (1.07 1.44 1.61) |
| 35-S-109 (1.24 1.65 1.40) | 35-S-113 (0.84 1.71 1.34) | 35-S-115 (1.11 1.27 1.78) | 35-S-133 (1.45 1.42 1.63) |
| 35-S-150 (2.27 1.29 1.76) | 35-S-151 (2.17 1.55 1.50) | 35-S-152 (2.82 1.85 1.20) | 35-S-153 (2.20 1.39 1.66) |
| 35-S-177 (1.28 1.07 1.98) | 35-S-183 (0.93 1.41 1.64) | 35-S-184 (2.02 0.88 2.17) | 35-S-192 (1.62 1.40 1.65) |
| 35-S-207 (1.19 1.71 1.34) | 35-S-231 (1.67 1.52 1.53) | 35-S-233 (1.05 0.94 2.11) | 35-S-234 (0.87 1.02 2.03) |
| 35-S-237 (0.88 1.32 1.73) | 35-S-244 (0.94 0.93 2.12) | 35-S-246 (1.19 1.27 1.78) | 35-S-305 (1.14 0.84 2.21) |
| 35-S-327 (0.91 1.24 1.81) | 35-S-364 (1.38 2.07 0.98) | 35-S-367 (1.20 1.39 1.66) | 35-S-368 (1.31 1.93 1.11) |
| 35-S-371 (2.36 1.54 1.51) | 35-S-395 (1.39 1.24 1.81) | 35-S-440 (1.07 1.15 1.90) | 35-S-441 (1.00 1.07 1.98) |
| 35-S-473 (1.23 1.42 1.63) | 38-S-43 (1.20 1.21 1.55) | 38-S-70 (1.26 1.42 1.34) | 38-S-89 (1.01 1.16 1.60) |
| 38-S-90 (0.92 1.01 1.75) | 38-S-109 (1.10 1.22 1.54) | 38-S-115 (0.97 0.83 1.93) | 38-S-133 (1.30 0.98 1.77) |
| 38-S-150 (2.12 0.86 1.90) | 38-S-151 (2.03 1.12 1.64) | 38-S-152 (2.68 1.41 1.34) | 38-S-153 (2.06 0.96 1.80) |
| 38-S-192(1.48 0.97 1.79) | 38-S-207 (1.05 1.27 1.48) | 38-S-231 (1.52 1.08 1.68) | 38-S-246 (1.05 0.84 1.92) |
| 38-S-364 (1.24 1.64 1.12) | 38-S-367 (1.05 0.96 1.80) | 38-S-368 (1.16 1.50 1.26) | 38-S-371 (2.21 1.10 1.66) |
| 38-S-395 (1.25 0.80 1.95) | 38-S-473 (1.08 0.98 1.77) | 39-S-27 (1.13 1.75 1.61) | 39-S-28 (1.20 2.02 1.34) |
| 39-S-29 (0.96 1.74 1.62) | 39-S-43 (1.77 2.38 0.97) | 39-S-44 (0.85 0.90 2.46) | 39-S-46 (2.37 1.90 1.45) |
| 39-S-56 (1.12 1.21 2.15) | 39-S-61(1.11 1.72 1.63) | 39-S-62 (0.99 1.92 1.43) | 39-S-65 (1.12 1.52 1.84) |
| 39-S-68 (0.83 1.48 1.88) | 39-S-79 (1.10 1.89 1.46) | 39-S-80 (1.06 1.85 1.50) | 39-S-81 (1.13 1.98 1.38) |
| 39-S-82 (0.86 2.16 1.19) | 39-S-83 (1.16 1.15 2.21) | 39-S-85 (1.62 1.71 1.65) | 39-S-86 (0.83 2.08 1.28) |
| 39-S-89 (1.59 2.33 1.02) | 39-S-90 (1.50 2.18 1.17) | 39-S-109 (1.67 2.39 0.96) | 39-S-110 (1.17 2.03 1.32) |
| 39-S-111 (1.87 1.15 2.20) | 39-S-112 (1.06 1.53 1.83) | 39-S-113 (1.27 2.45 0.91) | 39-S-115 (1.54 2.01 1.35) |
| 39-S-118 (1.15 1.43 1.93) | 39-S-119 (1.13 1.64 1.71) | 39-S-131 (1.18 1.11 2.25) | 39-S-132 (1.09 1.35 2.01) |
| 39-S-133 (1.88 2.16 1.20) | 39-S-144 (1.21 2.07 1.29) | 39-S-150 (2.70 2.03 1.32) | 39-S-151 (2.61 2.29 1.07) |
| 39-S-153 (2.63 2.13 1.22) | 39-S-154 (2.17 1.26 2.10) | 39-S-166 (1.89 1.09 2.27) | 39-S-171 (1.66 1.08 2.27) |
| 39-S-177 (1.71 1.81 1.54) | 39-S-183 (1.36 2.15 1.21) | 39-S-184 (2.45 1.62 1.73) | 39-S-187 (1.59 1.00 2.36) |
| 39-S-192 (2.06 2.14 1.21) | 39-S-193 (0.97 1.31 2.05) | 39-S-195 (1.88 1.47 1.89) | 39-S-198 (1.59 1.53 1.83) |
| 39-S-205 (1.11 1.59 1.77) | 39-S-207 (1.63 2.45 0.91) | 39-S-208 (1.07 1.06 2.30) | 39-S-209 (0.82 1.14 2.22) |
| 39-S-213 (1.56 1.48 1.87) | 39-S-217 (0.98 1.52 1.84) | 39-S-218 (0.95 1.69 1.66) | 39-S-222 (0.86 1.10 2.26) |
| 39-S-231 (2.10 2.26 1.10) | 39-S-233 (1.48 1.68 1.68) | 39-S-234 (1.30 1.76 1.59) | 39-S-237 (1.32 2.06 1.30) |
| 39-S-244 (1.37 1.67 1.68) | 39-S-245 (1.29 1.45 1.91) | 39-S-246 (1.62 2.01 1.34) | 39-S-285 (0.89 1.44 1.91) |
| 39-S-286 (1.14 1.35 2.01) | 39-S-287 (0.95 1.36 2.00) | 39-S-288 (0.93 1.30 2.06) | 39-S-297 (1.00 1.04 2.32) |
| 39-S-300 (1.26 0.91 2.44) | 39-S-303 (1.02 0.89 2.47) | 39-S-304 (1.06 1.36 2.00) | 39-S-305 (1.57 1.58 1.78) |
| 39-S-311 (0.90 1.25 2.11) | 39-S-312 (0.99 1.12 2.24) | 39-S-327 (1.35 1.98 1.38) | 39-S-331 (1.21 1.16 2.20) |
| 39-S-332 (1.06 1.33 2.03) | 39-S-358 (1.00 1.50 1.86) | 39-S-367 (1.63 2.13 1.22) | 39-S-370 (0.97 1.56 1.79) |
| 39-S-371 (2.79 2.28 1.08) | 39-S-391 (0.89 1.25 2.11) | 39-S-395 (1.82 1.98 1.38) | 39-S-430 (0.83 2.08 1.28) |
| 39-S-434 (0.90 1.55 1.81) | 39-S-440 (1.51 1.89 1.47) | 39-S- 441 (1.44 1.81 1.54) | 39-S-473 (1.66 2.16 1.20) |
| 41-S-27 (1.45 1.60 1.30) | 41-S-28 (1.51 1.87 1.03) | 41-S-29 (1.27 1.59 1.30) | 41-S-38 (0.89 1.02 1.87) |
| 41-S-40 (1.09 1.59 1.30) | 41-S- 46 (2.68 1.75 1.14) | 41-S-56 (1.44 1.06 1.83) | 41-S-61 (1.42 1.57 1.32) |
| 41-S-62 (1.30 1.77 1.12) | 41-S-65 (1.43 1.37 1.53) | 41-S-68 (1.14 1.33 1.56) | 41-S-79 (1.42 1.74 1.15) |
| 41-S-80 (1.37 1.70 1.19) | 41-S-81 (1.44 1.82 1.07) | 41-S-83 (1.48 1.00 1.89) | 41-S-85 (1.93 1.55 1.34) |
| 41-S-86 (1.15 1.92 0.97) | 41-S-110 (1.48 1.88 1.01) | 41-S-111 (2.18 1.00 1.89) | 41-S-112 (1.38 1.38 1.51) |
| 41-S-115 (1.86 1.86 1.04) | 41-S-118 (1.47 1.28 1.61) | 41-S-119 (1.44 1.49 1.40) | 41-S-123 (1.08 1.62 1.27) |
| 41-S-131 (1.49 0.95 1.94) | 41-S-132 (1.40 1.20 1.69) | 41-S-144 (1.53 1.92 0.97) | 41-S-150 (3.01 1.88 1.01) |
| 41-S-153 (2.95 1.98 0.91) | 41-S-154 (2.48 1.11 1.78) | 41-S-166 (2.20 0.94 1.96) | 41-S-171 (1.97 0.93 1.96) |
| 41-S-177 (2.03 1.66 1.23) | 41-S-184 (2.76 1.47 1.42) | 41-S-187 (1.91 0.84 2.05) | 41-S-193 (1.29 1.16 1.74) |
| 41-S-195 (2.19 1.32 1.57) | 41-S-198 (1.90 1.38 1.51) | 41-S-205 (1.42 1.44 1.45) | 41-S-208 (1.39 0.91 1.98) |
| 41-S-209 (1.13 0.99 1.91) | 41-S-213 (1.87 1.33 1.56) | 41-S-217 (1.29 1.37 1.53) | 41-S-218 (1.26 1.54 1.35) |
| 41-S-219 (1.07 1.10 1.79) | 41-S-222 (1.18 0.95 1.94) | 41-S-233 (1.80 1.53 1.36) | 41-S-234 (1.62 1.61 1.28) |
| 41-S-237 (1.63 1.91 0.98) | 41-S-244 (1.68 1.52 1.37) | 41-S-245 (1.60 1.30 1.60) | 41-S-246 (1.94 1.86 1.03) |
| 41-S-275 (1.01 1.50 1.39) | 41-S-285 (1.20 1.29 1.60) | 41-S-286 (1.45 1.20 1.69) | 41-S-287 (1.26 1.21 1.68) |
| 41-S-288 (1.25 1.15 1.74) | 41-S-297 (1.31 0.89 2.00) | 41-S-304 (1.37 1.21 1.68) | 41-S-305 (1.89 1.43 1.47) |
| 41-S-311 (1.21 1.10 1.79) | 41-S-312 (1.31 0.97 1.92) | 41-S-313 (1.08 1.14 1.75) | 41-S-327 (1.66 1.83 1.06) |
| 41-S-331 (1.52 1.01 1.89) | 41-S-332 (1.37 1.18 1.71) | 41-S-341 (0.97 1.70 1.19) | 41-S-358 (1.32 1.34 1.55) |
| 41-S-367 (1.94 1.98 0.91) | 41-S-370 (1.29 1.41 1.48) | 41-S-391 (1.21 1.09 1.80) | 41-S-395 (2.13 1.83 1.07) |
| 41-S-430 (1.15 1.93 0.97) | 41-S-434 (1.21 1.40 1.49) | 41-S-440 (1.82 1.74 1.16) | 41-S-441 (1.75 1.66 1.23) |
| 44-S-43 (0.92 1.49 1.82) | 44-S-46 (1.52 1.01 2.30) | 44-S-70 (0.99 1.70 1.61) | 44-S-109 (0.82 1.50 1.81) |
| 44-S-133 (1.03 1.26 2.05) | 44-S-150 (1.85 1.13 2.17) | 44-S-151 (1.76 1.39 1.92) | 44-S-152 (2.40 1.69 1.62) |
| 44-S-153 (1.78 1.23 2.07) | 44-S-177 (0.86 0.91 2.39) | 44-S-192 (1.21 1.25 2.06) | 44-S-231 (1.25 1.36 1.95) |
| 44-S-364 (0.96 1.91 1.40) | 44-S-368 (0.89 1.78 1.53) | 44-S-371 (1.94 1.38 1.93) | 44-S-395 (0.97 1.08 2.23) |
| 44-S-473 (0.81 1.26 2.05) | 49-S-38 (1.37 1.18 1.39) | 49-S-44 (1.64 0.90 1.67) | 49-S-56 (1.92 1.22 1.36) |
| 49-S-65 (1.91 1.53 1.05) | 49-S-68 (1.62 1.49 1.08) | 49-S-83 (1.95 1.16 1.41) | 49-S-111 (2.66 1.16 1.41) |
| 49-S-112 (1.86 1.54 1.03) | 49-S-118 (1.95 1.44 1.14) | 49-S-119 (1.92 1.65 0.92) | 49-S-131 (1.97 1.11 1.46) |
| 49-S-132 (1.88 1.36 1.21) | 49-S-154 (2.96 1.27 1.30) | 49-S-166 (2.68 1.09 1.48) | 49-S-171 (2.45 1.09 1.48) |
| 49-S-184 (3.24 1.63 0.94) | 49-S-187 (2.39 1.00 1.57) | 49-S-193 (1.77 1.31 1.26) | 49-S-195 (2.67 1.48 1.10) |
| 49-S-198 (2.38 1.54 1.04) | 49-S-205 (1.90 1.60 0.98) | 49-S-208 (1.87 1.07 1.50) | 49-S-209 (1.61 1.15 1.43) |
| 49-S-213 (2.35 1.49 1.08) | 49-S-217 (1.77 1.52 1.05) | 49-S-219 (1.54 1.26 1.31) | 49-S-222 (1.66 1.11 1.47) |
| 49-S-245 (2.08 1.45 1.12) | 49-S-275 (1.49 1.66 0.91) | 49-S-285 (1.68 1.45 1.12) | 49-S-286 (1.93 1.36 1.22) |
| 49-S-287 (1.74 1.37 1.20) | 49-S-288 (1.72 1.31 1.27) | 49-S-297 (1.79 1.05 1.52) | 49-S-300 (2.05 0.92 1.65) |
| 49-S-303 (1.81 0.89 1.68) | 49-S-304 (1.85 1.37 1.20) | 49-S-305 (2.37 1.58 0.99) | 49-S-311 (1.69 1.26 1.32) |
| 49-S-312 (1.79 1.13 1.44) | 49-S-313 (1.56 1.30 1.28) | 49-S-331 (2.00 1.16 1.41) | 49-S-332 (1.85 1.34 1.23) |
| 49-S-358 (1.80 1.50 1.07) | 49-S-360 (1.24 0.90 1.67) | 49-S-370 (1.76 1.57 1.00) | 49-S-391 (1.68 1.25 1.32) |
| 49-S-434 (1.69 1.56 1.01) | 53-S-27 (0.90 1.31 1.84) | 53-S-28 (0.96 1.58 1.57) | 53-S-36 (1.12 2.09 1.06) |
| 53-S-43 (1.54 1.95 1.21) | 53-S- 46 (2.13 1.47 1.69) | 53-S-61 (0.87 1.29 1.87) | 53-S-65 (0.88 1.08 2.07) |
| 53-S-70 (1.60 2.16 1.00) | 53-S-79 (0.87 1.46 1.70) | 53-S-80 (0.82 1.42 1.74) | 53-S-81 (0.90 1.54 1.61) |
| 53-S-85 (1.38 1.27 1.89) | 53-S-89 (1.36 1.90 1.26) | 53-S-90 (1.27 1.75 1.41) | 53-S-109 (1.44 1.96 1.20) |
| 53-S-110 (0.93 1.60 1.56) | 53-S- 112 (0.83 1.10 2.06) | 53-S-113 (1.04 2.01 1.14) | 53-S-115 (1.31 1.57 1.58) |
| 53-S-118 (0.92 0.99 2.16) | 53-S-119 (0.89 1.21 1.95) | 53-S-132 (0.86 0.92 2.24) | 53-S-133 (1.65 1.72 1.43) |
| 53-S-144 (0.98 1.63 1.52) | 53-S-150 (2.47 1.60 1.56) | 53-S-151 (2.37 1.85 1.30) | 53-S-152 (3.02 2.15 1.00) |
| 53-S-153 (2.40 1.70 1.46) | 53-S-154 (1.93 0.83 2.33) | 53-S-177 (1.48 1.38 1.78) | 53-S-183 (1.13 1.71 1.44) |
| 53-S-184 (2.21 1.19 1.97) | 53-S-192 (1.82 1.71 1.45) | 53-S-195 (1.65 1.03 2.12) | 53-S-198 (1.36 1.09 2.06) |
| 53-S-205 (0.88 1.15 2.00) | 53-S-206 (0.87 2.07 1.09) | 53-S-207 (1.39 2.01 1.14) | 53-S-213 (1.32 1.05 2.11) |
| 53-S-231 (1.86 1.82 1.33) | 53-S-233 (1.25 1.25 1.91) | 53-S-234 (1.07 1.33 1.83) | 53-S-237 (1.08 1.62 1.53) |
| 53-S-244 (1.14 1.24 1.92) | 53-S-245 (1.05 1.01 2.14) | 53-S-246 (1.39 1.58 1.58) | 53-S-286 (0.91 0.91 2.24) |
| 53-S-304 (0.82 0.93 2.23) | 53-S-305 (1.34 1.14 2.01) | 53-S-327 (1.11 1.54 1.61) | 53-S-332 (0.83 0.90 2.26) |
| 53-S-367 (1.39 1.70 1.46) | 53-S-368 (1.51 2.24 0.92) | 53-S-371 (2.56 1.84 1.31) | 53-S-395 (1.59 1.54 1.61) |
| 53-S-440 (1.27 1.45 1.70) | 53-S-441 (1.20 1.38 1.78) | 53-S-473 (1.42 1.72 1.43) | 54-S-27 (0.81 1.06 1.94) |
| 54-S-28 (0.87 1.32 1.67) | 54-S-36 (1.03 1.84 1.16) | 54-S-43 (1.44 1.69 1.30) | 54-S-46 (2.04 1.21 1.78) |
| 54-S-70 (1.51 1.90 1.09) | 54-S-81 (0.80 1.28 1.71) | 54-S-85 (1.29 1.01 1.98) | 54-S-89 (1.26 1.64 1.35) |
| 54-S-90 (1.17 1.49 1.50) | 54-S-109 (1.35 1.70 1.29) | 54-S-110 (0.84 1.34 1.65) | 54-S-113 (0.95 1.76 1.24) |
| 54-S-115 (1.22 1.32 1.68) | 54-S-133 (1.55 1.47 1.53) | 54-S-144 (0.89 1.38 1.61) | 54-S-150 (2.37 1.34 1.65) |
| 54-S-151 (2.28 1.60 1.39) | 54-S-152 (2.92 1.90 1.10) | 54-S-153 (2.30 1.44 1.55) | 54-S-177 (1.39 1.12 1.87) |
| 54-S-183 (1.03 1.46 1.54) | 54-S-184 (2.12 0.93 2.06) | 54-S-192 (1.73 1.45 1.54) | 54-S-198 (1.26 0.84 2.16) |
| 54-S-207 (1.30 1.76 1.24) | 54-S-231 (1.77 1.56 1.43) | 54-S-233 (1.16 0.99 2.00) | 54-S-234 (0.98 1.07 1.92) |
| 54-S-237 (0.99 1.37 1.63) | 54-S-244 (1.04 0.98 2.01) | 54-S-246 (1.30 1.32 1.67) | 54-S-305 (1.25 0.89 2.11) |
| 54-S-327 (1.02 1.29 1.71) | 54-S-367 (1.30 1.44 1.55) | 54-S-368 (1.41 1.98 1.01) | 54-S-371 (2.46 1.59 1.41) |
| 54-S-395 (1.49 1.29 1.71) | 54-S-440 (1.18 1.19 1.80) | 54-S-441 (1.11 1.12 1.87) | 54-S-473 (1.33 1.47 1.53) |
| 55-S-36 (0.95 2.03 1.23) | 55-S-37 (0.95 2.33 0.93) | 55-S-43 (1.37 1.89 1.38) | 55-S-46 (1.96 1.41 1.86) |
| 55-S-70 (1.43 2.10 1.17) | 55-S-85 (1.21 1.21 2.06) | 55-S-89 (1.19 1.83 1.43) | 55-S-90 (1.09 1.68 1.58) |
| 55-S-109 (1.27 1.90 1.37) | 55-S-113 (0.87 1.95 1.31) | 55-S-115 (1.14 1.51 1.75) | 55-S-133 (1.47 1.66 1.60) |
| 55-S-144 (0.81 1.57 1.69) | 55-S-150 (2.29 1.53 1.73) | 55-S-151 (2.20 1.79 1.47) | 55-S-152 (2.85 2.09 1.17) |
| 55-S-153 (2.23 1.63 1.63) | 55-S-177 (1.31 1.31 1.95) | 55-S-183 (0.96 1.65 1.61) | 55-S-184 (2.04 1.13 2.14) |
| 55-S-192 (1.65 1.65 1.62) | 55-S-195 (1.47 0.97 2.29) | 55-S-198 (1.19 1.03 2.23) | 55-S-207 (1.22 1.95 1.31) |
| 55-S-213 (1.15 0.99 2.28) | 55-S-231 (1.69 1.76 1.51) | 55-S-233 (1.08 1.18 2.08) | 55-S-234 (0.90 1.26 2.00) |
| 55-S-237 (0.91 1.56 1.70) | 55-S-244 (0.96 1.18 2.09) | 55-S-245 (0.88 0.95 2.31) | 55-S-246 (1.22 1.52 1.75) |
| 55-S-305 (1.17 1.08 2.18) | 55-S-327 (0.94 1.48 1.78) | 55-S-364 (1.41 2.31 0.95) | 55-S-367 (1.22 1.63 1.63) |
| 55-S-368 (1.34 2.18 1.09) | 55-S-371 (2.39 1.78 1.48) | 55-S-395 (1.42 1.48 1.78) | 55-S-440 (1.10 1.39 1.88) |
| 55-S-441 (1.03 1.31 1.95) | 55-S-473 (1.25 1.66 1.60) | 58-S-28 (0.93 1.05 1.61) | 58-S-36 (1.09 1.56 1.09) |
| 58-S-43 (1.51 1.41 1.24) | 58-S-46 (2.10 0.94 1.72) | 58-S-70 (1.57 1.62 1.03) | 58-S-79 (0.84 0.93 1.73) |
| 58-S-81 (0.87 1.01 1.65) | 58-S-89 (1.33 1.36 1.29) | 58-S-90 (1.23 1.21 1.44) | 58-S-109 (1.41 1.43 1.23) |
| 58-S-110 (0.90 1.06 1.59) | 58-S-113 (1.01 1.48 1.17) | 58-S-115 (1.28 1.04 1.61) | 58-S-133 (1.61 1.19 1.46) |
| 58-S-144 (0.95 1.10 1.55) | 58-S-150 (2.43 1.06 1.59) | 58-S-151 (2.34 1.32 1.33) | 58-S-152 (2.99 1.62 1.03) |
| 58-S-153 (2.37 1.16 1.49) | 58-S-177 (1.45 0.84 1.81) | 58-S-183 (1.10 1.18 1.47) | 58-S-192 (1.79 1.17 1.48) |
| 58-S-206 (0.84 1.53 1.12) | 58-S-207 (1.36 1.48 1.17) | 58-S-231 (1.83 1.29 1.36) | 58-S-237 (1.05 1.09 1.56) |
| 58-S-246 (1.36 1.04 1.61) | 58-S-327 (1.08 1.01 1.64) | 58-S-367 (1.36 1.16 1.49) | 58-S-368 (1.48 1.71 0.95) |
| 58-S-371 (2.53 1.31 1.34) | 58-S-395 (1.56 1.01 1.64) | 58-S-440 (1.24 0.92 1.74) | 58-S-441 (1.17 0.84 1.81) |
| 58-S-473 (1.39 1.19 1.46) | 59-S-27 (0.83 0.81 1.91) | 59-S-28 (0.89 1.08 1.65) | 59-S-36 (1.05 1.59 1.13) |
| 59-S-43 (1.47 1.44 1.28) | 59-S-46 (2.06 0.96 1.76) | 59-S-70 (1.53 1.65 1.07) | 59-S-81 (0.83 1.04 1.69) |
| 59-S-89 (1.28 1.39 1.33) | 59-S-90 (1.19 1.24 1.48) | 59-S-109 (1.37 1.45 1.27) | 59-S-110 (0.86 1.09 1.63) |
| 59-S-113 (0.97 1.51 1.21) | 59-S-115 (1.24 1.07 1.66) | 59-S-133 (1.57 1.22 1.50) | 59-S-144 (0.91 1.13 1.59) |
| 59-S-150 (2.39 1.09 1.63) | 59-S-151 (2.30 1.35 1.37) | 59-S-152 (2.95 1.65 1.07) | 59-S-153 (2.33 1.19 1.53) |
| 59-S-177 (1.41 0.87 1.85) | 59-S-183 (1.05 1.21 1.51) | 59-S-192 (1.75 1.20 1.52) | 59-S-207 (1.32 1.51 1.21) |
| 59-S-231 (1.79 1.32 1.41) | 59-S-234 (1.00 0.82 1.90) | 59-S-237 (1.01 1.12 1.60) | 59-S-246 (1.32 1.07 1.65) |
| 59-S-327 (1.04 1.04 1.68) | 59-S-367 (1.32 1.19 1.53) | 59-S-368 (1.43 1.73 0.99) | 59-S-371 (2.48 1.34 1.39) |
| 59-S-395 (1.51 1.04 1.68) | 59-S-440 (1.20 0.95 1.78) | 59-S-441 (1.13 0.87 1.85) | 59-S-473 (1.35 1.22 1.50) |
| 60-S-36 (0.94 1.70 1.24) | 60-S-37 (0.94 2.00 0.94) | 60-S-43 (1.36 1.56 1.39) | 60-S-46 (1.96 1.08 1.86) |
| 60-S-70 (1.42 1.77 1.18) | 60-S-85 (1.20 0.88 2.06) | 60-S-89 (1.18 1.51 1.44) | 60-S-90 (1.09 1.36 1.59) |
| 60-S-109 (1.26 1.57 1.37) | 60-S-113 (0.86 1.62 1.32) | 60-S-115 (1.13 1.18 1.76) | 60-S-133 (1.47 1.33 1.61) |
| 60-S-144 (0.80 1.24 1.70) | 60-S-150 (2.29 1.21 1.74) | 60-S-151 (2.20 1.46 1.48) | 60-S-152 (2.84 1.76 1.18) |
| 60-S-153 (2.22 1.31 1.64) | 60-S-177 (1.30 0.99 1.96) | 60-S-183 (0.95 1.32 1.62) | 60-S-192 (1.64 1.32 1.62) |
| 60-S-207 (1.21 1.62 1.32) | 60-S-231 (1.69 1.43 1.51) | 60-S-233 (1.07 0.86 2.09) | 60-S-234 (0.89 0.94 2.01) |
| 60-S-237 (0.90 1.23 1.71) | 60-S-244 (0.96 0.85 2.09) | 60-S-246 (1.21 1.19 1.76) | 60-S-327 (0.93 1.15 1.79) |
| 60-S-364 (1.40 1.98 0.96) | 60-S-367 (1.22 1.31 1.64) | 60-S-368 (1.33 1.85 1.09) | 60-S-371 (2.38 1.45 1.49) |
| 60-S-395 (1.41 1.15 1.79) | 60-S-440 (1.09 1.06 1.88) | 60-S-441 (1.02 0.99 1.96) | 60-S- 473 (1.25 1.33 1.61) |
| 63-S-27 (0.87 1.50 1.88) | 63-S-28 (0.93 1.77 1.61) | 63-S-36 (1.09 2.29 1.10) | 63-S-43 (1.50 2.14 1.24) |
| 63-S-46 (2.10 1.66 1.72) | 63-S-56 (0.85 0.97 2.42) | 63-S-61 (0.84 1.48 1.90) | 63-S-65 (0.85 1.28 2.11) |
| 63-S-70 (1.57 2.35 1.03) | 63-S-79 (0.83 1.65 1.73) | 63-S-81 (0.86 1.73 1.65) | 63-S-83 (0.89 0.91 2.48) |
| 63-S-85 (1.35 1.46 1.92) | 63-S-89 (1.32 2.09 1.29) | 63-S-90 (1.23 1.94 1.44) | 63-S-109 (1.41 2.15 1.23) |
| 63-S-110 (0.90 1.79 1.59) | 63-S-111 (1.60 0.91 2.47) | 63-S-113 (1.00 2.21 1.18) | 63-S-115 (1.27 1.76 1.62) |
| 63-S-118 (0.88 1.19 2.20) | 63-S-119 (0.86 1.40 1.98) | 63-S-131 (0.91 0.86 2.52) | 63-S-132 (0.82 1.11 2.27) |
| 63-S-133 (1.61 1.92 1.47) | 63-S-144 (0.95 1.83 1.56) | 63-S-150 (2.43 1.79 1.59) | 63-S-151 (2.34 2.05 1.34) |
| 63-S-152 (2.98 2.35 1.04) | 63-S-153 (2.36 1.89 1.49) | 63-S-154 (1.90 1.02 2.36) | 63-S-166 (1.62 0.84 2.54) |
| 63-S-171 (1.39 0.84 2.54) | 63-S-177 (1.44 1.57 1.81) | 63-S-183 (1.09 1.90 1.48) | 63-S-184 (2.18 1.38 2.00) |
| 63-S-192 (1.79 1.90 1.48) | 63-S-195 (1.61 1.23 2.16) | 63-S-198 (1.32 1.29 2.10) | 63-S-205 (0.84 1.35 2.04) |
| 63-S-206 (0.84 2.26 1.12) | 63-S-207 (1.36 2.21 1.18) | 63-S-208 (0.81 0.82 2.56) | 63-S-213 (1.29 1.24 2.14) |
| 63-S-231 (1.83 2.01 1.37) | 63-S-233 (1.22 1.44 1.94) | 63-S-234 (1.04 1.52 1.86) | 63-S-237 (1.05 1.82 1.57) |
| 63-S-244 (1.10 1.43 1.95) | 63-S-245 (1.02 1.20 2.18) | 63-S-246 (1.36 1.77 1.61) | 63-S-286 (0.87 1.11 2.28) |
| 63-S-305 (1.31 1.33 2.05) | 63-S-327 (1.08 1.74 1.65) | 63-S-331 (0.94 0.91 2.47) | 63-S-367 (1.36 1.89 1.49) |
| 63-S-368 (1.47 2.43 0.95) | 63-S-371 (2.52 2.03 1.35) | 63-S-395 (1.55 1.73 1.65) | 63-S-440 (1.24 1.64 1.74) |
| 63-S-441 (1.17 1.57 1.81) | 63-S-473 (1.39 1.92 1.47) | 64-S-28 (0.86 1.29 1.68) | 64-S-36 (1.02 1.80 1.16) |
| 64-S-43 (1.44 1.65 1.31) | 64-S-46 (2.03 1.17 1.79) | 64-S-70 (1.50 1.86 1.10) | 64-S-85 (1.28 0.98 1.99) |
| 64-S-89 (1.25 1.60 1.36) | 64-S-90 (1.16 1.45 1.51) | 64-S-109 (1.34 1.66 1.30) | 64-S-110 (0.83 1.30 1.66) |
| 64-S-113 (0.94 1.72 1.24) | 64-S-115 (1.21 1.28 1.69) | 64-S-133 (1.54 1.43 1.53) | 64-S-144 (0.88 1.34 1.62) |
| 64-S-150 (2.36 1.30 1.66) | 64-S-151 (2.27 1.56 1.40) | 64-S-152 (2.92 1.86 1.10) | 64-S-153 (2.30 1.40 1.56) |
| 64-S-177 (1.38 1.08 1.88) | 64-S-183 (1.02 1.42 1.54) | 64-S-184 (2.11 0.89 2.07) | 64-S-192 (1.72 1.41 1.55) |
| 64-S-207 (1.29 1.72 1.24) | 64-S-231 (1.76 1.53 1.44) | 64-S-233 (1.15 0.95 2.01) | 64-S-234 (0.97 1.03 1.93) |
| 64-S-237 (0.98 1.33 1.63) | 64-S-244 (1.03 0.94 2.02) | 64-S-246 (1.29 1.28 1.68) | 64-S-305 (1.24 0.85 2.12) |
| 64-S-327 (1.01 1.25 1.71) | 64-S-367 (1.29 1.40 1.56) | 64-S-368 (1.40 1.95 1.02) | 64-S-371 (2.45 1.55 1.42) |
| 64-S-395 (1.48 1.25 1.71) | 64-S-440 (1.17 1.16 1.81) | 64-S-441 (1.10 1.08 1.88) | 64-S-473 (1.32 1.43 1.53) |
| 66-S-27 (1.81 1.57 0.94) | 66-S-29 (1.63 1.56 0.95) | 66-S-38 (1.25 1.00 1.51) | 66-S-40 (1.45 1.56 0.95) |
| 66-S-56 (1.79 1.03 1.48) | 66-S-61 (1.78 1.55 0.96) | 66-S-65 (1.79 1.34 1.17) | 66-S-68 (1.50 1.30 1.20) |
| 66-S-83 (1.83 0.97 1.54) | 66-S-85 (2.29 1.53 0.98) | 66-S-111 (2.54 0.98 1.53) | 66-S-112 (1.74 1.35 1.15) |
| 66-S-118 (1.83 1.25 1.26) | 66-S-119 (1.80 1.47 1.04) | 66-S-123 (1.44 1.60 0.91) | 66-S-131 (1.85 0.93 1.58) |
| 66-S-132 (1.76 1.17 1.33) | 66-S-154 (2.84 1.08 1.42) | 66-S-166 (2.56 0.91 1.60) | 66-S-171 (2.33 0.91 1.60) |
| 66-S-184 (3.12 1.45 1.06) | 66-S-187 (2.27 0.82 1.69) | 66-S-193 (1.64 1.13 1.38) | 66-S-195 (2.55 1.29 1.22) |
| 66-S-198 (2.26 1.35 1.16) | 66-S-205 (1.78 1.41 1.10) | 66-S-208 (1.75 0.88 1.62) | 66-S-209 (1.49 0.96 1.55) |
| 66-S-213 (2.23 1.31 1.20) | 66-S-217 (1.65 1.34 1.17) | 66-S-218 (1.62 1.52 0.99) | 66-S-219 (1.42 1.07 1.44) |
| 66-S-222 (1.54 0.92 1.59) | 66-S-233 (2.16 1.50 1.00) | 66-S-234 (1.98 1.59 0.92) | 66-S-244 (2.04 1.50 1.01) |
| 66-S-245 (1.96 1.27 1.24) | 66-S-275 (1.37 1.48 1.03) | 66-S-285 (1.56 1.27 1.24) | 66-S-286 (1.81 1.17 1.34) |
| 66-S-287 (1.62 1.18 1.33) | 66-S-288 (1.60 1.12 1.39) | 66-S-297 (1.67 0.86 1.64) | 66-S-304 (1.73 1.18 1.32) |
| 66-S-305 (2.25 1.40 1.11) | 66-S-311 (1.57 1.07 1.44) | 66-S-312 (1.67 0.94 1.56) | 66-S-313 (1.44 1.11 1.40) |
| 66-S-331 (1.88 0.98 1.53) | 66-S-332 (1.73 1.15 1.35) | 66-S-358 (1.67 1.32 1.19) | 66-S-370 (1.64 1.39 1.12) |
| 66-S-391 (1.56 1.07 1.44) | 66-S-434 (1.57 1.37 1.13) | 71-S-27 (0.87 1.03 1.87) | 71-S-28 (0.94 1.30 1.60) |
| 71-S-36 (1.10 1.81 1.09) | 71-S-43 (1.51 1.67 1.23) | 71-S-46 (2.11 1.19 1.71) | 71-S-61 (0.85 1.01 1.90) |
| 71-S-65 (0.86 0.80 2.10) | 71-S-70 (1.57 1.88 1.02) | 71-S-79 (0.84 1.18 1.72) | 71-S-81 (0.87 1.26 1.64) |
| 71-S-85 (1.36 0.99 1.91) | 71-S-89 (1.33 1.62 1.29) | 71-S-90 (1.24 1.47 1.44) | 71-S-109 (1.41 1.68 1.22) |
| 71-S-110 (0.91 1.32 1.59) | 71-S-112 (0.80 0.81 2.09) | 71-S-113 (1.01 1.73 1.17) | 71-S-115 (1.28 1.29 1.61) |
| 71-S-119 (0.86 0.93 1.97) | 71-S-133 (1.62 1.44 1.46) | 71-S-144 (0.95 1.35 1.55) | 71-S-150 (2.44 1.31 1.59) |
| 71-S-151 (2.35 1.57 1.33) | 71-S-152 (2.99 1.87 1.03) | 71-S-153 (2.37 1.42 1.49) | 71-S-177 (1.45 1.09 1.81) |
| 71-S-183 (1.10 1.43 1.47) | 71-S-184 (2.19 0.91 1.99) | 71-S-192 (1.79 1.43 1.47) | 71-S-198 (1.33 0.81 2.09) |
| 71-S-205 (0.85 0.87 2.03) | 71-S-206 (0.84 1.78 1.12) | 71-S-207 (1.36 1.73 1.17) | 71-S-231 (1.84 1.54 1.36) |
| 71-S-233 (1.22 0.96 1.94) | 71-S-234 (1.04 1.05 1.86) | 71-S-237 (1.05 1.34 1.56) | 71-S-244 (1.11 0.96 1.94) |
| 71-S-246 (1.36 1.30 1.60) | 71-S-305 (1.31 0.86 2.04) | 71-S-327 (1.09 1.26 1.64) | 71-S-367 (1.37 1.42 1.49) |
| 71-S-368 (1.48 1.96 0.94) | 71-S-371 (2.53 1.56 1.34) | 71-S-395 (1.56 1.26 1.64) | 71-S-440 (1.24 1.17 1.73) |
| 71-S-441 (1.18 1.10 1.81) | 71-S-473 (1.40 1.44 1.46) | 72-S-27 (1.14 1.78 1.60) | 72-S-28 (1.20 2.05 1.34) |
| 72-S-29 (0.96 1.78 1.61) | 72-S-43 (1.78 2.42 0.97) | 72-S-44 (0.85 0.93 2.45) | 72-S-46 (2.37 1.94 1.45) |
| 72-S-56 (1.13 1.24 2.14) | 72-S-61 (1.11 1.76 1.63) | 72-S-62 (0.99 1.96 1.43) | 72-S-65 (1.12 1.55 1.83) |
| 72-S-68 (0.83 1.52 1.87) | 72-S-79 (1.11 1.93 1.46) | 72-S-80 (1.06 1.89 1.50) | 72-S-81 (1.14 2.01 1.38) |
| 72-S-82 (0.87 2.20 1.19) | 72-S-83 (1.17 1.19 2.20) | 72-S-85 (1.62 1.74 1.65) | 72-S-86 (0.84 2.11 1.28) |
| 72-S-89 (1.60 2.37 1.02) | 72-S-90 (1.50 2.22 1.17) | 72-S-109 (1.68 2.43 0.96) | 72-S-110 (1.17 2.07 1.32) |
| 72-S-111 (1.88 1.19 2.20) | 72-S-112 (1.07 1.57 1.82) | 72-S-113 (1.28 2.48 0.90) | 72-S-115 (1.55 2.04 1.34) |
| 72-S-118 (1.16 1.46 1.92) | 72-S-119 (1.13 1.68 1.71) | 72-S-131 (1.18 1.14 2.25) | 72-S-132 (1.10 1.39 2.00) |
| 72-S-133 (1.88 2.19 1.19) | 72-S-144 (1.22 2.10 1.28) | 72-S-150 (2.70 2.07 1.32) | 72-S-151 (2.61 2.32 1.06) |
| 72-S-153 (2.64 2.17 1.22) | 72-S-154 (2.17 1.30 2.09) | 72-S-166 (1.89 1.12 2.26) | 72-S-167 (1.75 0.81 2.58) |
| 72-S-171 (1.66 1.12 2.27) | 72-S-177 (1.72 1.85 1.54) | 72-S-183 (1.37 2.18 1.20) | 72-S-184 (2.45 1.66 1.73) |
| 72-S-187 (1.60 1.03 2.36) | 72-S-192 (2.06 2.18 1.21) | 72-S-193 (0.98 1.34 2.05) | 72-S-195 (1.88 1.50 1.88) |
| 72-S-198 (1.60 1.56 1.82) | 72-S-205 (1.12 1.62 1.76) | 72-S-207 (1.63 2.48 0.90) | 72-S-208 (1.08 1.10 2.29) |
| 72-S-209 (0.83 1.17 2.21) | 72-S-213 (1.56 1.52 1.87) | 72-S-217 (0.99 1.55 1.83) | 72-S-218 (0.96 1.73 1.66) |
| 72-S-222 (0.87 1.13 2.25) | 72-S-231 (2.10 2.29 1.09) | 72-S-233 (1.49 1.72 1.67) | 72-S-234 (1.31 1.80 1.59) |
| 72-S-237 (1.32 2.09 1.29) | 72-S-244 (1.37 1.71 1.68) | 72-S-245 (1.29 1.48 1.90) | 72-S-246 (1.63 2.05 1.34) |
| 72-S-285 (0.89 1.48 1.91) | 72-S-286 (1.14 1.38 2.00) | 72-S-287 (0.95 1.39 1.99) | 72-S-288 (0.94 1.33 2.05) |
| 72-S-297 (1.00 1.08 2.31) | 72-S-300 (1.26 0.95 2.44) | 72-S-303 (1.02 0.92 2.46) | 72-S-304 (1.06 1.40 1.99) |
| 72-S-305 (1.58 1.61 1.77) | 72-S-311 (0.90 1.28 2.10) | 72-S-312 (1.00 1.16 2.23) | 72-S-327 (1.35 2.01 1.37) |
| 72-S-331 (1.21 1.19 2.20) | 72-S-332 (1.07 1.37 2.02) | 72-S-358 (1.01 1.53 1.86) | 72-S-367 (1.63 2.17 1.22) |
| 72-S-370 (0.98 1.60 1.79) | 72-S-371 (2.80 2.31 1.07) | 72-S-391 (0.90 1.28 2.11) | 72-S-395 (1.83 2.01 1.37) |
| 72-S-430 (0.84 2.11 1.27) | 72-S-434 (0.90 1.59 1.80) | 72-S-440 (1.51 1.92 1.47) | 72-S-441 (1.44 1.85 1.54) |
| 72-S-473 (1.66 2.19 1.19) | 73-S-27 (1.04 1.81 1.71) | 73-S-28 (1.10 2.08 1.44) | 73-S-29 (0.86 1.81 1.71) |
| 73-S-36 (1.26 2.60 0.93) | 73-S-43 (1.67 2.45 1.07) | 73-S-46 (2.27 1.97 1.55) | 73-S-56 (1.02 1.28 2.25) |
| 73-S-61 (1.01 1.79 1.73) | 73-S-62 (0.89 1.99 1.53) | 73-S-65 (1.02 1.59 1.94) | 73-S-79 (1.00 1.96 1.56) |
| 73-S-80 (0.96 1.92 1.60) | 73-S-81 (1.03 2.04 1.48) | 73-S-83 (1.06 1.22 2.30) | 73-S-85 (1.52 1.77 1.75) |
| 73-S-89 (1.49 2.40 1.12) | 73-S-90 (1.40 2.25 1.27) | 73-S-109 (1.58 2.46 1.06) | 73-S-110 (1.07 2.10 1.42) |
| 73-S-111 (1.77 1.22 2.30) | 73-S-112 (0.97 1.60 1.92) | 73-S-113 (1.18 2.52 1.01) | 73-S-115 (1.45 2.07 1.45) |
| 73-S-118 (1.06 1.50 2.03) | 73-S-119 (1.03 1.71 1.81) | 73-S-131 (1.08 1.17 2.35) | 73-S-132 (0.99 1.42 2.10) |
| 73-S-133 (1.78 2.23 1.30) | 73-S-144 (1.12 2.14 1.39) | 73-S-150 (2.60 2.10 1.42) | 73-S-151 (2.51 2.36 1.17) |
| 73-S-153 (2.53 2.20 1.32) | 73-S-154 (2.07 1.33 2.19) | 73-S-166 (1.79 1.15 2.37) | 73-S-167 (1.65 0.84 2.68) |
| 73-S-171 (1.56 1.15 2.37) | 73-S-177 (1.61 1.88 1.64) | 73-S-183 (1.26 2.21 1.31) | 73-S-184 (2.35 1.69 1.83) |
| 73-S-187 (1.50 1.06 2.46) | 73-S-192 (1.96 2.21 1.31) | 73-S-193 (0.87 1.37 2.15) | 73-S-194 (1.73 0.82 2.71) |
| 73-S-195 (1.78 1.54 1.99) | 73-S-198 (1.49 1.60 1.93) | 73-S-205 (1.01 1.66 1.87) | 73-S-206 (1.01 2.57 0.95) |
| 73-S-207 (1.53 2.52 1.01) | 73-S-208 (0.98 1.13 2.39) | 73-S-213 (1.46 1.55 1.97) | 73-S-217 (0.88 1.58 1.94) |
| 73-S-218 (0.85 1.76 1.76) | 73-S-231 (2.00 2.32 1.20) | 73-S-233 (1.39 1.75 1.77) | 73-S-234 (1.21 1.83 1.69) |
| 73-S-237 (1.22 2.13 1.40) | 73-S-244 (1.27 1.74 1.78) | 73-S-245 (1.19 1.51 2.01) | 73-S-246 (1.53 2.08 1.44) |
| 73-S-286 (1.04 1.42 2.11) | 73-S-287 (0.85 1.43 2.10) | 73-S-288 (0.83 1.37 2.16) | 73-S-297 (0.90 1.11 2.41) |
| 73-S-300 (1.16 0.98 2.54) | 73-S-303 (0.92 0.95 2.57) | 73-S-304 (0.96 1.43 2.09) | 73-S-305 (1.48 1.64 1.88) |
| 73-S-312 (0.90 1.19 2.33) | 73-S-327 (1.25 2.05 1.48) | 73-S-331 (1.11 1.22 2.30) | 73-S-332 (0.96 1.40 2.12) |
| 73-S-358 (0.91 1.56 1.96) | 73-S-367 (1.53 2.20 1.32) | 73-S-370 (0.87 1.63 1.89) | 73-S-371 (2.69 2.34 1.18) |
| 73-S-395 (1.72 2.04 1.48) | 73-S-420 (0.90 2.52 1.00) | 73-S-440 (1.41 1.95 1.57) | 73-S-441 (1.34 1.88 1.64) |
| 73-S-473 (1.56 2.23 1.30) | 74-S-28 (0.92 0.96 1.61) | 74-S-36 (1.08 1.48 1.10) | 74-S-43 (1.50 1.33 1.25) |
| 74-S-46 (2.09 0.85 1.73) | 74-S-70 (1.56 1.54 1.04) | 74-S-79 (0.83 0.84 1.74) | 74-S-81 (0.86 0.92 1.65) |
| 74-S-89 (1.32 1.28 1.30) | 74-S-90 (1.23 1.13 1.45) | 74-S-109 (1.40 1.34 1.24) | 74-S-110 (0.90 0.98 1.60) |
| 74-S-113 (1.00 1.40 1.18) | 74-S-115 (1.27 0.96 1.62) | 74-S-133 (1.61 1.11 1.47) | 74-S-144 (0.94 1.02 1.56) |
| 74-S-150 (2.43 0.98 1.60) | 74-S-151 (2.33 1.24 1.34) | 74-S-152 (2.98 1.54 1.04) | 74-S-153 (2.36 1.08 1.50) |
| 74-S-183 (1.09 1.10 1.48) | 74-S-192 (1.78 1.09 1.49) | 74-S-206 (0.83 1.45 1.13) | 74-S-207 (1.35 1.40 1.18) |
| 74-S-231 (1.83 1.21 1.37) | 74-S-237 (1.04 1.01 1.57) | 74-S-246 (1.35 0.96 1.62) | 74-S-327 (1.07 0.93 1.65) |
| 74-S-367 (1.36 1.08 1.50) | 74-S-368 (1.47 1.62 0.96) | 74-S-371 (2.52 1.23 1.35) | 74-S-395 (1.55 0.93 1.65) |
| 74-S-440 (1.23 0.83 1.74) | 74-S-473 (1.39 1.11 1.47) | 75-S-27 (1.48 0.90 1.26) | 75-S-28 (1.55 1.17 0.99) |
| 75-S-29 (1.31 0.89 1.27) | 75-S-40 (1.13 0.89 1.27) | 75-S-46 (2.72 1.06 1.10) | 75-S-61 (1.46 0.88 1.28) |
| 75-S-62 (1.34 1.08 1.08) | 75-S-79 (1.45 1.05 1.11) | 75-S-80 (1.40 1.01 1.15) | 75-S-81 (1.48 1.13 1.03) |
| 75-S-85 (1.97 0.86 1.30) | 75-S-86 (1.18 1.23 0.93) | 75-S-110 (1.52 1.19 0.97) | 75-S-115 (1.89 1.16 1.00) |
| 75-S-123 (1.12 0.93 1.23) | 75-S-144 (1.56 1.22 0.94) | 75-S-150 (3.05 1.19 0.98) | 75-S-177 (2.06 0.97 1.20) |
| 75-S-218 (1.30 0.85 1.31) | 75-S-233 (1.83 0.84 1.33) | 75-S-234 (1.65 0.92 1.24) | 75-S-237 (1.66 1.21 0.95) |
| 75-S-244 (1.72 0.83 1.33) | 75-S-246 (1.97 1.17 0.99) | 75-S-275 (1.05 0.81 1.35) | 75-S-327 (1.70 1.13 1.03) |
| 75-S-341 (1.01 1.00 1.16) | 75-S-395 (2.17 1.13 1.03) | 75-S-430 (1.18 1.23 0.93) | 75-S-440 (1.86 1.04 1.12) |
| 75-S-441 (1.79 0.97 1.19) | 76-S-27 (1.81 1.35 0.93) | 76-S-29 (1.64 1.35 0.94) | 76-S-40 (1.46 1.35 0.94) |
| 76-S-56 (1.80 0.82 1.47) | 76-S-61 (1.79 1.33 0.95) | 76-S-65 (1.80 1.12 1.16) | 76-S-68 (1.51 1.09 1.19) |
| 76-S-85 (2.30 1.31 0.97) | 76-S-112 (1.74 1.14 1.15) | 76-S-118 (1.83 1.04 1.25) | 76-S-119 (1.81 1.25 1.03) |
| 76-S-123 (1.45 1.38 0.90) | 76-S-132 (1.77 0.96 1.32) | 76-S-154 (2850871.42) | 76-S-184 (3.13 1.23 1.05) |
| 76-S-193 (1.65 0.91 1.37) | 76-S-195 (2.56 1.07 1.21) | 76-S-198 (2.27 1.13 1.15) | 76-S-205 (1.79 1.19 1.09) |
| 76-S-213 (2.24 1.09 1.19) | 76-S-217 (1.66 1.12 1.16) | 76-S-218 (1.63 1.30 0.98) | 76-S-219 (1.43 0.86 1.43) |
| 76-S-233 (2.17 1.29 0.99) | 76-S-234 (1.99 1.37 0.91) | 76-S-244 (2.05 1.28 1.00) | 76-S-245 (1.97 1.05 1.23) |
| 76-S-275 (1.38 1.26 1.02) | 76-S-285 (1.57 1.05 1.23) | 76-S-286 (1.82 0.95 1.33) | 76-S-287 (1.63 0.97 1.32) |
| 76-S-288 (1.61 0.91 1.38) | 76-S-304 (1.74 0.97 1.32) | 76-S-305 (2.25 1.18 1.10) | 76-S-311 (1.58 0.85 1.43) |
| 76-S-313 (1.45 0.89 1.39) | 76-S-332 (1.74 0.94 1.35) | 76-S-358 (1.68 1.10 1.18) | 76-S-370 (1.65 1.17 1.11) |
| 76-S-391 (1.57 0.85 1.43) | 76-S-434 (1.58 1.16 1.13) | 77-S-27 (1.33 1.24 1.41) | 77-S-28 (1.39 1.51 1.15) |
| 77-S-29 (1.15 1.23 1.42) | 77-S-40 (0.98 1.23 1.42) | 77-S-46 (2.56 1.40 1.26) | 77-S-61 (1.30 1.22 1.44) |
| 77-S-62 (1.18 1.42 1.24) | 77-S-65 (1.31 1.01 1.64) | 77-S-68 (1.02 0.97 1.68) | 77-S-79 (1.30 1.39 1.27) |
| 77-S-80 (1.25 1.35 1.31) | 77-S-81 (1.33 1.47 1.19) | 77-S-82 (1.06 1.66 1.00) | 77-S-85 (1.81 1.20 1.46) |
| 77-S-86 (1.03 1.57 1.09) | 77-S-90 (1.69 1.67 0.98) | 77-S-110 (1.36 1.53 1.13) | 77-S-112 (1.26 1.02 1.63) |
| 77-S-115 (1.74 1.50 1.15) | 77-S-118 (1.35 0.92 1.73) | 77-S-119 (1.32 1.14 1.52) | 77-S-123 (0.96 1.27 1.39) |
| 77-S-132 (1.29 0.84 1.81) | 77-S-133 (2.07 1.65 1.00) | 77-S-144 (1.41 1.56 1.09) | 77-S-150 (2.89 1.52 1.13) |
| 77-S-153 (2.83 1.63 1.03) | 77-S-177 (1.91 1.30 1.35) | 77-S-183 (1.56 1.64 1.01) | 77-S-184 (2.64 1.12 1.54) |
| 77-S-192 (2.25 1.64 1.02) | 77-S-195 (2.07 0.96 1.69) | 77-S-198 (1.79 1.02 1.63) | 77-S-205 (1.31 1.08 1.57) |
| 77-S-213 (1.75 0.98 1.68) | 77-S-217 (1.18 1.01 1.64) | 77-S-218 (1.15 1.19 1.47) | 77-S-231 (2.29 1.75 0.90) |
| 77-S-233 (1.68 1.17 1.48) | 77-S-234 (1.50 1.26 1.40) | 77-S-237 (1.51 1.55 1.10) | 77-S-244 (1.56 1.17 1.49) |
| 77-S-245 (1.48 0.94 1.71) | 77-S-246 (1.82 1.51 1.15) | 77-S-275 (0.89 1.15 1.51) | 77-S-285 (1.08 0.94 1.72) |
| 77-S-286 (1.33 0.84 1.81) | 77-S-287 (1.14 0.85 1.80) | 77-S-304 (1.25 0.85 1.80) | 77-S-305 (1.77 1.07 1.58) |
| 77-S-327 (1.54 1.47 1.18) | 77-S-332 (1.26 0.82 1.83) | 77-S-341 (0.85 1.34 1.31) | 77-S-358 (1.20 0.99 1.67) |
| 77-S-367 (1.82 1.63 1.03) | 77-S-370 (1.17 1.06 1.60) | 77-S-395 (2.02 1.47 1.18) | 77-S-430 (1.03 1.57 1.08) |
| 77-S-434 (1.09 1.04 1.61) | 77-S-440 (1.70 1.38 1.28) | 77-S-441 (1.63 1.31 1.35) | 77-S-473 (1.85 1.65 1.00) |
| 78-S-27 (1.51 1.29 1.24) | 78-S-28 (1.57 1.56 0.97) | 78-S-29 (1.33 1.29 1.25) | 78-S-40 (1.15 1.28 1.25) |
| 78-S-46 (2.74 1.45 1.08) | 78-S-61 (1.48 1.27 1.26) | 78-S-62 (1.36 1.47 1.06) | 78-S-65 (1.49 1.06 1.47) |
| 78-S-68 (1.20 1.03 1.50) | 78-S-79 (1.47 1.44 1.09) | 78-S-80 (1.43 1.40 1.13) | 78-S-81 (1.50 1.52 1.01) |
| 78-S-85 (1.99 1.25 1.28) | 78-S-86 (1.21 1.62 0.91) | 78-S-110 (1.54 1.58 0.95) | 78-S-112 (1.44 1.08 1.45) |
| 78-S-115 (1.91 1.55 0.98) | 78-S-118 (1.53 0.97 1.56) | 78-S-119 (1.50 1.19 1.34) | 78-S-123 (1.14 1.32 1.21) |
| 78-S-132 (1.46 0.90 1.63) | 78-S-144 (1.59 1.61 0.92) | 78-S-150 (3.07 1.58 0.95) | 78-S-154 (2.54 0.81 1.72) |
| 78-S-177 (2.08 1.36 1.17) | 78-S-184 (2.82 1.17 1.36) | 78-S-193 (1.34 0.85 1.68) | 78-S-195 (2.25 1.01 1.52) |
| 78-S-198 (1.96 1.07 1.46) | 78-S-205 (1.48 1.13 1.40) | 78-S-213 (1.93 1.03 1.50) | 78-S-217 (1.35 1.06 1.47) |
| 78-S-218 (1.32 1.24 1.29) | 78-S-233 (1.86 1.23 1.30) | 78-S-234 (1.68 1.31 1.22) | 78-S-237 (1.69 1.60 0.93) |
| 78-S-244 (1.74 1.22 1.31) | 78-S-245 (1.66 0.99 1.54) | 78-S-246 (2.00 1.56 0.97) | 78-S-275 (1.07 1.20 1.33) |
| 78-S-285 (1.26 0.99 1.54) | 78-S-286 (1.51 0.89 1.64) | 78-S-287 (1.32 0.90 1.63) | 78-S-288 (1.30 0.84 1.69) |
| 78-S-304 (1.43 0.91 1.62) | 78-S-305 (1.95 1.12 1.41) | 78-S-313 (1.14 0.83 1.70) | 78-S-327 (1.72 1.52 1.01) |
| 78-S-332 (1.43 0.88 1.65) | 78-S-341 (1.03 1.39 1.14) | 78-S-358 (1.37 1.04 1.49) | 78-S-370 (1.34 1.11 1.42) |
| 78-S-395 (2.19 1.52 1.01) | 78-S-430 (1.20 1.62 0.91) | 78-S-434 (1.27 1.10 1.43) | 78-S-440 (1.88 1.43 1.10) |
| 78-S-441 (1.81 1.36 1.17) | 91-S-27 (1.56 2.30 1.19) | 91-S-28 (1.62 2.57 0.92) | 91-S-29 (1.38 2.29 1.20) |
| 91-S-38 (1.00 1.73 1.76) | 91-S-40 (1.20 2.29 1.20) | 91-S-44 (1.27 1.45 2.04) | 91-S-46 (2.79 2.46 1.03) |
| 91-S-56 (1.54 1.76 1.73) | 91-S-61 (1.53 2.28 1.21) | 91-S-62 (1.41 2.48 1.01) | 91-S-65 (1.54 2.07 1.42) |
| 91-S-68 (1.25 2.03 1.45) | 91-S-79 (1.52 2.45 1.04) | 91-S-80 (1.48 2.41 1.08) | 91-S-81 (1.55 2.53 0.96) |
| 91-S-83 (1.58 1.70 1.79) | 91-S-85 (2.04 2.26 1.23) | 91-S-110 (1.59 2.59 0.90) | 91-S-111 (2.29 1.71 1.78) |
| 91-S-112 (1.49 2.08 1.41) | 91-S-115 (1.96 2.56 0.93) | 91-S-118 (1.57 1.98 1.51) | 91-S-119 (1.55 2.20 1.29) |
| 91-S-123 (1.19 2.33 1.16) | 91-S-127 (1.20 1.00 2.49) | 91-S-131 (1.60 1.66 1.83) | 91-S-132 (1.51 1.90 1.58) |
| 91-S-150 (3.12 2.58 0.90) | 91-S-154 (2.59 1.81 1.68) | 91-S-158 (1.66 1.03 2.46) | 91-S-161 (2.10 1.12 2.37) |
| 91-S-166 (2.31 1.64 1.85) | 91-S-167 (2.17 1.33 2.16) | 91-S-170 (2.38 1.05 2.44) | 91-S-171 (2.08 1.64 1.85) |
| 91-S-176 (1.25 1.03 2.46) | 91-S-177 (2.13 2.36 1.12) | 91-S-182 (1.27 1.21 2.28) | 91-S-184 (2.87 2.18 1.31) |
| 91-S-187 (2.01 1.55 1.94) | 91-S-193 (1.39 1.86 1.63) | 91-S-194 (2.25 1.30 2.19) | 91-S-195 (2.30 2.02 1.47) |
| 91-S-198 (2.01 2.08 1.41) | 91-S-205 (1.53 2.14 1.35) | 91-S-208 (1.50 1.61 1.88) | 91-S-209 (1.24 1.69 1.80) |
| 91-S-213 (1.98 2.04 1.45) | 91-S-214 (1.54 1.27 2.22) | 91-S-217 (1.40 2.07 1.42) | 91-S-218 (1.37 2.25 1.24) |
| 91-S-219 (1.17 1.80 1.69) | 91-S-222 (1.29 1.65 1.84) | 91-S-233 (1.91 2.23 1.25) | 91-S-234 (1.73 2.32 1.17) |
| 91-S-236 (1.95 1.20 2.29) | 91-S-244 (1.79 2.23 1.26) | 91-S-245 (1.71 2.00 1.49) | 91-S-246 (2.04 2.57 0.92) |
| 91-S-275 (1.12 2.21 1.28) | 91-S-285 (1.31 2.00 1.49) | 91-S-286 (1.56 1.90 1.59) | 91-S-287 (1.37 1.91 1.58) |
| 91-S-288 (1.35 1.85 1.64) | 91-S-297 (1.42 1.59 1.90) | 91-S-300 (1.68 1.47 2.02) | 91-S-303 (1.44 1.44 2.05) |
| 91-S-304(1.48 1.91 1.57) | 91-S-305 (1.99 2.13 1.36) | 91-S-308 (1.47 1.08 2.41) | 91-S-311 (1.32 1.80 1.69) |
| 91-S-312 (1.42 1.67 1.81) | 91-S-313 (1.19 1.84 1.65) | 91-S-327 (1.77 2.53 0.96) | 91-S-331 (1.63 1.71 1.78) |
| 91-S-332 (1.48 1.88 1.60) | 91-S-341 (1.08 2.40 1.09) | 91-S-358 (1.42 2.05 1.44) | 91-S-360 (0.87 1.44 2.04) |
| 91-S-370 (1.39 2.12 1.37) | 91-S-391 (1.31 1.80 1.69) | 91-S-395 (2.24 2.53 0.96) | 91-S-421 (1.01 0.83 2.66) |
| 91-S-434 (1.32 2.10 1.39) | 91-S-440 (1.93 2.44 1.05) | 91-S-441 (1.86 2.37 1.12) | 94-S-27 (1.06 1.35 1.68) |
| 94-S-28 (1.13 1.62 1.41) | 94-S-29 (0.89 1.34 1.69) | 94-S-43 (1.70 1.98 1.04) | 94-S-46 (2.30 1.50 1.52) |
| 94-S-56 (1.05 0.81 2.22) | 94-S-61 (1.04 1.32 1.70) | 94-S-62 (0.92 1.52 1.51) | 94-S-65 (1.05 1.12 1.91) |
| 94-S-79 (1.03 1.50 1.53) | 94-S-80 (0.98 1.45 1.58) | 94-S-81 (1.06 1.58 1.45) | 94-S-85 (1.55 1.31 1.72) |
| 94-S-89 (1.52 1.93 1.10) | 94-S-90 (1.43 1.78 1.25) | 94-S-109 (1.60 1.99 1.03) | 94-S-110 (1.10 1.63 1.39) |
| 94-S-112 (0.99 1.13 1.90) | 94-S-113 (1.20 2.05 0.98) | 94-S-115 (1.47 1.61 1.42) | 94-S-118 (1.08 1.03 2.00) |
| 94-S-119 (1.05 1.24 1.78) | 94-S-132 (1.02 0.95 2.08) | 94-S-133 (1.81 1.76 1.27) | 94-S-144 (1.14 1.67 1.36) |
| 94-S-150 (2.63 1.63 1.40) | 94-S-151 (2.54 1.89 1.14) | 94-S-153 (2.56 1.73 1.30) | 94-S-154 (2.09 0.86 2.17) |
| 94-S-177 (1.64 1.41 1.62) | 94-S-183 (1.29 1.75 1.28) | 94-S-184 (2.38 1.22 1.80) | 94-S-192 (1.98 1.74 1.28) |
| 94-S-193 (0.90 0.91 2.12) | 94-S-195 (1.81 1.07 1.96) | 94-S-198 (1.52 1.13 1.90) | 94-S-205 (1.04 1.19 1.84) |
| 94-S-206 (1.03 2.10 0.93) | 94-S-207 (1.55 2.05 0.98) | 94-S-213 (1.49 1.08 1.94) | 94-S-217 (0.91 1.12 1.91) |
| 94-S-218 (0.88 1.29 1.73) | 94-S-231 (2.03 1.86 1.17) | 94-S-233 (1.41 1.28 1.75) | 94-S-234 (1.23 1.36 1.66) |
| 94-S-237 (1.24 1.66 1.37) | 94-S-244 (1.30 1.27 1.75) | 94-S-245 (1.22 1.05 1.98) | 94-S-246 (1.55 1.61 1.41) |
| 94-S-285 (0.82 1.04 1.98) | 94-S-286 (1.07 0.95 2.08) | 94-S-287 (0.88 0.96 2.07) | 94-S-288 (0.86 0.90 2.13) |
| 94-S-304 (0.99 0.96 2.07) | 94-S-305 (1.50 1.18 1.85) | 94-S-311 (0.82 0.85 2.18) | 94-S-327 (1.28 1.58 1.45) |
| 94-S-332 (0.99 0.93 2.10) | 94-S-358 (0.93 1.10 1.93) | 94-S-367 (1.56 1.73 1.30) | 94-S-370 (0.90 1.16 1.87) |
| 94-S-371 (2.72 1.88 1.15) | 94-S-391 (0.82 0.85 2.18) | 94-S-395 (1.75 1.58 1.45) | 94-S-420 (0.93 2.06 0.97) |
| 94-S-434 (0.83 1.15 1.88) | 94-S-440 (1.44 1.49 1.54) | 94-S-441 (1.37 1.41 1.61) | 94-S-473 (1.59 1.76 1.27) |
| 95-S-27 (1.06 1.23 1.68) | 95-S-28 (1.12 1.50 1.42) | 95-S-29 (0.88 1.23 1.69) | 95-S-36 (1.28 2.01 0.90) |
| 95-S-43 (1.70 1.87 1.05) | 95-S-46 (2.29 1.39 1.53) | 95-S-61 (1.03 1.21 1.71) | 95-S-62 (0.91 1.41 1.51) |
| 95-S-65 (1.04 1.00 1.91) | 95-S-79 (1.03 1.38 1.54) | 95-S-80 (0.98 1.34 1.58) | 95-S-81 (1.06 1.46 1.46) |
| 95-S-85 (1.54 1.19 1.73) | 95-S-89 (1.52 1.82 1.10) | 95-S-90 (1.42 1.67 1.25) | 95-S-109 (1.60 1.88 1.04) |
| 95-S-110 (1.09 1.52 1.40) | 95-S-112 (0.99 1.02 1.90) | 95-S-113 (1.20 1.93 0.98) | 95-S-115 (1.471.491.42) |
| 95-S-118 (1.08 0.91 2.00) | 95-S-119 (1.05 1.13 1.79) | 95-S-132 (1.02 0.84 2.08) | 95-S-133 (1.80 1.64 1.27) |
| 95-S-144 (1.14 1.55 1.36) | 95-S-150 (2.62 1.52 1.40) | 95-S-151 (2.53 1.78 1.14) | 95-S-153 (2.56 1.62 1.30) |
| 95-S-177 (1.64 1.30 1.62) | 95-S-183 (1.29 1.63 1.28) | 95-S- 184 (2.37 1.11 1.81) | 95-S-192 (1.98 1.63 1.29) |
| 95-S-195 (1.80 0.95 1.96) | 95-S-198 (1.52 1.01 1.90) | 95-S-205 (1.04 1.07 1.84) | 95-S-206 (1.03 1.99 0.93) |
| 95-S-207 (1.55 1.93 0.98) | 95-S-213 (1.48 0.97 1.95) | 95-S-217 (0.91 1.00 1.91) | 95-S-218 (0.88 1.18 1.74) |
| 95-S-231 (2.02 1.74 1.17) | 95-S-233 (1.41 1.17 1.75) | 95-S-234 (1.23 1.25 1.67) | 95-S-237 (1.24 1.54 1.37) |
| 95-S-244 (1.29 1.16 1.76) | 95-S-245 (1.21 0.93 1.98) | 95-S-246 (1.55 1.50 1.42) | 95-S-285 (0.81 0.93 1.99) |
| 95-S-286 (1.06 0.83 2.08) | 95-S-287 (0.87 0.85 2.07) | 95-S-304 (0.98 0.85 2.07) | 95-S-305 (1.50 1.06 1.85) |
| 95-S-327 (1.27 1.46 1.45) | 95-S-332 (0.99 0.82 2.10) | 95-S-358 (0.93 0.98 1.94) | 95-S-367 (1.55 1.62 1.30) |
| 95-S-370 (0.90 1.05 1.87) | 95-S-371 (2.72 1.76 1.15) | 95-S-395 (1.75 1.46 1.45) | 95-S-420 (0.93 1.94 0.97) |
| 95-S-434 (0.82 1.04 1.88) | 95-S-440 (1.43 1.37 1.55) | 95-S-441 (1.36 1.30 1.62) | 95-S-473 (1.58 1.64 1.27) |
| 96-S-36 (1.16 1.02 1.03) | 96-S-43 (1.57 0.87 1.17) | 96-S-70 (1.64 1.08 0.96) | 96-S-89 (1.39 0.82 1.22) |
| 96-S-109 (1.47 0.89 1.16) | 96-S-113 (1.07 0.94 1.11) | 96-S-152 (3.05 1.08 0.97) | 96-S-206 (0.91 0.99 1.06) |
| 96-S-207 (1.43 0.94 1.11) | 96-S-420 (0.80 0.95 1.10) | 97-S-27 (1.15 1.47 1.59) | 97-S-28 (1.22 1.74 1.32) |
| 97-S-29 (0.98 1.46 1.60) | 97-S-43 (1.79 2.11 0.95) | 97-S-46 (2.39 1.63 1.43) | 97-S-56 (1.14 0.93 2.13) |
| 97-S-61 (1.13 1.45 1.61) | 97-S-62 (1.00 1.65 1.42) | 97-S-65 (1.14 1.24 1.82) | 97-S-68 (0.85 1.21 1.86) |
| 97-S-79 (1.12 1.62 1.44) | 97-S-80 (1.07 1.58 1.49) | 97-S-81 (1.15 1.70 1.36) | 97-S-82 (0.88 1.89 1.18) |
| 97-S-83 (1.18 0.87 2.19) | 97-S-85 (1.64 1.43 1.63) | 97-S-86 (0.85 1.80 1.26) | 97-S-89 (1.61 2.06 1.01) |
| 97-S-90 (1.52 1.91 1.16) | 97-S-109 (1.69 2.12 0.94) | 97-S-110 (1.19 1.76 1.30) | 97-S-111 (1.89 0.88 2.19) |
| 97-S-112 (1.08 1.26 1.81) | 97-S-115 (1.56 1.73 1.33) | 97-S-118 (1.17 1.15 1.91) | 97-S-119 (1.14 1.37 1.69) |
| 97-S-131 (1.20 0.83 2.23) | 97-S-132 (1.11 1.08 1.99) | 97-S-133 (1.90 1.88 1.18) | 97-S-144 (1.23 1.79 1.27) |
| 97-S-150 (2.72 1.76 1.31) | 97-S-151 (2.63 2.01 1.05) | 97-S-153 (2.65 1.86 1.21) | 97-S-154 (2.18 0.99 2.08) |
| 97-S-166 (1.90 0.81 2.25) | 97-S-171 (1.67 0.81 2.25) | 97-S-177 (1.73 1.54 1.53) | 97-S-183 (1.38 1.87 1.19) |
| 97-S-184 (2.47 1.35 1.71) | 97-S-192 (2.07 1.87 1.19) | 97-S-193 (0.99 1.03 2.03) | 97-S-195 (1.90 1.19 1.87) |
| 97-S-198 (1.61 1.25 1.81) | 97-S-205 (1.13 1.31 1.75) | 97-S-209 (0.84 0.86 2.20) | 97-S-213 (1.58 1.21 1.85) |
| 97-S-217 (1.00 1.24 1.82) | 97-S-218 (0.97 1.42 1.64) | 97-S-222 (0.88 0.82 2.24) | 97-S-231 (2.12 1.98 1.08) |
| 97-S-233 (1.50 1.41 1.66) | 97-S-234 (1.32 1.49 1.58) | 97-S-237 (1.33 1.78 1.28) | 97-S-244 (1.39 1.40 1.66) |
| 97-S-245 (1.31 1.17 1.89) | 97-S-246 (1.64 1.74 1.32) | 97-S-285 (0.90 1.17 1.89) | 97-S-286 (1.16 1.07 1.99) |
| 97-S-287 (0.97 1.08 1.98) | 97-S-288 (0.95 1.02 2.04) | 97-S-304 (1.08 1.09 1.98) | 97-S-305 (1.59 1.30 1.76) |
| 97-S-311 (0.91 0.97 2.09) | 97-S-312 (1.01 0.85 2.22) | 97-S-327 (1.37 1.70 1.36) | 97-S-331 (1.23 0.88 2.18) |
| 97-S-332 (1.08 1.06 2.01) | 97-S-358 (1.02 1.22 1.84) | 97-S-367 (1.65 1.86 1.21) | 97-S-370 (0.99 1.29 1.78) |
| 97-S-371 (2.81 2.00 1.06) | 97-S-391 (0.91 0.97 2.09) | 97-S-395 (1.84 1.70 1.36) | 97-S-430 (0.85 1.80 1.26) |
| 97-S-434 (0.92 1.28 1.79) | 97-S-440 (1.53 1.61 1.45) | 97-S-441 (1.46 1.54 1.52) | 97-S-473 (1.68 1.88 1.18) |
| 98-S-27 (0.80 0.87 1.94) | 98-S-28 (0.87 1.13 1.67) | 98-S-36 (1.03 1.65 1.16) | 98-S-43 (1.44 1.50 1.30) |
| 98-S-46 (2.04 1.02 1.78) | 98-S-70 (1.50 1.71 1.09) | 98-S-81 (0.80 1.09 1.71) | 98-S-85 (1.29 0.82 1.98) |
| 98-S-89 (1.26 1.45 1.35) | 98-S-90 (1.17 1.30 1.51) | 98-S-109 (1.34 1.51 1.29) | 98-S-110 (0.84 1.15 1.65) |
| 98-S-113 (094 157 1.24) | 98-S-115 (1.21 1.12 1.68) | 98-S-133 (1.55 1.28 153) | 98-S-144 (0.88 1.19 1.62) |
| 98-S-150 (2.37 1.15 1.66) | 98-S-151 (2.28 1.41 1.40) | 98-S-152 (2.92 1.71 1.10) | 98-S-153 (2.30 1.25 1.55) |
| 98-S-177 (1.38 0.93 1.88) | 98-S-183 (1.03 1.27 1.54) | 98-S-192 (1.73 1.26 1.54) | 98-S-207 (1.30 1.57 1.24) |
| 98-S-231 (1.77 1.37 1.43) | 98-S-234 (0.97 0.88 1.92) | 98-S-237 (0.98 1.18 1.63) | 98-S-246 (1.29 1.13 1.67) |
| 98-S-327 (1.02 1.10 1.71) | 98-S-367 (1.30 1.25 1.55) | 98-S-368 (1.41 1.79 1.01) | 98-S-371 (2.46 1.39 1.41) |
| 98-S-395 (1.49 1.10 1.71) | 98-S-440 (1.18 1.00 1.80) | 98-S-441 (1.11 0.93 1.87) | 98-S-473 (1.33 1.28 1.53) |
| 120-S-36 (0.94 2.99 1.24) | 120-S-37 (0.94 3.29 0.94) | 120-S-43 (1.36 2.84 1.38) | 120-S-46 (1.96 2.36 1.86) |
| 120-S-70 (1.42 3.05 1.17) | 120-S-85 (1.21 2.16 2.06) | 120-S-89 (1.18 2.79 1.44) | 120-S-90 (1.09 2.64 1.59) |
| 120-S-109 (1.26 2.85 1.37) | 120-S-111 (1.46 1.61 2.62) | 120-S-113 (0.86 2.91 1.32) | 120-S-115 (1.13 2.47 1.76) |
| 120-S-133 (1.47 2.62 1.61) | 120-S-144 (0.80 2.53 1.70) | 120-S-150 (2.29 2.49 1.74) | 120-S-151 (2.20 2.75 1.48) |
| 120-S-152 (2.84 3.05 1.18) | 120-S-153 (2.22 2.59 1.64) | 120-S-154 (1.75 1.72 2.51) | 120-S-158 (0.83 0.93 3.30) |
| 120-S-161 (1.26 1.02 3.21) | 120-S-166 (1.47 1.55 2.68) | 120-S-167 (1.34 1.23 3.00) | 120-S-170 (1.54 0.96 3.27) |
| 120-S-171 (1.24 1.54 2.68) | 120-S-177 (1.30 2.27 1.96) | 120-S-183 (0.95 2.61 1.62) | 120-S-184 (2.04 2.08 2.14) |
| 120-S-187 (1.18 1.45 2.77) | 120-S-192 (1.64 2.60 1.62) | 120-S-194 (1.41 1.21 3.02) | 120-S-195 (1.47 1.93 2.30) |
| 120-S-198 (1.18 1.99 2.24) | 120-S-207 (1.21 2.91 1.32) | 120-S-213 (1.15 1.94 2.28) | 120-S-231 (1.69 2.71 1.51) |
| 120-S-233 (1.07 2.14 2.09) | 120-S-234 (0.89 2.22 2.01) | 120-S-236 (1.11 1.11 3.12) | 120-S-237 (0.90 2.52 1.71) |
| 120-S-244 (0.96 2.13 2.09) | 120-S-245 (0.88 1.91 2.32) | 120-S-246 (1.21 2.47 1.75) | 120-S-300 (0.85 1.37 2.85) |
| 120-S-305 (1.16 2.04 2.19) | 120-S-327 (0.93 2.44 1.79) | 120-S-364 (1.40 3.27 0.96) | 120-S-367 (1.22 2.59 1.64) |
| 120-S-368 (1.33 3.13 1.09) | 120-S-371 (2.38 2.74 1.49) | 120-S-395 (1.41 2.44 1.79) | 120-S-440 (1.09 2.34 1.88) |
| 120-S-441 (1.03 2.27 1.96) | 120-S-473 (1.25 2.62 1.61) | 127-S-43 (0.99 1.93 1.75) | 127-S-46 (1.59 1.45 2.23) |
| 127-S-70 (1.05 2.14 1.54) | 127-S-85 (0.84 1.26 2.43) | 127-S-89 (0.81 1.88 1.81) | 127-S-109 (0.89 1.94 1.74) |
| 127-S-133 (1.10 1.71 1.98) | 127-S-150 (1.92 1.58 2.11) | 127-S-151 (1.83 1.84 1.85) | 127-S-152 (2.47 2.14 1.55) |
| 127-S-153 (1.85 1.68 2.01) | 127-S-154 (1.38 0.81 2.88) | 127-S-177 (0.93 1.36 2.33) | 127-S-184 (1.67 1.17 2.51) |
| 127-S-192 (1.27 1.69 1.99) | 127-S-195 (1.10 1.02 2.67) | 127-S-198 (0.81 1.08 2.61) | 127-S-207 (0.84 2.00 1.69) |
| 127-S-231 (1.32 1.81 1.88) | 127-S-246 (0.84 1.56 2.12) | 127-S-364 (1.03 2.36 1.33) | 127-S-367 (0.85 1.68 2.01) |
| 127-S-368 (0.96 2.22 1.46) | 127-S-371 (2.01 1.83 1.86) | 127-S-395 (1.04 1.53 2.16) | 127-S-473 (0.88 1.71 1.98) |
| 128-S-27 (1.20 2.11 1.54) | 128-S-28 (1.26 238 1.27) | 128-S-29 (1.03 2.11 1.55) | 128-S-40(0.85 2.11 1.55) |
| 128-S-43 (1.84 2.75 0.91) | 128-S-44 (0.92 1.26 2.39) | 128-S-46 (2.43 2.27 1.39) | 128-S-56 (1.19 1.58 2.08) |
| 128-S-61 (1.17 2.09 1.57) | 128-S-62 (1.05 2.29 1.37) | 128-S-65 (1.18 1.88 1.77) | 128-S-68 (0.90 1.85 1.81) |
| 128-S-79 (1.17 2.26 1.39) | 128-S-80 (112 2.22 1.44) | 128-S-81 (1.20 2.34 1.31) | 128-S-82 (0.93 2.53 1.13) |
| 128-S-83 (1.23 1.52 2.14) | 128-S-85 (1.68 2.07 1.58) | 128-S-86 (0.90 2.44 1.21) | 128-S-89 (1.66 2.70 0.96) |
| 128-S-90 (1.57 2.55 1.11) | 128-S-110 (1.24 2.40 1.26) | 128-S-111 (1.94 1.52 2.14) | 128-S-112 (1.13 1.90 1.76) |
| 128-S-115 (1.61 2.37 1.28) | 128-S-118 (1.22 1.80 1.86) | 128-S-119 (1.19 2.01 1.65) | 128-S-123 (0.83 2.14 1.52) |
| 128-S-127 (0.85 0.82 2.84) | 128-S-131 (1.25 1.47 2.18) | 128-S-132 (1.16 1.72 1.94) | 128-S-133 (1.95 2.52 1.13) |
| 128-S-144 (1.28 2.44 1.22) | 128-S-150 (2.77 2.40 1.26) | 128-S-151 (2.67 2.66 1.00) | 128-S-153 (2.70 2.50 1.16) |
| 128-S-154 (2.23 1.63 2.03) | 128-S-158 (1.30 0.84 2.82) | 128-S-161 (1.74 0.93 2.73) | 128-S-166 (1.95 1.45 2.20) |
| 128-S-167 (1.82 1.14 2.52) | 128-S-170 (2.02 0.86 2.79) | 128-S-171 (1.72 1.45 2.21) | 128-S-176 (0.90 0.84 2.81) |
| 128-S-177 (1.78 2.18 1.48) | 128-S-182 (0.92 1.02 2.64) | 128-S-183 (1.43 2.51 1.14) | 128-S-184 (2.52 1.99 1.67) |
| 128-S-187 (1.66 1.36 2.29) | 128-S-192 (2.12 2.51 1.15) | 128-S-193 (1.04 1.67 1.98) | 128-S-194 (1.89 1.11 2.54) |
| 128-S-195 (1.95 1.83 1.82) | 128-S-198 (1.66 1.89 1.76) | 128-S-205 (1.18 1.95 1.70) | 128-S-208 (1.14 1.43 2.23) |
| 128-S-209 (0.89 1.50 2.15) | 128-S-213 (1.62 1.85 1.81) | 128-S-214 (1.19 1.08 2.57) | 128-S-217 (1.05 1.88 1.77) |
| 128-S-218 (1.02 2.06 1.60) | 128-S-219 (0.82 1.62 2.04) | 128-S-222 (0.93 1.46 2.19) | 128-S-231 (2.17 2.62 1.03) |
| 128-S-233 (1.55 2.05 1.61) | 128-S-234 (1.37 2.13 1.53) | 128-S-236 (1.59 1.02 2.64) | 128-S-237 (1.38 2.43 1.23) |
| 128-S-244 (1.44 2.04 1.62) | 128-S-245 (1.35 1.81 1.84) | 128-S-246 (1.69 2.38 1.28) | 128-S-285 (0.95 1.81 1.85) |
| 128-S-286 (1.21 1.72 1.94) | 128-S-287 (1.01 1.73 1.93) | 128-S-288 (1.00 1.67 1.99) | 128-S-297 (1.06 1.41 2.25) |
| 128-S-300 (1.33 1.28 2.38) | 128-S-303 (1.08 1.25 2.40) | 128-S-304 (1.13 1.73 1.93) | 128-S-305 (1.64 1.94 1.71) |
| 128-S-308 (1.12 0.89 2.77) | 128-S-311 (0.96 1.62 2.04) | 128-S-312 (1.06 1.49 2.17) | 128-S-313 (0.84 1.65 2.00) |
| 128-S-327 (1.41 2.35 1.31) | 128-S-331 (1.27 1.52 2.13) | 128-S-332 (1.13 1.70 1.96) | 128-S-358 (1.07 1.86 1.79) |
| 128-S-367 (1.70 2.50 1.16) | 128-S-370 (1.04 1.93 1.73) | 128-S-371 (2.86 2.64 1.01) | 128-S-391 (0.96 1.61 2.04) |
| 128-S-395 (1.89 2.34 1.31) | 128-S-430 (0.90 2.44 1.21) | 128-S-434 (0.96 1.92 1.74) | 128-S-440 (1.57 2.25 1.40) |
| 128-S-441 (1.50 2.18 1.48) | 128-S-473 (1.73 2.53 1.13) | 129-S-36 (0.80 2.60 1.38) | 129-S-37 (0.80 2.90 1.08) |
| 129-S-43 (1.22 2.45 1.53) | 129-S-46 (1.81 1.97 2.00) | 129-S-70 (1.28 2.66 1.32) | 129-S-85 (1.06 1.78 2.20) |
| 129-S-89 (1.04 2.40 1.58) | 129-S-90 (0.95 2.25 1.73) | 129-S-109 (1.12 2.46 1.52) | 129-S-111 (1.32 1.22 2.76) |
| 129-S-115 (0.99 2.08 1.90) | 129-S-133 (1.33 2.23 1.75) | 129-S-150 (2.15 2.10 1.88) | 129-S-151 (2.06 2.36 1.62) |
| 129-S-152 (2.70 2.66 1.32) | 129-S-153 (2.08 2.20 1.78) | 129-S-154 (1.61 1.33 2.65) | 129-S-166 (1.33 1.16 2.82) |
| 129-S-167 (1.20 0.84 3.14) | 129-S-171 (1.10 1.15 2.83) | 129-S-177 (1.16 1.88 2.10) | 129-S-183 (0.81 2.22 1.76) |
| 129-S-184 (1.90 1.69 2.29) | 129-S-187 (1.04 1.07 2.91) | 129-S-192 (1.50 2.21 1.77) | 129-S-194 (1.27 0.82 3.16) |
| 129-S-195 (1.33 1.54 2.44) | 129-S-198 (1.04 1.60 2.38) | 129-S-207 (1.07 2.52 1.46) | 129-S-213 (1.01 1.55 2.43) |
| 129-S-231 (1.55 2.33 1.65) | 129-S-233 (0.93 1.75 2.23) | 129-S-244 (0.82 1.74 2.24) | 129-S-246 (1.07 2.08 1.90) |
| 129-S-305 (1.02 1.65 2.33) | 129-S-364 (1.26 2.88 1.10) | 129-S-367 (1.08 2.20 1.78) | 129-S-368 (1.19 2.74 1.23) |
| 129-S-371 (2.24 2.35 1.63) | 129-S-395 (1.27 2.05 1.93) | 129-S-440 (0.95 1.96 2.02) | 129-S-441 (0.88 1.88 2.10) |
| 129-S-473 (1.11 2.23 1.75) | 149-S-27 (0.89 1.47 1.85) | 149-S-28 (0.95 1.74 1.58) | 149-S-36 (1.11 2.25 1.07) |
| 149-S-43 (1.53 2.11 1.22) | 149-S-46 (2.12 1.63 1.70) | 149-S-56 (0.88 0.93 2.39) | 149-S-61 (0.86 1.45 1.88) |
| 149-S-65 (0.87 1.24 2.08) | 149-S-70 (1.59 2.32 1.01) | 149-S-79 (0.86 1.62 1.71) | 149-S-80 (0.81 1.58 1.75) |
| 149-S-81 (0.89 1.70 1.62) | 149-S-83 (0.92 0.87 2.45) | 149-S-85 (1.37 1.43 1.90) | 149-S-89 (1.35 2.06 1.27) |
| 149-S-90 (1.26 1.91 1.42) | 149-S-109 (1.43 2.12 1.21) | 149-S-110 (0.92 1.76 1.57) | 149-S-111 (1.63 0.88 2.45) |
| 149-S-112 (0.82 1.25 2.07) | 149-S-113 (1.03 2.17 1.15) | 149-S-115 (1.30 1.73 1.59) | 149-S-118(0.91 1.15 2.17) |
| 149-S-119 (0.88 1.37 1.96) | 149-S-131 (0.93 0.83 2.50) | 149-S-132 (0.85 1.08 2.25) | 149-S-133 (1.64 1.88 1.44) |
| 149-S-144 (0.97 1.79 1.53) | 149-S-150 (2.46 1.76 1.57) | 149-S-151 (2.36 2.01 1.31) | 149-S-152 (3.01 2.31 1.01) |
| 149-S-153 (2.39 1.86 1.47) | 149-S-154 (1.92 0.98 2.34) | 149-S-166 (1.64 0.81 2.51) | 149-S-171 (1.41 0.81 2.52) |
| 149-S-177 (1.47 1.54 1.79) | 149-S-183 (1.12 1.87 1.45) | 149-S-184 (2.20 1.35 1.98) | 149-S-192 (1.81 1.87 1.46) |
| 149-S-195 (1.64 1.19 2.13) | 149-S-198 (1.35 1.25 2.07) | 149-S-205 (0.87 1.31 2.01) | 149-S-206 (0.86 2.23 1.10) |
| 149-S-207 (1.38 2.17 1.15) | 149-S-213 (1.31 1.21 2.12) | 149-S-231 (1.85 1.98 1.34) | 149-S-233 (1.24 1.41 1.92) |
| 149-S-234 (1.06 1.49 1.84) | 149-S-237 (1.07 1.78 1.54) | 149-S-244 (1.13 1.40 1.93) | 149-S-245 (1.04 1.17 2.15) |
| 149-S-246 (1.38 1.74 1.59) | 149-S-286 (0.90 1.07 2.25) | 149-S-304 (0.81 1.09 2.24) | 149-S-305 (1.33 1.30 2.02) |
| 149-S-327 (1.10 1.70 1.62) | 149-S-331 (0.96 0.88 2.44) | 149-S-332 (0.82 1.06 2.27) | 149-S-367 (1.38 1.86 1.47) |
| 149-S-368 (1.50 2.40 0.93) | 149-S-371 (2.55 2.00 1.32) | 149-S-395 (1.58 1.70 1.62) | 149-S-440(1.26 1.61 1.71) |
| 149-S-441 (1.19 1.54 1.79) | 149-S-473 (1.41 1.88 1.44) | 156-S-36 (0.94 3.39 1.25) | 156-S-37 (0.93 3.69 0.95) |
| 156-S-43 (1.35 3.24 1.39) | 156-S-46 (1.95 2.76 1.87) | 156-S-70 (1.42 3.45 1.18) | 156-S-85 (1.20 2.56 2.07) |
| 156-S-89(1.17 3.19 1.44) | 156-S-90 (1.08 3.04 1.59) | 156-S-109 (1.25 3.25 1.38) | 156-S-111 (1.45 2.01 2.62) |
| 156-S-113 (0.85 3.31 1.33) | 156-S-115 (1.12 2.87 1.77) | 156-S-133 (1.46 3.02 1.62) | 156-S-150 (2.28 2.89 1.75) |
| 156-S-151 (2.19 3.15 1.49) | 156-S-152 (2.83 3.45 1.19) | 156-S-153 (2.21 2.99 1.64) | 156-S-154 (1.75 2.12 2.52) |
| 156-S-158 (0.82 1.33 3.30) | 156-S-160 (1.24 0.83 3.80) | 156-S-161 (1.26 1.42 3.21) | 156-S-166 (1.47 1.95 2.69) |
| 156-S-167 (1.33 1.63 3.00) | 156-S-168 (0.89 0.92 3.72) | 156-S-170 (1.54 1.36 3.28) | 156-S-171 (1.24 1.94 2.69) |
| 156-S-177 (1.29 2.67 1.97) | 156-S-183 (0.94 3.01 1.63) | 156-S-184 (2.03 2.48 2.15) | 156-S-187 (1.17 1.85 2.78) |
| 156-S-192 (1.64 3.00 1.63) | 156-S-194(1.41 161 303) | 156-S-195 (1.46 2.33 2.31) | 156-S-198 (1.17 2.39 2.25) |
| 156-S-207 (1.21 3.31 1.33) | 156-S-213 (1.14 2.34 2.29) | 156-S-231 (1.68 3.12 1.52) | 156-S-233 (1.06 2.54 2.10) |
| 156-S-234 (0.88 2.62 2.01) | 156-S-236 (1.11 1.51 3.13) | 156-S-237 (0.90 2.92 1.72) | 156-S-244 (0.95 2.53 2.10) |
| 156-S-245 (0.87 2.31 2.33) | 156-S-246 (1.20 2.87 1.76) | 156-S-300 (0.84 1.77 2.86) | 156-S-305 (1.15 2.44 2.20) |
| 156-S-327 (0.93 2.84 1.80) | 156-S-338 (1.04 0.85 3.79) | 156-S-364 (1.39 3.67 0.97) | 156-S-367 (1.21 2.99 1.64) |
| 156-S-368 (1.32 3.53 1.10) | 156-S-371 (2.37 3.14 1.50) | 156-S-395 (1.40 2.84 1.80) | 156-S-440 (1.09 2.74 1.89) |
| 156-S-441 (1.02 2.67 1.96) | 156-S-473 (1.24 3.02 1.62) | 199-S-27 (1.31 1.34 1.43) | 199-S-28 (1.38 1.61 1.16) |
| 199-S-29 (1.14 1.33 1.44) | 199-S-40 (0.96 1.33 1.44) | 199-S-46 (2.55 1.49 1.27) | 199-S-61 (1.29 1.31 1.45) |
| 199-S-62 (1.17 1.51 1.25) | 199-S-65 (1.30 1.11 1.66) | 199-S-68 (1.01 1.07 1.70) | 199-S-79 (1.28 1.48 1.28) |
| 199-S-80 (1.24 1.44 1.32) | 199-S-81 (1.31 1.56 1.20) | 199-S-82 (1.04 1.75 1.01) | 199-S-85 (1.80 1.29 1.47) |
| 199-S-86 (1.01 1.66 1.10) | 199-S-90 (1.68 1.77 0.99) | 199-S-110 (1.35 1.62 1.14) | 199-S-112 (1.24 1.12 1.65) |
| 199-S-115 (1.72 1.60 1.17) | 199-S-118 (1.33 1.02 1.75) | 199-S-119 (1.31 1.23 1.53) | 199-S-123 (0.95 1.36 1.40) |
| 199-S-132 (1.27 0.94 1.83) | 199-S-133 (2.06 1.75 1.02) | 199-S-144 (1.39 1.66 1.11) | 199-S-150 (2.88 1.62 1.15) |
| 199-S-153 (2.81 1.72 1.04) | 199-S-154 (2.35 0.85 1.92) | 199-S-177 (1.89 1.40 1.37) | 199-S-183 (1.54 1.74 1.03) |
| 199-S-184 (2.63 1.21 1.55) | 199-S-192 (2.24 1.73 1.03) | 199-S-193 (1.15 0.90 1.87) | 199-S-195 (2.06 1.06 1.71) |
| 199-S-198 (1.77 1.12 1.65) | 199-S-205 (1.29 1.18 1.59) | 199-S-213 (1.74 1.07 1.69) | 199-S-217 (1.16 1.11 1.66) |
| 199-S-218 (1.13 1.28 1.48) | 199-S-219 (0.93 0.84 1.93) | 199-S-231 (2.28 1.85 0.92) | 199-S-233 (1.66 1.27 1.50) |
| 199-S-234 (1.48 1.35 1.41) | 199-S-237 (1.50 1.65 1.12) | 199-S-244 (1.55 1.26 1.50) | 199-S-245 (1.47 1.04 1.73) |
| 199-S-246 (1.80 1.60 1.16) | 199-S-275 (0.88 1.24 1.52) | 199-S-285 (1.07 1.03 1.73) | 199-S-286 (1.32 0.94 1.83) |
| 199-S-287 (1.13 0.95 1.82) | 199-S-288 (1.11 0.89 1.88) | 199-S-304 (1.24 0.95 1.82) | 199-S-305 (1.75 1.17 1.60) |
| 199-S-311 (1.08 0.84 1.93) | 199-S-313 (0.95 0.88 1.89) | 199-S-327 (1.53 1.57 1.20) | 199-S-332 (1.24 0.92 1.85) |
| 199-S-341 (0.84 1.44 1.33) | 199-S-358 (1.18 1.08 1.68) | 199-S-367 (1.81 1.72 1.04) | 199-S-370 (1.15 1.15 1.61) |
| 199-S-391 (1.07 0.83 1.93) | 199-S-395 (2.00 1.57 1.20) | 199-S-430 (1.01 1.67 1.10) | 199-S-434 (1.08 1.14 1.63) |
| 199-S-440 (1.69 1.47 1.29) | 199-S-441 (1.62 1.40 1.36) | 199-S-473 (1.84 1.75 1.02) | 200-S-27 (0.85 1.38 1.89) |
| 200-S-28 (0.92 1.65 1.62) | 200-S-36 (1.07 2.16 1.11) | 200-S-43 (1.49 2.01 1.26) | 200-S-46 (2.08 1.53 1.73) |
| 200-S-56 (0.84 0.84 2.43) | 200-S-61 (0.82 1.35 1.92) | 200-S-65 (0.84 1.15 2.12) | 200-S-70 (1.55 2.22 1.05) |
| 200-S-79 (0.82 1.52 1.74) | 200-S-81 (0.85 1.61 1.66) | 200-S-85 (1.33 1.34 1.93) | 200-S-89 (1.31 1.96 1.31) |
| 200-S-90 (1.22 1.81 1.46) | 200-S-109 (1.39 2.02 1.24) | 200-S-110 (0.89 1.66 1.61) | 200-S-113 (0.99 2.08 1.19) |
| 200-S-115 (1.26 1.64 1.63) | 200-S-118 (0.87 1.06 2.21) | 200-S-119 (0.84 1.27 2.00) | 200-S-132 (0.81 0.98 2.29) |
| 200-S-133 (1.60 1.79 1.48) | 200-S-144 (0.93 1.70 1.57) | 200-S-150 (2.42 1.66 1.61) | 200-S-151 (2.33 1.92 1.35) |
| 200-S-152 (2.97 2.22 1.05) | 200-S-153 (2.35 1.76 1.51) | 200-S-154 (1.88 0.89 2.38) | 200-S-177 (1.43 1.44 1.83) |
| 200-S-183 (1.08 1.78 1.49) | 200-S-184 (2.17 1.25 2.02) | 200-S-192 (1.77 1.77 1.50) | 200-S-195 (1.60 1.10 2.17) |
| 200-S-198 (1.31 1.16 2.11) | 200-S-205 (0.83 1.22 2.05 | 200-S-206 (0.82 2.13 1.14) | 200-S-207 (1.34 2.08 1.19) |
| 200-S-213 (1.28 1.11 2.16) | 200-S-231 (1.82 1.89 1.38) | 200-S-233 (1.20 1.31 1.96) | 200-S-234 (1.02 1.39 1.88) |
| 200-S-237 (1.03 1.69 1.58) | 200-S-244 (1.09 1.30 1.96) | 200-S-245 (1.01 1.08 2.19) | 200-S-246 (1.34 1.64 1.63) |
| 200-S-286 (0.86 0.98 2.29) | 200-S-305 (1.29 1.21 2.06) | 200-S-327 (1.06 1.61 1.66) | 200-S-367 (1.35 1.76 1.51) |
| 200-S-368 (1.46 2.30 0.96) | 200-S-371 (2.51 1.91 1.36) | 200-S-395 (1.54 1.61 1.66) | 200-S-440 (1.22 1.52 1.75) |
| 200-S-441 (1.15 1.44 1.83) | 200-S-473 (1.38 1.79 1.48) | 223-S-27 (1.02 1.71 1.72) | 223-S-28 (1.09 1.97 1.45) |
| 223-S-29 (0.85 1.70 1.73) | 223-S-36 (1.24 2.49 0.94) | 223-S-43 (1.66 2.34 1.09) | 223-S-46 (2.26 1.86 1.56) |
| 223-S-56 (1.01 1.17 2.26) | 223-S-61 (1.00 1.68 1.75) | 223-S-62 (0.87 1.88 1.55) | 223-S-65 (1.01 1.48 1.95) |
| 223-S-79 (0.99 1.85 1.57) | 223-S-80 (0.94 1.81 1.62) | 223-S-81 (1.02 1.93 1.49) | 223-S-83 (1.05 1.11 2.32) |
| 223-S-85 (1.50 1.66 1.76) | 223-S-89 (1.48 2.29 1.14) | 223-S-90 (1.39 2.14 1.29) | 223-S-109 (1.56 2.35 1.07) |
| 223-S-110 (1.06 1.99 1.44) | 223-S-111 (1.76 1.11 2.32) | 223-S-112 (0.95 1.49 1.94) | 223-S-113 (1.16 2.41 1.02) |
| 223-S-115 (1.43 1.96 1.46) | 223-S-118 (1.04 1.39 2.04) | 223-S-119 (1.01 1.60 1.83) | 223-S-131 (1.07 1.06 2.36) |
| 223-S-132 (0.98 1.31 2.12) | 223-S-133 (1.77 2.12 1.31) | 223-S-144 (1.10 2.03 1.40) | 223-S-150 (2.59 1.99 1.44) |
| 223-S-151 (2.50 2.25 1.18) | 223-S-153 (2.52 2.09 1.34) | 223-S-154 (2.05 1.22 2.21) | 223-S-166 (1.77 1.05 2.38) |
| 223-S-171 (1.54 1.04 2.38) | 223-S-177 (1.60 1.77 1.66) | 223-S-183 (1.25 2.11 1.32) | 223-S-184 (2.34 1.58 1.85) |
| 223-S-187 (1.48 0.95 2.47) | 223-S-192 (1.94 2.10 1.32) | 223-S-193 (0.86 1.26 2.16) | 223-S-195 (1.77 1.43 2.00) |
| 223-S-198 (1.48 1.49 1.94) | 223-S-205 (1.00 1.55 1.88) | 223-S-206 (0.99 2.46 0.97) | 223-S-207 (1.51 2.41 1.02) |
| 223-S-208 (0.96 1.02 2.41) | 223-S-213 (1.45 1.44 1.98) | 223-S-217 (0.87 1.47 1.95) | 223-S-218 (0.84 1.65 1.77) |
| 223-S-231 (1.99 2.21 1.21) | 223-S-233 (1.37 1.64 1.79) | 223-S-234 (1.19 1.72 1.71) | 223-S-237 (1.20 2.02 1.41) |
| 223-S-244 (1.26 1.63 1.79) | 223-S-245 (1.18 1.41 2.02) | 223-S-246 (1.51 1.97 1.45) | 223-S-286 (1.03 1.31 2.12) |
| 223-S-287 (0.83 1.32 2.11) | 223-S-288 (0.82 1.26 2.17) | 223-S-297 (0.88 1.00 2.43) | 223-S-300 (1.15 0.87 2.55) |
| 223-S-303 (0.91 0.85 2.58) | 223-S-304 (0.95 1.32 2.11) | 223-S-305 (1.46 1.54 1.89) | 223-S-312 (0.88 1.08 2.35) |
| 223-S-327 (1.23 1.94 1.49) | 223-S-331 (1.09 1.11 2.31) | 223-S-332 (0.95 1.29 2.14) | 223-S-358 (0.89 1.45 1.97) |
| 223-S-367 (1.52 2.09 1.34) | 223-S-370 (0.86 1.52 1.91) | 223-S-371 (2.68 2.24 1.19) | 223-S-395 (1.71 1.94 1.49) |
| 223-S-420 (0.89 2.41 1.01) | 223-S-440 (1.39 1.84 1.58) | 223-S-441 (1.32 1.77 1.66) | 223-S-473 (1.55 2.12 1.31) |
| 239-S-46 (1.35 1.69 2.47) | 239-S-70 (0.81 2.38 1.78) | 239-S-111 (0.85 0.94 3.22) | 239-S-133 (0.86 1.94 2.22) |
| 239-S-150 (1.68 1.81 2.35) | 239-S-151 (1.59 2.07 2.09) | 239-S-152 (2.23 2.37 1.79) | 239-S-153 (1.61 1.92 2.24) |
| 239-S-154 (1.14 1.04 3.12) | 239-S-166 (0.87 0.87 3.29) | 239-S-184 (1.43 1.41 2.75) | 239-S-192 (1.04 1.93 2.23) |
| 239-S-195 (0.86 1.25 2.91) | 239-S-231 (1.08 2.04 2.12) | 239-S-371 (1.77 2.06 2.10) | 239-S-395 (0.80 1.76 2.40) |
| 239-S-429 (2.17 3.16 1.00) | 242-S-27 (0.84 1.73 1.91) | 242-S-28 (0.90 2.00 1.64) | 242-S-36 (1.06 2.51 1.13) |
| 242-S-43 (1.47 2.37 1.27) | 242-S-46 (2.07 1.89 1.75) | 242-S-56 (0.82 1.19 2.45) | 242-S-61 (0.81 1.71 1.93) |
| 242-S-65 (0.82 1.50 2.14) | 242-S-70 (1.54 2.58 1.06) | 242-S-79 (0.80 1.88 1.76) | 242-S-81 (0.83 1.96 1.68) |
| 242-S-83 (0.86 1.13 2.50) | 242-S-85 (1.32 1.69 1.95) | 242-S-89 (1.29 2.32 1.32) | 242-S-90 (1.20 2.17 1.47) |
| 242-S-109 (1.38 2.38 1.26) | 242-S-110 (0.87 2.02 1.62) | 242-S-111 (1.57 1.14 2.50) | 242-S-113 (0.98 2.43 1.21) |
| 242-S-115 (1.25 1.99 1.65) | 242-S-118 (0.86 1.41 2.23) | 242-S-119 (0.83 1.63 2.01) | 242-S-131 (0.88 1.09 2.55) |
| 242-S-133 (1.58 2.14 1.50) | 242-S-144 (0.92 2.05 1.59) | 242-S-150 (2.40 2.01 1.62) | 242-S-151 (2.31 2.27 1.37) |
| 242-S-152 (2.95 2.57 1.07) | 242-S-153 (2.33 2.12 1.52) | 242-S-154 (1.87 1.24 2.39) | 242-S-166 (1.59 1.07 2.57) |
| 242-S-171 (1.36 1.07 2.57) | 242-S-177 (1.41 1.79 1.84) | 242-S-183 (1.06 2.13 1.51) | 242-S-184 (2.15 1.61 2.03) |
| 242-S-187 (1.30 0.98 2.66) | 242-S-192 (1.76 2.13 1.51) | 242-S-195 (1.58 1.45 2.19) | 242-S-198 (1.29 1.51 2.13) |
| 242-S-205 (0.81 1.57 2.07) | 242-S-206 (0.81 2.48 1.15) | 242-S-207 (1.33 2.43 1.21) | 242-S-213 (1.26 1.47 2.17) |
| 242-S-231 (1.80 2.24 1.40) | 242-S-233 (1.19 1.66 1.97) | 242-S-234 (1.01 1.75 1.89) | 242-S-237 (1.02 2.04 1.60) |
| 242-S-244 (1.07 1.66 1.98) | 242-S-245 (0.99 1.43 2.21) | 242-S-246 (1.33 2.00 1.64) | 242-S-286 (0.84 1.33 2.31) |
| 242-S-300 (0.96 0.90 2.74) | 242-S-305 (1.28 1.56 2.08) | 242-S-327 (1.05 1.96 1.68) | 242-S-331 (0.91 1.14 2.50) |
| 242-S-367 (1.33 2.12 1.52) | 242-S-368 (1.44 2.66 0.98) | 242-S-371 (2.49 2.26 1.38) | 242-S-395 (1.52 1.96 1.68) |
| 242-S-440 (1.21 1.87 1.77) | 242-S-441 (1.14 1.80 1.84) | 242-S-473 (1.36 2.14 1.50) | 317-S-27 (1.13 1.52 1.61) |
| 317-S-28 (1.20 1.78 1.34) | 317-S-29 (0.96 1.51 1.62) | 317-S-43 (1.77 2.15 0.97) | 317-S-46 (2.37 1.67 1.45) |
| 317-S-56 (1.12 0.98 2.15) | 317-S-61 (1.11 1.49 1.63) | 317-S-62 (0.99 1.69 1.43) | 317-S-65 (1.12 1.29 1.84) |
| 317-S-68 (0.83 1.25 1.88) | 317-S-79 (1.10 1.66 1.46) | 317-S-80 (1.05 1.62 1.50) | 317-S-81 (1.13 1.74 1.38) |
| 317-S-82 (0.86 1.93 1.20) | 317-S-83 (1.16 0.92 2.21) | 317-S-85 (1.62 1.47 1.65) | 317-S-86 (0.83 1.84 1.28) |
| 317-S-89 (1.59 2.10 1.03) | 317-S-90 (1.50 1.95 1.18) | 317-S-109 (1.67 2.16 0.96) | 317-S-110 (1.17 1.80 1.32) |
| 317-S-111 (1.87 0.92 2.20) | 317-S-112 (1.06 1.30 1.83) | 317-S-113 (1.27 2.22 0.91) | 317-S-115 (1.54 1.77 1.35) |
| 317-S-118 (1.15 1.20 1.93) | 317-S-119 (1.13 1.41 1.71) | 317-S-131 (1.18 0.87 2.25) | 317-S-132 (1.09 1.12 2.01) |
| 317-S-133 (1.88 1.93 1.20) | 317-S-144 (1.21 1.84 1.29) | 317-S-150 (2.70 1.80 1.33) | 317-S-151 (2.61 2.06 1.07) |
| 317-S-153 (2.63 1.90 1.22) | 317-S-154 (2.16 1.03 2.10) | 317-S-166 (1.89 0.86 2.27) | 317-S-171 (1.66 0.85 2.27) |
| 317-S-177 (1.71 1.58 1.55) | 317-S-183 (1.36 1.92 1.21) | 317-S-184 (2.45 1.39 1.73) | 317-S-192 (2.06 1.91 1.21) |
| 317-S-193 (0.97 1.07 2.05) | 317-S-195 (1.88 1.24 1.89) | 317-S-198 (1.59 1.30 1.83) | 317-S-205 (1.11 1.36 1.77) |
| 317-S-207 (1.62 2.22 0.91) | 317-S-208 (1.07 0.83 2.30) | 317-S-209 (0.82 0.91 2.22) | 317-S-213 (1.56 1.25 1.87) |
| 317-S-217 (0.98 1.28 1.84) | 317-S-218 (0.95 1.46 1.66) | 317-S-222 (0.86 0.87 2.26) | 317-S-231 (2.10 2.02 1.10) |
| 317-S-233 (1.48 1.45 1.68) | 317-S-234 (1.30 1.53 1.59) | 317-S-237 (1.31 1.83 1.30) | 317-S-244 (1.37 1.44 1.68) |
| 317-S-245 (1.29 1.22 1.91) | 317-S-246 (1.62 1.78 1.34) | 317-S-285 (0.89 1.21 191) | 317-S-286 (1.14 1.12 2.01) |
| 317-S-287 (0.95 1.13 2.00) | 317-S-288 (0.93 1.07 2.06) | 317-S-297 (0.99 0.81 2.32) | 317-S-304 (1.06 1.13 2.00) |
| 317-S-305 (1.57 1.35 1.78) | 317-S-311 (0.89 1.02 2.11) | 317-S-312 (0.99 0.89 2.24) | 317-S-327 (1.35 1.75 1.38) |
| 317-S-331 (1.21 0.92 2.20) | 317-S-332 (1.06 1.10 2.03) | 317-S-358 (1.00 1.26 1.86) | 317-S-367 (1.63 1.90 1.22) |
| 317-S-370 (0.97 1.33 1.79) | 317-S-371 (2.79 2.05 1.08) | 317-S-391 (0.89 1.01 2.11) | 317-S-395 (1.82 1.75 1.38) |
| 317-S-420 (1.00 2.22 0.90) | 317-S-430 (0.83 1.85 1.28) | 317-S-434 (0.90 1.32 1.81) | 317-S-440 (1.51 1.65 1.47) |
| 317-S-441 (1.44 1.58 1.54) | 317-S-473 (1.66 1.93 1.20) | 328-S-36 (0.88 2.05 1.30) | 328-S-37 (0.88 2.35 1.00) |
| 328-S-43 (1.30 1.90 1.45) | 328-S-46 (1.89 1.42 1.92) | 328-S-70 (1.36 2.11 1.24) | 328-S-85 (1.14 1.22 2.12) |
| 328-S-89 (1.12 1.85 1.50) | 328-S-90 (1.03 1.70 1.65) | 328-S-109 (1.20 1.91 1.43) | 328-S-113 (0.80 1.97 1.38) |
| 328-S-115 (1.07 1.53 1.82) | 328-S-133 (1.41 1.68 1.67) | 328-S-150 (2.23 1.55 1.80) | 328-S-151 (2.14 1.81 1.54) |
| 328-S-152 (2.78 2.11 1.24) | 328-S-153 (2.16 1.65 1.70) | 328-S-177 (1.24 1.33 2.02) | 328-S-183 (0.89 1.67 1.68) |
| 328-S-184 (1.98 1.14 2.21) | 328-S-192 (1.58 1.66 1.69) | 328-S-195 (1.41 0.99 2.36) | 328-S-198 (1.12 1.05 2.30) |
| 328-S-207 (1.15 1.97 1.38) | 328-S-213 (1.09 1.00 2.35) | 328-S-231 (1.63 1.78 1.57) | 328-S-233 (1.01 1.20 2.15) |
| 328-S-234 (0.83 1.28 2.07) | 328-S-237 (0.84 1.58 1.77) | 328-S-244 (0.90 1.19 2.15) | 328-S-245 (0.82 0.97 2.38) |
| 328-S-246 (1.15 1.53 1.82) | 328-S-305 (1.10 1.10 2.25) | 328-S-327 (0.87 1.50 1.85) | 328-S-364 (1.34 2.33 1.02) |
| 328-S-367 (1.16 1.65 1.70) | 328-S-368 (1.27 2.19 1.15) | 328-S-371 (2.32 1.80 1.55) | 328-S-395 (1.35 1.50 1.85) |
| 328-S-440 (1.03 1.41 1.94) | 328-S-441 (0.96 1.33 2.02) | 328-S-473 (1.19 1.68 1.67) | 330-S-43 (1.10 1.40 1.65) |
| 330-S-46 (1.69 0.92 2.13) | 330-S-70 (1.16 1.61 1.44) | 330-S-89 (0.91 1.35 1.70) | 330-S-90 (0.82 1.20 1.85) |
| 330-S-93 (0.89 2.09 0.96) | 330-S-109 (1.00 1.41 1.64) | 330-S-115 (0.87 1.02 2.03) | 330-S-133 (1.20 1.17 1.87) |
| 330-S-150 (2.02 1.05 2.00) | 330-S-151 (1.93 1.31 1.74) | 330-S-152 (2.58 1.60 1.44) | 330-S-153 (1.96 1.15 1.90) |
| 330-S-177 (1.04 0.83 2.22) | 330-S-192 (1.38 1.16 1.89) | 330-S-207 (0.95 1.46 1.58) | 330-S-231 (1.42 1.27 1.78) |
| 330-S-246 (0.95 1.03 2.02) | 330-S-364 (1.14 1.83 1.22) | 330-S-367 (0.95 1.15 1.90) | 330-S-368 (1.06 1.69 1.36) |
| 330-S-371 (2.11 1.29 1.76) | 330-S-395 (1.14 0.99 2.06) | 330-S-440 (0.83 0.90 2.15) | 330-S-473 (0.98 1.17 1.87) |
| 331-S-150 (1.49 0.88 2.53) | 331-S-151 (1.40 1.13 2.27) | 331-S-152 (2.05 1.43 1.97) | 331-S-153 (1.43 0.98 2.43) |
| 331-S-192 (0.85 0.99 2.42) | 331-S-231 (0.89 1.10 2.31) | 331-S-371 (1.58 1.12 2.29) | 331-S-429 (1.99 2.22 1.18) |
| 337-S-27 (1.22 1.78 1.53) | 337-S-28 (1.28 2.05 1.26) | 337-S-29 (1.04 1.77 1.53) | 337-S-40 (0.86 1.77 1.54) |
| 337-S-44 (0.93 0.93 2.38) | 337-S-46 (2.45 1.94 1.37) | 337-S-56 (1.21 1.24 2.07) | 337-S-61 (1.19 1.76 1.55) |
| 337-S-62 (1.07 1.96 1.35) | 337-S-65 (1.20 1.55 1.76) | 337-S-68 (0.91 1.51 1.79) | 337-S-79 (1.18 1.93 1.38) |
| 337-S-80 (1.14 1.89 1.42) | 337-S-81 (1.21 2.01 1.30) | 337-S-82 (0.95 2.20 1.11) | 337-S-83 (1.24 1.18 2.12) |
| 337-S-85 (1.70 1.74 1.57) | 337-S-86 (0.92 2.11 1.20) | 337-S-89 (1.67 2.37 0.94) | 337-S-90 (1.58 2.22 1.09) |
| 337-S-110 (1.25 2.07 1.24) | 337-S-111 (1.95 1.192.12) | 337-S-112 (1.15 1.56 1.74) | 337-S-115 (1.63 2.04 1.27) |
| 337-S-118 (1.24 1.46 1.85) | 337-S-119 (1.21 1.68 1.63) | 337-S-123 (0.85 1.81 1.50) | 337-S-131 (1.26 1.14 2.17) |
| 337-S-132 (1.17 1.38 1.92) | 337-S-133 (1.96 2.19 1.12) | 337-S-144 (1.30 2.10 1.21) | 337-S-150 (2.78 2.07 1.24) |
| 337-S-151 (2.69 2.32 0.98) | 337-S-153 (2.71 2.17 1.14) | 337-S-154 (2.25 1.29 2.01) | 337-S-166 (1.97 1.12 2.19) |
| 337-S-167 (1.83 0.81 2.50) | 337-S-171 (1.74 1.122.19) | 337-S-177 (1.79 1.85 1.46) | 337-S-183 (1.44 2.18 1.13) |
| 337-S-184 (2.53 1.66 1.65) | 337-S-187 (1.68 1.03 2.28) | 337-S-192 (2.14 2.18 1.13) | 337-S-193 (1.06 1.34 1.97) |
| 337-S-195 (1.96 1.50 1.81) | 337-S-198 (1.67 1.56 1.75) | 337-S-205 (1.19 1.62 1.69) | 337-S-208 (1.16 1.09 2.21) |
| 337-S-209 (0.90 1.17 2.14) | 337-S-213 (1.64 1.52 1.79) | 337-S-217 (1.06 1.55 1.76) | 337-S-218 (1.03 1.73 1.58) |
| 337-S-219 (0.83 1.28 2.02) | 337-S-222 (0.95 1.13 2.18) | 337-S-231 (2.18 2.29 1.02) | 337-S-233 (1.57 1.71 1.59) |
| 337-S-234 (1.39 1.80 1.51) | 337-S-237 (1.40 2.09 1.22) | 337-S-244 (1.45 1.71 1.60) | 337-S-245 (1.37 1.48 1.83) |
| 337-S-246 (1.71 2.05 1.26) | 337-S-285 (0.97 1.48 1.83) | 337-S-286 (1.22 1.38 1.93) | 337-S-287 (1.03 1.39 1.91) |
| 337-S-288 (1.01 1.33 1.98) | 337-S-297 (1.08 1.07 2.23) | 337-S-300 (1.34 0.95 2.36) | 337-S-303 (1.10 0.92 2.39) |
| 337-S-304 (1.14 1.39 1.91) | 337-S-305 (1.66 1.61 1.70) | 337-S-311 (0.98 1.28 2.03) | 337-S-312 (1.08 1.15 2.15) |
| 337-S-313 (0.85 1.32 1.99) | 337-S-327 (1.43 2.01 1.30) | 337-S-331 (1.29 1.19 2.12) | 337-S-332 (1.14 1.36 1.94) |
| 337-S-358 (1.09 1.53 1.78) | 337-S-367 (1.71 2.17 1.14) | 337-S-370 (1.05 1.60 1.71) | 337-S-371 (2.87 2.31 1.00) |
| 337-S-391 (0.97 1.28 2.03) | 337-S-395 (1.90 2.01 1.30) | 337-S-430 (0.91 2.11 1.20) | 337-S-434 (0.98 1.58 1.72) |
| 337-S-440 (1.59 1.92 1.39) | 337-S-441 (1.52 1.85 1.46) | 337-S-473 (1.74 2.19 1.12) | 339-S-27 (1.27 2.15 1.47) |
| 339-S-28 (1.34 2.42 1.20) | 339-S-29 (1.10 2.14 1.48) | 339-S-40 (0.92 2.14 1.48) | 339-S-44 (0.99 1.30 2.32) |
| 339-S-46 (2.51 2.30 1.31) | 339-S-56 (1.26 1.61 2.01) | 339-S-61 (1.25 2.12 1.49) | 339-S-62 (1.13 2.32 1.29) |
| 339-S-65 (1.26 1.92 1.70) | 339-S-68 (0.97 1.88 1.73) | 339-S-79 (1.24 2.29 1.32) | 339-S-80 (1.20 2.25 1.36) |
| 339-S-81 (1.27 2.38 1.24) | 339-S-82 (1.01 2.56 1.05) | 339-S-83 (1.30 1.55 2.07) | 339-S-85 (1.76 2.10 1.51) |
| 339-S-86 (0.97 2.47 1.14) | 339-S-90 (1.64 2.58 1.03) | 339-S-110 (1.31 2.43 1.18) | 339-S-111 (2.01 1.55 2.06) |
| 339-S-112 (1.20 1.93 1.69) | 339-S-115 (1.68 2.41 1.21) | 339-S-118 (1.29 1.83 1.79) | 339-S-119 (1.27 2.04 1.57) |
| 339-S-123 (0.91 2.17 1.44) | 339-S-127 (0.92 0.85 2.77) | 339-S-131 (1.32 1.50 2.11) | 339-S-132 (1.23 1.75 1.86) |
| 339-S-133 (2.02 2.56 1.06) | 339-S-144 (1.36 2.47 1.15) | 339-S-150 (2.84 2.43 1.18) | 339-S-151 (2.75 2.69 0.93) |
| 339-S-153 (2.77 2.53 1.08) | 339-S-154 (2.31 1.66 1.96) | 339-S-158 (1.38 0.87 2.74) | 339-S-161 (1.82 0.96 2.65) |
| 339-S-166 (2.03 1.49 2.13) | 339-S-167 (1.89 1.17 2.44) | 339-S-170 (2.10 0.90 2.72) | 339-S-171 (1.80 1.48 2.13) |
| 339-S-176 (0.97 0.88 2.74) | 339-S-177 (1.85 2.21 1.40) | 339-S-182 (0.99 1.05 2.56) | 339-S-183 (1.50 2.55 1.07) |
| 339-S-184 (2.59 2.02 1.59) | 339-S-187 (1.73 1.39 2.22) | 339-S-192 (2.20 2.54 1.07) | 339-S-193 (1.11 1.71 1.91) |
| 339-S-194 (1.97 1.15 2.47) | 339-S-195 (2.02 1.87 1.75) | 339-S-198 (1.73 1.93 1.69) | 339-S-205 (1.25 1.99 1.63) |
| 339-S-208 (1.21 1.46 2.16) | 339-S-209 (0.96 1.54 2.08) | 339-S-213 (1.70 1.88 1.73) | 339-S-214 (1.26 1.12 2.50) |
| 339-S-217 (1.12 1.92 1.70) | 339-S-218 (1.09 2.09 1.52) | 339-S-219 (0.89 1.65 1.97) | 339-S-222 (1.01 1.50 2.12) |
| 339-S-231 (2.24 2.66 0.96) | 339-S-233 (1.63 2.08 1.53) | 339-S-234 (1.45 2.16 1.45) | 339-S-236 (1.67 1.05 2.57) |
| 339-S-237 (1.46 2.46 1.16) | 339-S-244 (1.51 2.07 1.54) | 339-S-245 (1.43 1.85 1.77) | 339-S-246 (1.76 2.41 1.20) |
| 339-S-275 (0.84 2.05 1.56) | 339-S-285 (1.03 1.84 1.77) | 339-S-286 (1.28 1.75 1.87) | 339-S-287 (1.09 1.76 1.86) |
| 339-S-288 (1.07 1.70 1.92) | 339-S-297 (1.14 1.44 2.18) | 339-S-300 (1.40 1.31 2.30) | 339-S-303 (1.16 1.29 2.33) |
| 339-S-304 (1.20 1.76 1.85) | 339-S-305 (1.71 1.98 1.64) | 339-S-308 (1.19 0.92 2.69) | 339-S-311 (1.04 1.65 1.97) |
| 339-S-312 (1.13 1.52 2.10) | 339-S-313 (0.91 1.69 1.93) | 339-S-327 (1.49 2.38 1.24) | 339-S-331 (1.35 1.56 2.06) |
| 339-S-332 (1.20 1.73 1.88) | 339-S-358 (1.14 1.89 1.72) | 339-S-367 (1.77 2.53 1.08) | 339-S-370 (1.11 1.96 1.65) |
| 339-S-371 (2.93 2.68 0.94) | 339-S-391 (1.03 1.65 1.97) | 339-S-395 (1.96 2.38 1.24) | 339-S-430 (0.97 2.48 1.14) |
| 339-S-434 (1.04 1.95 1.67) | 339-S-440 (1.65 2.29 1.33) | 339-S-441 (1.58 2.21 1.40) | 339-S-473 (1.80 2.56 1.06) |
| 344-S-27 (0.92 2.26 1.82) | 344-S-28 (0.98 2.53 1.55) | 344-S-36 (1.14 3.04 1.04) | 344-S-43 (1.56 2.90 1.19) |
| 344-S-46 (2.15 2.42 1.67) | 344-S-56 (0.91 1.72 2.36) | 344-S-61 (0.89 2.23 1.85) | 344-S-65 (0.90 2.03 2.05) |
| 344-S-70 (1.62 3.11 0.98) | 344-S-79 (0.89 2.41 1.68) | 344-S-80 (0.84 2.36 1.72) | 344-S-81 (0.92 2.49 1.59) |
| 344-S-83 (0.95 1.66 2.42) | 344-S-85 (1.40 2.22 1.87) | 344-S-89 (1.38 2.84 1.24) | 344-S-90 (1.29 2.69 1.39) |
| 344-S-109 (1.46 2.91 1.18) | 344-S-110 (0.96 2.54 1.54) | 344-S-111 (1.66 1.66 2.42) | 344-S-112 (0.85 2.04 2.04) |
| 344-S-113 (1.06 2.96 1.12) | 344-S-115 (1.33 2.52 1.56) | 344-S-118 (0.94 1.94 2.14) | 344-S-119 (0.91 2.16 1.93) |
| 344-S-131 (0.97 1.62 2.46) | 344-S-132 (0.88 1.86 2.22) | 344-S-133 (1.67 2.67 1.41) | 344-S-144 (1.00 2.58 1.50) |
| 344-S-150 (2.49 2.54 1.54) | 344-S-151 (2.39 2.80 1.28) | 344-S-152 (3.04 3.10 0.98) | 344-S-153 (2.42 2.64 1.44) |
| 344-S-154 (1.95 1.77 2.31) | 344-S-158 (1.02 0.98 3.10) | 344-S-161 (1.46 1.07 3.01) | 344-S-166 (1.67 1.60 2.48) |
| 344-S-167 (1.53 1.28 2.80) | 344-S-170 (1.74 1.01 3.07) | 344-S-171 (1.44 1.60 2.49) | 344-S-177 (1.50 2.32 1.76) |
| 344-S-183 (1.15 2.66 1.42) | 344-S-184 (2.23 2.14 1.95) | 344-S-187 (1.38 1.51 2.57) | 344-S-192 (1.84 2.66 1.43) |
| 344-S-194 (1.61 1.26 2.82) | 344-S-195 (1.67 1.98 2.10) | 344-S-198 (1.38 2.04 2.04) | 344-S-205 (0.90 2.10 1.98) |
| 344-S-206 (0.89 3.01 1.07) | 344-S-207 (1.41 2.96 1.12) | 344-S-208 (0.86 1.57 2.51) | 344-S-213 (1.34 2.00 2.09) |
| 344-S-214 (0.90 1.23 2.85) | 344-S-231 (1.88 2.77 1.31) | 344-S-233 (1.27 2.19 1.89) | 344-S-234 (1.09 2.27 1.81) |
| 344-S-236 (1.31 1.162.92) | 344-S-237 (1.10 2.57 1.51) | 344-S-244 (1.16 2.19 1.90) | 344-S-245 (1.07 1.96 2.12) |
| 344-S-246 (1.41 2.53 1.56) | 344-S-286 (0.93 1.86 2.22) | 344-S-300 (1.04 1.43 2.66) | 344-S-303 (0.80 1.40 2.68) |
| 344-S-304 (0.84 1.87 2.21) | 344-S-305 (1.36 2.09 1.99) | 344-S-308 (0.84 1.03 3.05) | 344-S-327 (1.13 2.49 1.59) |
| 344-S-331 (0.99 1.67 2.41) | 344-S-332 (0.85 1.84 2.24) | 344-S-367 (1.42 2.64 1.44) | 344-S-371 (2.58 2.79 1.29) |
| 344-S-395 (1.61 2.49 1.59) | 344-S-440 (1.29 2.40 1.68) | 344-S-441 (1.22 2.33 1.76) | 344-S-473 (1.44 2.67 1.41) |
| 345-S-28 (0.86 2.38 1.68) | 345-S-36 (1.02 2.89 1.17) | 345-S-43 (1.43 2.74 1.31) | 345-S-46 (2.03 2.26 1.79) |
| 345-S-70 (1.50 2.95 1.10) | 345-S-83 (0.82 1.51 2.55) | 345-S-85 (1.28 2.07 1.99) | 345-S-89 (1.25 2.69 1.36) |
| 345-S-90 (1.16 2.54 1.51) | 345-S-109 (1.33 2.75 1.30) | 345-S-110 (0.83 2.39 1.66) | 345-S-111 (1.53 1.51 2.54) |
| 345-S-113 (0.93 2.81 1.25) | 345-S-115 (1.20 2.37 1.69) | 345-S-118 (0.81 1.79 2.27) | 345-S-131 (0.84 1.47 2.59) |
| 345-S-133 (1.54 2.52 1.54) | 345-S-144 (0.87 2.43 1.63) | 345-S-150 (2.36 2.39 1.67) | 345-S-151 (2.27 2.65 1.41) |
| 345-S-152 (2.91 2.95 1.11) | 345-S-153 (2.29 2.49 1.56) | 345-S-154 (1.83 1.62 2.44) | 345-S-158 (0.90 0.83 3.22) |
| 345-S-161 (1.34 0.92 3.13) | 345-S-166 (1.55 1.45 2.61) | 345-S-167 (1.41 1.132.92) | 345-S-170 (1.62 0.86 3.20) |
| 345-S-171 (1.32 1.44 2.61) | 345-S-177 (1.37 2.17 1.89) | 345-S-183 (1.02 2.51 1.55) | 345-S-184 (2.11 1.98 2.07) |
| 345-S-187 (1.25 1.36 2.70) | 345-S-192 (1.72 2.50 1.55) | 345-S-194 (1.49 1.11 2.95) | 345-S-195 (1.54 1.83 2.23) |
| 345-S-198 (1.25 1.89 2.17) | 345-S-207 (1.29 2.81 1.25) | 345-S-213 (1.22 1.84 2.21) | 345-S-231 (1.76 2.62 1.44) |
| 345-S-233 (1.14 2.04 2.02) | 345-S-234 (0.96 2.12 1.93) | 345-S-236 (1.19 1.01 3.05) | 345-S-237 (0.98 2.42 1.64) |
| 345-S-244 (1.03 2.03 2.02) | 345-S-245 (0.95 1.81 2.25) | 345-S-246 (1.28 2.37 1.68) | 345-S-300 (0.92 1.27 2.78) |
| 345-S-305 (1.23 1.94 2.12) | 345-S-327 (1.01 2.34 1.72) | 345-S-331 (0.87 1.52 2.54) | 345-S-367 (1.29 2.49 1.56) |
| 345-S-368 (1.40 3.04 1.02) | 345-S-371 (2.45 2.64 1.42) | 345-S-395 (1.48 2.34 1.72) | 345-S-440 (1.17 2.25 1.81) |
| 345-S-441 (1.10 2.17 1.88) | 345-S-473 (1.32 2.52 1.54) | 346-S-36 (0.83 2.87 1.35) | 346-S-37 (0.83 3.17 1.05) |
| 346-S-43 (1.25 2.73 1.50) | 346-S-46 (1.84 2.25 1.97) | 346-S-70 (1.31 2.94 1.29) | 346-S-85 (1.09 2.05 2.17) |
| 346-S-89 (1.07 2.68 1.55) | 346-S-90 (0.98 2.53 1.70) | 346-S-109 (1.15 2.74 1.48) | 346-S-111 (1.35 1.50 2.73) |
| 346-S-115 (1.02 2.35 1.87) | 346-S-133 (1.36 2.50 1.72) | 346-S-150 (2.18 2.38 1.85) | 346-S-151 (2.09 2.63 1.59) |
| 346-S-152 (2.73 2.93 1.29) | 346-S-153 (2.11 2.48 1.75) | 346-S-154 (1.64 1.60 2.62) | 346-S-161 (1.15 0.91 3.32) |
| 346-S-166 (1.36 1.43 2.79) | 346-S-167 (1.23 1.12 3.11) | 346-S-170 (1.43 0.84 3.38) | 346-S-171 (1.13 1.43 2.80) |
| 346-S-177 (1.19 2.16 2.07) | 346-S-183 (0.84 2.49 1.73) | 346-S-184 (1.93 1.97 2.26) | 346-S-187 (1.07 1.34 2.88) |
| 346-S-192 (1.53 2.49 1.73) | 346-S-194 (1.30 1.09 3.13) | 346-S-195 (1.36 1.81 2.41) | 346-S-198 (1.07 1.87 2.35) |
| 346-S-207 (1.10 2.79 1.43) | 346-S-213 (1.04 1.83 2.40) | 346-S-231 (1.58 2.60 1.62) | 346-S-233 (0.96 2.03 2.20) |
| 346-S-236 (1.00 0.99 3.23) | 346-S-244 (0.85 2.02 2.20) | 346-S-246 (1.10 2.36 1.87) | 346-S-305 (1.05 1.92 2.30) |
| 346-S-327 (0.82 2.32 1.90) | 346-S-364 (1.29 3.15 1.07) | 346-S-367 (1.11 2.48 1.75) | 346-S-368 (1.22 3.02 1.20) |
| 346-S-371 (2.27 2.62 1.60) | 346-S-395 (1.30 2.32 1.90) | 346-S-440 (0.98 2.23 1.99) | 346-S-441 (0.91 2.16 2.07) |
| 346-S-473 (1.14 2.50 1.72) | 347-S-36 (0.89 2.96 1.30) | 347-S-37 (0.88 3.26 1.00) | 347-S-43 (1.30 2.82 1.44) |
| 347-S-46 (1.90 2.34 1.92) | 347-S-70 (1.36 3.03 1.23) | 347-S-85 (1.15 2.14 2.12) | 347-S-89 (1.12 2.76 1.50) |
| 347-S-90 (1.03 2.61 1.65) | 347-S-109 (1.20 2.83 1.43) | 347-S-111 (1.40 1.59 2.67) | 347-S-113 (0.80 2.88 1.38) |
| 347-S-115 (1.07 2.44 1.82) | 347-S-133 (1.41 2.59 1.67) | 347-S-150 (2.23 2.46 1.80) | 347-S-151 (2.14 2.72 1.54) |
| 347-S-152 (2.78 3.02 1.24) | 347-S-153 (2.16 2.56 1.70) | 347-S-154 (1.69 1.69 2.57) | 347-S-161 (1.20 0.99 3.27) |
| 347-S-166 (1.41 1.52 2.74) | 347-S-167 (1.28 1.20 3.05) | 347-S-170 (1.49 0.93 3.33) | 347-S-171 (1.19 1.52 2.74) |
| 347-S-177 (1.24 2.24 2.02) | 347-S-183 (0.89 2.58 1.68) | 347-S-184 (1.98 2.06 2.20) | 347-S-187 (1.12 1.43 2.83) |
| 347-S-192 (1.58 2.58 1.68) | 347-S-194 (1.35 1.18 3.08) | 347-S-195 (1.41 1.90 2.36) | 347-S-198 (1.12 1.96 2.30) |
| 347-S-207 (1.15 2.88 1.38) | 347-S-213 (1.09 1.92 2.34) | 347-S-231 (1.63 2.69 1.57) | 347-S-233 (1.01 2.11 2.15) |
| 347-S-234 (0.83 2.20 2.06) | 347-S-236 (1.05 1.08 3.18) | 347-S-237 (0.84 2.49 1.77) | 347-S-244 (0.90 2.11 2.15) |
| 347-S-245 (0.82 1.88 2.38) | 347-S-246 (1.15 2.45 1.81) | 347-S-305 (1.10 2.01 2.25) | 347-S-327 (0.88 2.41 1.85) |
| 347-S-364 (1.34 3.24 1.02) | 347-S-367 (1.16 2.56 1.70) | 347-S-368 (1.27 3.11 1.15) | 347-S-371 (2.32 2.71 1.55) |
| 347-S-395 (1.35 2.41 1.85) | 347-S-440 (1.04 2.32 1.94) | 347-S-441 (0.97 2.25 2.01) | 3473 (1.19 2.59 1.67) |
| 348-S-27 (1.01 1.94 1.73) | 348-S-28 (1.07 2.21 1.46) | 348-S-29 (0.84 1.93 1.74) | 348-S-36 (1.23 2.72 0.95) |
| 348-S-43 (1.65 2.58 1.10) | 348-S-46 (2.24 2.10 1.58) | 348-S-56 (1.00 1.40 2.27) | 348-S-61 (0.98 1.92 1.76) |
| 348-S-62 (0.86 2.12 1.56) | 348-S-65 (0.99 1.71 1.96) | 348 - S - 79 (0.98 2.09 1.59) | 348-S-80 (0.93 2.05 1.63) |
| 348-S-81 (1.01 2.17 1.50) | 348-S-83 (1.04 1.34 2.33) | 348-S-85 (1.49 1.90 1.77) | 348-S-89 (1.47 2.53 1.15) |
| 348-S-90 (1.38 2.38 1.30) | 348-S-109 (1.55 2.59 1.09) | 348-S-110 (1.05 2.23 1.45) | 348-S-111 (1.75 1.35 2.33) |
| 348-S-112 (0.94 1.72 1.95) | 348-S-113 (1.15 2.64 1.03) | 348-S-115 (1.42 2.20 1.47) | 348-S-118 (1.03 1.62 2.05) |
| 348-S-119 (1.00 1.84 1.84) | 348-S-131 (1.06 1.30 2.37) | 348-S-132 (0.97 1.54 2.13) | 348-S-133 (1.76 2.35 1.32) |
| 348-S-144 (1.09 2.26 1.41) | 348-S-150 (2.58 2.23 1.45) | 348-S-151 (2.48 2.48 1.19) | 348-S-153 (2.51 2.33 1.35) |
| 348-S-154 (2.04 1.45 2.22) | 348-S-166 (1.76 1.28 2.39) | 348-S-167 (1.63 0.97 2.71) | 348-S-171 (1.53 1.28 2.40) |
| 348-S-177 (1.59 2.01 1.67) | 348-S-183 (1.24 2.34 1.33) | 348-S-184 (2.33 1.82 1.86) | 348-S-187 (1.47 1.19 2.48) |
| 348-S-192 (1.93 2.34 1.34) | 348-S-193 (0.85 1.50 2.17) | 348-S-194 (1.70 0.94 2.73) | 348-S-195 (1.76 1.66 2.01) |
| 348-S-198 (1.47 1.72 1.95) | 348-S-205 (0.99 1.78 1.89) | 348-S-206 (0.98 2.69 0.98) | 348-S-207 (1.50 2.64 1.03) |
| 348-S-208 (0.95 1.25 2.42) | 348-S-213 (1.43 1.68 2.00) | 348-S-214 (1.00 0.91 2.76) | 348-S-217 (0.86 1.71 1.96) |
| 348-S-218 (0.83 1.89 1.79) | 348-S-231 (1.98 2.45 1.22) | 348-S-233 (1.36 1.87 1.80) | 348-S-234 (1.18 1.96 1.72) |
| 348-S-236 (1.40 0.84 2.83) | 348-S-237 (1.19 2.25 1.42) | 348-S-244 (1.25 1.87 1.81) | 348-S-245 (1.16 1.64 2.03) |
| 348-S-246 (1.50 2.21 1.47) | 348-S-286 (1.02 1.54 2.13) | 348-S-287 (0.82 1.55 2.12) | 348-S-288 (0.81 1.49 2.18) |
| 348-S-297 (0.87 1.23 2.44) | 348-S-300 (1.14 1.11 2.57) | 348-S-303 (0.89 1.08 2.59) | 348-S-304 (0.94 1.55 2.12) |
| 348-S-305 (1.45 1.77 1.90) | 348- S-312 (0.87 1.31 2.36) | 348-S-327 (1.22 2.17 1.50) | 348-S-331 (1.08 1.35 2.32) |
| 348-S-332 (0.94 1.52 2.15) | 348-S-358 (0.88 1.69 1.98) | 348-S-367 (1.51 2.33 1.35) | 348-S-370 (0.85 1.76 1.92) |
| 348-S-371 (2.67 2.47 1.20) | 348-S-395 (1.70 2.17 1.50) | 348-S-420 (0.88 2.65 1.02) | 348-S-440 (1.38 2.08 1.59) |
| 348-S-441 (1.31 2.01 1.67) | 348-S-473 (1.54 2.35 1.32) | 349-S-43 (1.16 2.71 1.58) | 349-S-46 (1.76 2.24 2.06) |
| 349-S-70 (1.23 2.92 1.37) | 349-S-85 (1.01 2.04 2.26) | 349-S-89 (0.98 2.66 1.63) | 349-S-90 (0.89 2.51 1.78) |
| 349-S-109 (1.07 2.72 1.57) | 349-S-111 (1.26 1.48 2.81) | 349-S-115 (0.93 2.34 1.96) | 349-S-133 (1.27 2.49 1.81) |
| 349-S-150 (2.09 2.36 1.93) | 349-S-151 (2.00 2.62 1.68) | 349-S-152 (2.64 2.92 1.38) | 349-S-153 (2.02 2.46 1.83) |
| 349-S-154 (1.56 1.59 2.70) | 349-S-161 (1.07 0.89 3.40) | 349-S-166 (1.28 1.42 2.88) | 349-S-167 (1.14 1.10 3.19) |
| 349-S-170 (1.35 0.83 3.47) | 349-S-171 (1.05 1.41 2.88) | 349-S-177 (1.10 2.14 2.15) | 349-S-184 (1.84 1.95 2.34) |
| 349-S-187 (0.99 1.33 2.97) | 349-S-192 (1.45 2.47 1.82) | 349-S-194 (1.22 1.08 3.22) | 349-S-195 (1.27 1.80 2.50) |
| 349-S-198 (0.98 1.86 2.44) | 349-S-207 (1.02 2.78 1.52) | 349-S-213 (0.95 1.81 2.48) | 349-S-231 (1.49 2.59 1.71) |
| 349-S-233 (0.88 2.01 2.28) | 349-S-236 (0.92 0.98 3.32) | 349-S-246 (1.02 2.34 1.95) | 349-S-305 (0.97 1.91 2.39) |
| 349-S-364 (1.20 3.14 1.16) | 349-S-367 (1.02 2.46 1.83) | 349-S-368 (1.13 3.01 1.29) | 349-S-371 (2.18 2.61 1.69) |
| 349-S-395 (1.21 2.31 1.99) | 349-S-440 (0.90 2.22 2.08) | 349-S-441 (0.83 2.14 2.15) | 349-S-473 (1.05 2.49 1.81) |
| 350-S-43 (1.14 2.63 1.61) | 350-S-46 (1.73 2.15 2.08) | 350-S-70 (1.20 2.84 1.40) | 350-S-85 (0.98 1.95 2.28) |
| 350-S-89 (0.96 2.57 1.66) | 350-S-90 (0.87 2.42 1.81) | 350-S-93 (0.93 3.32 0.91) | 350-S-109 (1.04 2.64 1.59) |
| 350-S-111 (1.24 1.39 2.84) | 350-S-115 (0.91 2.25 1.98) | 350-S-133 (1.25 2.40 1.83) | 350-S-150 (2.07 2.27 1.96) |
| 350-S-151 (1.98 2.53 1.70) | 350-S-152 (2.62 2.83 1.40) | 350-S-153 (2.00 2.37 1.86) | 350-S-154 (1.53 1.50 2.73) |
| 350-S-161 (1.04 0.80 3.43) | 350-S-166 (1.25 1.33 2.90) | 350-S-167 (1.12 1.01 3.22) | 350-S-171 (1.02 1.33 2.91) |
| 350-S-177 (1.08 2.05 2.18) | 350-S-184 (1.82 1.87 2.37) | 350-S-187 (0.96 1.24 2.99) | 350-S-192 (1.42 2.39 1.85) |
| 350-S-194 (1.19 0.99 3.24) | 350-S-195 (1.25 1.71 2.52) | 350-S-198 (0.96 1.77 2.46) | 350-S-207 (0.99 2.69 1.54) |
| 350-S-213 (0.93 1.73 2.51) | 350-S-231 (1.47 2.50 1.73) | 350-S-233 (0.85 1.92 2.31) | 350-S-236 (0.89 0.89 3.34) |
| 350-S-246 (0.99 2.26 1.98) | 350-S-305 (0.94 1.82 2.41) | 350-S-364 (1.18 3.05 1.18) | 350-S-367 (1.00 2.37 1.86) |
| 350-S-368 (1.11 2.92 1.31) | 350-S-371 (2.16 2.52 1.71) | 350-S-395 (1.19 2.22 2.01) | 350-S-440 (0.87 2.13 2.10) |
| 350-S-441 (0.80 2.06 2.18) | 350-S-473 (1.03 2.40 1.83) | 351-S-36 (0.82 2.77 1.36) | 351-S-37 (0.82 3.07 1.06) |
| 351-S-43 (1.24 2.63 1.51) | 351-S-46 (1.83 2.15 1.98) | 351-S-70 (1.30 2.84 1.30) | 351-S-85 (1.08 1.95 2.18) |
| 351-S-89 (1.06 2.57 1.56) | 351-S-90 (0.97 2.42 1.71) | 351-S-109 (1.14 2.64 1.50) | 351-S-111 (1.34 1.39 2.74) |
| 351-S-115 (1.01 2.25 1.88) | 351-S-133 (1.35 2.40 1.73) | 351-S-150 (2.17 2.27 1.86) | 351-S-151 (2.08 2.53 1.60) |
| 351-S-152 (2.72 2.83 1.30) | 351-S-153 (2.10 2.37 1.76) | 351-S-154 (1.63 1.50 2.63) | 351-S-161 (1.14 0.80 3.33) |
| 351-S-166 (1.35 1.33 2.80) | 351-S-167 (1.22 1.01 3.12) | 351-S-171 (1.12 1.33 2.81) | 351-S-177 (1.18 2.05 2.08) |
| 351-S-183 (0.83 2.39 1.74) | 351-S-184 (1.92 1.87 2.27) | 351-S-187 (1.06 1.24 2.89) | 351-S-192 (1.52 2.39 1.75) |
| 351-S-194 (1.29 0.99 3.14) | 351-S-195 (1.35 1.71 2.42) | 351-S-198 (1.06 1.77 2.36) | 351-S-207 (1.09 2.69 1.44) |
| 351-S-213 (1.03 1.73 2.41) | 351-S-231 (1.57 2.50 1.63) | 351-S-233 (0.95 1.92 2.21) | 351-S-236 (0.99 0.89 3.24) |
| 351-S-244 (0.84 1.92 2.22) | 351-S-246 (1.09 2.26 1.88) | 351-S-305 (1.04 1.82 2.31) | 351-S-327 (0.81 2.22 1.91) |
| 351-S-364 (1.28 3.05 1.08) | 351-S-367 (1.10 2.37 1.76) | 351-S-368 (1.21 2.92 1.21) | 351-S-371 (2.26 2.52 1.61) |
| 351-S-395 (1.29 2.22 1.91) | 351-S-440 (0.97 2.13 2.00) | 351-S-441 (0.90 2.05 2.08) | 351-S-473 (1.13 2.40 1.73) |
| 352-S-43 (1.00 1.93 1.74) | 352-S-46 (1.60 1.45 2.22) | 352-S-70 (1.07 2.14 1.53) | 352-S-85 (0.85 1.25 2.42) |
| 352-S-89 (0.82 1.87 1.79) | 352-S-109 (0.91 1.94 1.73) | 352-S-133 (1.11 1.70 1.97) | 352-S-150 (1.93 1.57 2.09) |
| 352-S-151 (1.84 1.83 1.84) | 352-S-152 (2.48 2.13 1.54) | 352-S-153 (1.86 1.67 1.99) | 352-S-154 (1.40 0.80 2.86) |
| 352-S-177 (0.94 1.35 2.31) | 352-S-184 (1.68 1.17 2.50) | 352-S-192 (1.29 1.69 1.98) | 352-S-195 (1.11 1.01 2.66) |
| 352-S-198 (0.82 1.07 2.60) | 352-S-207 (0.86 1.99 1.68) | 352-S-231 (1.33 1.80 1.87) | 352-S-246 (0.86 1.56 2.11) |
| 352-S-305 (0.81 1.12 2.55) | 352-S-364 (1.04 2.35 1.32) | 352-S-367 (0.86 1.67 1.99) | 352-S-368 (0.97 2.22 1.45) |
| 352-S-371 (2.02 1.82 1.85) | 352-S-395 (1.05 1.52 2.15) | 352-S-473 (0.89 1.70 1.97) | 353-S-43 (1.08 1.89 1.67) |
| 353-S-46 (1.67 1.41 2.15) | 353-S-70 (1.14 2.10 1.46) | 353-S-85 (0.92 1.21 2.35) | 353-S-89 (0.89 1.84 1.72) |
| 353-S-90 (0.80 1.69 1.87) | 353-S-93 (0.87 2.58 0.98) | 353-S-109 (0.98 1.90 1.66) | 353-S-115 (0.85 1.51 2.05) |
| 353-S-133 (1.18 1.66 1.89) | 353-S-150 (2.00 1.53 2.02) | 353-S-151 (1.91 1.79 1.76) | 353-S-152 (2.56 2.09 1.46) |
| 353-S-153 (1.94 1.64 1.92) | 353-S-177 (1.02 1.31 2.24) | 353-S-184 (1.75 1.13 2.43) | 353-S-192 (1.36 1.65 1.91) |
| 353-S-195 (1.18 0.97 2.58) | 353-S-198 (0.89 1.03 2.52) | 353-S-207 (0.93 1.95 1.60) | 353-S-213 (0.86 0.99 2.57) |
| 353-S-231 (1.40 1.76 1.80) | 353-S-246 (0.93 1.52 2.04) | 353-S-305 (0.88 1.08 2.48) | 353-S-364 (1.12 2.31 1.24) |
| 353-S-367 (0.93 1.64 1.92) | 353-S-368 (1.04 2.18 1.38) | 353-S-371 (2.09 1.78 1.78) | 353-S-395 (1.12 1.48 2.08) |
| 353-S-440 (0.81 1.39 2.17) | 353-S-473 (0.96 1.66 1.89) | 354-S-27 (0.94 1.42 1.80) | 354-S-28 (1.00 1.69 1.53) |
| 354-S-36 (1.16 2.20 1.02) | 354-S-43 (1.58 2.06 1.17) | 354-S-46 (2.17 1.58 1.65) | 354-S-56 (0.93 0.89 2.34) |
| 354-S-61 (0.91 1.40 1.83) | 354-S-65 (0.92 1.19 2.03) | 354-S-70 (1.64 2.27 0.96) | 354-S-79 (0.91 1.57 1.65) |
| 354-S-80 (0.86 1.53 1.70) | 354-S-81 (0.94 1.65 1.57) | 354-S-83 (0.97 0.83 2.40) | 354-S-85 (1.42 1.38 1.84) |
| 354-S-89 (1.40 2.01 1.22) | 354-S-90 (1.31 1.86 1.37) | 354-S-109 (1.48 2.07 1.16) | 354-S-110 (0.98 1.71 1.52) |
| 354-S-111 (1.68 0.83 2.40) | 354-S-112 (0.87 1.21 2.02) | 354-S-113 (1.08 2.12 1.10) | 354-S-115 (1.35 1.68 1.54) |
| 354-S-118 (0.96 1.10 2.12) | 354-S-119 (0.93 1.32 1.91) | 354-S-132 (0.90 1.03 2.20) | 354-S-133 (1.69 1.83 1.39) |
| 354-S-144 (1.02 1.74 1.48) | 354-S-150 (2.51 1.71 1.52) | 354-S-151 (2.41 1.97 1.26) | 354-S-152 (3.06 2.26 0.96) |
| 354-S-153 (2.44 1.81 1.42) | 354-S-154 (1.97 0.94 2.29) | 354-S-177 (1.52 1.49 1.74) | 354-S-183 (1.17 1.82 1.40) |
| 354-S-184 (2.26 1.30 1.93) | 354-S-192 (1.86 1.82 1.41) | 354-S-195 (1.69 1.14 2.08) | 354-S-198 (1.40 1.20 2.02) |
| 354-S-205 (0.92 1.26 1.96) | 354-S-206 (0.91 2.18 1.05) | 354-S-207 (1.43 2.12 1.10) | 354-S-213 (1.36 1.16 2.07) |
| 354-S-231 (1.91 1.93 1.29) | 354-S-233 (1.29 1.36 1.87) | 354-S-234 (1.11 1.44 1.79) | 354-S-237 (1.12 1.73 1.49) |
| 354-S-244 (1.18 1.35 1.88) | 354-S-245 (1.09 1.12 2.10) | 354-S-246 (1.43 1.69 1.54) | 354-S-286 (0.95 1.02 2.20) |
| 354-S-304 (0.87 1.04 2.19) | 354-S-305 (1.38 1.25 1.97) | 354-S-327 (1.15 1.65 1.57) | 354-S-331 (1.01 0.83 2.39) |
| 354-S-332 (0.87 1.01 2.22) | 354-S-358 (0.81 1.17 2.05) | 354-S-367 (1.44 1.81 1.42) | 354-S-371 (2.60 1.95 1.27) |
| 354-S-395 (1.63 1.65 1.57) | 354-S-420 (0.81 2.13 1.09) | 354-S-440 (1.31 1.56 1.66) | 354-S-441 (1.24 1.49 1.74) |
| 354-S-473 (1.47 1.83 1.39) | 360-S-36 (0.91 1.64 1.28) | 360-S-37 (0.90 1.94 0.98) | 360-S-43 (1.32 1.49 1.42) |
| 360-S-46 (1.92 1.01 1.90) | 360-S-70 (1.38 1.70 1.21) | 360-S-85 (1.17 0.81 2.10) | 360-S-89 (1.14 1.44 1.48) |
| 360-S-90 (1.05 1.29 1.63) | 360-S-109 (1.22 1.50 1.41) | 360-S-113 (0.82 1.56 1.36) | 360-S-115 (1.09 1.12 1.80) |
| 360-S-133 (1.43 1.27 1.65) | 360-S-150 (2.25 1.14 1.78) | 360-S-151 (2.16 1.40 1.52) | 360-S-152 (2.80 1.70 1.22) |
| 360-S-153 (2.18 1.24 1.68) | 360-S-177 (1.26 0.92 2.00) | 360-S-183 (0.91 1.26 1.66) | 360-S-192 (1.60 1.25 1.66) |
| 360-S-207 (1.17 1.56 1.36) | 360-S-231 (1.65 1.37 1.55) | 360-S-234 (0.85 0.87 2.04) | 360-S-237 (0.86 1.17 1.75) |
| 360-S-246 (1.17 1.12 1.79) | 360-S-327 (0.90 1.09 1.83) | 360-S-364 (1.36 1.92 1.00) | 360-S-367 (1.18 1.24 1.68) |
| 360-S-368 (1.29 1.78 1.13) | 360-S-371 (2.34 1.39 1.53) | 360-S-395 (1.37 1.09 1.83) | 360-S-440 (1.06 1.00 1.92) |
| 360-S-441 (0.99 0.92 1.99) | 360-S-473 (1.21 1.27 1.65) | 366-S-36 (0.81 2.38 1.38) | 366-S-37 (0.80 2.68 1.08) |
| 366-S-43 (1.22 2.24 1.52) | 366-S-46 (1.82 1.76 2.00) | 366-S-70 (1.29 2.45 1.31) | 366-S-85 (1.07 1.56 2.20) |
| 366-S-89 (1.04 2.18 1.57) | 366-S-90 (0.95 2.03 1.72) | 366-S-109 (1.12 2.25 1.51) | 366-S-111 (1.32 1.01 2.75) |
| 366-S-115 (0.99 1.86 1.90) | 366-S-133 (1.33 2.01 1.75) | 366-S-150 (2.15 1.88 1.87) | 366-S-151 (2.06 2.14 1.62) |
| 366-S-152 (2.70 2.44 1.32) | 366-S-153 (2.08 1.98 1.77) | 366-S-154 (1.62 1.11 2.65) | 366-S-166 (1.34 0.94 2.82) |
| 366-S-171 (1.11 0.94 2.82) | 366-S-177 (1.16 1.66 2.09) | 366-S-183 (0.81 2.00 1.76) | 366-S-184 (1.90 1.48 2.28) |
| 366-S-187 (1.04 0.85 2.91) | 366-S-192 (1.51 2.00 1.76) | 366-S-195 (1.33 1.32 2.44) | 366-S-198 (1.04 1.38 2.38) |
| 366-S-207 (1.08 2.30 1.46) | 366-S-213 (1.01 1.34 2.42) | 366-S-231 (1.55 2.11 1.65) | 366-S-233 (0.94 1.53 2.22) |
| 366-S-244 (0.82 1.53 2.23) | 366-S-246 (1.07 1.87 1.89) | 366-S-305 (1.02 1.43 2.33) | 366-S-364 (1.26 2.66 1.10) |
| 366-S-367 (1.08 1.98 1.77) | 366-S-368 (1.19 2.53 1.23) | 366-S-371 (2.24 2.13 1.63) | 366-S-395 (1.27 1.83 1.93) |
| 366-S-440 (0.96 1.74 2.02) | 366-S-441 (0.89 1.67 2.09) | 366-S-473 (1.11 2.01 1.75) | 377-S-27 (1.12 1.16 1.62) |
| 377-S-28 (1.18 1.43 1.36) | 377-S-29 (0.94 1.15 1.63) | 377-S-43 (1.76 1.79 0.99) | 377-S-46 (2.35 1.32 1.47) |
| 377-S-61 (1.09 1.13 1.65) | 377-S-62 (0.97 1.33 1.45) | 377-S-65 (1.10 0.93 1.85) | 377-S-68 (0.81 0.89 1.89) |
| 377-S-79 (1.09 1.31 1.48) | 377-S-80 (1.04 1.26 1.52) | 377-S-81 (1.12 1.39 1.40) | 377-S-82 (0.85 1.57 1.21) |
| 377-S-85 (1.60 1.12 1.67) | 377-S-86 (0.82 1.49 1.30) | 377-S-89 (1.57 1.74 1.04) | 377-S-90 (1.48 1.59 1.19) |
| 377-S-109 (1.66 1.80 0.98) | 377-S-110 (1.15 1.44 1.34) | 377-S-112 (1.05 0.94 1.84) | 377-S-113 (1.26 1.86 0.92) |
| 377-S-115 (1.53 1.42 1.37) | 377-S-118 (1.14 0.84 1.94) | 377-S-119 (1.11 1.05 1.73) | 377-S-133 (1.86 1.57 1.21) |
| 377-S-144 (1.20 1.48 1.30) | 377-S-150 (2.68 1.44 1.34) | 377-S-151 (2.59 1.70 1.08) | 377-S-153 (2.62 1.54 1.24) |
| 377-S-177 (1.70 1.22 1.56) | 377-S-183 (1.35 1.56 1.22) | 377-S-184 (2.43 1.03 1.75) | 377-S-192 (2.04 1.55 1.23) |
| 377-S-195 (1.86 0.88 1.90) | 377-S-198 (1.58 0.94 1.84) | 377-S-205 (1.10 1.00 1.78) | 377-S-207 (1.61 1.86 0.92) |
| 377-S-213 (1.54 0.89 1.89) | 377-S-217 (0.97 0.93 1.86) | 377-S-218 (0.94 1.10 1.68) | 377-S-231 (2.08 1.67 1.12) |
| 377-S-233 (1.47 1.09 1.69) | 377-S-234 (1.29 1.17 1.61) | 377-S-237 (1.30 1.47 1.31) | 377-S-244 (1.35 1.08 1.70) |
| 377-S-245 (1.27 0.86 1.92) | 377-S-246 (1.61 1.42 1.36) | 377-S-285 (0.87 0.86 1.93) | 377-S-305 (1.56 0.99 1.80) |
| 377-S-327 (1.33 1.39 1.39) | 377-S-358 (0.99 0.91 1.88) | 377-S-367 (1.61 1.54 1.24) | 377-S-370 (0.96 0.97 1.81) |
| 377-S-371 (2.77 1.69 1.09) | 377-S-395 (1.81 1.39 1.39) | 377-S-420 (0.99 1.87 0.92) | 377-S-430 (0.82 1.49 1.29) |
| 377-S-434 (0.88 0.96 1.82) | 377-S-440 (1.49 1.30 1.49) | 377-S-441 (1.42 1.22 1.56) | 377-S-473 (1.64 1.57 1.21) |
| 383-S-27 (1.30 2.20 1.45) | 383-S-28 (1.36 2.47 1.18) | 383-S-29 (1.12 2.19 1.46) | 383-S-40 (0.94 2.19 1.46) |
| 383-S-44 (1.01 1.35 2.30) | 383-S-46 (2.53 2.36 1.29) | 383-S-56 (1.28 1.66 1.99) | 383-S-61 (1.27 2.17 1.47) |
| 383-S-62 (1.15 2.37 1.27) | 383-S-65 (1.28 1.97 1.68) | 383-S-68 (0.99 1.93 1.71) | 383-S-79 (1.26 2.35 1.30) |
| 383-S-80 (1.22 2.30 1.34) | 383-S-81 (1.29 2.43 1.22) | 383-S-82 (1.03 2.61 1.03) | 383-S-83 (1.32 1.60 2.05) |
| 383-S-85 (1.78 2.16 1.49) | 383-S-86 (1.00 2.53 1.12) | 383-S-90 (1.66 2.63 1.01) | 383-S-110 (1.33 2.48 1.16) |
| 383-S-111 (2.03 1.60 2.04) | 383-S-112 (1.23 1.98 1.67) | 383-S-115 (1.70 2.46 1.19) | 383-S-118 (1.31 1.88 1.77) |
| 383-S-119 (1.29 2.10 1.55) | 383-S-123 (0.93 2.22 1.42) | 383-S-127 (0.94 0.90 2.75) | 383-S-131 (1.34 1.56 2.09) |
| 383-S-132 (1.25 1.80 1.84) | 383-S-133 (2.04 2.61 1.04) | 383-S-144 (1.38 2.52 1.13) | 383-S-150 (2.86 2.48 1.16) |
| 383-S-151 (2.77 2.74 0.91) | 383-S-153 (2.79 2.58 1.06) | 383-S-154 (2.33 1.71 1.94) | 383-S-158 (1.40 0.92 2.72) |
| 383-S-161 (1.84 1.01 2.63) | 383-S-166 (2.05 1.54 2.11) | 383-S-167 (1.91 1.22 2.42) | 383-S-170 (2.12 0.95 2.70) |
| 383-S-171 (1.82 1.54 2.11) | 383-S-176 (0.99 0.93 2.72) | 383-S-177 (1.87 2.26 1.38) | 383-S-182 (1.01 1.10 2.54) |
| 383-S-183 (1.52 2.60 1.05) | 383-S-184 (2.61 2.08 1.57) | 383-S-187 (1.75 1.45 2.20) | 383-S-192 (2.22 2.60 1.05) |
| 383-S-193 (1.13 1.76 1.89) | 383-S-194 (1.99 1.20 2.45) | 383-S-195 (2.04 1.92 1.73) | 383-S-198 (1.75 1.98 1.67) |
| 383-S-205 (1.27 2.04 1.61) | 383-S-208 (1.24 1.51 2.14) | 383-S-209 (0.98 1.59 2.06) | 383-S-213 (1.72 1.94 1.71) |
| 383-S-214 (1.28 1.17 2.48) | 383-S-217 (1.14 1.97 1.68) | 383-S-218 (1.11 2.15 1.50) | 383-S-219 (0.91 1.70 1.95) |
| 383-S-222 (1.03 1.55 2.10) | 383-S-231 (2.26 2.71 0.94) | 383-S-233 (1.65 2.13 1.51) | 383-S-234 (1.47 2.21 1.43) |
| 383-S-236 (1.69 1.10 2.55) | 383-S-237 (1.48 2.51 1.14) | 383-S-244 (1.53 2.13 1.52) | 383-S-245 (1.45 1.90 1.75) |
| 383-S-246 (1.78 2.47 1.18) | 383-S-275 (0.86 2.11 1.54) | 383-S-285 (1.05 1.90 1.75) | 383-S-286 (1.30 1.80 1.85) |
| 383-S-287 (1.11 1.81 1.84) | 383-S-288 (1.09 1.75 1.90) | 383-S-297 (1.16 1.49 2.16) | 383-S-300 (1.42 1.37 2.28) |
| 383-S-303 (1.18 1.34 2.31) | 383-S-304 (1.22 1.81 1.83) | 383-S-305 (1.73 2.03 1.62) | 383-S-308 (1.21 0.97 2.67) |
| 383-S-311 (1.06 1.70 1.95) | 383-S-312 (1.16 1.57 2.07) | 383-S-313 (0.93 1.74 1.91) | 383-S-327 (1.51 2.43 1.22) |
| 383-S-331 (1.37 1.61 2.04) | 383-S-332 (1.22 1.78 1.86) | 383-S-341 (0.82 2.30 1.35) | 383-S-358 (1.16 1.95 1.70) |
| 383-S-367 (1.79 2.58 1.06) | 383-S-370 (1.13 2.01 1.63) | 383-S-371 (2.95 2.73 0.92) | 383-S-391 (1.05 1.70 1.95) |
| 383-S-395 (1.98 2.43 1.22) | 383-S-430 (0.99 2.53 1.12) | 383-S-434 (1.06 2.00 1.65) | 383-S-440 (1.67 2.34 1.31) |
| 383-S-441 (1.60 2.26 1.38) | 383-S-473 (1.82 2.61 1.04) | 384-S-28 (0.82 2.21 1.72) | 384-S-36 (0.98 2.73 1.20) |
| 384-S-37 (0.98 3.03 0.90) | 384-S-43 (1.40 2.58 1.35) | 384-S-46 (1.99 2.10 1.83) | 384-S-70 (1.46 2.79 1.14) |
| 384-S-85 (1.24 1.90 2.03) | 384-S-89 (1.21 2.53 1.40) | 384-S-90 (1.12 2.38 1.55) | 384-S-109 (1.30 2.59 1.34) |
| 384-S-111 (1.50 1.35 2.58) | 384 -S-113 (0.90 2.65 1.28) | 384-S-115 (1.17 2.21 1.73) | 384-S-131 (0.80 1.30 2.63) |
| 384-S-133 (1.50 2.36 1.57) | 384-S-144 (0.84 2.27 1.66) | 384-S-150 (2.32 2.23 1.70) | 384-S-151 (2.23 2.49 1.44) |
| 384-S-152 (2.88 2.79 1.14) | 384-S-153 (2.26 2.33 1.60) | 384-S-154 (1.79 1.46 2.47) | 384-S-166 (1.51 1.29 2.65) |
| 384-S-167 (1.37 0.97 2.96) | 384-S-171 (1.28 1.28 2.65) | 384-S-177 (1.34 2.01 1.92) | 384-S-183 (0.98 2.35 1.59) |
| 384-S-184 (2.07 1.82 2.11) | 384-S-187 (1.22 1.19 2.74) | 384-S-192 (1.68 2.34 1.59) | 384-S-194 (1.45 0.95 2.98) |
| 384-S-195 (1.50 1.67 2.26) | 384-S-198 (1.21 1.73 2.20) | 384-S-207 (1.25 2.65 1.28) | 384-S-213 (1.18 1.68 2.25) |
| 384-S-231 (1.72 2.45 1.48) | 384-S-233 (1.11 1.88 2.05) | 384-S-234 (0.93 1.96 1.97) | 384-S-236 (1.15 0.85 3.08) |
| 384-S-237 (0.94 2.26 1.67) | 384-S-244 (0.99 1.87 2.06) | 384-S-245 (0.91 1.65 2.29) | 384-S-246 (1.25 2.21 1.72) |
| 384-S-300 (0.88 1.11 2.82) | 384-S-305 (1.20 1.78 2.16) | 384-S-327 (0.97 2.18 1.75) | 384-S-331 (0.83 1.35 2.58) |
| 384-S-364 (1.44 3.01 0.92) | 384-S-367 (1.25 2.33 1.60) | 384-S-368 (1.36 2.87 1.06) | 384-S-371 (2.41 2.48 1.46) |
| 384-S-395 (1.44 2.18 1.76) | 384-S-440 (1.13 2.08 1.85) | 384-S-441 (1.06 2.01 1.92) | 384-S-473 (1.28 2.36 1.57) |
| 387-S-27 (1.36 2.21 1.39) | 387-S-28 (1.42 2.48 1.12) | 387-S-29 (1.18 2.20 1.39) | 387-S-40 (1.00 2.20 1.39) |
| 387-S-44 (1.07 1.36 2.24) | 387-S-46 (2.59 2.37 1.23) | 387-S-56 (1.35 1.67 1.92) | 387-S-61 (1.33 2.19 1.41) |
| 387-S-62 (1.21 2.39 1.21) | 387-S-65 (1.34 1.98 1.62) | 387-S-68 (1.05 1.95 1.65) | 387-S-79 (1.33 2.36 1.24) |
| 387-S-80 (1.28 2.32 1.28) | 387-S-81 (1.35 2.44 1.16) | 387-S-82 (1.09 2.63 0.97) | 387-S-83 (1.38 1.61 1.98) |
| 387-S-85 (1.84 2.17 1.43) | 387-S-86 (1.06 2.54 1.06) | 387-S-90 (1.72 2.65 0.95) | 387-S-110 (1.39 2.50 1.10) |
| 387-S-111 (2.09 1.62 1.98) | 387-S-112 (1.29 1.99 1.60) | 387-S-115 (1.77 2.47 1.13) | 387-S-118 (1.38 1.89 1.70) |
| 387-S-119 (1.35 2.11 1.49) | 387-S-123 (0.99 2.24 1.36) | 387-S-127 (1.00 0.91 2.68) | 387-S-131 (1.40 1.57 2.03) |
| 387-S-132 (1.31 1.81 1.78) | 387-S-133 (2.10 2.62 0.98) | 387-S-144 (1.44 2.53 1.06) | 387-S-150 (2.92 2.50 1.10) |
| 387-S-153 (2.85 2.60 1.00) | 387-S-154 (2.39 1.72 1.87) | 387-S-158 (1.46 0.94 2.66) | 387-S-161 (1.90 1.03 2.57) |
| 387-S-166 (2.11 1.55 2.05) | 387-S-167 (1.97 1.24 2.36) | 387-S-170 (2.18 0.96 2.64) | 387-S-171 (1.88 1.55 2.05) |
| 387-S-176 (1.05 0.94 2.66) | 387-S-177 (1.94 2.28 1.32) | 387-S-182 (1.08 1.12 2.48) | 387-S-183 (1.58 2.61 0.99) |
| 387-S-184 (2.67 2.09 1.51) | 387-S-187 (1.82 1.46 2.14) | 387-S-192 (2.28 2.61 0.99) | 387-S-193 (1.20 1.77 1.83) |
| 387-S-194 (2.05 1.21 2.39) | 387-S-195 (2.10 1.93 1.67) | 387-S-198 (1.81 1.99 1.61) | 387-S-205 (1.33 2.05 1.55) |
| 387-S-208 (1.30 1.52 2.07) | 387-S-209 (1.04 1.60 2.00) | 387-S-213 (1.78 1.95 1.65) | 387-S-214 (1.34 1.18 2.42) |
| 387-S-217 (1.20 1.98 1.62) | 387-S-218 (1.17 2.16 1.44) | 387-S-219 (0.97 1.71 1.88) | 387-S-222 (1.09 1.56 2.04) |
| 387-S-233 (1.71 2.14 1.45) | 387-S-234 (1.53 2.23 1.37) | 387-S-236 (1.75 1.11 2.49) | 387-S-237 (1.54 2.52 1.08) |
| 387-S-244 (1.59 2.14 1.46) | 387-S-245 (1.51 1.91 1.69) | 387-S-246(1.85 2.48 1.12) | 387-S-275 (0.92 2.12 1.48) |
| 387-S-285 (1.11 1.91 1.69) | 387-S-286 (1.36 1.81 1.79) | 387-S-287 (1.17 1.82 1.77) | 387-S-288 (1.16 1.76 1.83) |
| 387-S-297 (1.22 1.50 2.09) | 387-S-300 (1.48 1.38 2.22) | 387-S-303 (1.24 1.35 2.25) | 387-S-304 (1.28 1.82 1.77) |
| 387-S-305 (1.80 2.04 1.56) | 387-S-308 (1.27 0.99 2.61) | 387-S-311 (1.12 1.71 1.89) | 387-S-312 (1.22 1.58 2.01) |
| 387-S-313 (0.99 1.75 1.85) | 387-S-327 (1.57 2.44 1.15) | 387-S-331 (1.43 1.62 1.98) | 387-S-332 (1.28 1.79 1.80) |
| 387-S-341 (0.88 2.31 1.29) | 387-S-358 (1.23 1.96 1.64) | 387-S-367 (1.85 2.60 1.00) | 387-S-370 (1.19 2.03 1.57) |
| 387-S-391 (1.12 1.71 1.89) | 387-S-395 (2.04 2.44 1.16) | 387-S-430 (1.05 2.54 1.06) | 387-S-434 (1.12 2.01 1.58) |
| 387-S-440 (1.73 2.35 1.25) | 387-S-441 (1.66 2.28 1.32) | 387-S-473 (1.88 2.62 0.97) | 388-S-27 (0.89 1.90 1.86) |
| 388-S-28 (0.95 2.17 1.59) | 388-S-36 (1.11 2.68 1.07) | 388-S-43 (1.52 2.54 1.22) | 388-S-46 (2.12 2.06 1.70) |
| 388-S-56 (0.88 1.36 2.39) | 388-S-61 (0.86 1.88 1.88) | 388-S-65 (0.87 1.67 2.09) | 388-S-70 (1.59 2.75 1.01) |
| 388-S-79 (0.86 2.05 1.71) | 388-S-80 (0.81 2.01 1.75) | 388-S-81 (0.88 2.13 1.63) | 388-S-83 (0.91 1.30 2.45) |
| 388-S-85 (1.37 1.86 1.90) | 388-S-89 (1.34 2.49 1.27) | 388-S-90 (1.25 2.33 1.42) | 388-S-109 (1.43 2.55 1.21) |
| 388-S-110 (0.92 2.19 1.57) | 388-S-111 (1.62 1.31 2.45) | 388-S-112 (0.82 1.68 2.07) | 388-S-113 (1.03 2.60 1.16) |
| 388-S-115 (1.30 2.16 1.60) | 388-S-118 (0.91 1.58 2.17) | 388-S-119 (0.88 1.80 1.96) | 388-S-131 (0.93 1.26 2.50) |
| 388-S-132 (0.84 1.50 2.25) | 388-S-133 (1.63 2.31 1.45) | 388-S-144 (0.97 2.22 1.53) | 388-S-150 (2.45 2.18 1.57) |
| 388-S-151 (2.36 2.44 1.31) | 388-S-152 (3.00 2.74 1.01) | 388-S-153 (2.39 2.29 1.47) | 388-S-154 (1.92 1.41 2.34) |
| 388-S-166 (1.64 1.24 2.52) | 388-S-167 (1.50 0.93 2.83) | 388-S-171 (1.41 1.24 2.52) | 388-S-177 (1.47 1.96 1.79) |
| 388-S-183 (1.11 2.30 1.46) | 388-S-184 (2.20 1.78 1.98) | 388-S-187 (1.35 1.15 2.61) | 388-S-192 (1.81 2.30 1.46) |
| 388-S-194 (1.58 0.90 2.86) | 388-S-195 (1.63 1.62 2.14) | 388-S-198 (1.34 1.68 2.08) | 388-S-205 (0.86 1.74 2.02) |
| 388-S-206 (0.86 2.65 1.10) | 388-S-207 (1.38 2.60 1.15) | 388-S-208 (0.83 1.21 2.54) | 388-S-213 (1.31 1.64 2.12) |
| 388-S-214 (0.87 0.87 2.89) | 388-S-231 (1.85 2.41 1.35) | 388-S-233 (1.24 1.83 1.92) | 388-S-234 (1.06 1.92 1.84) |
| 388-S-236 (1.28 0.80 2.95) | 388-S-237 (1.07 2.21 1.54) | 388-S-244 (1.12 1.83 1.93) | 388-S-245 (1.04 1.60 2.16) |
| 388-S-246 (1.38 2.17 1.59) | 388-S-286 (0.89 1.50 2.25) | 388-S-300 (1.01 1.07 2.69) | 388-S-304 (0.81 1.51 2.24) |
| 388-S-305 (1.33 1.73 2.03) | 388-S-327 (1.10 2.13 1.62) | 388-S-331 (0.96 1.31 2.45) | 388-S-332 (0.81 1.48 2.27) |
| 388-S-367 (1.38 2.29 1.47) | 388-S-368 (1.49 2.83 0.93) | 388-S-371 (2.54 2.43 1.33) | 388-S-395 (1.57 2.13 1.63) |
| 388-S-440 (1.26 2.04 1.72) | 388-S-441 (1.19 1.97 1.79) | 388-S-473 (1.41 2.31 1.44) | 400-S-28 (1.31 0.90 1.22) |
| 400-S-62 (1.10 0.80 1.32) | 400-S-81 (1.25 0.86 1.26) | 400-S-82 (0.98 1.04 1.08) | 400-S-86 (0.95 0.96 1.16) |
| 400-S-89 (1.71 1.21 0.91) | 400-S-90 (1.62 1.06 1.06) | 400-S-110 (1.29 0.91 1.21) | 400-S-115 (1.66 0.89 1.23) |
| 400-S-133 (2.00 1.04 1.08) | 400-S-144 (1.33 0.95 1.17) | 400-S-150 (2.82 0.91 1.21) | 400-S-151 (2.72 1.17 0.95) |
| 400-S-153 (2.75 1.01 1.11) | 400-S-183 (1.48 1.03 1.09) | 400-S-192 (2.17 1.03 1.10) | 400-S-231 (2.22 1.14 0.98) |
| 400-S-237 (1.43 0.94 1.18) | 400-S-246 (1.74 0.89 1.23) | 400-S-327 (1.46 0.86 1.26) | 400-S-367 (1.75 1.01 1.11) |
| 400-S-371 (2.91 1.16 0.96) | 400-S-395 (1.94 0.86 1.26) | 400-S-430 (0.95 0.96 1.16) | 400-S-473 (1.78 1.04 1.08) |
| 401-S-43 (0.88 2.09 1.87) | 401-S-46 (1.47 1.61 2.34) | 401-S-70 (0.94 2.30 1.66) | 401-S-111 (0.98 0.86 3.10) |
| 401-S-133 (0.99 1.86 2.09) | 401-S-150 (1.81 1.74 2.22) | 401-S-151 (1.72 1.99 1.96) | 401-S-152 (2.36 2.29 1.66) |
| 401-S-153 (1.74 1.84 2.12) | 401-S-154 (1.27 0.97 2.99) | 401-S-177 (0.82 1.52 2.44) | 401-S-184 (1.56 1.33 2.63) |
| 401-S-192 (1.16 1.85 2.11) | 401-S-195 (0.99 1.17 2.78) | 401-S-231 (1.21 1.96 1.99) | 401-S-364 (0.92 2.51 1.44) |
| 401-S-368 (0.85 2.38 1.57) | 401-S-371 (1.90 1.98 1.97) | 401-S-395 (0.93 1.68 2.27) | 404-S-27 (1.25 2.22 1.49) |
| 404-S-28 (1.32 2.49 1.22) | 404-S-29 (1.08 2.21 1.50) | 404-S-40 (0.90 2.21 1.50) | 404-S-44 (0.97 1.37 2.34) |
| 404-S-46 (2.49 2.38 1.33) | 404-S-56 (1.24 1.68 2.03) | 404-S-61 (1.23 2.19 1.51) | 404-S-62 (1.11 2.39 1.31) |
| 404-S-65 (1.24 1.99 1.72) | 404-S-68 (0.95 1.95 1.76) | 404-S-79 (1.22 2.37 1.34) | 404-S-80 (1.17 2.32 1.38) |
| 404-S-81 (1.25 2.45 1.26) | 404-S-82 (0.98 2.63 1.07) | 404-S-83 (1.28 1.62 2.09) | 404-S-85 (1.74 2.18 1.53) |
| 404-S-86 (0.95 2.55 1.16) | 404-S-89 (1.71 2.80 0.90) | 404-S-90 (1.62 2.65 1.06) | 404-S-110 (1.29 2.50 1.20) |
| 404-S-111 (1.99 1.62 2.08) | 404-S-112 (1.18 2.00 1.71) | 404-S-115 (1.66 2.48 1.23) | 404-S-118 (1.27 1.90 1.81) |
| 404-S-119 (1.25 2.11 1.59) | 404-S-123 (0.89 2.24 1.46) | 404-S-127 (0.90 0.92 2.79) | 404-S-131 (1.30 1.58 2.13) |
| 404-S-132 (1.21 1.82 1.89) | 404-S-133 (2.00 2.63 1.08) | 404-S-144 (1.33 2.54 1.17) | 404-S-150 (2.82 2.50 1.21) |
| 404-S-151 (2.73 2.76 0.95) | 404-S-153 (2.75 2.60 1.10) | 404-S-154 (2.28 1.73 1.98) | 404-S-158 (1.36 0.94 2.76) |
| 404-S-161 (1.79 1.03 2.67) | 404-S-166 (2.01 1.56 2.15) | 404-S-167 (1.87 1.24 2.46) | 404-S-170 (2.08 0.97 2.74) |
| 404-S-171 (1.78 1.56 2.15) | 404-S-176 (0.95 0.95 2.76) | 404-S-177 (1.83 2.28 1.43) | 404-S-182 (0.97 1.12 2.58) |
| 404-S-183 (1.48 2.62 1.09) | 404-S-184 (2.57 2.09 1.61) | 404-S-187 (1.71 1.47 2.24) | 404-S-192 (2.18 2.62 1.09) |
| 404-S-193 (1.09 1.78 1.93) | 404-S-194 (1.95 1.22 2.49) | 404-S-195 (2.00 1.94 1.77) | 404-S-198 (1.71 2.00 1.71) |
| 404-S-205 (1.23 2.06 1.65) | 404-S-208 (1.19 1.53 2.18) | 404-S-209 (0.94 1.61 2.10) | 404-S-213 (1.68 1.96 1.75) |
| 404-S-214 (1.24 1.19 2.52) | 404-S-217 (1.10 1.99 1.72) | 404-S-218 (1.07 2.17 1.54) | 404-S-219 (0.87 1.72 1.99) |
| 404-S-222 (0.98 1.57 2.14) | 404-S-231 (2.22 2.73 0.98) | 404-S-233 (1.60 2.15 1.56) | 404-S-234 (1.42 2.23 1.47) |
| 404-S-236 (1.65 1.12 2.59) | 404-S-237 (1.43 2.53 1.18) | 404-S-244 (1.49 2.15 1.56) | 404-S-245 (1.41 1.92 1.79) |
| 404-S-246 (1.74 2.49 1.22) | 404-S-275 (0.82 2.12 1.58) | 404-S-285 (1.01 1.92 1.79) | 404-S-286 (1.26 1.82 1.89) |
| 404-S-287 (1.07 1.83 1.88) | 404-S-288 (1.05 1.77 1.94) | 404-S-297 (1.12 1.51 2.20) | 404-S-300 (1.38 1.39 2.32) |
| 404-S-303 (1.14 1.36 2.35) | 404-S-304 (1.18 1.83 1.88) | 404-S-305 (1.69 2.05 1.66) | 404-S-308 (1.17 0.99 2.71) |
| 404-S-311 (1.01 1.72 1.99) | 404-S-312 (1.11 1.59 2.12) | 404-S-313 (0.89 1.76 1.95) | 404-S-327 (1.47 2.45 1.26) |
| 404-S-331 (1.33 1.63 2.08) | 404-S-332 (1.18 1.80 1.91) | 404-S-358 (1.12 1.97 1.74) | 404-S-367 (1.75 2.60 1.10) |
| 404-S-370 (1.09 2.03 1.67) | 404-S-371 (2.91 2.75 0.96) | 404-S-391 (1.01 1.72 1.99) | 404-S-395 (1.94 2.45 1.26) |
| 404-S-430 (0.95 2.55 1.16) | 404-S-434 (1.02 2.02 1.69) | 404-S-440 (1.63 2.36 1.35) | 404-S-441 (1.56 2.28 1.42) |
| 404-S-473 (1.78 2.63 1.08) | 405-S-27 (0.91 1.54 1.84) | 405-S-28 (0.97 1.81 1.57) | 405-S-36 (1.13 2.32 1.05) |
| 405-S-43 (1.55 2.18 1.20) | 405-S-46 (2.14 1.70 1.68) | 405-S-56 (0.90 1.01 2.37) | 405-S-61 (0.88 1.52 1.86) |
| 405-S-65 (0.89 1.31 2.06) | 405-S-70 (1.61 2.39 0.99) | 405-S-79 (0.88 1.69 1.69) | 405-S-80 (0.83 1.65 1.73) |
| 405-S-81 (0.90 1.77 1.61) | 405-S-83 (0.94 0.95 2.43) | 405-S-85 (1.39 1.50 1.88) | 405-S-89 (1.36 2.13 1.25) |
| 405-S-90 (1.27 1.98 1.40) | 405-S-109 (1.45 2.19 1.19) | 405-S-110 (0.94 1.83 1.55) | 405-S- 111 (1.64 0.95 2.43) |
| 405-S-112 (0.84 1.33 2.05) | 405-S-113 (1.05 2.24 1.14) | 405-S-115 (1.32 1.80 1.58) | 405-S-118 (0.93 1.22 2.15) |
| 405-S-119 (0.90 1.44 1.94) | 405-S-131 (0.95 0.90 2.48) | 405-S-132 (0.86 1.15 2.23) | 405-S-133 (1.65 1.95 1.42) |
| 405-S-144 (0.99 1.86 1.51) | 405-S-150 (2.47 1.83 1.55) | 405-S-151 (2.38 2.09 1.29) | 405-S-152 (3.03 2.38 0.99) |
| 405-S-153 (2.41 1.93 1.45) | 405-S-154 (1.94 1.06 2.32) | 405-S-166 (1.66 0.88 2.50) | 405-S-171 (1.43 0.88 2.50) |
| 405-S-177 (1.49 1.61 1.77) | 405-S-183 (1.13 1.94 1.44) | 405-S-184 (2.22 1.42 1.96) | 405-S-192 (1.83 1.94 1.44) |
| 405-S-195 (1.65 1.26 2.11) | 405-S-198 (1.36 1.32 2.05) | 405-S-205 (0.88 1.38 1.99) | 405-S-206 (0.88 2.30 1.08) |
| 405-S-207 (1.40 2.24 1.13) | 405-S-208 (0.85 0.86 2.52) | 405-S-213 (1.33 1.28 2.10) | 405-S-231 (1.87 2.05 1.33) |
| 405-S-233 (1.26 1.48 1.90) | 405-S-234 (1.08 1.56 1.82) | 405-S-237 (1.09 1.85 1.52) | 405-S-244 (1.14 1.47 1.91) |
| 405-S-245 (1.06 1.24 2.14) | 405-S-246 (1.40 1.81 1.57) | 405-S-286 (0.91 1.14 2.23) | 405-S-304 (0.83 1.16 2.22) |
| 405-S-305 (1.35 1.37 2.01) | 405-S-327 (1.12 1.77 1.60) | 405-S-331 (0.98 0.95 2.43) | 405-S-332 (0.83 1.13 2.25) |
| 405-S-367 (1.40 1.93 1.45) | 405-S-368 (1.51 2.47 0.91) | 405-S-371 (2.56 2.07 1.31) | 405-S-395 (1.59 1.77 1.61) |
| 405-S-440 (1.28 1.68 1.70) | 405-S-441 (1.21 1.61 1.77) | 405-S-473 (1.43 1.95 1.42) | 406-S-27 (1.19 2.13 1.55) |
| 406-S-28 (1.25 2.39 1.28) | 406-S-29 (1.01 2.12 1.56) | 406-S-40 (0.84 2.12 1.56) | 406-S-43 (1.83 2.76 0.92) |
| 406-S-44 (0.91 1.282.40) | 406-S-46 (2.42 2.28 1.40) | 406-S-56 (1.18 1.59 2.09) | 406-S-61 (1.16 2.10 1.58) |
| 406-S-62 (1.04 2.30 1.38) | 406-S-65 (1.17 1.90 1.78) | 406-S-68 (0.89 1.86 1.82) | 406-S-79 (1.16 2.27 1.41) |
| 406-S-80 (1.11 2.23 1.45) | 406-S-81 (1.19 2.35 1.32) | 406-S-82 (0.92 2.54 1.14) | 406-S-83 (1.22 1.53 2.15) |
| 406-S-85 (1.67 2.08 1.59) | 406-S-86 (0.89 2.45 1.22) | 406-S-89 (1.65 2.71 0.97) | 406-S-90 (1.56 2.56 1.12) |
| 406-S-109 (1.73 2.77 0.91) | 406-S-110 (1.23 2.41 1.27) | 406-S-111 (1.93 1.53 2.15) | 406-S-112 (1.12 1.91 1.77) |
| 406-S-115 (1.60 2.39 1.29) | 406-S-118 (1.21 1.81 1.87) | 406-S-119 (1.18 2.02 1.66) | 406-S-123 (0.82 2.15 1.53) |
| 406-S-127 (0.84 0.83 2.85) | 406-S-131 (1.24 1.48 2.19) | 406-S-132 (1.15 1.73 1.95) | 406-S-133 (1.94 2.54 1.14) |
| 406-S-144 (1.27 2.45 1.23) | 406-S-150 (2.76 2.41 1.27) | 406-S-151 (2.66 2.67 1.01) | 406-S-153 (2.69 2.51 1.17) |
| 406-S-154 (2.22 1.64 2.04) | 406-S-158 (1.29 0.85 2.83) | 406-S-161 (1.73 0.94 2.74) | 406-S-166 (1.94 1.47 2.21) |
| 406-S-167 (1.80 1.15 2.53) | 406-S-170 (2.01 0.88 2.80) | 406-S-171 (1.71 1.46 2.22) | 406-S-176 (0.89 0.86 2.82) |
| 406-S-177 (1.77 2.19 1.49) | 406-S-182 (0.91 1.03 2.65) | 406-S-183 (1.42 2.53 1.15) | 406-S-184 (2.51 2.00 1.68) |
| 406-S-187 (1.65 1.37 2.30) | 406-S-192 (2.11 2.52 1.16) | 406-S-193 (1.03 1.68 1.99) | 406-S-194 (1.88 1.13 2.55) |
| 406-S-195 (1.94 1.85 1.83) | 406-S-198 (1.65 1.91 1.77) | 406-S-205 (1.17 1.97 1.71) | 406-S-208 (1.13 1.44 2.24) |
| 406-S-209 (0.88 1.52 2.16) | 406-S-213 (1.61 1.86 1.82) | 406-S-214 (1.17 1.10 2.58) | 406-S-217 (1.04 1.90 1.78) |
| 406-S-218 (1.01 2.07 1.61) | 406-S-219 (0.81 1.63 2.05) | 406-S-222 (0.92 1.48 2.20) | 406-S-231 (2.16 2.64 1.04) |
| 406-S-233 (1.54 2.06 1.62) | 406-S-234 (1.36 2.14 1.54) | 406-S-236 (1.58 1.03 2.65) | 406-S-237 (1.37 2.44 1.24) |
| 406-S-244 (1.43 2.05 1.63) | 406-S-245 (1.34 1.83 1.85) | 406-S-246 (1.68 2.39 1.29) | 406-S-285 (0.94 1.82 1.86) |
| 406-S-286 (1.20 1.73 1.95) | 406-S-287 (1.00 1.74 1.94) | 406-S-288 (0.99 1.68 2.00) | 406-S-297 (1.05 1.42 2.26) |
| 406-S-300 (1.31 1.29 2.39) | 406-S-303 (1.07 1.27 2.41) | 406-S-304 (1.11 1.74 1.94) | 406-S-305 (1.63 1.96 1.72) |
| 406-S-308 (1.11 0.90 2.78) | 406-S-311 (0.95 1.63 2.05) | 406-S-312 (1.05 1.50 2.18) | 406-S-313 (0.83 1.67 2.01) |
| 406-S-327 (1.40 2.36 1.32) | 406-S-331 (1.26 1.53 2.14) | 406-S-332 (1.12 1.71 1.97) | 406-S-358 (1.06 1.87 1.80) |
| 406-S-367 (1.69 2.51 1.17) | 406-S-370 (1.03 1.94 1.74) | 406-S-371 (2.85 2.66 1.02) | 406-S-391 (0.95 1.62 2.05) |
| 406-S-395 (1.88 2.36 1.32) | 406-S-430 (0.89 2.46 1.22) | 406-S-434 (0.95 1.93 1.75) | 406-S-440 (1.56 2.26 1.41) |
| 406-S-441 (1.49 2.19 1.49) | 406-S-473 (1.72 2.54 1.14) | 407-S-27 (1.32 2.16 1.42) | 407-S-28 (1.39 2.43 1.15) |
| 407-S-29 (1.15 2.16 1.43) | 407-S-40 (0.97 2.15 1.43) | 407-S-44 (1.04 1.31 2.27) | 407-S-46 (2.56 2.32 1.26) |
| 407-S-56 (1.31 1.62 1.96) | 407-S-61 (1.30 2.14 1.45) | 407-S-62 (1.17 2.34 1.25) | 407-S-65 (1.31 1.93 1.65) |
| 407-S-68 (1.02 1.90 1.69) | 407-S-79 (1.29 2.31 1.27) | 407-S-80 (1.24 2.27 1.32) | 407-S-81 (1.32 2.39 1.19) |
| 407-S-82 (1.05 2.58 1.01) | 407-S-83 (1.35 1.57 2.02) | 407-S-85 (1.81 2.12 1.46) | 407-S-86 (1.02 2.49 1.09) |
| 407-S-90 (1.69 2.60 0.99) | 407-S-110 (1.36 2.45 1.14) | 407-S-111 (2.06 1.57 2.02) | 407-S-112 (1.25 1.95 1.64) |
| 407-S-115 (1.73 2.42 1.16) | 407-S-118 (1.34 1.84 1.74) | 407-S-119 (1.31 2.06 1.52) | 407-S-123 (0.95 2.19 1.40) |
| 407-S-127 (0.97 0.87 2.72) | 407-S-131 (1.37 1.52 2.06) | 407-S-132 (1.28 1.77 1.82) | 407-S-133 (2.07 2.57 1.01) |
| 407-S-144 (1.40 2.48 1.10) | 407-S-150 (2.89 2.45 1.14) | 407-S-153 (2.82 2.55 1.04) | 407-S-154 (2.35 1.68 1.91) |
| 407-S-158 (1.43 0.89 2.70) | 407-S-161 (1.86 0.98 2.61) | 407-S-166 (2.07 1.50 2.08) | 407-S-167 (1.94 1.19 2.40) |
| 407-S-170 (2.14 0.91 2.67) | 407-S-171 (1.84 1.50 2.08) | 407-S-176 (1.02 0.89 2.69) | 407-S-177 (1.90 2.23 1.36) |
| 407-S-182 (1.04 1.07 2.52) | 407-S-183 (1.55 2.56 1.02) | 407-S-184 (2.64 2.04 1.54) | 407-S-187 (1.78 1.41 2.17) |
| 407-S-192 (2.24 2.56 1.02) | 407-S-193 (1.16 1.72 1.86) | 407-S-194 (2.01 1.16 2.42) | 407-S-195 (2.07 1.88 1.70) |
| 407-S-198 (1.78 1.94 1.64) | 407-S-205 (1.30 2.00 1.58) | 407-S-208 (1.26 1.48 2.11) | 407-S-209 (1.01 1.55 2.03) |
| 407-S-213 (1.75 1.90 1.68) | 407-S-214 (1.31 1.132.45) | 407-S-217 (1.17 1.93 1.65) | 407-S-218 (1.14 2.11 1.47) |
| 407-S-219 (0.94 1.67 1.92) | 407-S-222 (1.05 1.51 2.07) | 407-S-231 (2.29 2.67 0.91) | 407-S-233 (1.67 2.10 1.49) |
| 407-S-234 (1.49 2.18 1.41) | 407-S-236 (1.71 1.06 2.52) | 407-S-237 (1.50 2.47 1.11) | 407-S-244 (1.56 2.09 1.49) |
| 407-S-245 (1.48 1.86 1.72) | 407-S-246 (1.81 2.43 1.15) | 407-S-275 (0.89 2.07 1.51) | 407-S-285 (1.07 1.86 1.72) |
| 407-S-286 (1.33 1.76 1.82) | 407-S-287 (1.14 1.77 1.81) | 407-S-288 (1.12 1.71 1.87) | 407-S-297 (1.18 1.46 2.13) |
| 407-S-300 (1.45 1.33 2.25) | 407-S-303 (1.21 1.30 2.28) | 407-S-304 (1.25 1.78 1.81) | 407-S-305 (1.76 1.99 1.59) |
| 407-S-308 (1.24 0.94 2.65) | 407-S-311 (1.08 1.66 1.92) | 407-S-312 (1.18 1.54 2.05) | 407-S-313 (0.96 1.70 1.88) |
| 407-S-327 (1.54 2.39 1.19) | 407-S-331 (1.40 1.57 2.01) | 407-S-332 (1.25 1.75 1.84) | 407-S-341 (0.85 2.26 1.32) |
| 407-S-358 (1.19 1.91 1.67) | 407-S-367 (1.82 2.55 1.04) | 407-S-370 (1.16 1.98 1.61) | 407-S-391 (1.08 1.66 1.92) |
| 407-S-395 (2.01 2.39 1.19) | 407-S-430 (1.02 2.49 1.09) | 407-S-434 (1.09 1.97 1.62) | 407-S-440 (1.69 2.30 1.28) |
| 407-S-441 (1.63 2.23 1.36) | 407-S-473 (1.85 2.57 1.01) | 410-S-27 (1.26 2.29 1.49) | 410-S-28 (1.32 2.56 1.22) |
| 410-S-29 (1.08 2.29 1.49) | 410-S-40 (0.90 2.29 1.49) | 410-S-44 (0.97 1.44 2.34) | 410-S-46 (2.49 2.45 1.33) |
| 410-S-56 (1.25 1.76 2.02) | 410-S-61 (1.23 2.27 1.51) | 410-S-62 (1.11 2.47 1.31) | 410-S-65 (1.24 2.06 1.72) |
| 410-S-68 (0.95 2.03 1.75) | 410-S-79 (1.23 2.44 1.34) | 410-S-80 (1.18 2.40 1.38) | 410-S-81 (1.25 2.52 1.26) |
| 410-S-82 (0.99 2.71 1.07) | 410-S-83 (1.28 1.70 2.08) | 410-S-85 (1.74 2.25 1.53) | 410-S-86 (0.96 2.62 1.16) |
| 410-S-89 (1.71 2.88 0.90) | 410-S-90 (1.62 2.73 1.05) | 410-S-110 (1.29 2.58 1.20) | 410-S-111 (1.99 1.70 2.08) |
| 410-S-112 (1.19 2.08 1.70) | 410-S-115 (1.67 2.55 1.23) | 410-S-118 (1.28 1.98 1.80) | 410-S-119 (1.25 2.19 1.59) |
| 410-S-123 (0.89 2.32 1.46) | 410-S-127 (0.90 1.00 2.78) | 410-S-131 (1.30 1.65 2.13) | 410-S-132 (1.21 1.90 1.88) |
| 410-S-133 (2.00 2.70 1.08) | 410-S-144 (1.34 2.62 1.16) | 410-S-150 (2.82 2.58 1.20) | 410-S-151 (2.73 2.84 0.94) |
| 410-S-153 (2.75 2.68 1.10) | 410-S-154 (2.29 1.81 1.97) | 410-S-158 (1.36 1.02 2.76) | 410-S-161 (1.80 1.11 2.67) |
| 410-S-166 (2.01 1.63 2.15) | 410-S-167 (1.87 1.32 2.46) | 410-S-170 (2.08 1.04 2.74) | 410-S-171 (1.78 1.63 2.15) |
| 410-S-176 (0.95 1.02 2.76) | 410-S-177 (1.84 2.36 1.42) | 410-S-182 (0.98 1.20 2.58) | 410-S-183 (1.48 2.69 1.09) |
| 410-S-184 (2.57 2.17 1.61) | 410-S-187 (1.72 1.54 2.24) | 410-S-192 (2.18 2.69 1.09) | 410-S-193 (1.10 1.85 1.93) |
| 410-S-194 (1.95 1.30 2.49) | 410-S-195 (2.00 2.02 1.77) | 410-S-198 (171208171) | 410-S-205 (1.23 2.14 1.65) |
| 410-S-208 (1.20 1.61 2.17) | 410-S-209 (0.94 1.68 2.10) | 410-S-213 (1.68 2.03 1.75) | 410-S-214 (1.24 1.26 2.52) |
| 410-S-217 (1.10 2.06 1.72) | 410-S-218 (1.07 2.24 1.54) | 410-S-219 (0.87 1.80 1.98) | 410-S-222 (0.99 1.65 2.14) |
| 410-S-231 (2.22 2.80 0.98) | 410-S-233 (1.61 2.23 1.55) | 410-S-234 (1.43 2.31 1.47) | 410-S-236 (1.65 1.20 2.59) |
| 410-S-23 (1.44 2.61 1.18) | 410-S-244 (1.49 2.22 1.56) | 410-S-245 (1.41 1.99 1.79) | 410-S-246 (1.75 2.56 1.22) |
| 410-S-275 (0.82 2.20 1.58) | 410-S-285 (1.01 1.99 1.79) | 410-S-286 (1.26 1.90 1.89) | 410-S-287 (1.07 1.91 1.87) |
| 410-S-288 (1.06 1.85 1.94) | 410-S-297 (1.12 1.59 2.19) | 410-S-300 (1.38 1.46 2.32) | 410-S-303 (1.14 1.43 2.35) |
| 410-S-304 (1.18 1.91 1.87) | 410-S-305 (1.70 2.12 1.66) | 410-S-308 (1.17 1.072.71) | 410-S-311 (102180199) |
| 410-S-312 (1.12 1.67 2.11) | 410-S-313 (0.89 1.84 1.95) | 410-S-327 (1.47 2.53 1.25) | 410-S-331 (1.33 1.70 2.08) |
| 410-S-332 (1.18 1.88 1.90) | 410-S-358 (1.13 2.04 1.74) | 410-S-367 (1.75 2.68 1.10) | 410-S-370 (1.09 2.11 1.67) |
| 410-S-371 (2.91 2.82 0.96) | 410-S-391 (1.02 1.79 1.99) | 410-S-395 (1.94 2.52 1.26) | 410-S-430 (0.95 2.62 1.16) |
| 410-S-434 (1.02 2.10 1.68) | 410-S-440 (1.63 2.43 1.35) | 410-S-441 (1.56 2.36 1.42) | 410-S-473 (1.78 2.71 1.08) |
| 411-S-27 (1.33 2.36 1.41) | 411-S-28 (1.39 2.63 1.14) | 411-S-29 (1.15 2.35 1.42) | 411-S-40 (0.98 2.35 1.42) |
| 411-S-44 (1.04 1.51 2.26) | 411-S-46 (2.56 2.52 1.26) | 411-S-56 (1.32 1.82 1.95) | 411-S-61 (1.30 2.33 1.44) |
| 411-S-62 (1182531.24) | 411-S-65 (1.31 2.13 1.64) | 411-S-68 (1.02 2.09 1.68) | 411-S-79 (1.30 2.51 1.27) |
| 411-S-80 (1.252.46131) | 411-S-81 (1.33 2.59 1.19) | 411-S-82 (1.06 2.77 1.00) | 411-S-83 (1.36 1.76 2.01) |
| 411-S-85 (1.81 2.32 1.46) | 411-S-86 (1.03 2.69 1.09) | 411-S-90 (1.70 2.79 0.98) | 411-S-110 (1.36 2.64 1.13) |
| 411-S-111 (2.07 1.76 2.01) | 411-S-112 (1.26 2.14 1.63) | 411-S-115 (1.74 2.62 1.15) | 411-S-118 (1.35 2.04 1.73) |
| 411-S-119 (1.32 2.26 1.52) | 411-S-123 (0.96 2.38 1.39) | 411-S-127 (0.98 1.06 2.71) | 411-S-131 (1.37 1.72 2.06) |
| 411-S-132 (1.29 1.96 1.81) | 411-S-133 (2.07 2.77 1.00) | 411-S-144 (1.41 2.68 1.09) | 411-S-150 (2.89 2.64 1.13) |
| 411-S-153 (2.83 2.74 1.03) | 411-S-154 (2.36 1.87 1.90) | 411-S-158 (1.43 1.08 2.69) | 411-S-161 (1.87 1.17 2.60) |
| 411-S-166 (2.08 1.70 2.07) | 411-S-167 (1.94 1.38 2.39) | 411-S-170 (2.15 1.11 2.66) | 411-S-171 (1.85 1.70 2.08) |
| 411-S-176 (1.03 1.09 2.68) | 411-S-177 (1.91 2.42 1.35) | 411-S-182 (1.05 1.26 2.51) | 411-S-183 (1.56 2.76 1.01) |
| 411-S-184 (2.64 2.24 1.54) | 411-S-187 (1.79 1.61 2.17) | 411-S-192 (2.25 2.76 1.02) | 41-S-193 (1.17 1.92 1.86) |
| 411-S-194 (2.02 1.36 2.41) | 411-S-195 (2.07 2.08 1.69) | 411-S-198 (1.79 2.14 1.63) | 411-S-205 (1.31 2.20 1.57) |
| 411-S-208 (1.27 1.67 2.10) | 411-S-209 (1.02 1.75 2.02) | 411-S-213 (1.75 2.10 1.68) | 411-S-214 (1.31 1.33 2.44) |
| 411-S-217 (1.182.131.64) | 411-S-218 (1.152.31 1.47) | 411-S-219 (0.95 1.86 1.91) | 411-S-222 (1.06 1.71 2.06) |
| 411-S-231 (2.29 2.87 0.90) | 411-S-233 (1.68 2.29 1.48) | 411-S-234 (1.50 2.37 1.40) | 411-S-236 (1.72 1.26 2.51) |
| 411-S-237 (1.51 2.67 1.10) | 411-S-244 (1.56 2.29 1.49) | 411-S-245 (1.48 2.06 1.71) | 411-S-246 (1.82 2.63 1.15) |
| 411-S-275 (0.89 2.27 1.51) | 411-S-285 (1.08 2.06 1.72) | 411-S-286 (1.33 1.96 1.81) | 411-S-287 (1.14 1.97 1.80) |
| 411-S-288 (1.13 1.91 1.86) | 411-S-297 (1.19 1.65 2.12) | 411-S-300 (1.45 1.53 2.25) | 411-S-303 (1.21 1.50 2.27) |
| 411-S-304 (1.25 1.97 1.80) | 411-S-305 (1.77 2.19 1.58) | 411-S-308 (1.25 1.13 2.64) | 411 -S-311 (1.09 1.86 1.91) |
| 411-S-312 (1.19 1.73 2.04) | 411-S-313 (0.97 1.90 1.87) | 411-S-327 (1.54 2.59 1.18) | 411-S-331 (1.40 1.77 2.00) |
| 411-S-332 (1.26 1.94 1.83) | 411-S-341 (0.85 2.46 1.31) | 411-S-358 (1.20 2.11 1.67) | 411-S-367 (1.82 2.74 1.03) |
| 411-S-370 (1.172.17 1.60) | 411-S-391 (1.09 1.86 1.92) | 411-S-395 (2.02 2.59 1.18) | 411-S-430 (1.03 2.69 1.08) |
| 411-S-434 (1.09 2.16 1.61) | 411-S-440 (1.70 2.50 1.28) | 411-S-441 (1.63 2.42 1.35) | 411-S-473 (1.85 2.77 1.00) |
| 413-S-27 (1.74 2.54 1.00) | 413-S-29 (1.56 2.54 1.01) | 413-S-38 (1.18 1.97 1.58) | 413-S-40 (1.38 2.54 1.01) |
| 413-S-44 (1.45 1.69 1.86) | 413-S-56 (1.73 2.01 1.54) | 413-S-61 (1.71 2.52 1.03) | 413-S-65 (1.72 2.32 1.23) |
| 413-S-68 (1.43 2.28 1.27) | 413-S-71 (0.87 1.51 2.04) | 413-S-80 (1.66 2.65 0.90) | 413-S-83 (1.77 1.95 1.60) |
| 413-S-85 (2.22 2.50 1.05) | 413-S-111 (2.48 1.95 1.60) | 413-S-112 (1.67 2.33 1.22) | 413-S-118 (1.76 2.23 1.32) |
| 413-S-119 (1.73 2.44 1.11) | 413-S-123 (1.37 2.57 0.98) | 413-S-127 (1.39 1.25 2.30) | 413-S-131 (1.78 1.90 1.65) |
| 413-S-132 (1.69 2.15 1.40) | 413-S-136 (1.80 0.84 2.71) | 413-S-154 (2.77 2.06 1.49) | 413-S-158 (1.84 1.27 2.28) |
| 413-S-161 (2.28 1.36 2.19) | 413-S-166 (2.49 1.88 1.67) | 413-S-167 (2.35 1.57 1.98) | 413-S-168 (1.91 0.85 2.70) |
| 413-S-170 (2.56 1.29 2.26) | 413-S-171 (2.26 1.88 1.67) | 413-S-176 (1.44 1.27 2.28) | 413-S-177 (2.32 2.61 0.94) |
| 413-S-182 (1.46 1.45 2.10) | 413-S-184 (3.05 2.42 1.13) | 413-S-187 (2.20 1.79 1.76) | 413-S-193 (1.58 2.10 1.45) |
| 413-S-194 (2.43 1.55 2.00) | 413-S-195 (2.48 2.27 1.28) | 413-S-198 (2.19 2.33 1.22) | 413-S-205 (1.71 2.39 1.16) |
| 413-S-208 (1.68 1.86 1.69) | 413-S-209 (1.43 1.94 1.61) | 413-S-213 (2.16 2.28 1.27) | 413-S-214 (1.72 1.52 2.03) |
| 413-S-217 (1.59 2.31 1.24) | 413-S-218 (1.55 2.49 1.06) | 413-S-219 (1.36 2.05 1.50) | 413-S-222 (1.47 1.90 1.65) |
| 413-S-233 (2.09 2.48 1.07) | 413-S-234 (1.91 2.56 0.99) | 413-S-236 (2.13 1.45 2.10) | 413-S-244 (1.97 2.47 1.08) |
| 413-S-245 (1.89 2.24 1.31) | 413-S-275 (1.30 2.45 1.10) | 413-S-285 (1.49 2.24 1.31) | 413-S-286 (1.74 2.15 1.40) |
| 413-S-287 (1.55 2.16 1.39) | 413-S-288 (1.54 2.10 1.45) | 413-S-297 (1.60 1.84 1.71) | 413-S-300 (1.86 1.71 1.84) |
| 413-S-303 (1.62 1.68 1.87) | 413-S-304 (1.66 2.16 1.39) | 413-S-305 (2.18 2.37 1.18) | 413-S-308 (1.65 1.32 2.23) |
| 413-S-311 (1.50 2.05 1.50) | 413-S-312 (1.60 1.92 1.63) | 413-S-313 (1.37 2.09 1.46) | 413-S-331 (181195160) |
| 413-S-332 (1.66 2.13 1.42) | 413-S-341 (1.26 2.65 0.90) | 413-S-358 (1.61 2.29 1.26) | 413-S-360 (1.05 1.69 1.86) |
| 413-S-370 (1.58 2.36 1.19) | 413-S-391 (1.50 2.04 1.51) | 413-S-421 (1.20 1.08 2.47) | 413-S-434 (1.50 2.35 1.20) |
| 413-S-441 (2.04 2.61 0.94) | 414-S-27 (1.75 2.56 0.99) | 414-S-29 (1.58 2.56 1.00) | 414-S-38 (1.19 1.99 1.57) |
| 414-S-40 (1.40 2.55 1.00) | 414-S-44 (1.47 1.71 1.84) | 414-S-56 (1.74 2.02 1.53) | 414-S-61 (1.72 2.54 1.02) |
| 414-S-65 (1.73 2.33 1.22) | 414-S-68 (1.45 2.30 1.26) | 414-S-71 (0.88 1.53 2.02) | 414-S-83 (1.78 1.97 1.59) |
| 414-S-85 (2.23 2.52 1.03) | 414-S-111 (2.49 1.97 1.59) | 414-S-112 (1.68 2.35 1.21) | 414-S-118 (1.77 2.24 1.31) |
| 414-S-119 (1.74 2.46 1.10) | 414-S-123 (1.38 2.59 0.97) | 414-S-127 (1.40 1.27 2.29) | 414-S-131 (1.80 1.92 1.63) |
| 414-S-132 (1.71 2.17 1.39) | 414-S-136 (1.81 0.86 2.70) | 414-S-154 (2.78 2.08 1.48) | 414-S-158 (1.85 1.29 2.27) |
| 414-S-161 (2.29 1.38 2.18) | 414-S-166 (2.50 1.90 1.65) | 414-S-167 (2.37 1.59 1.97) | 414-S-168 (1.93 0.87 2.68) |
| 414-S-170 (2.57 1.31 2.24) | 414-S-171 (2.27 1.90 1.66) | 414-S-176 (1.45 1.29 2.26) | 414-S-177 (2.33 2.63 0.93) |
| 414-S-182 (1.47 1.47 2.09) | 414-S-184 (3.07 2.44 1.12) | 414-S-187 (2.21181174) | 414-S-193 (1.59 2.12 1.43) |
| 414-S-194 (2.44 1.56 1.99) | 414-S-195 (2.50 2.28 1.27) | 414-S-198 (2.21 2.34 1.21) | 414-S-205 (1.73 2.40 1.15) |
| 414-S-208 (1.69 1.88 1.68) | 414-S-209 (1.44 1.95 1.60) | 414-S-213 (2.17 2.30 1.26) | 414-S-214 (1.74 1.53 2.02) |
| 414-S-217 (1.60 2.33 1.22) | 414-S-218 (1.57 2.51 1.05) | 414-S-219 (1.37 2.07 1.49) | 414-S-222 (1.48 1.91 1.64) |
| 414-S-233 (2.10 2.50 1.06) | 414-S-234 (1.92 2.58 0.98) | 414-S-236 (2.14 1.46 2.09) | 414-S-244 (1.99 2.49 1.07) |
| 414-S-245 (1.90 2.26 1.29) | 414-S-275 (1.31 2.47 1.09) | 414-S-285 (1.50 2.26 1.30) | 414-S-286 (1.76 2.16 1.39) |
| 414-S-287 (1.56 2.17 1.38) | 414-S-288 (1.55 2.11 1.44) | 414-S-297 (1.61 1.86 1.70) | 414-S-300 (1.88 1.73 1.83) |
| 414-S-303 (1.63 1.70 1.85) | 414-S-304 (1.68 2.18 1.38) | 414-S-305 (2.19 2.39 1.16) | 414-S-308 (1.67 1.34 2.22) |
| 414-S-311 (1.51 2.06 1.49) | 414-S-312 (1.61 1.94 1.62) | 414-S-313 (1.39 2.10 1.45) | 414-S-331 (1.82 1.97 1.58) |
| 414-S-332 (1682151.41) | 414-S-338 (2.08 0.80 2.75) | 414-S-358 (1.62 2.31 1.24) | 414-S-360 (1.07 1.71 1.85) |
| 414-S-370 (1.59 2.38 1.18) | 414-S-391 (1.51 2.06 1.49) | 414-S-421 (1.21 1.09 2.46) | 414-S-434 (1.51 2.37 1.19) |
| 414-S-441 (2.05 2.63 0.93) | 417-S-27 (1.33 2.30 1.41) | 417-S-28 (1.40 2.57 1.14) | 417-S-29 (1.16 2.29 1.42) |
| 417-S-40 (0.98 2.29 1.42) | 417-S-44 (1.05 1.45 2.26) | 417-S-46 (2.56 2.46 1.25) | 417-S-56 (1.32 1.76 1.95) |
| 417-S-61 (1.30 2.27 1.44) | 417-S-62 (1182.471.24) | 417-S-65 (1.32 2.07 1.64) | 417-S-68 (1.03 2.03 1.68) |
| 417-S-79 (1.30 2.45 1.26) | 417-S-80 (1.252.40 131) | 417-S-81 (1.33 2.53 1.18) | 417-S-82 (1.06 2.71 1.00) |
| 417-S-83 (1.36 1.70 2.01) | 417-S-85 (1.81 2.26 1.45) | 417-S-86 (1.03 2.63 1.08) | 417-S-90 (1.70 2.73 0.98) |
| 417-S-110 (1.37 2.58 1.13) | 417-S-111 (2.07 1.70 2.01) | 417-S-112 (1.26 2.08 1.63) | 417-S-115 (1.74 2.56 1.15) |
| 417-S-118 (1.35 1.98 1.73) | 417-S-119 (1.32 2.19 1.52) | 417-S-123 (0.96 2.32 1.39) | 417-S-127 (0.98 1.00 2.71) |
| 417-S-131 (138166205) | 417-S-132 (1.29 1.90 1.81) | 417-S-133 (2.08 2.71 1.00) | 417-S-144 (1.41 2.62 1.09) |
| 417-S-150 (2.90 2.58 1.13) | 417-S-153 (2.83 2.68 1.03) | 417-S-154 (2.36 1.81 1.90) | 417-S-158 (1.43 1.02 2.69) |
| 417-S-161 (1.87 1.11 2.60) | 417-S-166 (2.08 1.64 2.07) | 417-S-167 (1.95 1.32 2.39) | 417-S-170 (2.15 1.05 2.66) |
| 417-S171 (1.85 1.63 2.08) | 417-S-176 (1.03 1.03 2.68) | 417-S-177 (1.91 2.36 1.35) | 417-S-182 (1.05 1.20 2.51) |
| 417-S-183 (1.56 2.70 1.01) | 417-S-184 (2.65 2.17 1.54) | 417-S-187 (1.79 1.55 2.16) | 417-S-192 (2.25 2.70 1.02) |
| 417-S-193 (1.17 1.86 1.85) | 417-S-194 (2.02 1.30 2.41) | 417-S-195 (2.08 2.02 1.69) | 417-S-198 (1.79 2.08 1.63) |
| 417-S-205 (1.31 2.14 1.57) | 417-S-208 (1.27 1.61 2.10) | 417-S-209 (1.02 1.69 2.02) | 417-S-213 (1.76 2.03 1.68) |
| 417-S-214 (1321.272.44) | 417-S-217 (1.18 2.07 1.64) | 417-S-218 (1.15 2.25 1.47) | 417-S-219 (0.95 1.80 1.91) |
| 417-S-222 (1.06 1.65 2.06) | 417-S-231 (2.30 2.81 0.90) | 417-S-233 (1.68 2.23 1.48) | 417-S-234 (1.50 2.31 1.40) |
| 417-S-236 (1.72 1.20 2.51) | 417-S-237 (1.51 2.61 1.10) | 417-S-244 (1.57 2.23 1.49) | 417-S-245 (1.48 2.00 1.71) |
| 417-S-246 (1.82 2.56 1.15) | 417-S-275 (0.89 2.20 1.51) | 417-S-285 (1.08 2.00 1.71) | 417-S-286 (1.34 1.90 1.81) |
| 417-S-287 (1.14 1.91 1.80) | 417-S-288 (1.13 1.85 1.86) | 417-S-297 (1.19 1.59 2.12) | 417-S-300 (1.46 1.46 2.25) |
| 417-S-303 (1.21 1.44 2.27) | 417-S-304 (1.26 1.91 1.80) | 417-S-305 (1.77 2.13 1.58) | 417-S-308 (1.25 1.07 2.64) |
| 417-S-311 (109180191) | 417-S-312 (1.19 1.67 2.04) | 417-S-313 (0.97 1.84 1.87) | 417-S-327 (1.54 2.53 1.18) |
| 417-S-331 (1.40 1.71 2.00) | 417-S-332 (1.26 1.88 1.83) | 417-S-341 (0.85 2.40 1.31) | 417-S-358 (1.20 2.05 1.66) |
| 417-S-367 (1.83 2.68 1.03) | 417-S-370 (1.172.11 1.60) | 417-S-391 (1.09 1.80 1.91) | 417-S-395 (2.02 2.53 1.18) |
| 417-S-430 (1.03 2.63 1.08) | 417-S-434 (1.09 2.10 1.61) | 417-S-440 (1.70 2.44 1.27) | 417-S-441 (1.63 2.36 1.35) |
| 417-S-473 (1.86 2.71 1.00) | 418-S-27 (1.29 1.65 1.45) | 418-S-28 (1.36 1.92 1.18) | 418-S-29 (1.12 1.65 1.46) |
| 418-S-40 (0.94 1.65 1.46) | 418-S-44 (1.01 0.80 2.30) | 418-S-46 (2.53 1.81 1.29) | 418-S-56 (1.28 1.12 1.99) |
| 418-S-61 (1.27 1.63 1.48) | 418-S-62 (1.14 1.83 1.28) | 418-S-65 (1.28 1.42 1.68) | 418-S-68 (0.99 1.39 1.72) |
| 418-S-79 (1.26 1.80 1.30) | 418-S-80 (1.21 1.76 1.35) | 418-S-81 (1.29 1.88 1.22) | 418-S-82 (1.02 2.07 1.04) |
| 418-S-83 (1.32 1.06 2.05) | 418-S-85 (1.78 1.61 1.49) | 418-S-86 (0.99 1.98 1.12) | 418-S-90 (1.66 2.09 1.02) |
| 418-S-110 (1.33 1.94 1.17) | 418-S-111 (2.03 1.06 2.05) | 418-S-112 (1.22 1.44 1.67) | 418-S-115 (1.70 1.91 1.19) |
| 418-S-118 (1.31 1.34 1.77) | 418-S-119 (1.28 1.55 1.55) | 418-S-123 (0.92 1.68 1.43) | 418-S-131 (1.34 1.01 2.09) |
| 418-S-132 (1.25 1.26 1.85) | 418-S-133 (2.04 2.06 1.04) | 418-S-144 (1.37 1.98 1.13) | 418-S-150 (2.86 1.94 1.17) |
| 418-S-151 (2772.20091) | 418-S-153 (2.79 2.04 1.07) | 418-S-154 (2.32 1.17 1.94) | 418-S-166 (2.04 0.99 2.11) |
| 418-S-171 (1.81 0.99 2.11) | 418-S-177 (1.87 1.72 1.39) | 418-S-183 (1.52 2.05 1.05) | 418-S-184 (2.61 1.53 1.57) |
| 418-S-187 (1.75 0.90 2.20) | 418-S-192 (2.21 2.05 1.05) | 418-S-193 (1.13 1.21 1.89) | 418-S-195 (2.04 1.38 1.73) |
| 418-S-198 (1.75 1.44 1.67) | 418-S-205 (1.27 1.50 1.61) | 418-S-208 (1.23 0.97 2.14) | 418-S-209 (0.98 1.04 2.06) |
| 418-S-213 (1.72 1.39 1.71) | 418-S-217 (1.14 1.42 1.68) | 418-S-218 (1.11 1.60 1.50) | 418-S-219 (0.91 1.16 1.95) |
| 418-S-222 (1.02 1.01 2.10) | 418-S-231 (2.26 2.16 0.94) | 418-S-233 (1.64 1.59 1.52) | 418-S-234 (1.46 1.67 1.44) |
| 418-S-237 (1.47 1.97 1.14) | 418-S-244 (1.53 1.58 1.52) | 418-S-245 (1.45 1.35 1.75) | 418-S-246 (1.78 1.92 1.18) |
| 418-S-275 (0.86 1.56 1.54) | 418-S-285 (1.04 1.35 1.75) | 418-S-286 (1.30 1.26 1.85) | 418-S-287 (1.11 1.27 1.84) |
| 418-S-288 (1091.21190) | 418-S-297 (1.15 0.95 2.16) | 418-S-300 (1.42 0.82 2.28) | 418-S-304 (1.22 1.27 1.84) |
| 418-S-305 (1.73 1.48 1.62) | 418-S-311 (1.05 1.16 1.95) | 418-S-312 (1.15 1.03 2.08) | 418-S-313 (0.93 1.20 1.91) |
| 418-S-327 (1.51 1.89 1.22) | 418-S-331 (1.37 1.06 2.04) | 418-S-332 (1.22 1.24 1.87) | 418-S-341 (0.82 1.76 1.35) |
| 418-S-358 (1.16 1.40 1.70) | 418-S-367 (1.79 2.04 1.07) | 418-S-370 (1.13 1.47 1.64) | 418-S-371 (2.95 2.18 0.92) |
| 418-S-391 (1.05 1.15 1.95) | 418-S-395 (1.98 1.88 1.22) | 418-S-430 (0.99 1.98 1.12) | 418-S-434 (1.06 1.46 1.65) |
| 418-S-440 (1.66 1.79 1.31) | 418-S-441 (1.60 1.72 1.39) | 418-S-473 (1.82 2.07 1.04) | 425-S-38 (1.44 0.87 1.32) |
| 425-S-56 (1.98 0.90 1.29) | 425-S-65 (1.98 1.21 0.98) | 425-S-68 (1.69 1.17 1.02) | 425-S-83 (2.02 0.84 1.35) |
| 425-S-111 (2.73 0.84 1.34) | 425-S-112 (1.92 1.22 0.97) | 425-S-118 (2.01 1.12 1.07) | 425-S-132 (1.95 1.04 1.15) |
| 425-S-154 (3.02 0.95 1.24) | 425-S-193 (1.83 1.00 1.19) | 425-S-195 (2.74 1.16 1.03) | 425-S-198 (2.45 1.22 0.97) |
| 425-S-205 (1.97 1.28 0.91) | 425-S-209 (1.68 0.83 1.36) | 425-S-213 (2.42 1.18 1.01) | 425-S-217 (1.84 1.21 0.98) |
| 425-S-219 (1.61 0.94 1.25) | 425-S-245 (2.15 1.14 1.05) | 425-S-285 (1.75 1.14 1.05) | 425-S-286 (2.00 1.04 1.15) |
| 425-S-287 (1.81 1.05 1.14) | 425-S-288 (1.79 0.99 1.20) | 425-S-304 (1.92 1.05 1.14) | 425-S-305 (2.43 1.27 0.92) |
| 425-S-311 (1.75 0.94 1.25) | 425-S-312 (1.85 0.81 1.38) | 425-S-313 (1.63 0.98 1.21) | 425-S-331 (2.07 0.85 1.34) |
| 425-S-332 (1.92 1.02 1.17) | 425-S-358 (1.86 1.19 1.00) | 425-S-370 (1.83 1.25 0.94) | 425-S-391 (1.75 0.94 1.25) |
| 425-S-434 (1.76 1.24 0.95) | 432-S-46 (1.30 1.15 2.52) | 432-S-133 (0.81 1.41 2.27) | 432-S-150 (1.63 1.28 2.39) |
| 432-S-151 (1.54 1.54 2.14) | 432-S-152 (2.18 1.84 1.84) | 432-S-153 (1.56 1.38 2.29) | 432-S-184 (1.38 0.87 2.80) |
| 432-S-192 (0.99 1.39 2.28) | 432-S-231 (1.03 1.50 2.17) | 432-S-371 (1.72 1.53 2.15) | 432-S-429 (2.12 2.63 1.05) |
| 433-S-43 (0.99 1.62 1.76) | 433-S-46 (1.58 1.14 2.24) | 433-S-70 (1.05 1.83 1.55) | 433-S-85 (0.83 0.94 2.43) |
| 433-S-89 (0.81 1.57 1.81) | 433-S-109 (0.89 1.63 1.75) | 433-S-133 (1.10 1.39 1.98) | 433-S-150 (1.92 1.27 2.11) |
| 433-S-151 (1.82 1.53 1.85) | 433-S-152 (2.47 1.83 1.55) | 433-S-153 (1.85 1.37 2.01) | 433-S-177 (0.93 1.05 2.33) |
| 433-S-184 (1.67 0.86 2.52) | 433-S-192 (1.27 1.38 2.00) | 433-S-207 (0.84 1.69 1.69) | 433-S-231 (1.32 1.49 1.88) |
| 433-S-246 (0.84 1.25 2.13) | 433-S-364 (1.03 2.05 1.33) | 433-S-367 (0.85 1.37 2.01) | 433-S-368 (0.96 1.91 1.47) |
| 433-S-371 (2.01 1.51 1.86) | 433-S-395 (1.04 1.21 2.16) | 433-S-473 (0.88 1.40 1.98) | 436-S-27 (1.05 1.31 1.69) |
| 436-S-28 (1.12 1.58 1.42) | 436-S-29 (0.88 1.30 1.70) | 436-S-36 (1.28 2.09 0.91) | 436-S-43 (1.69 1.94 1.05) |
| 436-S-46 (2.29 1.46 1.53) | 436-S-61 (1.03 1.28 1.71) | 436-S-62 (0.91 1.48 1.51) | 436-S-65 (1.04 1.08 1.92) |
| 436-S-79 (1.02 1.45 1.54) | 436-S-80 (0.98 1.41 1.58) | 436-S-81 (1.05 1.54 1.46) | 436-S-85 (1.54 1.27 1.73) |
| 436-S-89 (1.51 1.89 1.10) | 436-S-90 (1.42 1.74 1.25) | 436-S-109 (1.59 1.95 1.04) | 436-S-110 (1.09 1.59 1.40) |
| 436-S-112 (0.98 1.09 1.91) | 436-S-113 (1.19 2.01 0.99) | 436-S-115 (1.46 1.57 1.43) | 436-S-118 (1.07 0.99 2.01) |
| 436-S-119 (1.05 1.20 1.79) | 436-S-132 (1.01 0.91 2.09) | 436-S-133 (1.80 1.72 1.28) | 436-S-144 (1.13 1.63 1.37) |
| 436-S-150 (2.62 1.59 1.40) | 436-S-151 (2.53 1.85 1.15) | 436-S-153 (2.55 1.69 1.30) | 436-S-154 (2.09 0.82 2.18) |
| 436-S-177 (1.63 1.37 1.62) | 436-S-183 (1.28 1.71 1.29) | 436-S-184 (2.37 1.18 1.81) | 436-S-192 (1.98 1.70 1.29) |
| 436-S-193 (0.89 0.87 2.13) | 436-S-195 (1.80 1.03 1.97) | 436-S-198 (1.51 1.09 1.91) | 436-S-205 (1.03 1.15 1.85) |
| 436-S-206 (1.03 2.06 0.94) | 436-S-207 (1.55 2.01 0.99) | 436-S-213 (1.48 1.04 1.95) | 436-S-217 (0.90 1.08 1.92) |
| 436-S-218 (0.87 1.25 1.74) | 436-S-231 (2.02 1.82 1.18) | 436-S-233 (1.40 1.24 1.76) | 436-S-234 (1.22 1.32 1.67) |
| 436-S-237 (1.24 1.62 1.38) | 436-S-244 (1.29 1.23 1.76) | 436-S-245 (1.21 1.01 1.99) | 436-S-246 (1.54 1.57 1.42) |
| 436-S-285 (0.81 1.00 1.99) | 436-S-286 (1.06 0.91 2.09) | 436-S-287 (0.87 0.92 2.08) | 436-S-288 (0.85 0.86 2.14) |
| 436-S-304 (0.98 0.92 2.08) | 436-S-305 (1.49 1.14 1.86) | 436-S-311 (0.82 0.81 2.19) | 436-S-327 (1.27 1.54 1.46) |
| 436-S-332 (0.98 0.89 2.11) | 436-S-358 (0.92 1.06 1.94) | 436-S-367 (1.55 1.69 1.30) | 436-S-370 (0.89 1.12 1.87) |
| 436-S-371 (2.71 1.84 1.16) | 436-S-391 (0.81 0.81 2.19) | 436-S-395 (1.74 1.54 1.46) | 436-S-420 (0.92 2.02 0.98) |
| 436-S-434 (0.82 1.11 1.89) | 436-S-440 (1.43 1.45 1.55) | 436-S-441 (1.36 1.37 1.62) | 436-S-473 (1.58 1.72 1.28) |
| 444-S-43 (0.80 1.98 1.94) | 444-S-46 (1.40 1.50 2.42) | 444-S-70 (0.87 2.19 1.73) | 444-S-133 (0.91 1.75 2.17) |
| 444-S-150 (1.73 1.63 2.29) | 444-S-151 (1.64 1.88 2.04) | 444-S-152 (2.28 2.18 1.74) | 444-S-153 (1.66 1.73 2.19) |
| 444-S-154 (1.20 0.86 3.06) | 444-S-184 (1.48 1.22 2.70) | 444-S-192 (1.09 1.74 2.18) | 444-S-195 (0.91 1.06 2.86) |
| 444-S-231 (1.13 1.85 2.07) | 444-S-364 (0.84 2.40 1.51) | 444-S-371 (1.82 1.87 2.05) | 444-S-395 (0.85 1.57 2.35) |
| 444-S-429 (2.22 2.97 0.95) | 445-S-43 (1.13 2.02 1.62) | 445-S-46 (1.72 1.54 2.10) | 445-S-70 (1.19 2.23 1.41) |
| 445-S-85 (0.97 1.34 2.30) | 445-S-89 (0.94 1.97 1.67) | 445-S-90 (0.85 1.82 1.82) | 445-S-93 (0.92 2.71 0.93) |
| 445-S-109 (1.03 2.03 1.61) | 445-S-115 (0.90 1.64 2.00) | 445-S-133 (1.23 1.79 1.84) | 445-S-150 (2.05 1.67 1.97) |
| 445-S-151 (1.96 1.92 1.71) | 445-S-152 (2.61 2.22 1.41) | 445-S-153 (1.99 1.77 1.87) | 445-S-154 (1.52 0.90 2.74) |
| 445-S-177 (1.07 1.45 2.19) | 445-S-184 (1.80 1.26 2.38) | 445-S-192 (1.41 1.78 1.86) | 445-S-195 (1.23 1.10 2.53) |
| 445-S-198 (0.95 1.16 2.47) | 445-S-207 (0.98 2.08 1.55) | 445-S-213 (0.91 1.12 2.52) | 445-S-231 (1.45 1.89 1.75) |
| 445-S-233 (0.84 1.32 2.32) | 445-S-246 (0.98 1.65 1.99) | 445-S-305 (0.93 1.21 2.43) | 445-S-364 (1.17 2.44 1.19) |
| 445-S-367 (0.98 1.77 1.87) | 445-S-368 (1.10 2.31 1.33) | 445-S-371 (2.14 1.91 1.72) | 445-S-395 (1.18 1.61 2.02) |
| 445-S-440 (0.86 1.52 2.12) | 445-S-473 (1.01 1.79 1.84) | 477-S-27 (1.57 1.32 1.17) | 477-S-28 (1.64 1.59 0.90) |
| 477-S-29 (1.40 1.32 1.18) | 477-S-40 (1.22 1.31 1.18) | 477-S-46 (2.81 1.48 1.01) | 477-S-61 (1.55 1.30 1.19) |
| 477-S-62 (1.42 1.50 1.00) | 477-S-65 (1.56 1.09 1.40) | 477-S-68 (1.27 1.06 1.44) | 477-S-79 (1.54 1.47 1.02) |
| 477-S-80 (1.49 1.43 1.07) | 477-S-81 (1.57 1.55 0.94) | 477-S-85 (2.06 1.28 1.21) | 477-S-112 (1.50 1.11 1.39) |
| 477-S-115 (1.98 1.58 0.91) | 477-S-118 (1.59 1.00 1.49) | 477-S-119 (1.56 1.22 1.27) | 477-S-123 (1.20 1.35 1.15) |
| 477-S-132 (1.53 0.93 1.57) | 477-S-154 (2.60 0.84 1.66) | 477-S-177 (2.15 1.39 1.11) | 477-S-184 (2.89 1.20 1.29) |
| 477-S-193 (1.41 0.88 1.61) | 477-S-195 (2.32 1.04 1.45) | 477-S-198 (2.03 1.10 1.39) | 477-S-205 (1.55 1.16 1.33) |
| 477-S-213 (2.00 1.06 1.43) | 477-S-217 (1.42 1.09 1.40) | 477-S-218 (1.39 1.27 1.22) | 477-S-219 (1.19 0.83 1.67) |
| 477-S-233 (1.92 1.26 1.24) | 477-S-234 (1.74 1.34 1.16) | 477-S-244 (1.81 1.25 1.24) | 477-S-245 (1.73 1.02 1.47) |
| 477-S-246 (2.06 1.59 0.90) | 477-S-275 (1.14 1.23 1.26) | 477-S-285 (1.33 1.02 1.47) | 477-S-286 (1.58 0.92 1.57) |
| 477-S-287 (1.39 0.94 1.56) | 477-S-288 (1.37 0.87 1.62) | 477-S-304 (1.50 0.94 1.56) | 477-S-305 (2.01 1.15 1.34) |
| 477-S-311 (1.33 0.82 1.67) | 477-S-313 (1.21 0.86 1.63) | 477-S-327 (1.79 1.55 0.94) | 477-S-332 (1.50 0.91 1.59) |
| 477-S-341 (1.10 1.42 1.07) | 477-S-358 (1.44 1.07 1.42) | 477-S-370 (1.41 1.14 1.36) | 477-S-391 (1.33 0.82 1.67) |
| 477-S-395 (2.26 1.55 0.94) | 477-S-434 (1.34 1.13 1.37) | 477-S-440 (1.95 1.46 1.03) | 477-S-441 (1.88 1.39 1.10) |
| 478-S-27 (1.64 1.37 1.11) | 478-S-29 (1.46 1.36 1.11) | 478-S-40 (1.28 1.36 1.11) | 478-S-46 (2.87 1.53 0.95) |
| 478-S-56 (1.63 0.83 1.64) | 478-S-61 (1.61 1.34 1.13) | 478-S-62 (1.49 1.54 0.93) | 478-S-65 (1.62 1.14 1.33) |
| 478-S-68 (1.33 1.10 1.37) | 478-S-79 (1.61 1.52 0.96) | 478-S-80 (1.56 1.47 1.00) | 478-S-85 (2.12 1.33 1.15) |
| 478-S-112 (1.57 1.15 1.32) | 478-S-118 (1.66 1.05 1.42) | 478-S-119 (1.63 1.26 1.21) | 478-S-123 (1.27 1.39 1.08) |
| 478-S-132 (1.59 0.97 1.50) | 478-S-154 (2.67 0.88 1.59) | 478-S-177 (2.22 1.43 1.04) | 478-S-184 (2.95 1.24 1.23) |
| 478-S-193 (1.48 0.93 1.55) | 478-S-195 (2.38 1.09 1.38) | 478-S-198 (2.09 1.15 1.32) | 478-S-205 (1.61 1.21 1.26) |
| 478-S-213 (2.06 1.10 1.37) | 478-S-217 (1.48 1.14 1.34) | 478-S-218 (1.45 1.31 1.16) | 478-S-219 (1.26 0.87 1.60) |
| 478-S-233 (1.99 1.30 1.17) | 478-S-234 (1.81 1.38 1.09) | 478-S-244 (1.87 1.29 1.18) | 478-S-245 (1.79 1.07 1.41) |
| 478-S-275 (1.20 1.27 1.20) | 478-S-285 (1.39 1.07 1.41) | 478-S-286 (1.64 0.97 1.50) | 478-S-287 (1.45 0.98 1.49) |
| 478-S-288 (1.44 0.92 1.55) | 478-S-304 (1.56 0.98 1.49) | 478-S-305 (2.08 1.20 1.28) | 478-S-311 (1.40 0.87 1.60) |
| 478-S-313 (1.27 0.91 1.56) | 478-S-332 (1.56 0.95 1.52) | 478-S-341 (1.16 1.47 1.00) | 478-S-358 (1.51 1.12 1.36) |
| 478-S-370 (1.48 1.18 1.29) | 478-S-391 (1.40 0.87 1.61) | 478-S-434 (1.40 1.17 1.30) | 478-S-440 (2.01 1.51 0.97) |
| 478-S-441 (1.94 1.43 1.04) | 479-S-27 (1.77 1.23 0.98) | 479-S-29 (1.59 1.22 0.99) | 479-S-40 (1.41 1.22 0.99) |
| 479-S-61 (1.74 1.20 1.00) | 479-S-65 (1.75 1.00 1.21) | 479-S-68 (1.46 0.96 1.24) | 479-S-85 (2.25 1.18 1.02) |
| 479-S-112 (1.70 1.01 1.20) | 479-S-118 (1.78 0.91 1.30) | 479-S-119 (1.76 1.12 1.08) | 479-S-123 (1.40 1.25 0.95) |
| 479-S-132 (1.72 0.83 1.37) | 479-S-177 (2.34 1.29 0.91) | 479-S-184 (3.08 1.10 1.10) | 479-S-195 (2.51 0.95 1.26) |
| 479-S-198 (2.22 1.01 1.20) | 479-S-205 (1.74 1.07 1.14) | 479-S-213 (2.19 0.96 1.24) | 479-S-217 (1.61 1.00 1.21) |
| 479-S-218 (1.58 1.17 1.03) | 479-S-233 (2.12 1.16 1.04) | 479-S-234 (1.94 1.24 0.96) | 479-S-244 (2.00 1.15 1.05) |
| 479-S-245 (1.92 0.93 1.28) | 479-S-275 (1.33 1.13 1.07) | 479-S-285 (1.52 0.92 1.28) | 479-S-286 (1.77 0.83 1.38) |
| 479-S-287 (1.58 0.84 1.37) | 479-S-304 (1.69 0.84 1.36) | 479-S-305 (2.21 1.06 1.15) | 479-S-332 (1.69 0.81 1.39) |
| 479-S-358 (1.63 0.97 1.23) | 479-S-370 (1.60 1.04 1.16) | 479-S-434 (1.53 1.03 1.17) | 479-S-441 (2.07 1.29 0.91) |
| 480-S-36 (0.82 2.01 1.36) | 480-S-37 (0.82 2.31 1.06) | 480-S-43 (1.24 1.86 1.51) | 480-S-46 (1.83 1.38 1.99) |
| 480-S-70 (1.30 2.07 1.30) | 480-S-85 (1.08 1.19 2.19) | 480-S-89 (1.06 1.81 1.56) | 480-S-90 (0.97 1.66 1.71) |
| 480-S-109 (1.14 1.87 1.50) | 480-S-115 (1.01 1.49 1.88) | 480-S-133 (1.35 1.64 1.73) | 480-S-150 (2.17 1.51 1.86) |
| 480-S-151 (2.07 1.77 1.60) | 480-S-152 (2.72 2.07 1.30) | 480-S-153 (2.10 1.61 1.76) | 480-S-177 (1.18 1.29 2.08) |
| 480-S-183 (0.83 1.63 1.74) | 480-S-184 (1.91 1.10 2.27) | 480-S-192 (1.52 1.62 1.75) | 480-S-195 (1.35 0.95 2.42) |
| 480-S-198 (1.06 1.01 2.36) | 480-S-207 (1.09 1.93 1.44) | 480-S-213 (1.02 0.96 2.41) | 480-S-231 (1.56 1.74 1.63) |
| 480-S-233 (0.95 1.16 2.21) | 480-S-244 (0.84 1.15 2.22) | 480-S-246 (1.09 1.49 1.88) | 480-S-305 (1.04 1.06 2.31) |
| 480-S-327 (0.81 1.46 1.91) | 480-S-364 (1.28 2.29 1.08) | 480-S-367 (1.10 1.61 1.76) | 480-S-368 (1.21 2.15 1.22) |
| 480-S-371 (2.26 1.76 1.61) | 480-S-395 (1.29 1.46 1.91) | 480-S-440 (0.97 1.37 2.00) | 480-S-441 (0.90 1.29 2.08) |
| 480-S-473 (1.12 1.64 1.73) | 481-S-27 (1.05 1.94 1.69) | 481-S-28 (1.11 2.21 1.42) | 481-S-29 (0.87 1.93 1.70) |
| 481-S-36 (1.27 2.72 0.91) | 481-S-43 (1.69 2.57 1.06) | 481-S-46 (2.28 2.09 1.54) | 481-S-56 (1.04 1.40 2.23) |
| 481-S-61 (1.02 1.91 1.72) | 481-S-62 (0.90 2.11 1.52) | 481-S-65 (1.03 1.71 1.92) | 481-S-79 (1.02 2.08 1.55) |
| 481-S-80 (0.97 2.04 1.59) | 481-S-81 (1.05 2.17 1.46) | 481-S-83 (1.08 1.34 2.29) | 481-S-85 (1.53 1.90 1.74) |
| 481-S-89 (1.51 2.52 1.11) | 481-S-90 (1.42 2.37 1.26) | 481-S-109 (1.59 2.58 1.05) | 481-S-110 (1.09 2.22 1.41) |
| 481-S-111 (1.79 1.34 2.29) | 481-S-112 (0.98 1.72 1.91) | 481-S-113 (1.19 2.64 0.99) | 481-S-115 (1.46 2.20 1.43) |
| 481-S-118 (1.07 1.62 2.01) | 481-S-119 (1.04 1.83 1.80) | 481-S-131 (1.10 1.30 2.33) | 481-S-132 (1.01 1.54 2.09) |
| 481-S-133 (1.80 2.35 1.28) | 481-S-144 (1.13 2.26 1.37) | 481-S-150 (2.62 2.22 1.41) | 481-S-151 (2.52 2.48 1.15) |
| 481-S-153 (2.55 2.32 1.31) | 481-S-154 (2.08 1.45 2.18) | 481-S-166 (1.80 1.28 2.35) | 481-S-167 (1.66 0.96 2.67) |
| 481-S-171 (1.57 1.27 2.36) | 481-S-177 (1.63 2.00 1.63) | 481-S-183 (1.28 2.34 1.29) | 481-S-184 (2.36 1.81 1.82) |
| 481-S-187 (1.51 1.19 2.44) | 481-S-192 (1.97 2.33 1.30) | 481-S-193 (0.89 1.50 2.13) | 481-S-194 (1.74 0.94 2.69) |
| 481-S-195 (1.80 1.66 1.97) | 481-S-198 (1.51 1.72 1.91) | 481-S-205 (1.03 1.78 1.85) | 481-S-206 (1.02 2.69 0.94) |
| 481-S-207 (1.54 2.64 0.99) | 481-S-208 (0.99 1.25 2.38) | 481-S-213 (1.47 1.67 1.96) | 481-S-214 (1.03 0.91 2.72) |
| 481-S-217 (0.90 1.71 1.92) | 481-S-218 (0.87 1.88 1.75) | 481-S-231 (2.02 2.45 1.18) | 481-S-233 (1.40 1.87 1.76) |
| 481-S-234 (1.22 1.95 1.68) | 481-S-236 (1.44 0.84 2.79) | 481-S-237 (1.23 2.25 1.38) | 481-S-244 (1.29 1.86 1.77) |
| 481-S-245 (1.20 1.64 1.99) | 481-S-246 (1.54 2.20 1.43) | 481-S-285 (0.80 1.63 2.00) | 481-S-286 (1.06 1.54 2.09) |
| 481-S-287 (0.86 1.55 2.08) | 481-S-288 (0.85 1.49 2.14) | 481-S-297 (0.91 1.23 2.40) | 481-S-300 (1.17 1.10 2.53) |
| 481-S-303 (0.93 1.08 2.55) | 481-S-304 (0.97 1.55 2.08) | 481-S-305 (1.49 1.77 1.86) | 481-S-311 (0.81 1.44 2.19) |
| 481-S-312 (0.91 1.31 2.32) | 481-S-327 (1.26 2.17 1.46) | 481-S-331 (1.12 1.35 2.28) | 481-S-332 (0.98 1.52 2.11) |
| 481-S-358 (0.92 1.69 1.94) | 481-S-367 (1.55 2.32 1.31) | 481-S-370 (0.89 1.75 1.88) | 481-S-371 (2.71 2.47 1.16) |
| 481-S-391 (0.81 1.44 2.19) | 481-S-395 (1.74 2.17 1.46) | 481-S-420 (0.92 2.65 0.98) | 481-S-434 (0.81 1.74 1.89) |
| 481-S-440 (1.42 2.08 1.55) | 481-S-441 (1.35 2.00 1.63) | 481-S-473 (1.58 2.35 1.28) | |

In einer Ausführungsform werden an die chemisch substituierbaren Positionen der so erhaltenen organischen Moleküle weitere Reste R angefügt, um die Löslichkeit der Emitter zu steigern und/oder die Polymerisierbarkeit zu ermöglichen ohne dabei die elektronischen Eigenschaften des Moleküls signifikant zu verändern, sodass auch bei Verwendung von R ein Emitter vorliegt, wobei gilt:
jedes R ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN, -CF₃,-NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C=C-, bzw. eine benachbarte CH₂-Gruppe durch -Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden. In einer Ausführungsform ist das Ringsystem, das gebildet werden kann, auf ein monozyklisches aliphatisches Ringsystem mit insgesamt fünf oder sechs Ringgliedern beschränkt.
R² ist bei jedem Auftreten unabhängig voneinander ausgewählt aus der Gruppe bestehend aus H, Deuterium, Phenyl, Naphthyl, CF₃, C(=O)OR³, C(=O)N(R²)₂, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, bzw. eine benachbarte CH₂-Gruppe durch -Si(R⁴)₂-,-Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, oder -S-ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ ist bei jedem Auftreten unabhängig voneinander ausgewählt aus der Gruppe bestehend aus H, Deuterium, Phenyl, Naphthyl, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
R⁴ ist bei jedem Auftreten unabhängig voneinander ausgewählt aus der Gruppe bestehend aus H, Deuterium, Phenyl, Naphthyl, N(R²)₂, CN, CF₃, OH, C(=O)OR³, C(=O)N(R³)₂, C(=O)R³, P(=O)(R⁷)₂, As(=O)(R⁷)₂, P(=S)(R⁷)₂, As(=S)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch -Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁴ auch miteinander ein mono- oder polycyclisches, aliphatisches, aromatisches und/oder benzoannelliertes Ringsystem bilden;
R⁵ ist bei jedem Auftreten unabhängig voneinander ausgewählt aus der Gruppe bestehend aus Phenyl, Naphthyl, CF₃, C(=O)R³, P(=O)(R⁷)₂, As(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch -Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁵ auch miteinander ein mono- oder polycyclisches, aliphatisches, aromatisches und/oder benzoannelliertes Ringsystem bilden;
R⁶ ist bei jedem Auftreten unabhängig voneinander ausgewählt aus der Gruppe bestehend aus Phenyl, Naphthyl, CF₃, Si(R⁴)₃, C(=O)R³, P(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch-R⁹C=CR⁹-, -C≡C-, bzw. eine benachbarte CH₂-Gruppe durch-Si(R⁴)₂-, -Ge(R⁴)₂-, -Sn(R⁴)₂,-C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁶ auch miteinander ein mono- oder polycyclisches, aliphatisches, aromatisches und/oder benzoannelliertes Ringsystem bilden;
R⁷ ist bei jedem Auftreten unabhängig voneinander ausgewählt aus der Gruppe bestehend aus Phenyl, Naphthyl, N(R²)₂, CN, CF₃, C(=O)OR³, C(=O)N(R³)₂, Si(R⁴)₃, C(=O)R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-, -C=N-, -C(=O)O-,-C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-,-O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R⁷ auch miteinander ein mono- oder polycyclisches, aliphatisches, aromatisches und/oder benzoannelliertes Ringsystem bilden;
R⁸ ist bei jedem Auftreten unabhängig voneinander ausgewählt aus der Gruppe bestehend aus H, Deuterium, Phenyl, Naphthyl, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R⁸ auch miteinander ein mono- oder polycyclisches, aliphatisches Ringsystem bilden;
R⁹ ist bei jedem Auftreten unabhängig voneinander ausgewählt aus der Gruppe bestehend aus H, Deuterium, Phenyl, Naphthyl, N(R²)₂, CN, CF₃, NO₂, OH, COOH, C(=O)OR³, C(=O)N(R³)₂, Si(R⁴)₃, B(OR⁵)₂, C(=O)R³, P(=O)(R⁷)₂, P(=S)(R⁷)₂, As(=O)(R⁷)₂, P(=S)(R⁷)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch -R³C=CR³-, -C≡C-, bzw. eine benachbarte CH₂-Gruppe durch -Si(R⁴)₂-, -Ge(R⁴)₂-, -Sn(R⁴)₂, -C(=O)-, -C(=S)-, -C(=Se)-,-C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann, oder eine Kombination dieser Systeme; dabei können zwei oder mehrere dieser Substituenten R⁹ auch miteinander ein mono- oder polycyclisches, aliphatisches, aromatisches und/oder benzoannelliertes Ringsystem.

Polymerisierbare Reste sind solche Reste, die polymerisierbare funktionelle Einheiten tragen, die mit sich selbst homopolymerisiert oder mit anderen Monomeren copolymiersiert werden können. Somit können die erfindungsgemäßen Moleküle als Polymer mit folgenden Wiederholungseinheiten der Formeln 4 und 5 erhalten werden, die als Polymere in der lichtemittierenden Schicht des optoelektronischen Bauelements Verwendung finden können.

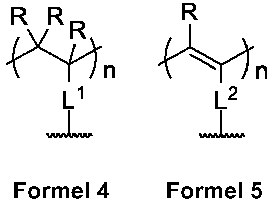

In Formel 4 und 5 stehen L1 und L2 für gleiche oder verschiedene Linkergruppen, die 0 bis 20, insbesondere 1 bis 15, oder 2 bis 10 Kohlenstoffatome aufweisen, und wobei die gewellte Linie die Position kennzeichnet, über die die Linkergruppe an das organische Molekül der Formel 1 oder Formel 2a bis Formel 2d angebunden ist. In einer Ausführungsform weist die Linkergruppe L1 und/oder L2 eine Form -X-L3- auf, wobei X für O oder S steht und L3 für eine Linkergruppe ausgewählt aus der Gruppe aus einer substituierten und unsubstituierten Alkylengruppe (linear, verzweigt oder cyclisch) und einer substituierten und unsubstituierten Arylengruppe, insbesondere eine substituierte oder unsubstituierte Alkylengruppe mit 1 bis 10 Kohlenstoffatomen oder eine substituierte oder unsubstituierte Phenylengruppe, wobei auch Kombinationen möglich sind. In einer weiteren Ausführungsform weist die Linkergruppe L1 und/oder L2 eine Form -C(=O)O- auf. R ist definiert wie oben definiert.

Vorteilhafte Ausführungsformen der Wiederholungseinheiten sind Strukturen der Formeln 6 bis 11:

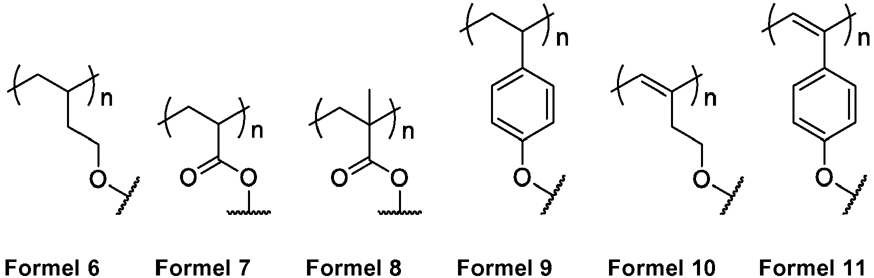

Zur Herstellung der Polymere, die die Wiederholungseinheiten gemäß Formel 6 bis 11 aufweisen, werden die polymerisierbaren funktionellen Einheiten über eine Linkergruppe der Formeln 12 bis 17, die eine Hydroxyleinheit aufweisen, an das organische Molekül der Formel 1 oder Formel 2a bis Formel 2dangebunden und die daraus resultierenden Verbindungen mit sich selbst homopolymerisiert oder mit anderen geeigneten Monomeren copolymerisiert.

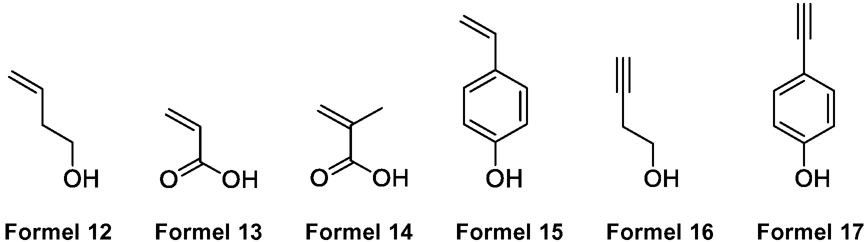

Polymere, die eine Einheit gemäß Formel 4 oder Formel 5 aufweisen, können dabei entweder ausschließlich Wiederholungseinheiten mit einer Struktur der allgemeinen Formel 4 oder 5, oder Wiederholungseinheiten mit einer anderen Struktur aufweisen. Beispiele von Wiederholungseinheiten mit anderen Strukturen weisen Einheiten auf, die sich aus entsprechenden Monomeren ergeben, die typischerweise in Copolymerisationen eingesetzt oder verwendet werden. Beispiele für derartige Wiederholungseinheiten, die sich aus Monomeren ergeben, sind Wiederholungseinheiten, die ungesättigte Einheiten wie Ethylen oder Styrol aufweisen.

Eine Ausführungsform der Erfindung betrifft organischen Moleküle, welche
- einen ΔE(S₁-T₁)-Wert zwischen dem untersten angeregten Singulett (S₁)- und dem darunter liegenden Triplett (T₁)-Zustand von kleiner als 0,2 eV, insbesondere kleiner als 0,1 eV aufweisen und/oder
- eine Emissionslebensdauer von höchstens 50 µs aufweisen.

Eine weitere Ausführungsform der Erfindung betrifft die Verwendung eines Separators S in Form einer neutralen chemischen Einheit zur Bereitstellung eins erfindungsgemäßen organischen Moleküls, wobei mindestens eine erste chemische Einheit AF1, aufweisend ein konjugiertes System, insbesondere mindestens sechs in Konjugation stehende π-Elektronen und mindestens eine zweite chemische Einheit AF2, aufweisend ein konjugiertes System, insbesondere mindestens sechs in Konjugation stehende π-Elektronen, kovalent über den Separator S derart verknüpft wird, dass der Separator S eine direkte elektronische Wechselwirkung über konjugierte Bindungen zwischen dem konjugierten System der ersten chemischen Einheit AF1 und dem konjugierten System der zweiten chemischen Einheit AF2 unterbindet.

Die Erfindung betrifft in einem Aspekt die Verwendung eines erfindungsgemäßen organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:
- organischen lichtemittierenden Dioden (OLEDs),
- lichtemittierenden elektrochemischen Zellen,
- OLED-Sensoren, insbesondere in nicht hermetisch nach außen abgeschirmten Gas- und Dampf-Sensoren,
- organischen Dioden,
- organischen Solarzellen,
- organischen Transistoren,
- organischen Feldeffekttransistoren,
- organischen Lasern und
- Down-Konversions-Elementen.

Der Anteil des erfindungsgemäßen organischen Moleküls am lumineszierenden Emitter und/oder Hostmaterial und/oder Elektronentransportmaterial und/oder Lochinjektionsmaterial und/oder Lochblockiermaterial beträgt in einer Ausführungsform 1 % bis 99 % (Gew%), insbesondere beträgt der Anteil am Emitter in optischen Licht emittierenden Bauelementen, insbesondere in OLEDs, zwischen 5 % und 80 %.

Die Erfindung betrifft in einem weiteren Aspekt optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischen lichtemittierenden Dioden (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

Eine Ausführungsform betrifft das erfindungsgemäße optoelektronische Bauelement aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein erfindungsgemäßes organisches Molekül enthält.

In einer weiteren Ausführungsform des Bauelements wird das organische Molekül als Emissionsmaterial in einer Emissionsschicht eingesetzt wird, wobei sie in Kombination mit mindestens einem Hostmaterial oder insbesondere als Reinschicht eingesetzt werden kann. In einer Ausführungsform beträgt dabei der Anteil des organischen Moleküls als Emissionsmaterial in einer Emissionsschicht in optischen Licht-emittierenden Bauelementen, insbesondere in OLEDs, zwischen 5 % und 80 % (Gew%).

In einer weiteren Ausführungsform des erfindungsgemäßen Bauelements ist die ein erfindungsgemäßes organisches Molekül aufweisende lichtemittierende Schicht auf ein Substrat aufgebracht.

In einer Ausführungsform betrifft die Erfindung ein optoelektronisches Bauelement, bei dem die lichtemittierende Schicht ausschließlich ein erfindungsgemäßes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement neben dem erfindungsgemäßen organischen Molekül mindestens ein Hostmaterial auf, wobei insbesondere der angeregte Singulettzustand (S₁) und/oder der angeregte Triplettzustand (T₁) des mindestens einen Hostmaterials höher ist als der angeregte Singulettzustand (S₁) und/oder der angeregte Triplettzustand (T) des organischen Moleküls, und wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement ein Substrat, eine Anode, eine Kathode und mindestens je eine löcherinjizierende und eine elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett (T₁)- und Singulett (S₁)-Energieniveaus energetisch höher liegen als die Triplett (T₁)- und Singulett (S₁)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer weiteren Ausführungsform weist das optoelektronische Bauelement ein Substrat, eine Anode, eine Kathode und mindestens je eine löcherinjizierende und eine elektroneninjizierende Schicht, und mindestens je eine löchertransportierende und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett (T₁)- und Singulett (S₁)-Energieniveaus energetisch höher liegen als die Triplett (T₁)- und Singulett (S₁)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement mindestens ein Hostmaterial aus einem Material gemäß Formel 1 oder Formel 2a bis Formel 2d auf.

In einer weiteren Ausführungsform des optoelektronischen Bauelements beinhaltet die lichtemittierende Schicht fluoreszente oder phosphoreszente Materialien, welche ausgewählt sein können aus Formel 1 oder Formel 2a bis Formel 2d.

In einer weiteren Ausführungsform des optoelektronischen Bauelements bilden ein organisches Molekül gemäß Formel 1 oder Formel 2a bis Formel 2d und ein funktionelles Material, beispielsweise in Form eines weiteren Emitter-Materials, eines Host-Materials, oder eines weiteren organisches Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

In einer weiteren Ausführungsform des optoelektronischen Bauelements ist die Emission durch thermisch aktivierte verzögerte Fluoreszenz (TADF) charakterisiert.

In einer weiteren Ausführungsform des optoelektronischen Bauelements werden organische Moleküle gemäß Formel 1 oder Formel 2a bis Formel 2d als Ladungstransportschicht verwendet.

Die Erfindung betrifft in einem Aspekt ein lichtemittierendes Material, aufweisend ein erfindungsgemäßes organisches Molekül und ein Hostmaterial, wobei die Triplett (T₁)- und Singulett (S₁)-Energieniveaus des Hostmaterials energetisch höher liegen als die Triplett (T₁)- und Singulett (S₁)-Energieniveaus des organischen Moleküls, und wobei das organische Molekül Fluoreszenz oder thermisch aktivierte verzögerte Fluoreszenz (TADF) emittiert, und einen ΔE(S₁-T₁)-Wert zwischen dem untersten angeregten Singulett (S₁)- und dem darunter liegenden Triplett (T₁)-Zustand von kleiner als 0,2 eV, insbesondere kleiner als 0,1 eV aufweist.

Ein Aspekt der Erfindung betrifft ein Verfahren zur Herstellung eines optoelektronischen Bauelements aufweisend ein erfindungsgemäßes organisches Molekül. In einer Ausführungsform weist das Verfahren den Schritt der Verarbeitung des organischen Moleküls mittels eines Vakuumverdampfungsverfahrens oder aus einer Lösung auf.

In einer Ausführungsform weist das Verfahren das Aufbringen des organischen Moleküls auf einen Träger auf, wobei das Aufbringen insbesondere nass-chemisch, mittels kolloidaler Suspension oder mittels Sublimation erfolgt.

In einer weiteren Ausführungsform des Verfahrens wird mindestens eine Schicht
- mit einem Sublimationsverfahren beschichtet
- mit einem OVPD (Organic Vapor Phase Deposition) Verfahren beschichtet
- mit Hilfe einer Trägergassublimation beschichtet oder
- aus Lösung oder mit einem beliebigen Druckverfahren hergestellt.

Ein Aspekt der Erfindung betrifft ein Verfahren zur Veränderung der Emissions- und/oder Absorptionseigenschaften eines elektronischen Bauelements, wobei ein erfindungsgemäßes organisches Molekül in ein Matrixmaterial zur Leitung von Elektronen oder Löchern in einem optoelektronischen Bauelement eingebracht wird.

Die Erfindung betrifft zudem in einem weiteren Aspekt die Verwendung eines erfindungsgemäßen Moleküls zur Umwandlung von UV-Strahlung oder von blauem Licht in sichtbares Licht, insbesondere in grünes, gelbes oder rotes Licht (Down-Konversion), insbesondere in einem optoelektronischen Bauelement der hier beschriebenen Art.

In einem weiteren Aspekt betrifft die Erfindung eine Anwendung, in der mindestens ein Material aus Formel 1 oder Formel 2a bis Formel 2d, durch äußere energetische Anregung zum Leuchten angeregt wird. Die äußere Anregung kann elektronisch oder optisch oder radioaktiv sein.

### Beispiele

### Berechnungen nach der Dichtefuntionaltheorie

### Variante 1 (BP86)

Für die DFT-Rechnungen (Dichtefunktionaltheorie) wurde das BP86-Funktional (Becke, A. D. Phys. Rev. A1988, 38, 3098-3100; Perdew, J. P. Phys. Rev. B1986, 33, 8822-8827) und def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) verwendet. Zur numerischen Integration kam das m4-Grid zum Einsatz und die resolution-of-identity-Näherung (RI) (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) wurde in allen Rechnungen verwendet. Die DFT-Rechnungen wurden mit dem Turbomole-Programmpaket (Version 6.5) (TURBOMOLE V6.4 2012, University of Karlsruhe und Forschungszentrum Karlsruhe GmbH, 1989-2007, TURBOMOLE GmbH, seit 2007; http://www.turbomole.com) durchgeführt.

### Variante 2 (TD-B3LYP)

Für die Optimierung der Molekülstrukturen wurde das BP86-Funktional (Becke, A. D. Phys. Rev. A1988, 38, 3098-3100; Perdew, J. P. Phys. Rev. B1986, 33, 8822-8827) verwendet, wobei die resolution-of-identity-Näherung (RI) (Sierka, M.; Hogekamp, A.; Ahlrichs, R. J. Chem. Phys. 2003, 118, 9136-9148; Becke, A.D. , J.Chem.Phys. 98 (1993) 5648-5652; Lee, C; Yang, W; Parr, R.G. Phys. Rev. B 37 (1988) 785-789) zum Einsatz kam. Anregungsenergien wurden bei der mit BP86 optimierten Struktur mit der Time-Dependent DFT-Methode (TD-DFT) unter Verwendung des B3LYP-Funktionals (Becke, A.D. , J.Chem.Phys. 98 (1993) 5648-5652; Lee, C; Yang, W; Parr, R.G. Phys. Rev. B 37 (1988) 785-789; Vosko, S. H.; Wilk, L.; Nusair, M. Can. J. Phys. 58 (1980) 1200-1211; Stephens, P. J.; Devlin, F. J.; Chabalowski, C. F. ; Frisch, M. J. J.Phys.Chem. 98 (1994) 11623-11627) berechnet. In allen Rechnungen wurden def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) und ein m4 -Grid zur numerischen Integration verwendet. Alle DFT-Rechnungen wurden mit dem Turbomole-Programmpaket (Version 6.5) (TURBOMOLE V6.4 2012, University of Karlsruhe und Forschungszentrum Karlsruhe GmbH, 1989-2007, TURBOMOLE GmbH, seit 2007; http://www.turbomole.com) durchgeführt.

### Synthesevorschriften:

### AAV1: Hartwig-Buchwald-Aminierung

Unter Schutzgasatmosphäre werden das entsprechende Arylbromid oder -lodid und das entsprechende Amin im gewünschten stöchiometrischen Verhältnis sowie NaO*t*Bu (1,5 mmol pro mmol Amin), PdOAc₂ (0,05 Äquiv.) und P(*t*Bu)₃ (0,1 Äquiv.) in absolutem Toluol suspendiert. Das Gemisch wird 24 h unter Rückfluss erhitzt. Nach dem Abkühlen auf RT wird das Reaktionsgemisch mit dem gleichen Volumen Ethylacetat versetzt und 3x mit Wasser extrahiert. Die organische Phase wird über MgSO₄ getrocknet und anschließend filtriert. Nach Entfernen des Lösungsmittels wird der Rückstand durch Umkristallisation oder per MPLC gereinigt.

### AAV2: kupferkatalysierte Aminierung von Arylhalogeniden

Unter Schutzgasatmosphäre werden das entsprechende Arylbromid oder -lodid (1 Äquiv.), das entsprechende Amin (1,1 Äquiv. pro zu substituierendem Halogenidäquivalent), K₂CO₃ (1,5 mmol pro eingesetztem mmol Amin) und Cul (0,5 Äquiv.) in abs. *o*-Dichlorbenzol (10 mL pro mmol Amin) suspendiert. Das Gemisch wird 24 h unter Rückfluss erhitzt. Nach Abkühlen auf RT wird das Reaktionsgemisch filtriert und anschließend das Filtrat durch Destillation vom Lösungsmittel befreit. Der Rückstand wird durch Umkristallisation oder per MPLC gereinigt.

### AAV3: Nucleophile Aromatische Substitution

Unter Schutzgasatmosphäre werden das entsprechende Arylfluorid und das entsprechende Amin im gewünschten stöchiometrischen Verhältnis sowie K₃PO₄ (2 mmol pro mmol Amin) vorgelegt. Nach der Zugabe von absolutem DMSO wird das Gemisch bis zur vollständigen Umsetzung auf 120 °C erhitzt. Nach Abkühlen auf RT werden durch Zugabe von Wasser die organischen Komponenten ausgefällt und anschließend abfiltriert und mit Wasser gewaschen. Der Rückstand wird durch Umkristallisation gereinigt.

### AAV4: Suzuki-Kupplung

Unter Schutzgasatmosphäre werden das entsprechende Arylbromid und die entsprechende Arylboronsäure in gewünschten stöchiometrischen Verhältnis sowie Na₂CO₃ (2,5 mmol pro mmol Boronsäure) und Pd(PPh₃)₄ (0,02 mmol pro mmol Arylbromid) in 1,2-Dimethoxyethan (10 mL pro mmol Arylbromid) suspendiert. Nach Zugabe von absolutem EtOH (0,3 mL pro mmol Arylbromid) und entgastem Wasser (0,3 mL pro mmol Arylbromid) wird das Gemisch 4-12 h auf 90 °C erhitzt. Nach Abkühlen auf RT werden dem Gemisch gleiche Volumen Wasser und Ethylacetat zugesetzt und die Phasen getrennt. Die wässrige Phase wird 3x mit Ethylacetat extrahiert und die organischen Phasen vereinigt. Die organische Phase wird mit ges. NaCI-Lösung gewaschen, über MgSO4 getrocknet und filtriert. Unter vermindertem Druck wird das Lösungsmittel entfernt und der Rückstand durch Umkristallisation oder per MPLC gereinigt.

### AAV5: Einführung von Cyanogruppen

Unter Schutzgasatmosphäre werden das entsprechende Arylbromid oder -lodid und CuCN im gewünschten stöchiometrischen Verhältnis (1,25 mmol CuCN pro mmol zu substituierendem Halogenidatom) in absolutem DMF suspendiert. Das Gemisch wird bis zur vollständigen Umsetzung auf 150 °C erhitzt. Nach Abkühlen auf RT werden durch Zugabe von Dichlormethan die enthaltenen Kupfersalze ausgefällt und anschließend abfiltriert. Das Filtrat wird unter vermindertem Druck vom Lösungsmittel befreit und der Rückstand durch Umkristallisation oder per MPLC gereinigt.

### Beispiel 1:

Kommerziell erhältliches p-Bromtertaphenylmethan wurde mit 2 Äquivalenten einer Boronsäure umgesetzt (siehe beispielsweise Cui, Synthesis, 2007, 393-399) und anschließend mit 2 Äquivalenten Diphenylamin gekuppelt.

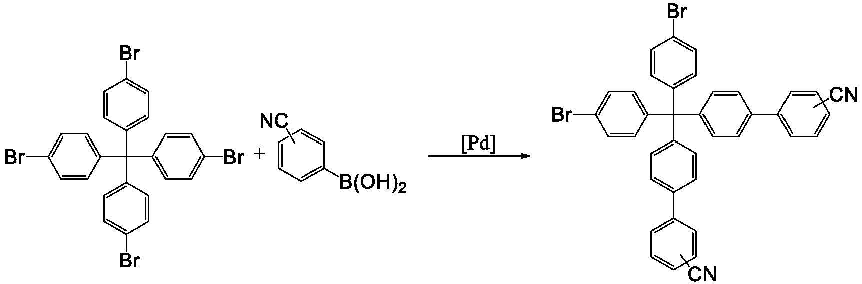

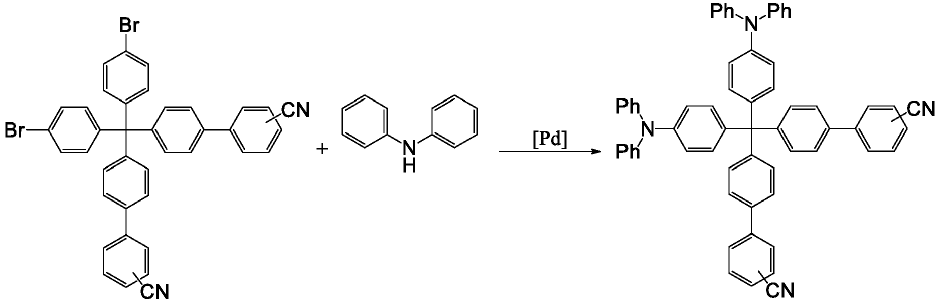

### Beispiel 2

Tris(p-Bromphenyl)-phenylmethan (Schoepfle, J. Am. Chem. Soc., 1936, 58 (5), 791-794) wurde mit zwei Äquivalenten Diphenylamin abreagieren gelassen (siehe beispielsweise Sheng, Hartwig, Org. Lett., 2008, 10, 4109-4112). Im nächsten Schritt wurde die verbleibende Bromfunktionalität in das Boronsäurederivat überführt (siehe beispielsweise Cundy, Tetrahedron Letters 1998, 39, 7979-7982), um dieses im letzten Schritt mit 1-(4-Bromophenyl)-2,2-dimethylpropan-1-one zu kuppeln (siehe beipielsweise Cui, Synthesis, 2007, 393-399).

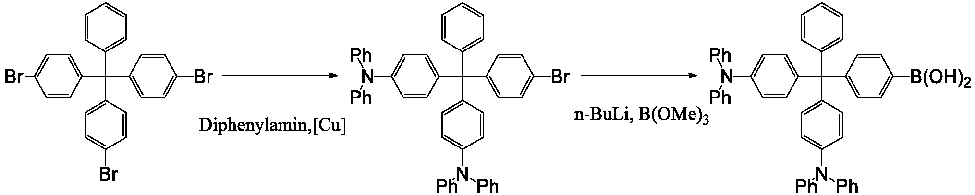

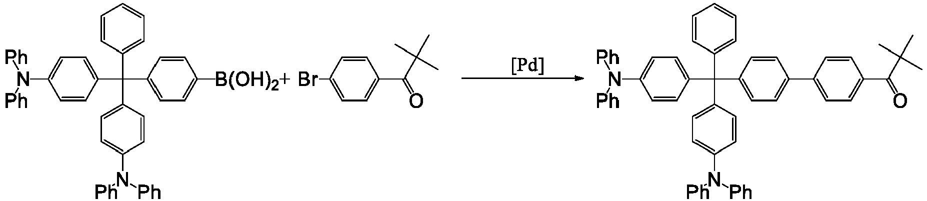

### Figuren

Es zeigen
- Figur 1:: Schematische Darstellung des Aufbaus einer organischen lichtemittierenden Diode (OLED).
- Figur 2:: Schematische Darstellung des Energieniveaudiagrammes (relative Energie in eV) eines erfindungsgemäßen Emitters (Lichtemission resultiert aus dem Übergang LUMO AF2 hin zu HOMO AF1).
- Figur 3:: HOMO der Verbindung A.
- Figur 4:: LUMO der Verbindung A.

## Patentansprüche

1. Organisches Molekül, aufweisend eine Struktur der Formel 1 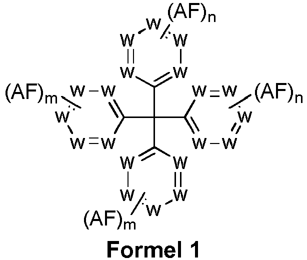 wobei in Formel 1 gilt
m ist unabhängig voneinander bei jedem Auftreten gleich 1, 2, 3, 4 oder 5;
n ist unabhängig voneinander bei jedem Auftreten gleich 0, 1, 2, 3, 4 oder 5;
w ist CR**;
R** ist entweder ein Rest R* oder kennzeichnet die Stelle, über die ein Rest AF an das Kohlenstoffatom des Ringes gebunden ist;
AF ist eine organische chemische Einheit, wobei im organischen Molekül mindestens eine erste chemische AF1 und eine zweite dazu unterschiedliche chemische Einheit AF2 enthalten sind, wobei AF1 und AF2 an jeweils unterschiedlichen Ringen angebunden sind und wobei, wenn die Gesamtzahl der Einheiten AF im Molekül mehr als 2 beträgt, die weiteren Einheiten AF identisch zu AF1 oder AF2 sind;
wobei AF2 eine Struktur der Formel 3a aufweist: 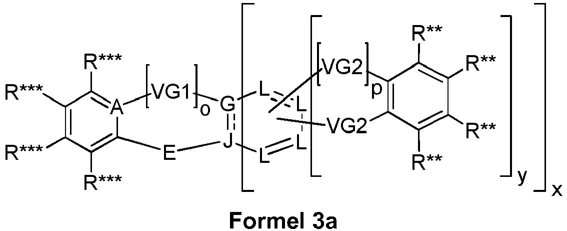 wobei in Formel 3a gilt:
x ist 0 oder 1;
y ist 0 oder 1, wobei bei x = 0 immer auch y = 0 ist;
o ist 0 oder 1;
p ist 0 oder 1;
A ist CR*** wenn o = 0, ansonsten C;
VG1 ist eine verbrückende Gruppe ausgewählt aus der Gruppe bestehend aus
- NR**, CR**₂, O, S und einer C-C-Einfachbindung,
- NR**, CR**₂, O, S, einer C-C-Einfachbindung, BR**, AsR**, SiR**₂, GeR**₂, 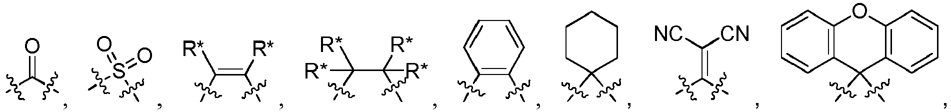 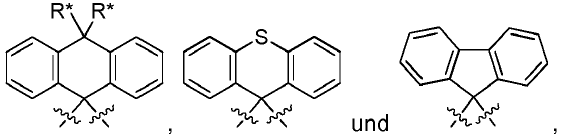 wenn x = 1 und gleichzeitig y = 0;
VG2 ist eine verbrückende Gruppe bei jedem Auftreten unabhängig voneinander ausgewählt aus der Gruppe bestehend aus CR**₂, NR**, O, S und einer C-C-Einfachbindung, wobei nicht zwei Einheiten VG2 gleichzeitig gleich eine C-C-Einfachbindung sind;
E ist NR**, 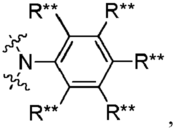 O oder S;
G ist C wenn o = 1 und gleichzeitig x = 1; G ist CR** wenn o = 0 und gleichzeitig x = 1; G ist CR** oder CR**₂, wenn o = 1 und gleichzeitig x = 0;G ist R* wenn o = 0 und gleichzeitig x = 0; G ist CR**, CR**₂, N oder NR* wenn x = 0 und gleichzeitig VG1 eine C-C-Einfachbindung ist;
J ist C wenn x = 1; J ist CR**, CR**₂ oder NR** wenn x = 0;
L ist CR*** wenn y = 0; L ist CR** oder C (bei kovalenter Bindung zu VG2) wenn y = 1;
R*** ist R** oder ist ausgewählt aus den folgenden Einheiten, wobei maximal zwei der Reste
R*** gleichzeitig gleich einer der folgenden Einheiten sind: 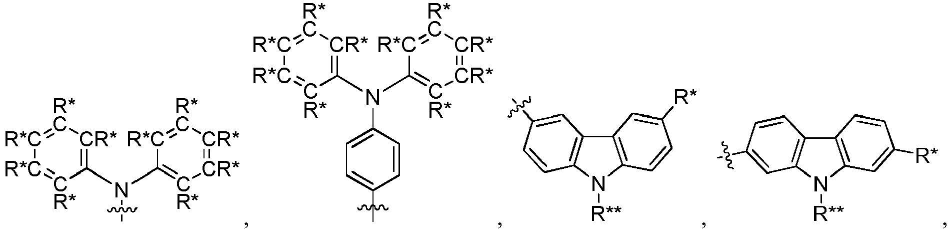 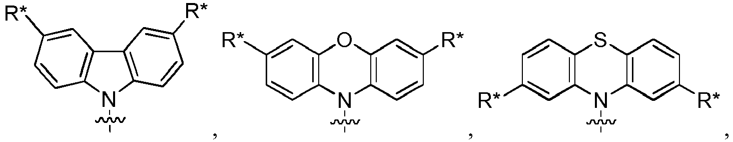 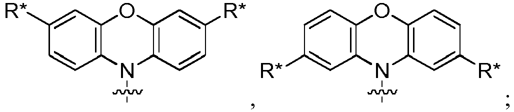
R** ist bei jedem Auftreten unabhängig voneinander ein Rest R* und/oder markiert die Anknüpfungsstelle für eine Tetraarylmethaneinheit;
und wobei die chemischen Einheiten AF1 eine Struktur der Formel 3b aufweisen: 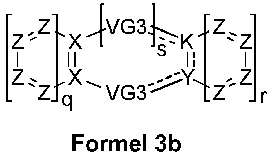 wobei in Formel 3b gilt:
q ist 0 oder 1; r ist 0 oder 1; s ist 0 oder 1;
VG3 = verbrückende Gruppe ist bei jedem Auftreten unabhängig voneinander ausgewählt aus der Gruppe bestehend aus
- N, O, S, CR**, eine Element-Element-Einfachbindung zwischen X und Y oder zwischen X und K, wobei nicht 2 Einheiten VG3 gleichzeitig eine Element-Element-Einfachbindung zwischen X und Y und zwischen X und K sind;
- BR**, NR**, GeR**₂, AsR**₂, SiR**₂, wobei nicht zwei Einheiten VG3 gleichzeitig gleich BR**, NR**, GeR**₂, AsR**₂, SiR**₂ sind; 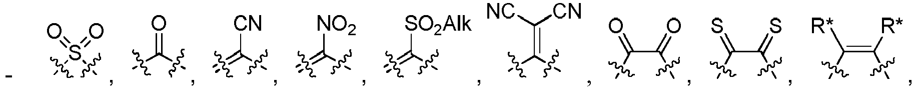 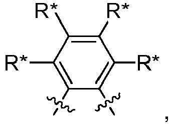 wobei nicht zwei Einheiten VG3 gleichzeitig gleich 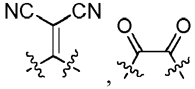 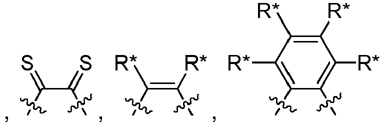 sind;
X ist bei jedem Auftreten unabhängig voneinander C; oder X ist CR**, N wenn q = 0;
Y ist C; oder Y ist CR**, CR**₂, N, NR*, O oder S wenn r = 0;
K ist Y; oder K ist R* wenn r = 0 und gleichzeitig s = 0;
Z ist bei jedem Auftreten unabhängig voneinander CR** oder N;
und wobei maximal 4 der Einheiten VG3, K, X, Y, Z gleichzeitig gleich N sind;
und wobei mindestens 1 der Einheiten VG3, K, X, Y, Z gleich einer von C-H verschiedenen Gruppe ist, die mindestens 1 Stickstoff- oder ein Sauerstoff- oder ein Schwefelatom enthält;
und wobei im Falle von r = 0 auch zwei benachbarte Gruppen Z miteinander oder eine Gruppe VG3 mit der ihr am nächsten gelegenen Gruppe Z über die folgenden Einheiten verbrückt sein können: 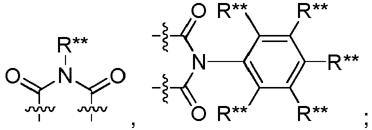
und wobei im Falle von r = 0 und gleichzeitig q = 0 auch eine Gruppe VG3 mit der ihr benachbarten Gruppe X über die Einheiten 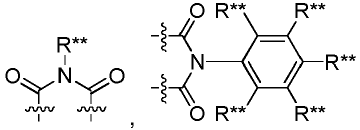 verbrückt sein kann;
und wobei maximal drei dieser Einheiten enthalten sind;
R** ist bei jedem Auftreten unabhängig voneinander ein Rest R* und/oder markiert die Anknüpfungsstelle für die Tetraarylmethaneinheit;
wobei für die Formel 1, die Formel 3a und die Formel 3b gilt:
R* ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch -Si(R⁴)₂-, -Ge(R⁴)₂-, -Sn(R⁴)₂, -C(=O)-, -C(=S)-, -C(=Se)-,-C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder-S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R* auch miteinander ein mono- oder polycyclisches, aliphatisches, aromatisches und/oder benzoannelliertes Ringsystem bilden;
R² ist bei jedem Auftreten unabhängig voneinander ausgewählt aus der Gruppe bestehend aus H, Deuterium, Phenyl, Naphthyl, CF₃, C(=O)OR³, C(=O)N(R²)₂, Si(R⁴)₃, C(=O)R³, P(=O)(R⁷)₂, As(=O)(R⁷)₂ P(=S)(R⁷)₂, As(=S)(R⁷)₂, S(=O)R³, S(=O)₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch -Si(R⁴)₂-,-Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, oder -S-ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R² auch miteinander ein mono- oder polycyclisches, aliphatisches, aromatisches und/oder benzoannelliertes Ringsystem bilden;
R³ ist bei jedem Auftreten unabhängig voneinander ausgewählt aus der Gruppe bestehend aus H, Deuterium, Phenyl, Naphthyl, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R³ auch miteinander ein mono- oder polycyclisches, aliphatisches Ringsystem bilden;
R⁴ ist bei jedem Auftreten unabhängig voneinander ausgewählt aus der Gruppe bestehend aus H, Deuterium, Phenyl, Naphthyl, N(R²)₂, CN, CF₃, OH, C(=O)OR³, C(=O)N(R³)₂, C(=O)R³, P(=O)(R⁷)₂, As(=O)(R⁷)₂, P(=S)(R⁷)₂, AS(=S)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder. eine benachbarte CH₂-Gruppe durch -Si(R⁴)₂-, -Ge(R⁴)₂-, -Sn(R⁴)₂, -C(=O)-,-C(=S)-, -C(=Se)-, -C=N-, -C(=O)O-, -C(=O)N(R³)-, -P(=O)(R⁷)-, -As(=O)(R⁷)-, -P(=S)(R⁷)-,-As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁴ auch miteinander ein mono- oder polycyclisches, aliphatisches, aromatisches und/oder benzoannelliertes Ringsystem bilden;
R⁵ ist bei jedem Auftreten unabhängig voneinander ausgewählt aus der Gruppe bestehend aus Phenyl, Naphthyl, CF₃, C(=O)R³, P(=O)(R⁷)₂, As(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch -Si(R⁴)₂-, -Ge(R⁴)₂-, -Sn(R⁴)₂, -C(=O)-,-C(=S)-, -C(=Se)-, -C=N-, -C(=O)O-, -C(=O)N(R³)-, -P(=O)(R⁷)-, -As(=O)(R⁷)-, -P(=S)(R⁷)-,-As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁵ auch miteinander ein mono- oder polycyclisches, aliphatisches, aromatisches und/oder benzoannelliertes Ringsystem bilden;
R⁶ ist bei jedem Auftreten unabhängig voneinander ausgewählt aus der Gruppe bestehend aus Phenyl, Naphthyl, CF₃, Si(R⁴)₃, C(=O)R³, P(=O)(R⁷)₂, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch-Si(R⁴)₂-, -Ge(R⁴)₂-, -Sn(R⁴)₂-, -C(=O)-,-C(=S)-, -C(=Se)-, -C=N-, -C(=O)O-, -C(=O)N(R³)-, -P(=O)(R⁷)-, -As(=O)(R⁷)-, -P(=S)(R⁷)-,-As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R⁶ auch miteinander ein mono- oder polycyclisches, aliphatisches, aromatisches und/oder benzoannelliertes Ringsystem bilden;
R⁷ ist bei jedem Auftreten unabhängig voneinander ausgewählt aus der Gruppe bestehend aus Phenyl, Naphthyl, N(R²)₂, CN, CF₃, C(=O)OR³, C(=O)N(R³)₂, Si(R⁴)₃, C(=O)R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch -Si(R⁴)₂-,-Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁹ substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R³ substituiert sein kann, oder eine Kombination dieser Systeme; dabei können zwei oder mehrere dieser Substituenten R⁷ auch miteinander ein mono- oder polycyclisches, aliphatisches, aromatisches und/oder benzoannelliertes Ringsystem bilden;
R⁸ ist bei jedem Auftreten unabhängig voneinander ausgewählt aus der Gruppe bestehend aus H, Deuterium, Phenyl, Naphthyl, F, CF₃ oder ein aliphatischer, aromatischer und/oder heteroaromatischer Kohlenwasserstoffrest mit 1 bis 20 C-Atomen, in dem auch ein oder mehrere H-Atome durch F oder CF₃ ersetzt sein können; dabei können zwei oder mehrere Substituenten R⁸ auch miteinander ein mono- oder polycyclisches, aliphatisches Ringsystem bilden;
R⁹ ist bei jedem Auftreten unabhängig voneinander ausgewählt aus der Gruppe bestehend aus H, Deuterium, Phenyl, Naphthyl, N(R²)₂, CN, CF₃, NO₂, OH, COOH, C(=O)OR³, C(=O)N(R³)₂, Si(R⁴)₃, B(OR⁵)₂, C(=O)R³, P(=O)(R⁷)₂, P(=S)(R⁷)₂, As(=O)(R⁷)₂, P(=S)(R⁷)₂, S(=O)R³, S(=O)₂R³, OSO₂R³, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁸ substituiert sein kann, wobei eine oder mehrere nicht benachbarte CH₂-Gruppen durch -R³C=CR³-, -C≡C-, oder eine benachbarte CH₂-Gruppe durch -Si(R⁴)₂-, -Ge(R⁴)₂-, -Sn(R⁴)₂, -C(=O)-, -C(=S)-, -C(=Se)-,-C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder-S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R⁸ substituiert sein kann, oder eine Aryloxy- oder Heteroaryloxygruppe mit 5 bis 60 aromatischen Ringatomen, die durch einen oder mehrere Reste R³ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁸ substituiert sein kann, oder eine Kombination dieser Systeme; dabei können zwei oder mehrere dieser Substituenten R⁹ auch miteinander ein mono- oder polycyclisches, aliphatisches, aromatisches und/oder benzoannelliertes Ringsystem bilden;

2. Organisches Molekül nach Anspruch 1, wobei das organische Molekül eine Struktur der Formel 2a bis 2d aufweist: 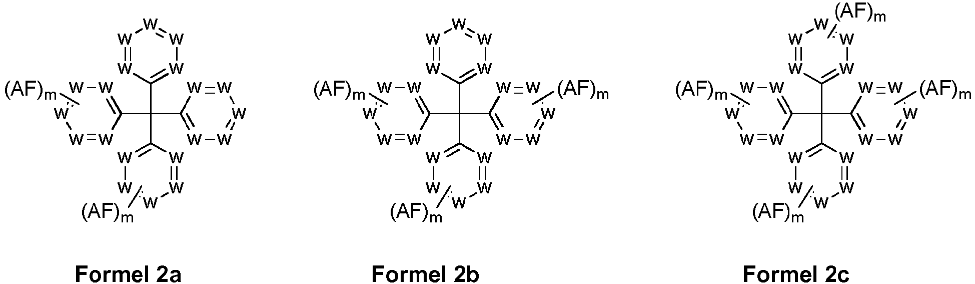 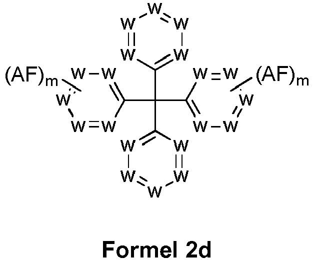 und wobei das organische Molekül mindestens zwei verschiedene AF aufweist, die an jeweils unterschiedlichen Ringen angebracht sind und wobei im Übrigen die bei Formel 1 angegebenen Definitionen gelten.

3. Organisches Molekül nach Anspruch 1, wobei das Molekül eine der nachfolgenden Strukturen aufweist: 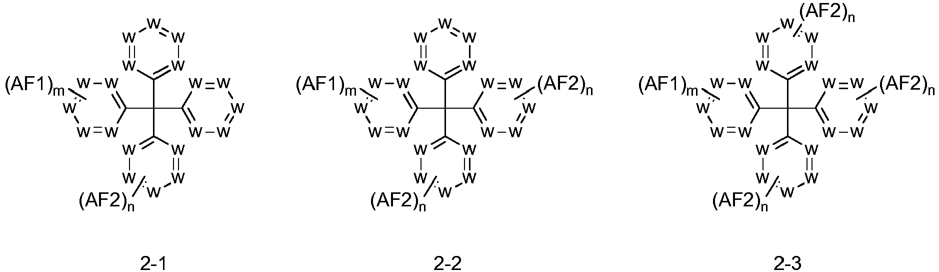 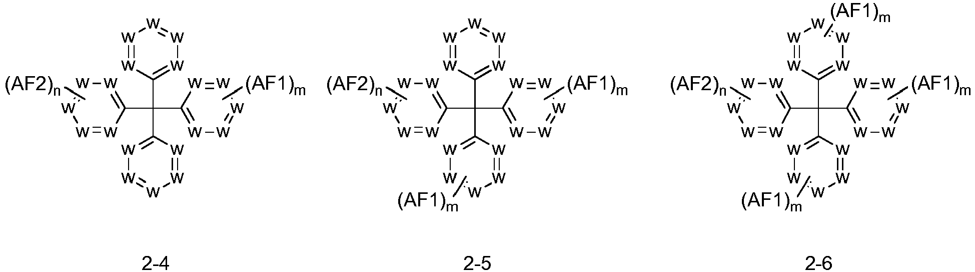 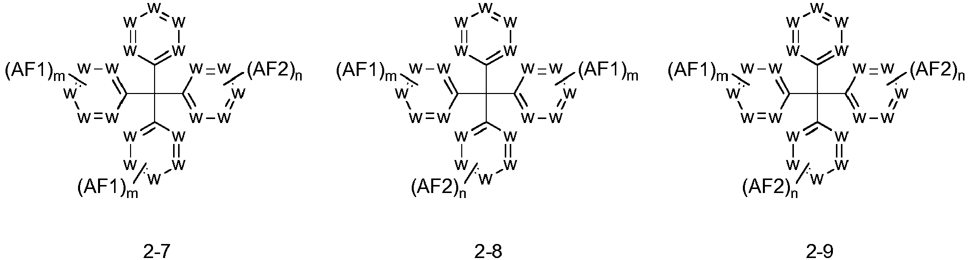 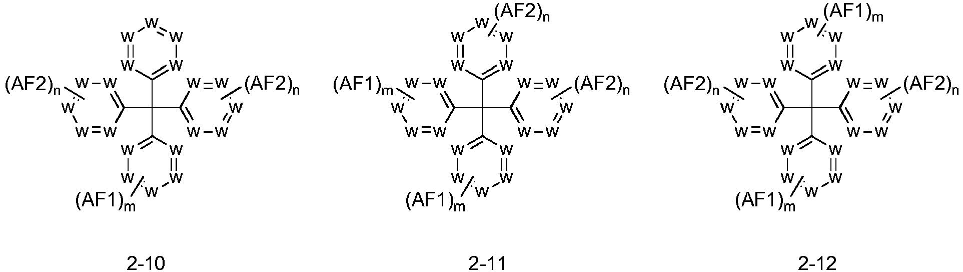 wobei m bei jedem Auftreten unabhängig voneinander die Werte 1, 2, 3, 4 oder 5 annehmen kann und wobei n bei jedem Auftreten unabhängig voneinander die Werte 1, 2, 3, 4 oder 5 annehmen kann und im Übrigen die in Anspruch 1 angegebenen Definitionen gelten.

4. Organisches Molekül nach Anspruch 1 bis 3, aufweisend eine der nachfolgenden Strukturen

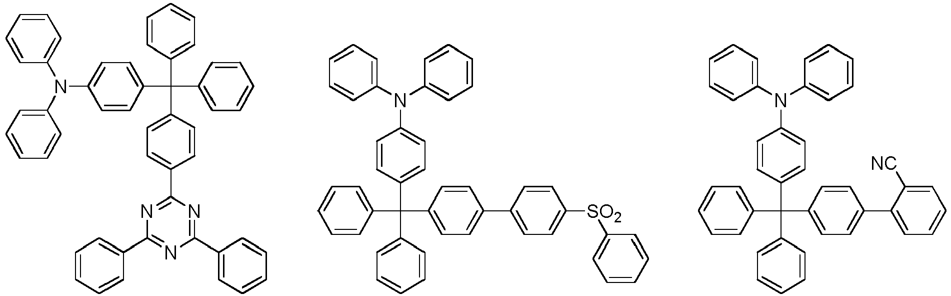

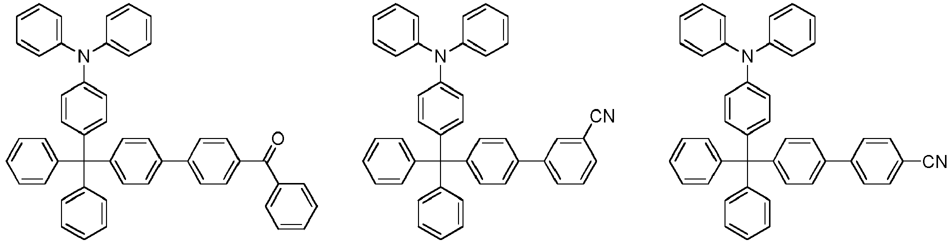

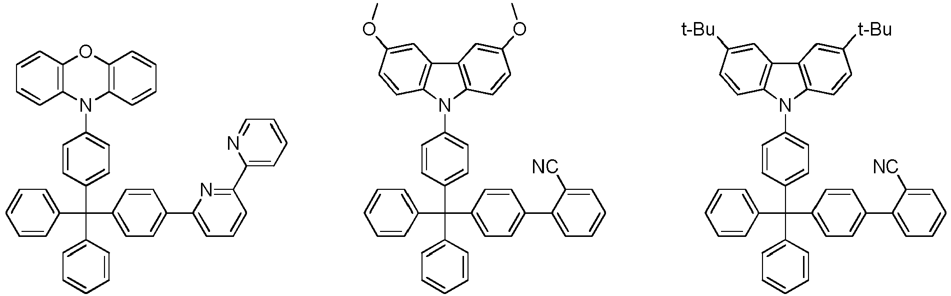

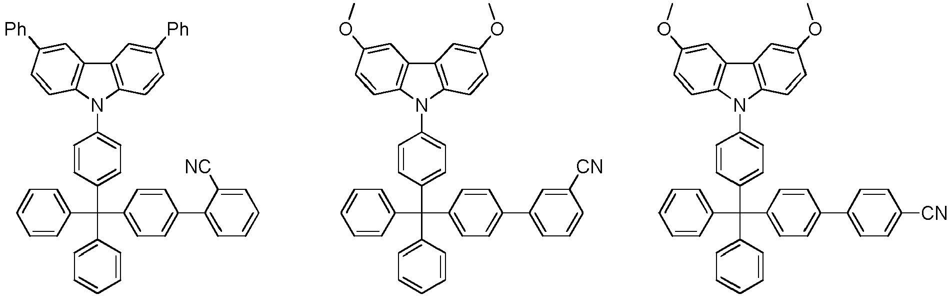

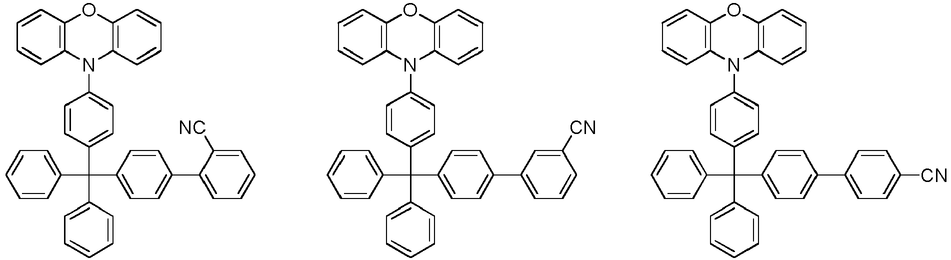

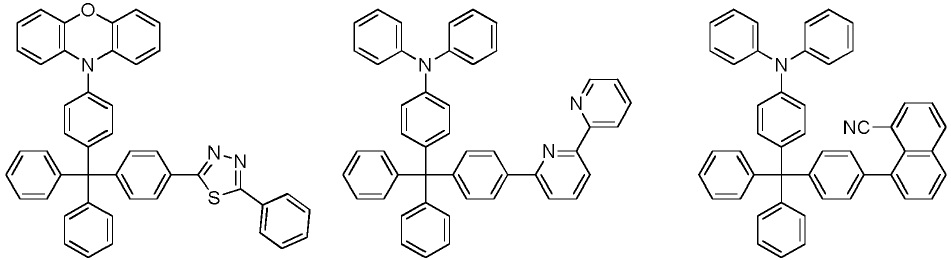

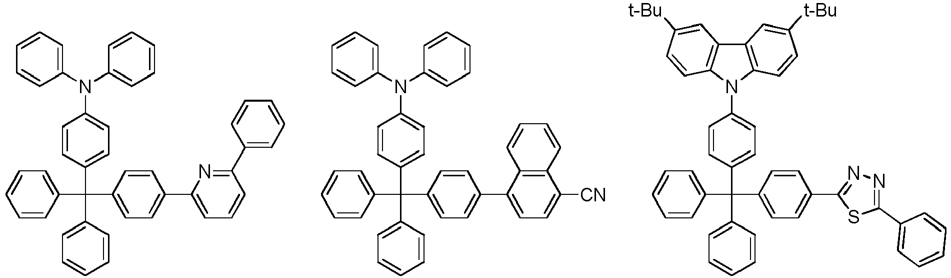

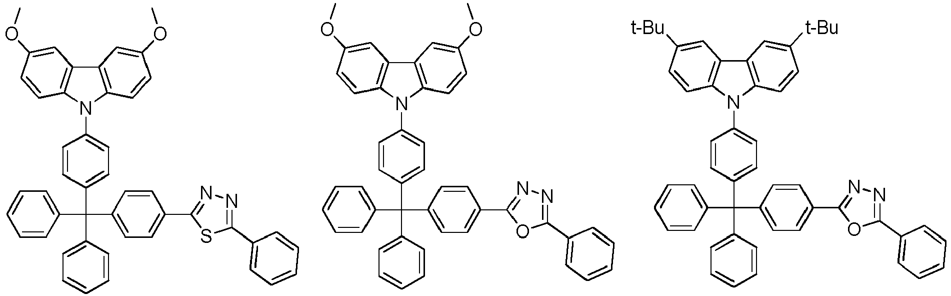

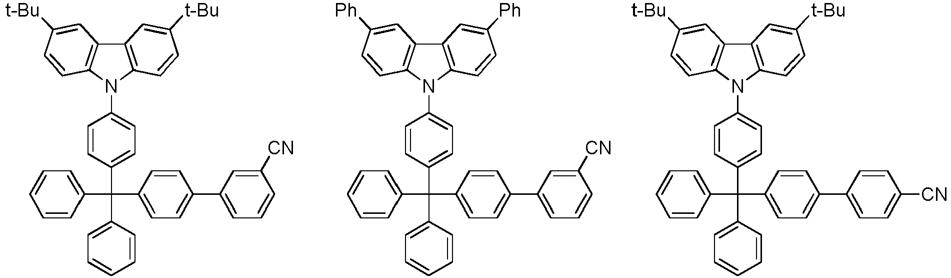

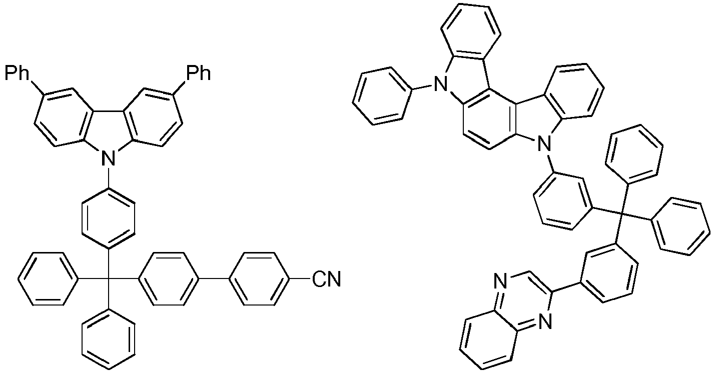

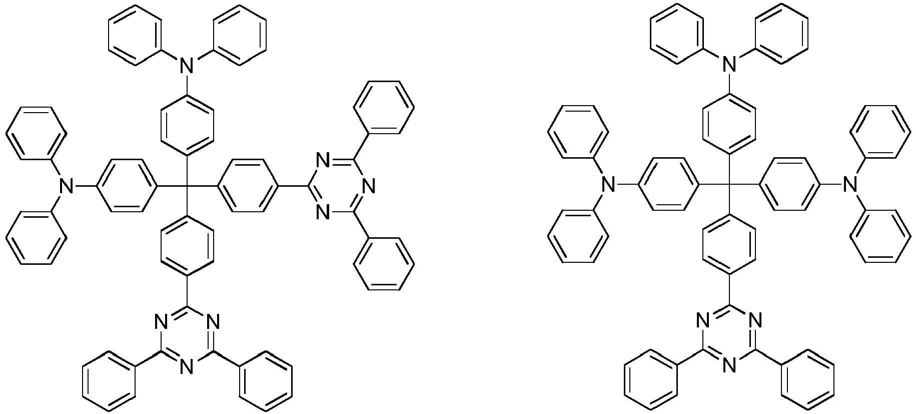

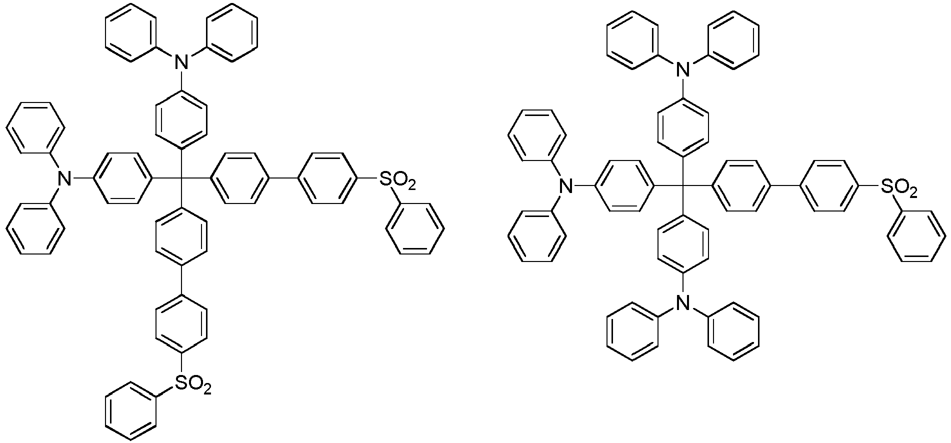

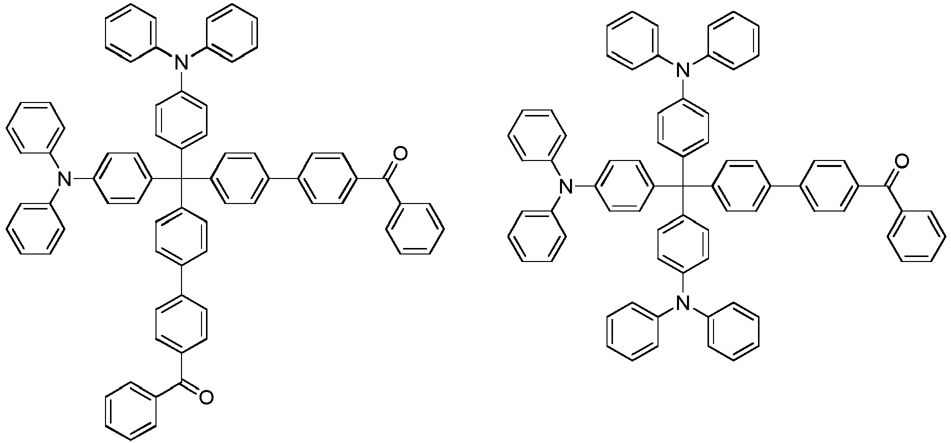

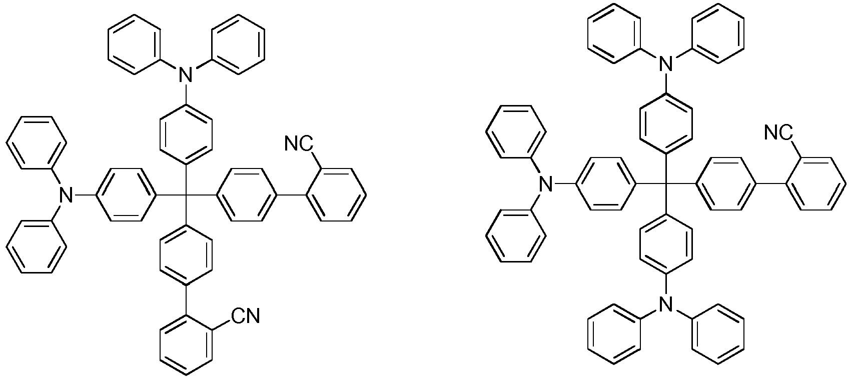

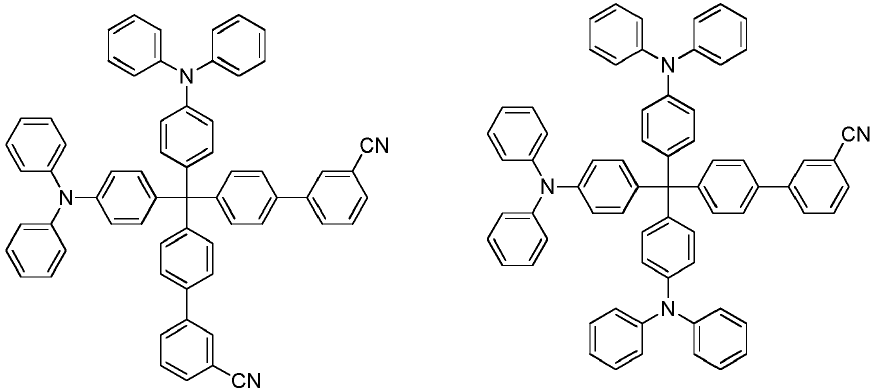

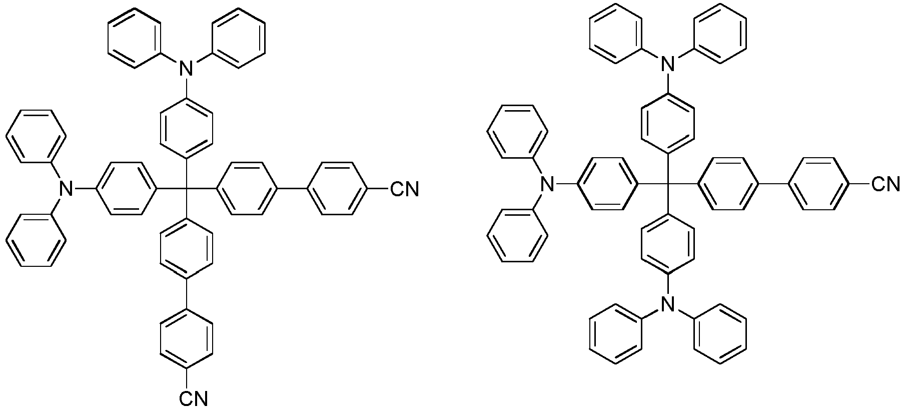

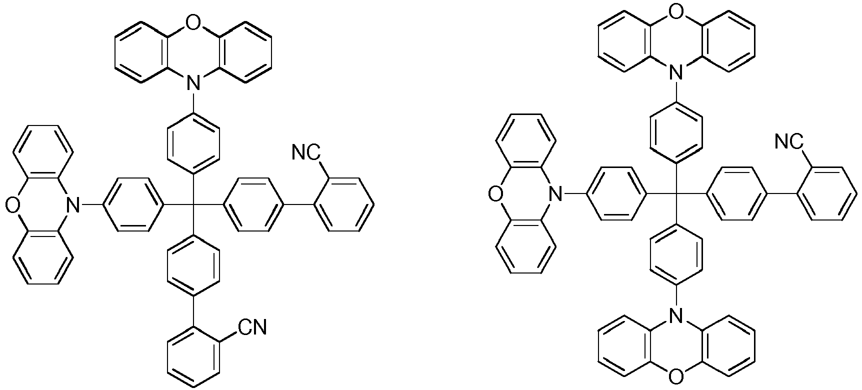

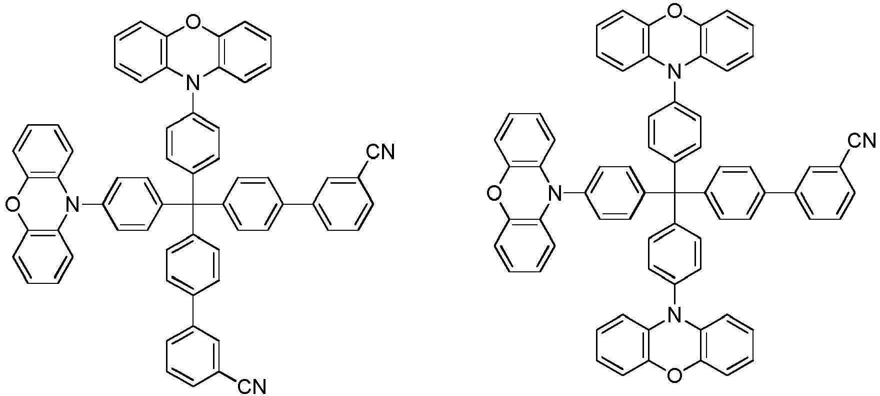

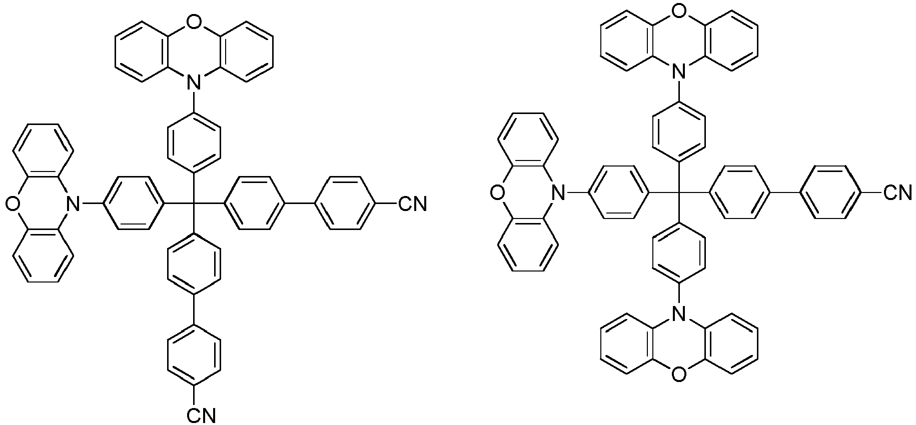

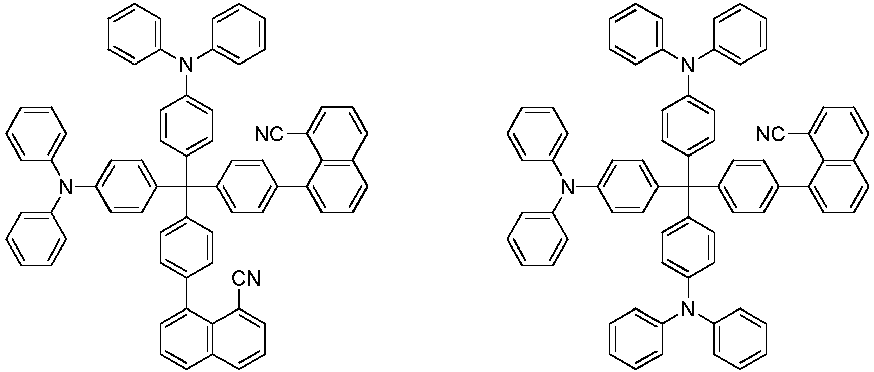

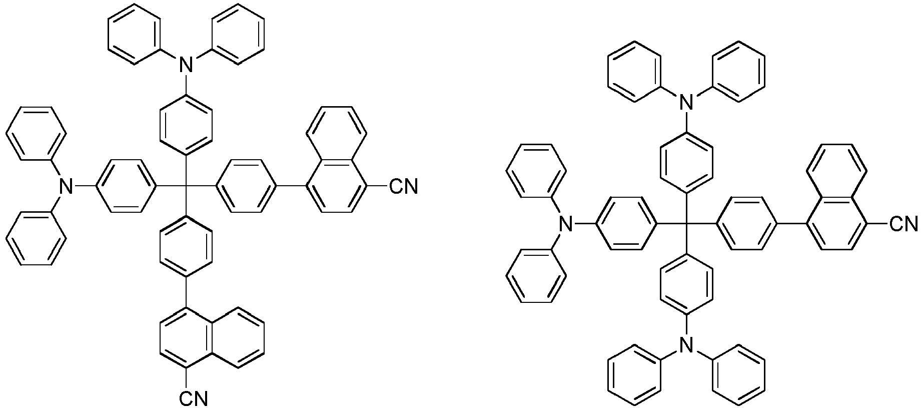

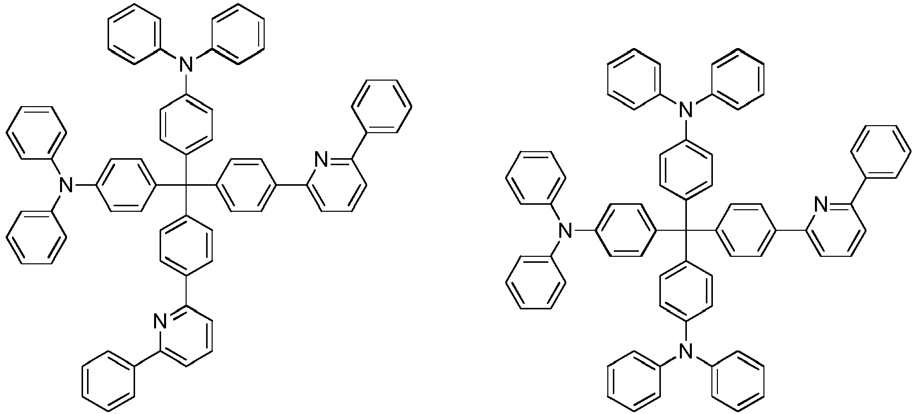

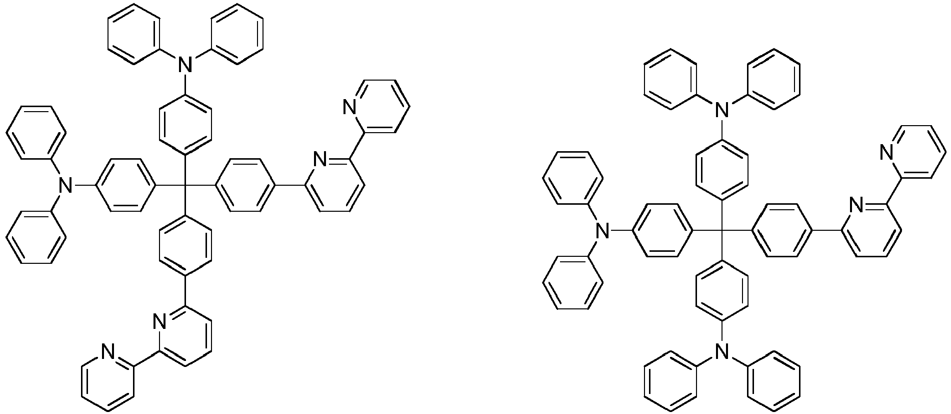

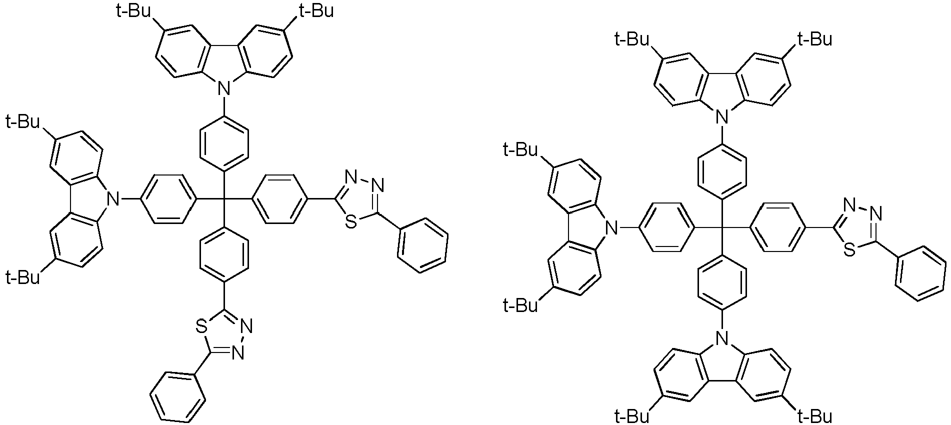

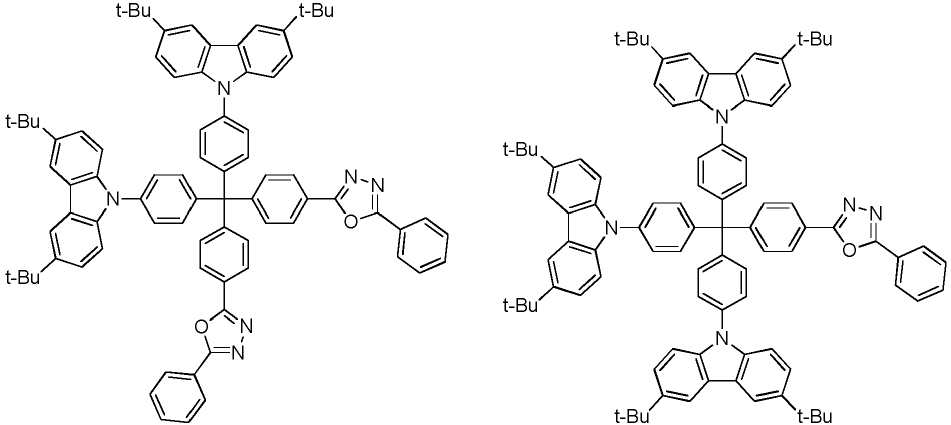

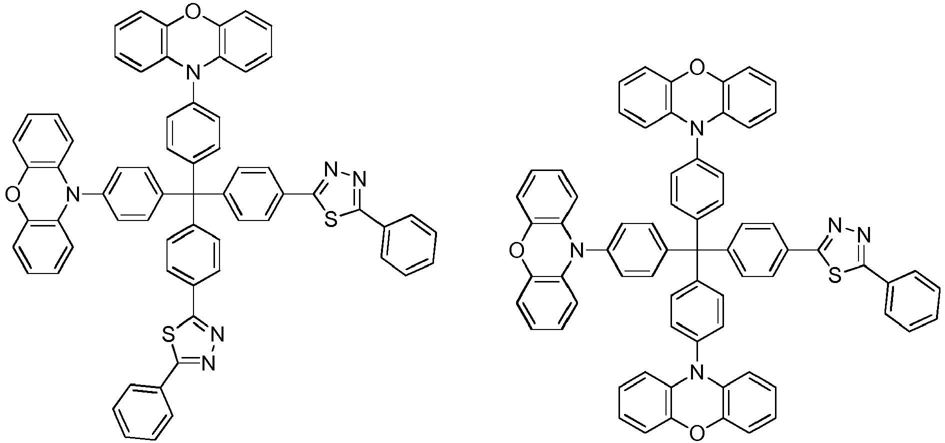

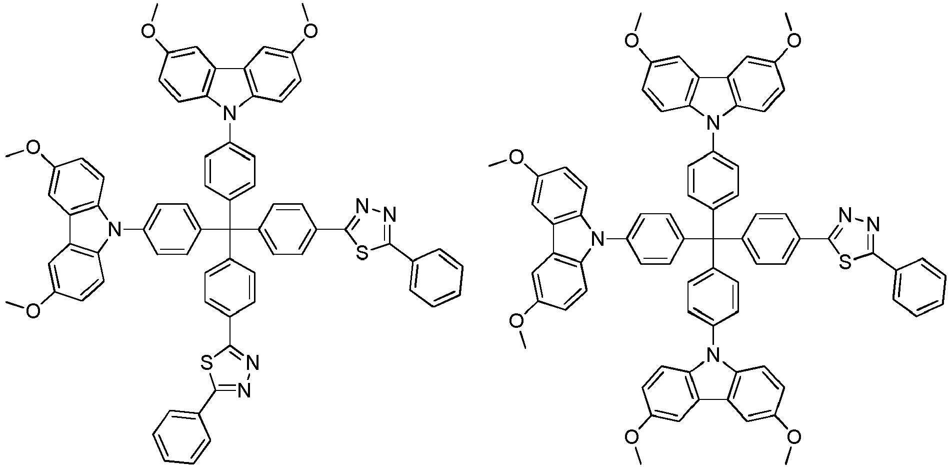

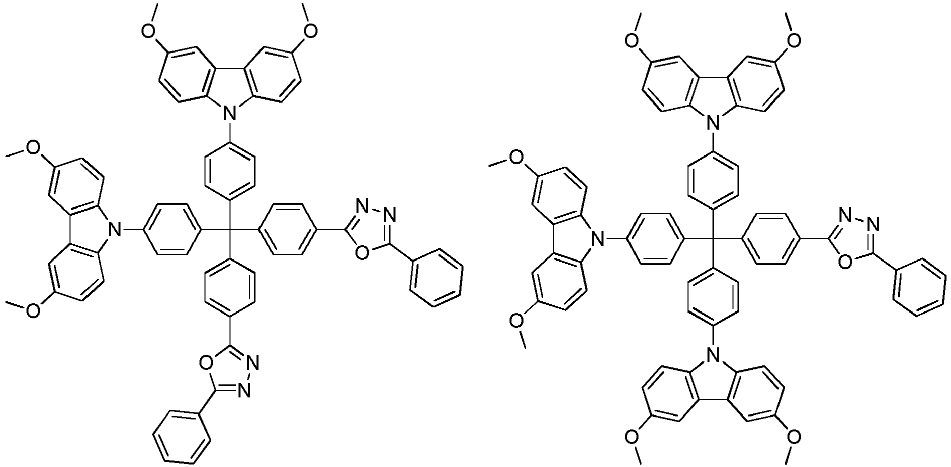

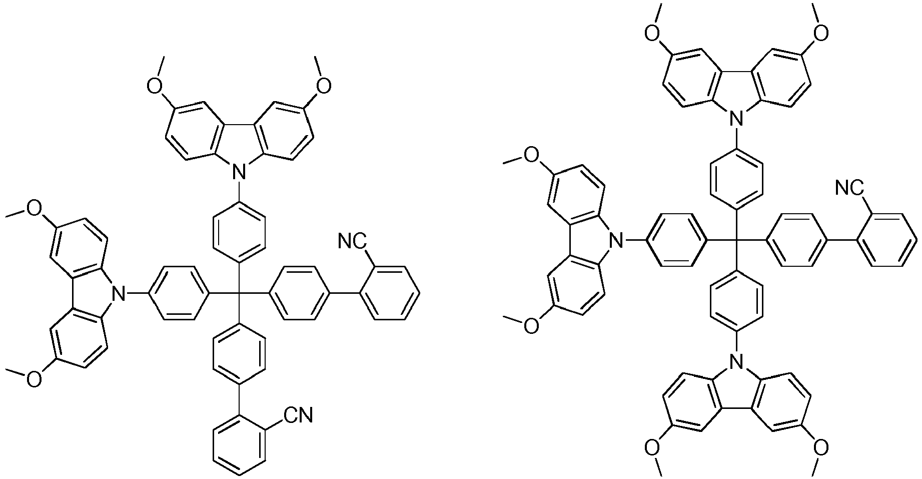

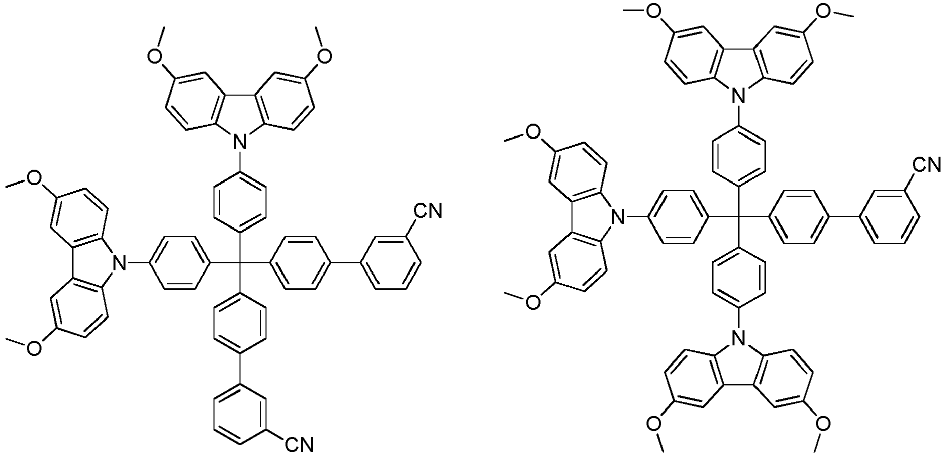

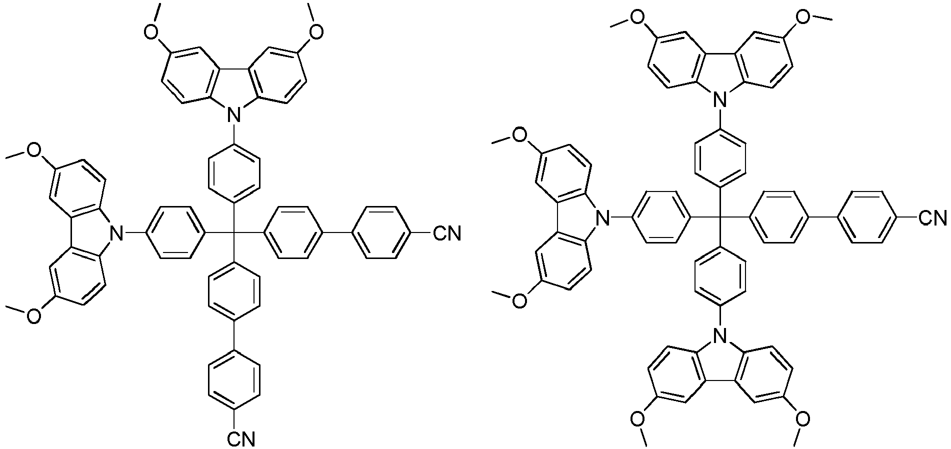

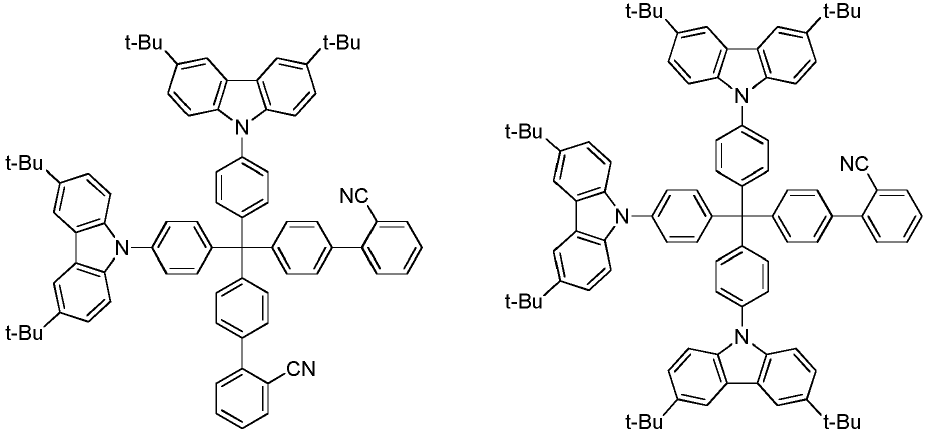

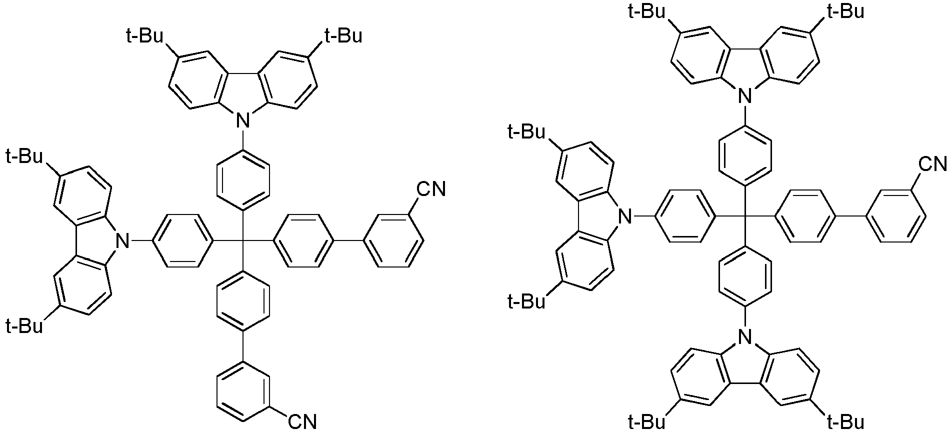

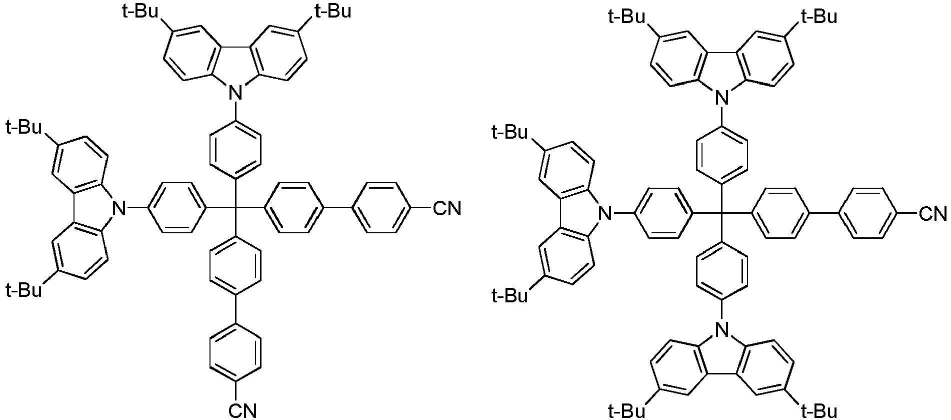

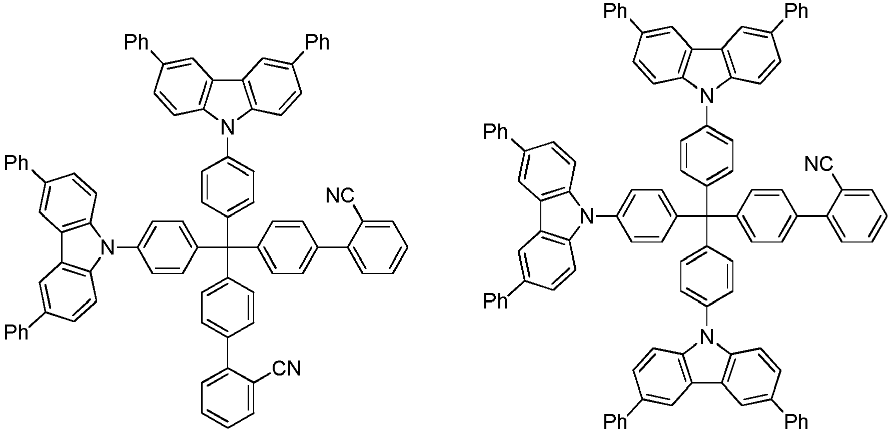

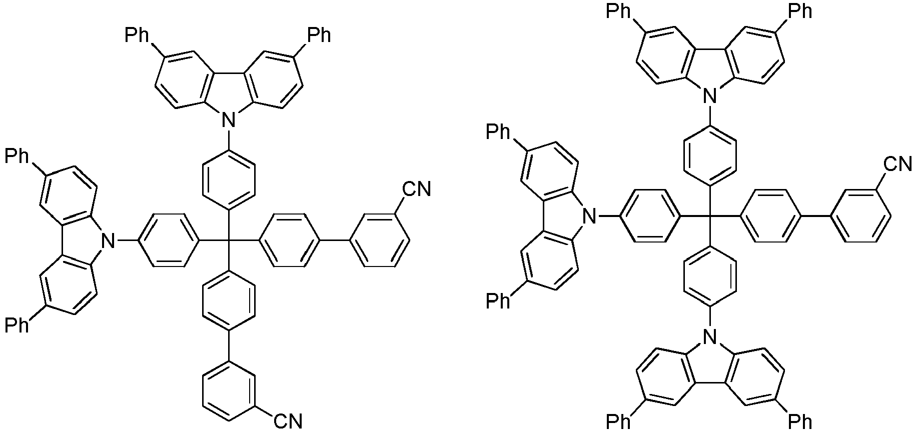

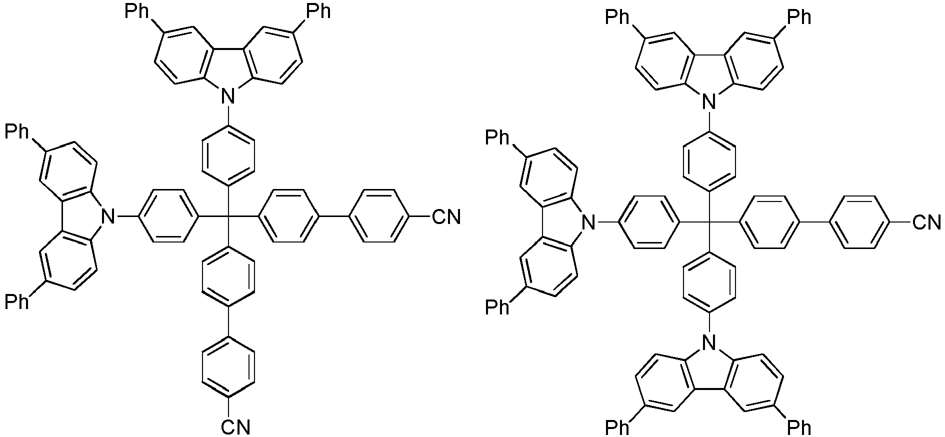

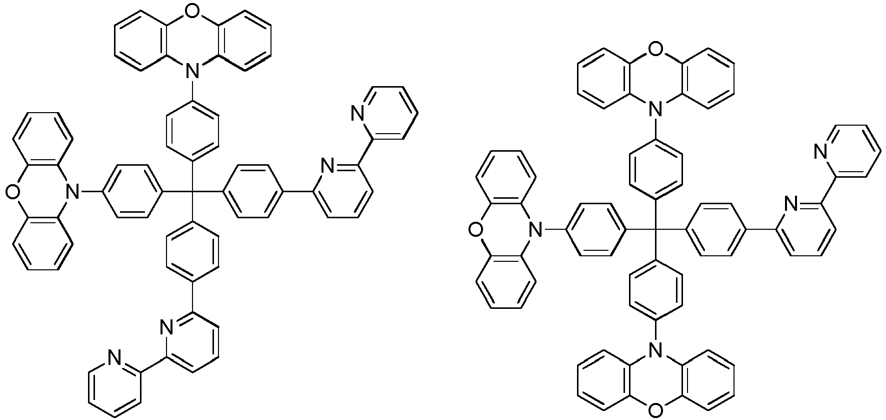

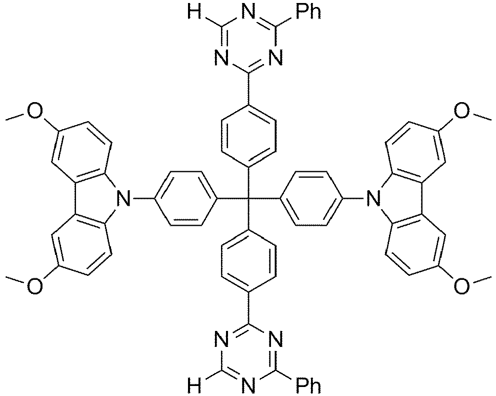

5. Organisches Molekül nach Anspruch 1 bis 4, wobei das organische Molekül an mindestens einer chemisch substituierbaren Position mindestens einen weiteren Rest R, aufweist, wobei
R ist bei jedem Auftreten unabhängig voneinander ausgewählt aus der Gruppe bestehend aus H, Deuterium, Phenyl, Naphthyl, F, Cl, Br, I, N(R²)₂, -CN, -NC, -SCN,-CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, AS(=S)(R⁷)₂, S(=O)R³, S=NR³, S(=O)NR³, S(=O)₂NR³, S(=O)₂R³, O-S(=O)₂R³, SF₅, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten R⁹ substituiert sein kann, wobei eine oder mehrere benachbarte CH₂-Gruppen durch -R⁹C=CR⁹-, -C≡C-, oder eine benachbarte CH₂-Gruppe durch -Si(R⁴)₂-, -Ge(R⁴)₂-, -Sn(R⁴)₂-, -C(=O)-, -C(=S)-, -C(=Se)-, -C=N-,-C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, oder -S- ersetzt sein können und wobei ein oder mehrere H-Atome durch Deuterium, F, Cl, Br, I, CN, CF₃ oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R⁹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R⁹ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden; wobei R² bis R⁹ definiert sind wie in Anspruch 1;
und wobei für polymerisierbare Reste gilt:
polymerisierbare Reste sind solche Reste, die polymerisierbare funktionelle Einheiten tragen, die mit sich selbst homopolymerisiert oder mit anderen Monomeren copolymiersiert werden können, wodurch das organische Molekül als Polymer mit Wiederholungseinheiten nach den Formeln 4 und/oder 5 erhalten werden 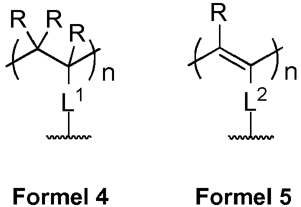 mit
gewellte Linie = Position, über die die Linkergruppe L¹ oder L² an das organische Molekül gebunden ist;
L¹ und L² = gleiche oder verschiedene Linkergruppen, aufweisend zwischen 0 bis 20 Kohlenstoffatome; oder aufweisend eine Form -C(=O)O;
und wobei insbesondere L¹ und L² = -X-L³ mit X = O oder S;
L³ = eine weitere Linkergruppe ausgewählt aus der Gruppe aus einer substituierten und unsubstituierten Alkylengruppe (linear, verzweigt oder cyclisch) und einer substituierten und unsubstituierten Arylengruppe, wobei auch Kombinationen möglich sind.

6. Verwendung eines organischen Moleküls nach Anspruch 1 bis 5 als lumineszierender Emitter und/oder als Hostmaterial und/oder als Elektronentransportmaterial und/oder als Lochinjektionsmaterial und/oder als Lochblockiermaterial in einem optoelektronischen Bauelement.

7. Verwendung nach Anspruch 6, wobei das optoelektronische Bauelement ausgewählt ist aus der Gruppe bestehend aus:
• organischen lichtemittierenden Dioden (OLEDs),
• lichtemittierenden elektrochemischen Zellen,
• OLED-Sensoren, insbesondere in nicht hermetisch nach außen abgeschirmten Gas- und Dampf-Sensoren,
• organischen Dioden,
• organischen Solarzellen,
• organischen Transistoren,
• organischen Feldeffekttransistoren,
• organischen Lasern und
• Down-Konversions-Elementen.

8. Verwendung nach Anspruch 6 oder 7, wobei der Anteil des organischen Moleküls am Emitter 1 % bis 99 % beträgt.

9. Verwendung nach Anspruch 6, 7 oder 8, wobei die Konzentration des organischen Moleküls als Emitter in optischen Licht emittierenden Bauelementen, insbesondere in OLEDs, zwischen 5 % und 80 % beträgt.

10. Optoelektronisches Bauelement, aufweisend ein organisches Molekül nach Anspruch 1 bis 5, insbesondere ausgeformt als ein Bauelement ausgewählt aus der Gruppe bestehend aus organischem lichtemittierendem Dioden (OLED), Licht-emittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

11. Optoelektronisches Bauelement nach Anspruch 10, aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein organisches Molekül nach Anspruch 1 bis 5 enthält.

12. Optoelektronisches Bauelement nach Anspruch 10 oder 11, in dem die lichtemittierende Schicht mindestens ein Hostmaterial aufweist, wobei insbesondere der angeregte Singulettzustand (S₁) und/oder der angeregte Triplettzustand (T₁) des mindestens einen Hostmaterials höher ist als der angeregte Singulettzustand (S₁) und/oder der angeregte Triplettzustand (T₁) des organischen Moleküls nach Anspruch 1 bis 5.

13. Optoelektronisches Bauelement nach Anspruch 10 bis 12, wobei mindestens ein Hostmaterial aus einem Material gemäß Anspruch 1 bis 5 besteht.

14. Optoelektronisches Bauelement nach Anspruch 10 bis 13, wobei die lichtemittierende Schicht fluoreszente oder phosphoreszente Materialien aufweist und wobei die Materialien der lichtemittierenden Schicht ausgewählt sind aus der Gruppe bestehend aus organischen Molekülen nach Anspruch 1 bis 5.

15. Optoelektronisches Bauelement nach Anspruch 14, in dem ein organisches Molekül nach Anspruch 1 bis 5 und ein funktionelles Material einen Exciplex bilden.

16. Optoelektronisches Bauelement nach Anspruch 12 bis 15, wobei die Emission durch thermisch aktivierte verzögerte Fluoreszenz (TADF) charakterisiert ist.

17. Optoelektronisches Bauelement nach Anspruch 12 bis 16, in dem ein organisches Molekül nach Anspruch 1 bis 5 als Ladungstransportschicht verwendet wird.

18. Verfahren zur Herstellung eines optoelektronischen Bauelements, wobei ein organisches Molekül nach Anspruch 1 bis 5 verwendet wird.

19. Verfahren nach Anspruch 18, wobei das organische Molekül mittels eines Vakuumverdampfungsverfahrens oder aus einer Lösung aufgetragen wird.

## Claims

1. Organic molecule, comprising a structure of formula I 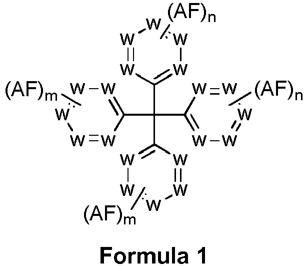 wherein in formula 1
m is independently of each other at each occurrence 1,2,3,4 or 5;
n is independently of each other at each occurrence 1,2,3,4 or 5;
w is CR**;
R** is either a moiety R* or indicates the position where a moiety AF is bound to the carbon atom of the ring;
AF is an organic chemical unit, wherein in the organic molecule comprises at least a first chemical unit AF1 and a second different chemical unit AF2, wherein AF1 and AF2 are each bound to different rings and wherein, if the total number of the units AF in the molecule is more than 2, the additional units AF are identical to AF1 or AF2;
wherein AF2 comprises a structure of formula 3a: 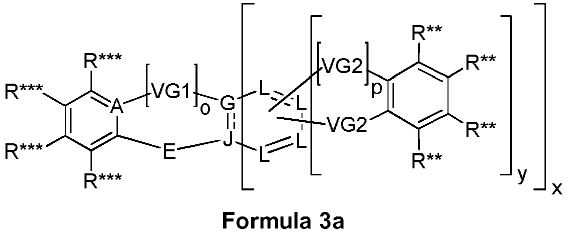 wherein in Formula 3a
x is 0 or 1;
y is 0 or 1, wherein if x = 0 then y = 0;
o is 0 or 1;
p is 0 or 1;
A is CR*** if o = 0, otherwise A is C;
VG1 is a bridging group selected from the group consisting of
- NR**, CR**₂, O, S, and a C-C-single bond,
- NR**, CR**₂, O, S, a C-C-single bond, BR**, AsR**, SiR**₂, GeR**₂, 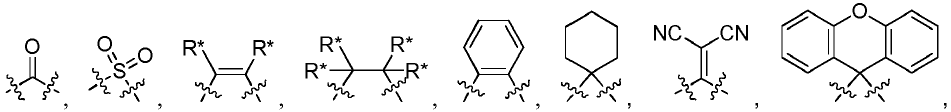 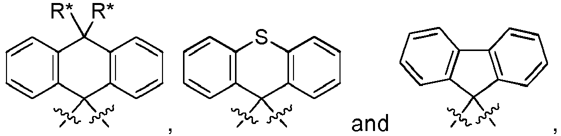 if x = 1 and y = 0;
VG2 is a bridging group, which is at each occurrence independently of each other selected form the group consisting of CR**₂, NR**, O, S and a C-C-single bond, wherein two units VG2 are not simultaneously a C-C-single bond;
E is NR**, 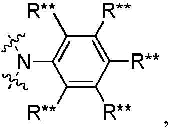 O or S;
G is C if o = 1 and simultaneously x = 1; G is CR** if o = 0 and simultaneously x = 1; G is CR** or CR**₂, if o = 1 and simultaneously x = 0; G is R* if o = 0 and simultaneously x = 0; G is CR**, CR**₂, N or NR* if x = 0 and VG1 is simultaneously a C-C-single;
J is C if x = 1; J is CR**, CR**₂ or NR** if x = 0;
L is CR*** if y = 0; L is CR** or C (covalently bound to VG2) if y = 1;
R*** is R** or is selected form the following units, wherein at the most two of the moieties R*** are simultaneously one of the following units: 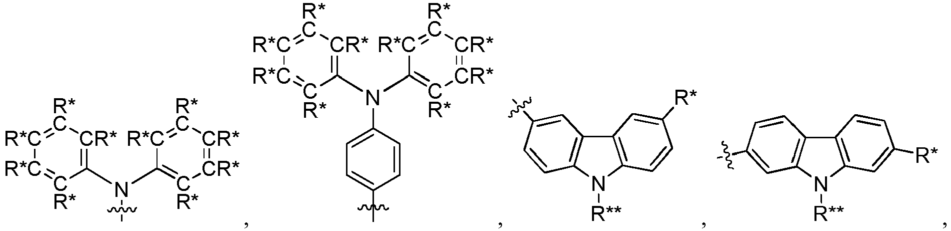 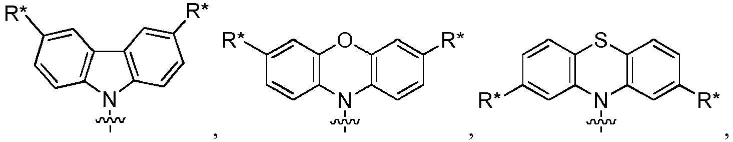 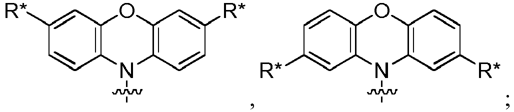
R** is at each occurrence independently of each other a moiety R* and/or indicates the binding site for a tetraarylmethane unit;
and wherein the chemical units AF1 comprise a structure of formula 3b: 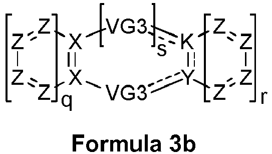 wherein in formula 3b:
q is 0 or 1; r is 0 or 1; s is 0 or 1;
VG3 = bridging group which is at each occurrence independently of each other selected form the group consisting of
- N, O, S, CR**, an element-element single bond between X and Y or between X and K, wherein two units VG3 are not simultaneously an element-element single bond between X and Y and between X and K;
- BR**, NR**, GeR**₂, AsR**₂, SiR**₂, wherein two units are not simultaneously BR**, NR**, GeR**₂, AsR**₂, SiR**₂; 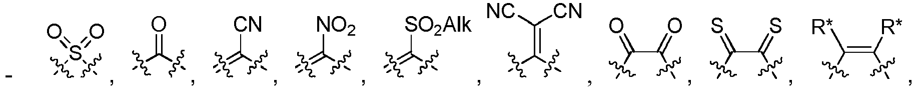 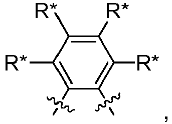 wherein two units VG3 are not at the same time 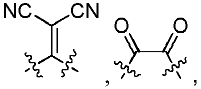 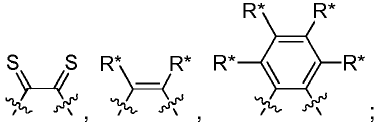
X is at each occurrence independently of each other C; or X is CR**, N if q = 0;
Y is C; or Y is CR**, CR**₂, N, NR*, O or S if r = 0;
K is Y; or K is R* if r = 0 and simultaneously s = 0;
Z is at each occurrence independently of each other CR** or N;
and wherein at the most 4 of the units VG3, K, X, Y, Z are simultaneously N;
and wherein at least 1 of the units VG3, K, X, Y, Z is a group which is different from a C-H-group and contains at least 1 nitrogen atom or an oxygen atom or a sulfur atom;
and wherein if r = 0 two adjacent groups Z may be bridged to each other or a group VG3 may be bridged to the closest group Z via the following units: 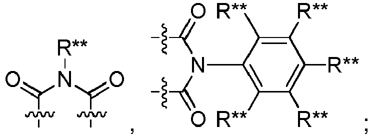
and wherein if r = 0 and simultaneously q = 0 a group VG3 may also be bridged to an adjacent group X via the units 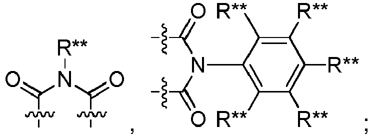
and wherein at most three of these units are present;
R** is at each occurrence independently of each other a moiety R* and/or indicates the binding site of the tetraarylmethane unit;
wherein in the formula 1, the formula 3a and the formula 3b:
R* is at each occurrence independently of each other selected from the group consisting of H, deuterium, phenyl, naphthyl, F, Cl, Br, I, N(R²)₂, -CN, -NC, -SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-,-Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R², or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R* may form a mono- or polycyclic, aliphatic, aromatic and/or benzo-fused ring system;
R² is at each occurrence independently of each other selected from the group consisting of H, deuterium, phenyl, naphthyl, CF₃, C(=O)OR³, C(=O)N(R²)₂, Si(R⁴)₃, C(=O)R³, P(=O)(R⁷)₂, As(=O)(R⁷)₂ P(=S)(R⁷)₂, AS(=S)(R⁷)₂, S(=O)R³, S(=O)₂R³, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-,-C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-,-O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁹, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R² may form a mono- or polycyclic, aliphatic, aromatic and/or benzo-fused ring system;
R³ is at each occurrence independently of each other selected from the group consisting of H, deuterium, phenyl, naphthyl, CF₃, or an aliphatic, aromatic and/or heteroaromatic hydrocarbon moieties having 1 to 20 C-atoms, in which one or more H-atoms may also be replaced by F or CF₃, wherein two or more substituents R³ may form a mono- or polycyclic, aliphatic, aromatic and/or benzo-fused ring system;
R⁴ is at each occurrence independently of each other selected from the group consisting of H, deuterium, phenyl, naphthyl, N(R²)₂, CN, CF₃, OH, C(=O)OR³, C(=O)N(R³)₂, C(=O)R³, P(=O)(R⁷)₂, As(=O)(R⁷)₂, P(=S)(R⁷)₂, AS(=S)(R⁷)₂, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-,-C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-,-O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁸, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R⁴ may form a mono- or polycyclic, aliphatic, aromatic and/or benzo-fused ring system;
R⁵ is at each occurrence independently of each other selected from the group consisting of H, deuterium, phenyl, naphthyl, CF₃, C(=O)R³, P(=O)(R⁷)₂, As(=O)(R⁷)₂, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁹, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R⁵ may form a mono- or polycyclic, aliphatic, aromatic and/or benzo-fused ring system;
R⁶ is at each occurrence independently of each other selected from the group consisting of H, deuterium, phenyl, naphthyl, CF₃, Si(R⁴)₃ C(=O)R³, P(=O)(R⁷)₂, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-, -NR²-, -O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁹, or an aryloxy- or heteroaryloxy group having 5 to 60 aromatic ring atoms, which may be substituted by one or more moieties R*, or a diarylamino group, diheteroarylamino group or arylheteroarylamino group having 10 to 40 aromatic ring atoms, which may be substituted by one or more moieties R⁹, or is a combination of these systems; wherein two or more of these substituents R⁶ may form a mono- or polycyclic, aliphatic, aromatic and/or benzo-fused ring system;
R⁷ is at each occurrence independently of each other selected from the group consisting of H, deuterium, phenyl, naphthyl, N(R²)₂, CN, CF₃, C(=O)OR³, C(=O)N(R³)₂, Si(R⁴)₃, C(=O)R³, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-,-As(=S)(R⁷)-, -S(=O)-, -S(=O)₂-, -NR²-, -O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁹, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R⁷ may form a mono- or polycyclic, aliphatic, aromatic and/or benzo-fused ring system;
R⁸ is at each occurrence independently of each other selected from the group consisting of H, deuterium, phenyl, naphthyl, F, CF₃, or an aliphatic, aromatic and/or heteroaromatic hydrocarbon moieties having 1 to 20 C-atoms, in which one or more H-atoms may also be replaced by F or CF₃, wherein two or more substituents R⁸ may form a mono- or polycyclic, aliphatic, aromatic and/or benzo-fused ring system;
R⁹ is at each occurrence independently of each other selected from the group consisting of H, deuterium, phenyl, naphthyl, N(R²)₂, CN, CF₃, NO₂, OH, COOH, C(=O)OR³, C(=O)N(R³)₂, Si(R⁴)₃, B(OR⁵)₂, C(=O)R³, P(=O)(R⁷)₂, P(=S)(R⁷)₂, As(=O)(R⁷)₂, P(=S)(R⁷)₂, S(=O)R³, S(=O)₂R³, OSO₂R³, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by-R⁹C=CR⁹-, -C≡C-, or one adjacent CH₂-group may be replaced by -Si(R⁴)₂-, -Ge(R⁴)₂-,-Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, or -S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁸, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R⁹ may form a mono- or polycyclic, aliphatic, aromatic and/or benzo-fused ring system.

2. Organic molecule according to claim 1, wherein the organic molecule comprises of a structure of the formula 2a to 2d: 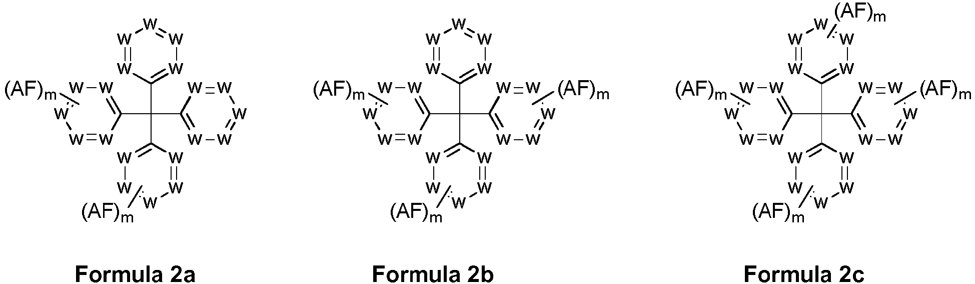 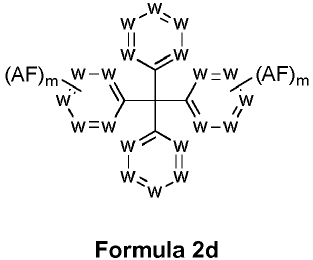 and wherein the organic molecule comprises at least two different AF, which are located in each case at different rings and wherein apart form that the aforementioned definitions of formula 1 apply

3. Organic molecule according to claim 1, wherein the organic molecule comprises of one of the following structures: 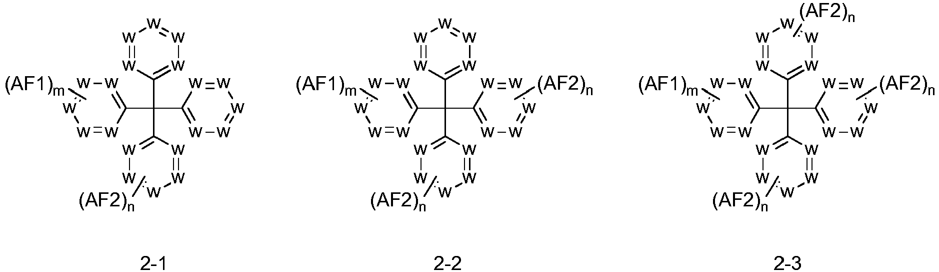 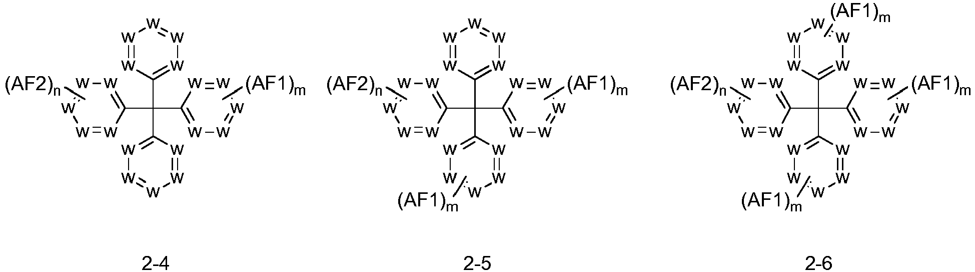 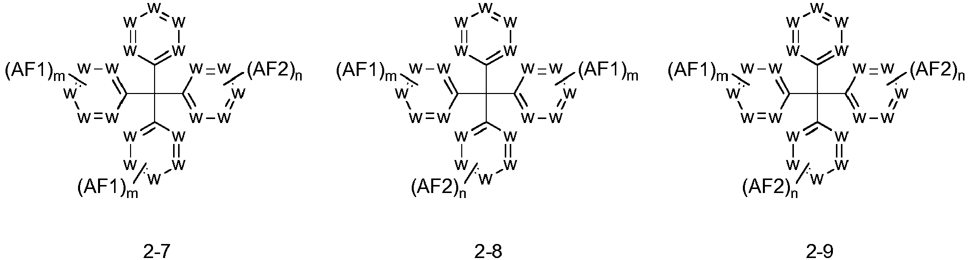 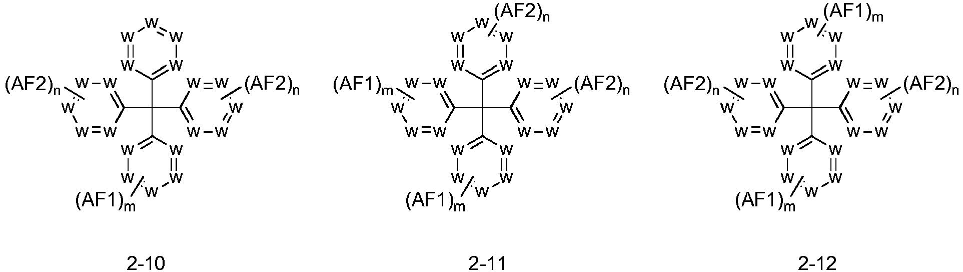 wherein m at each occurrence independently from each other may represent the value 1, 2, 3, 4, or 5 and wherein n at each occurrence independently of each other may represent the values 1, 2, 3, 4, or 5 and apart form that the aforementioned definitions of claim 1 apply.

4. Organic molecule according to claims 1 to 3, comprising one of the following structures:

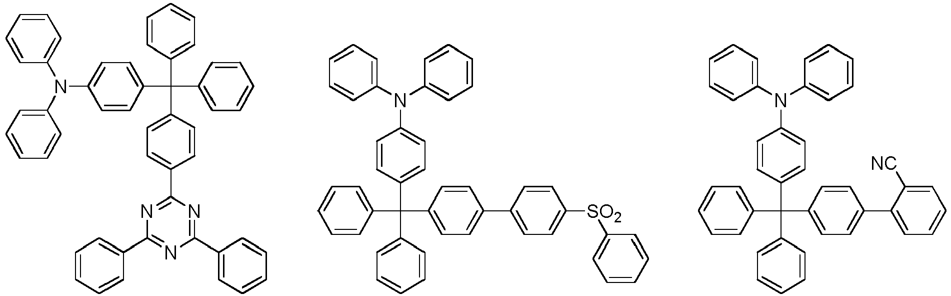

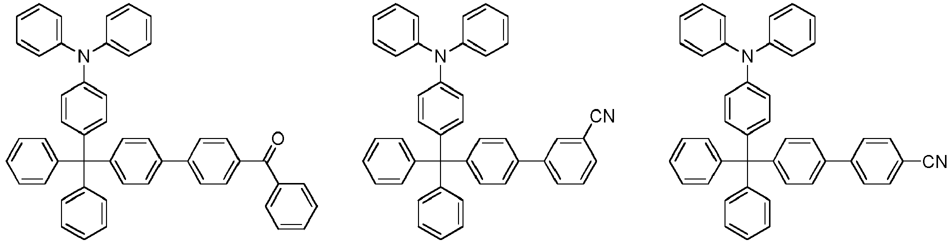

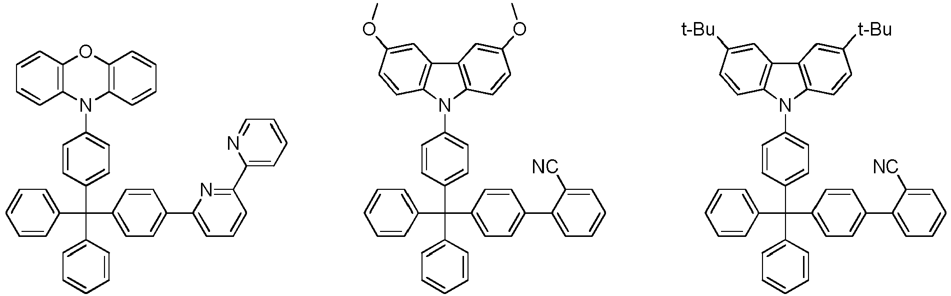

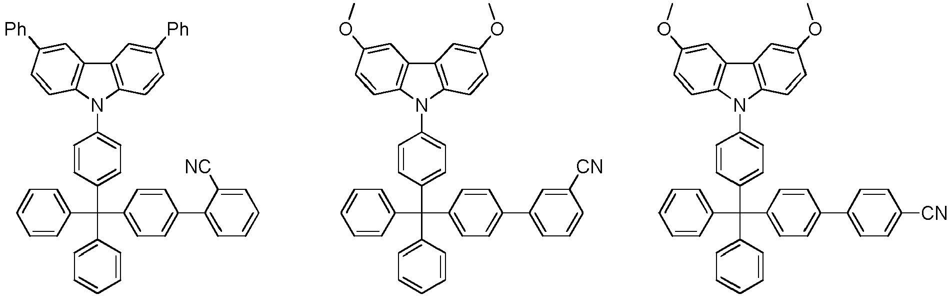

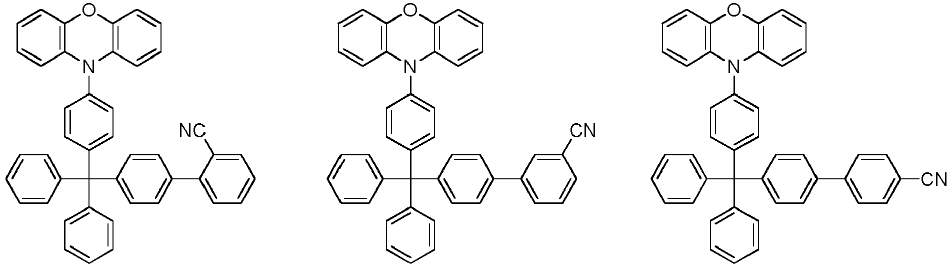

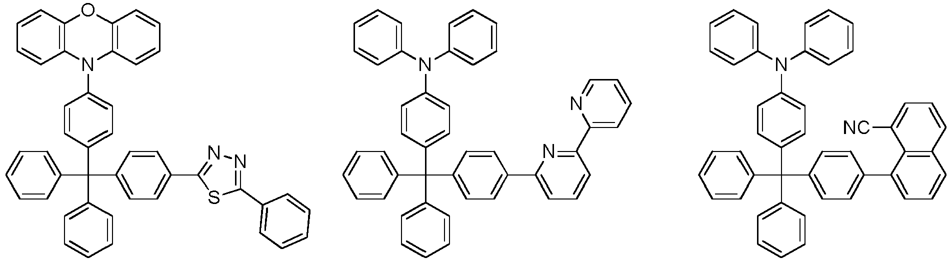

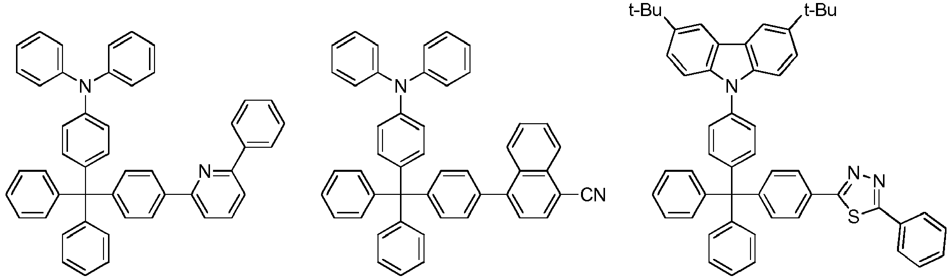

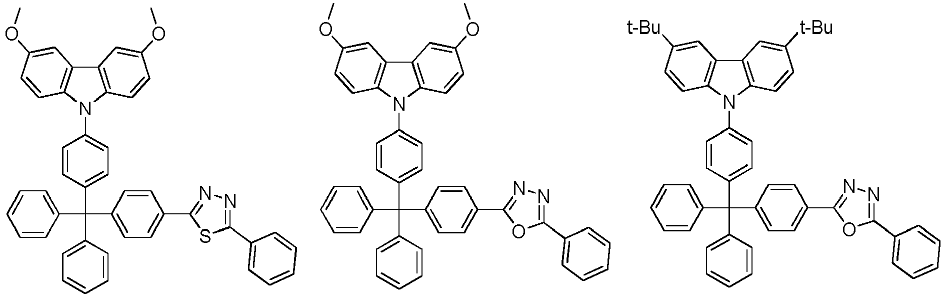

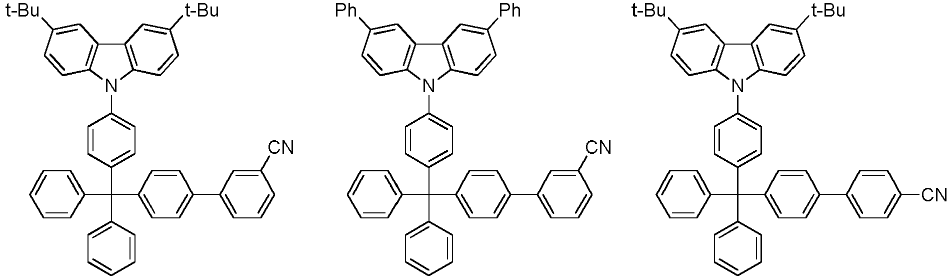

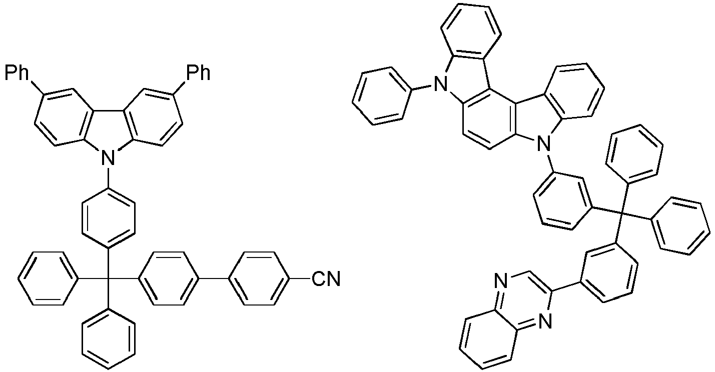

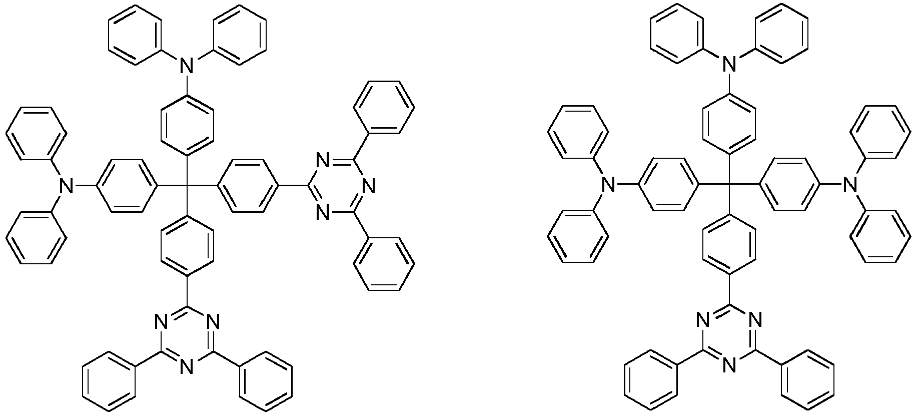

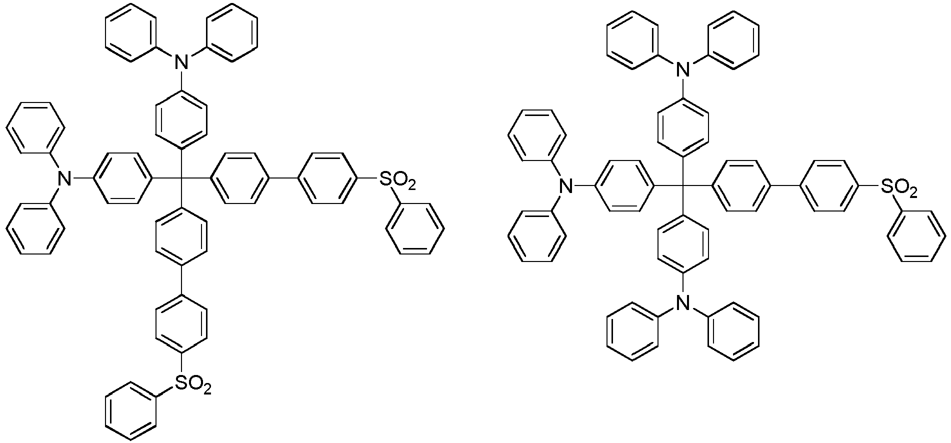

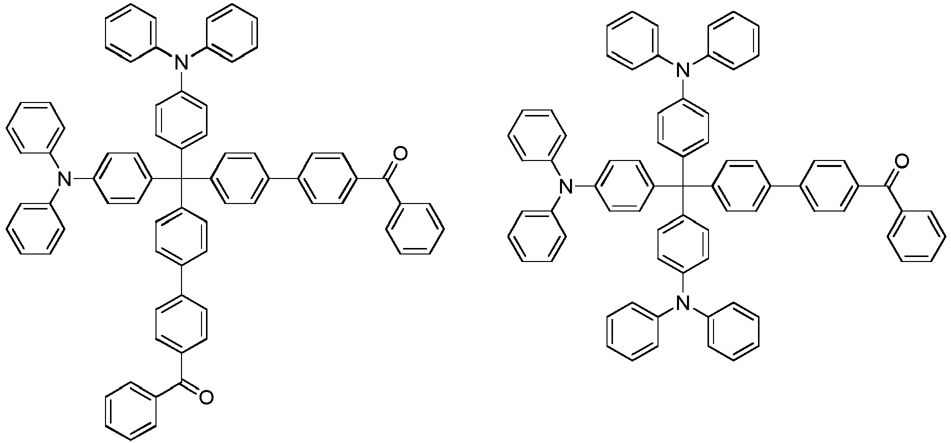

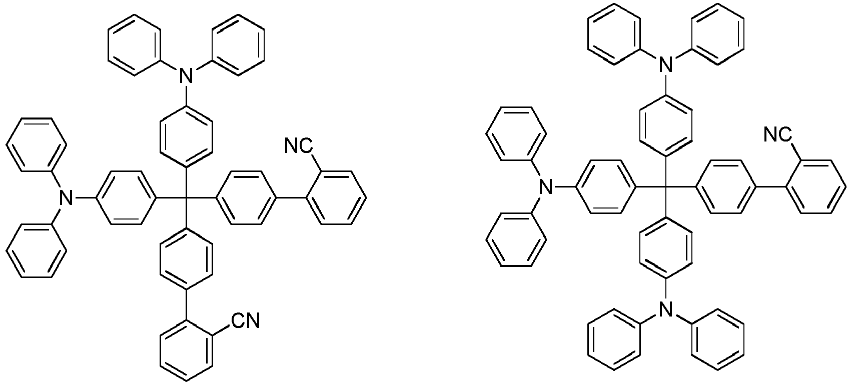

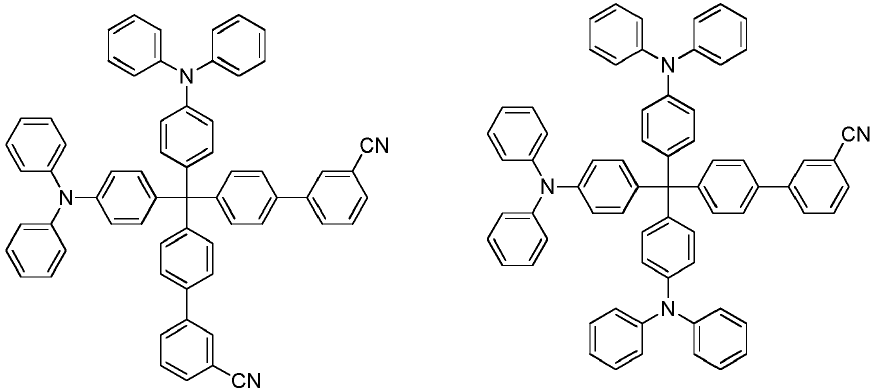

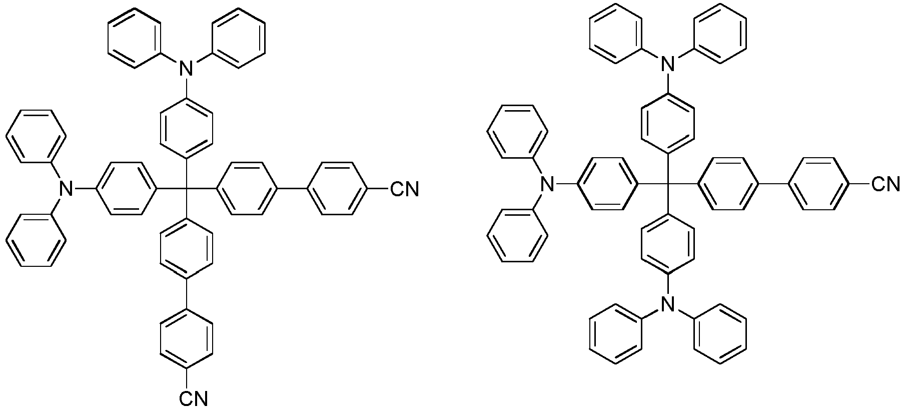

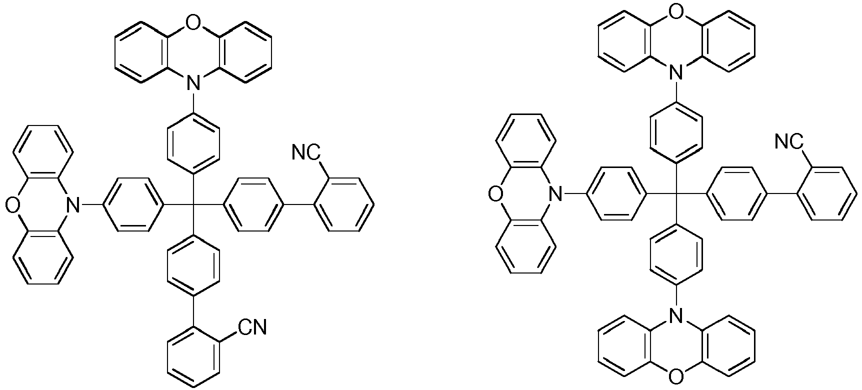

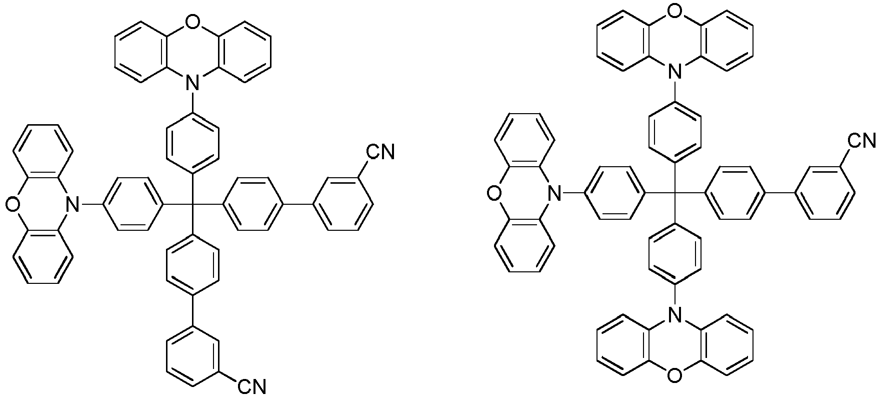

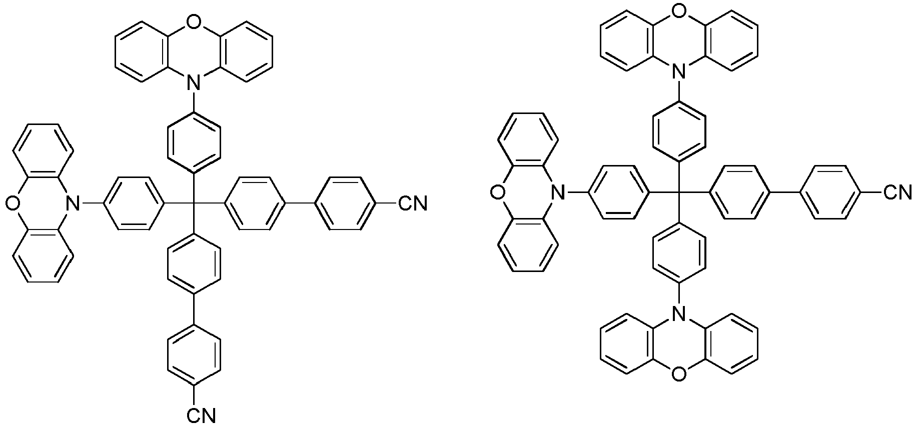

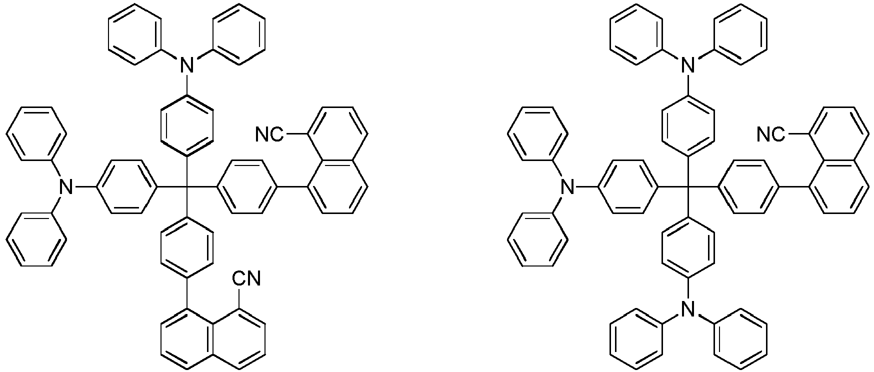

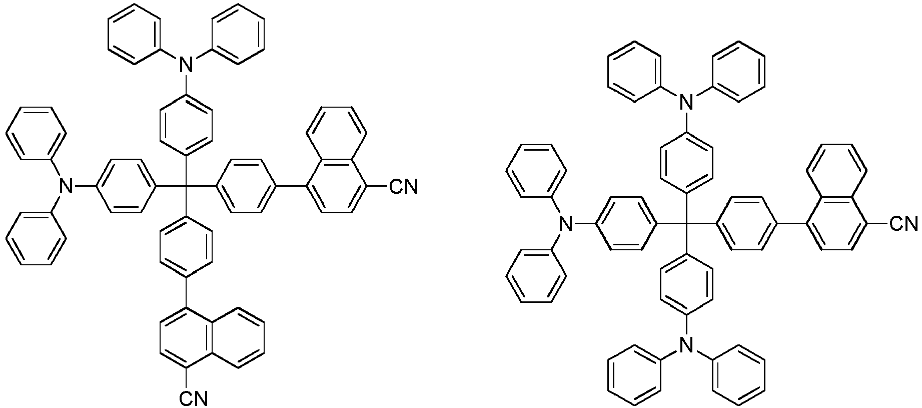

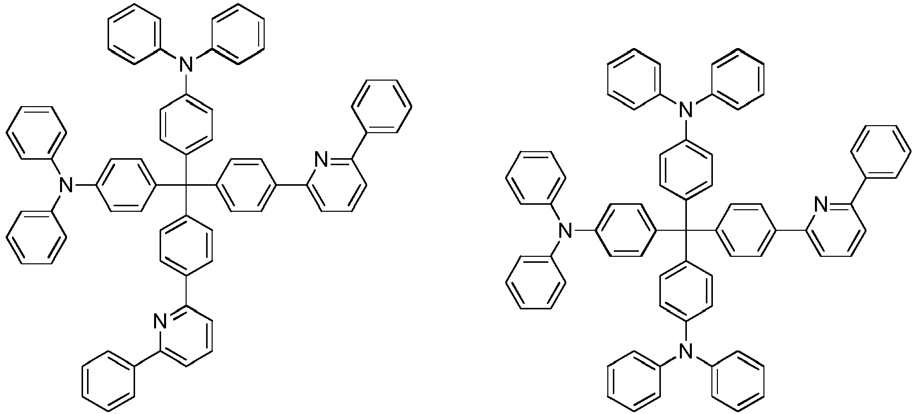

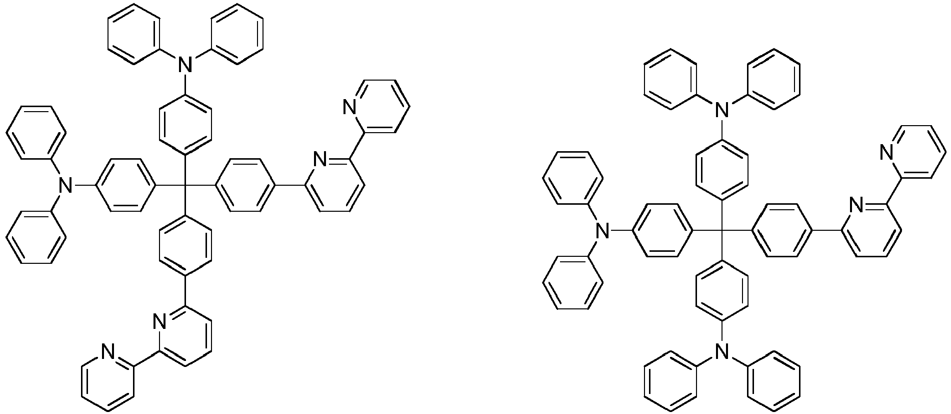

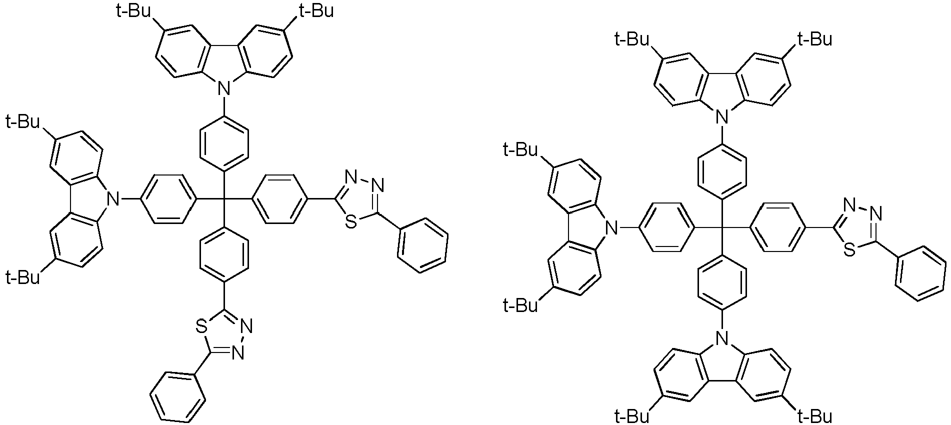

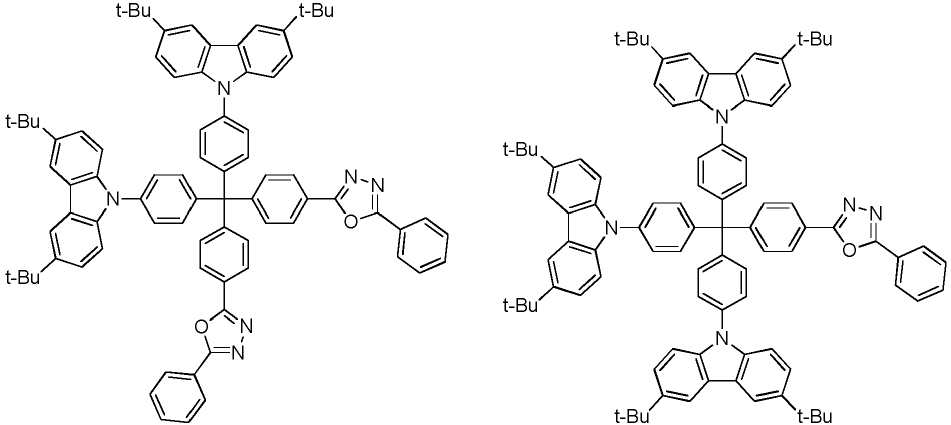

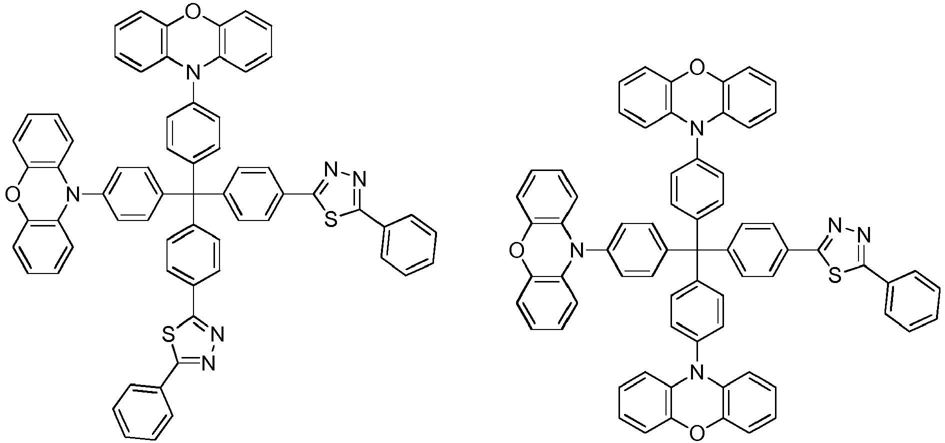

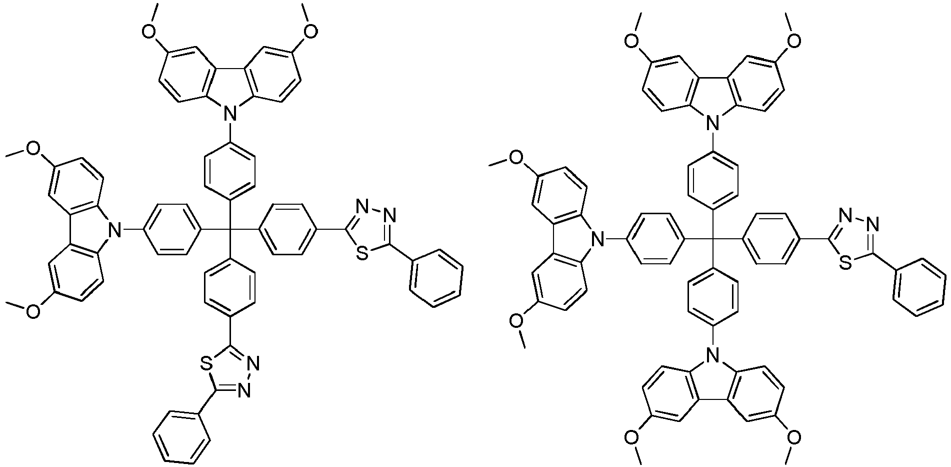

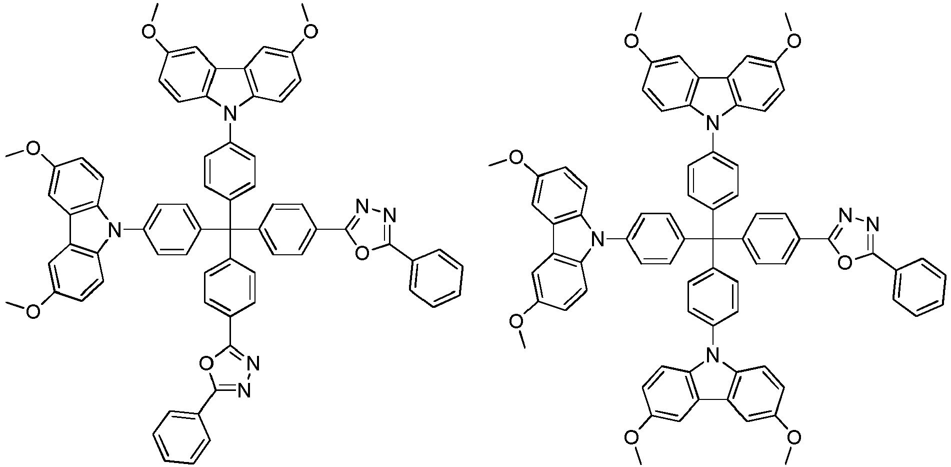

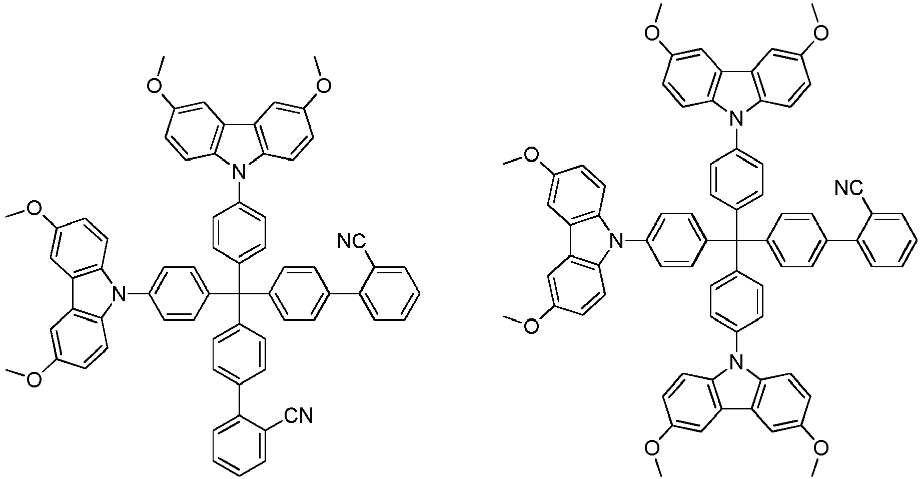

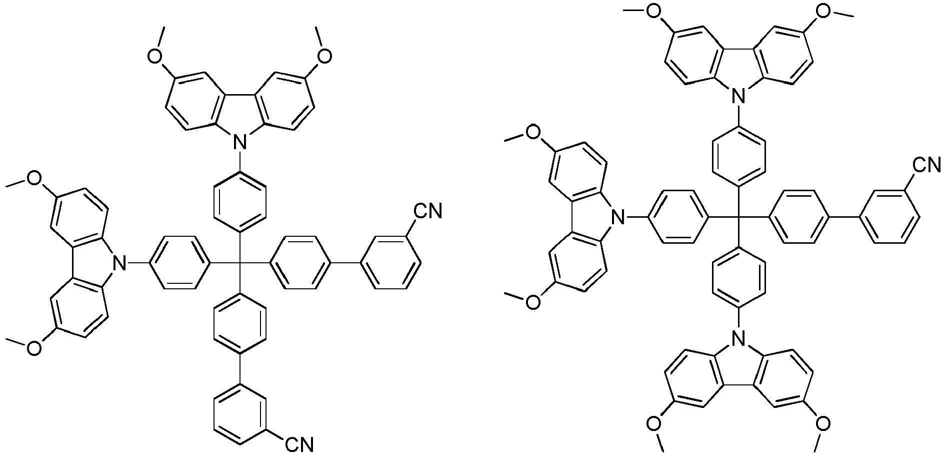

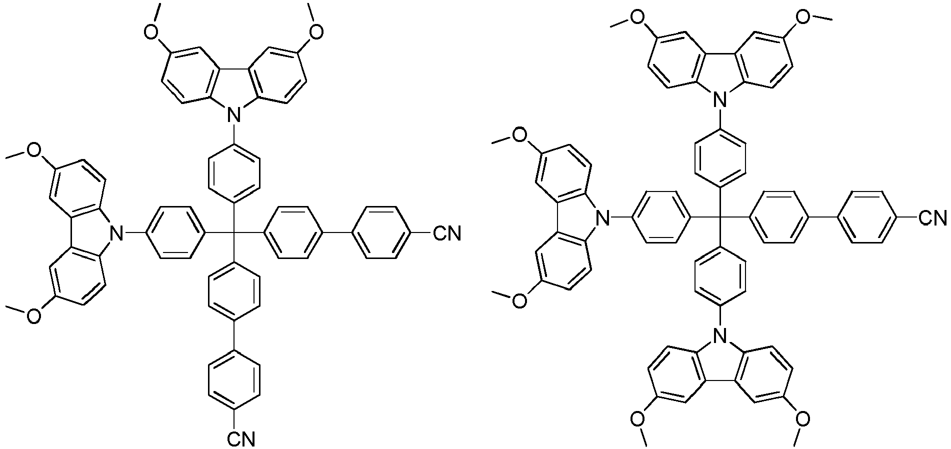

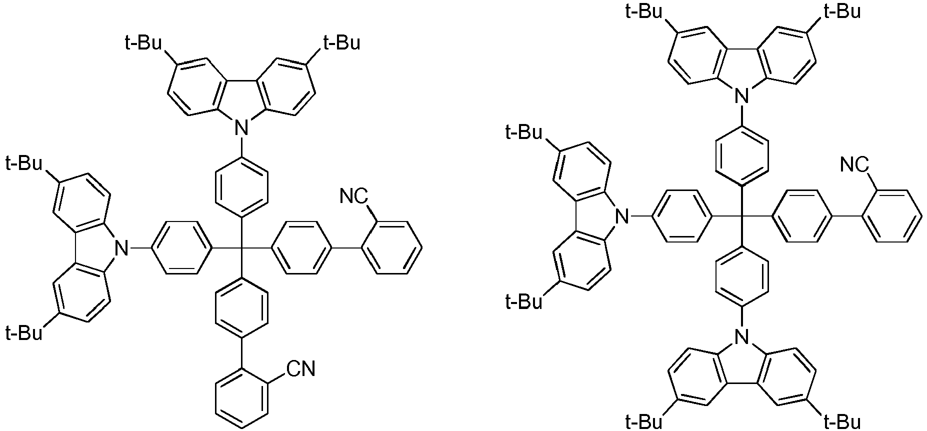

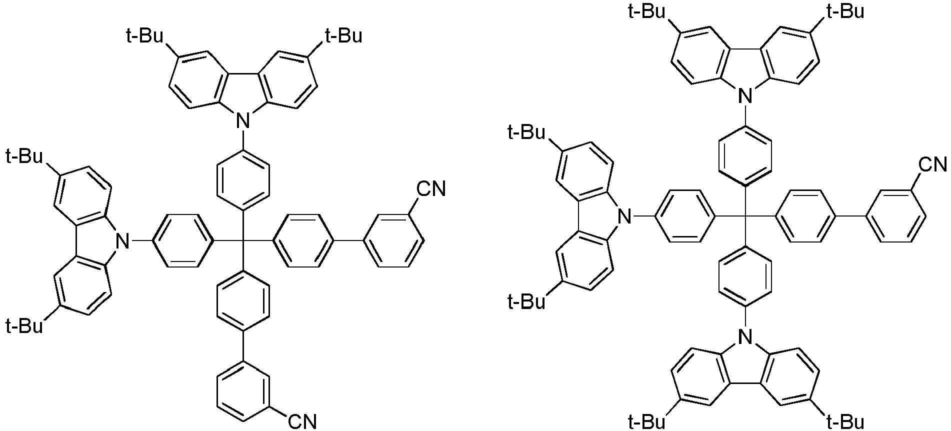

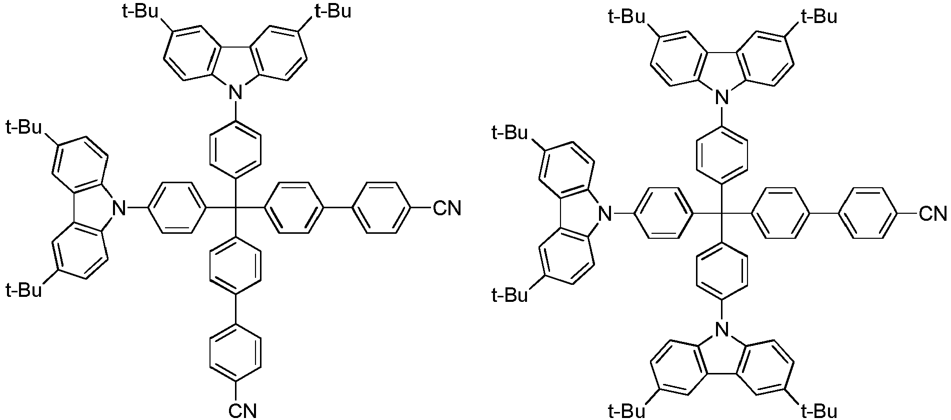

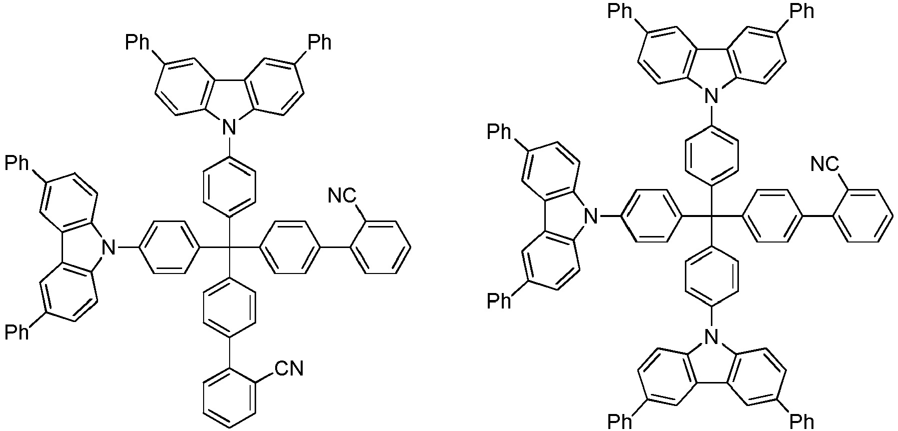

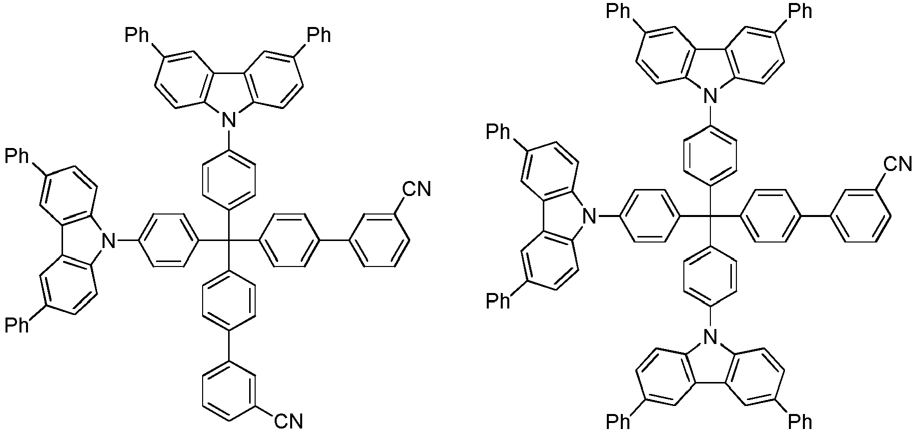

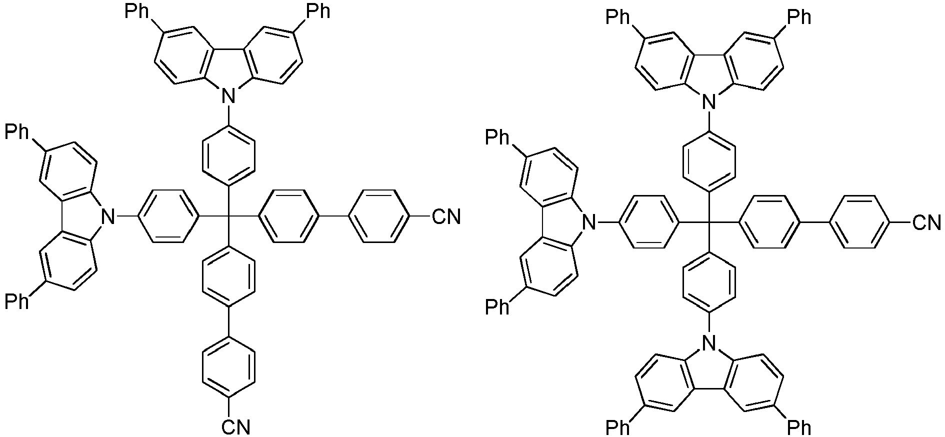

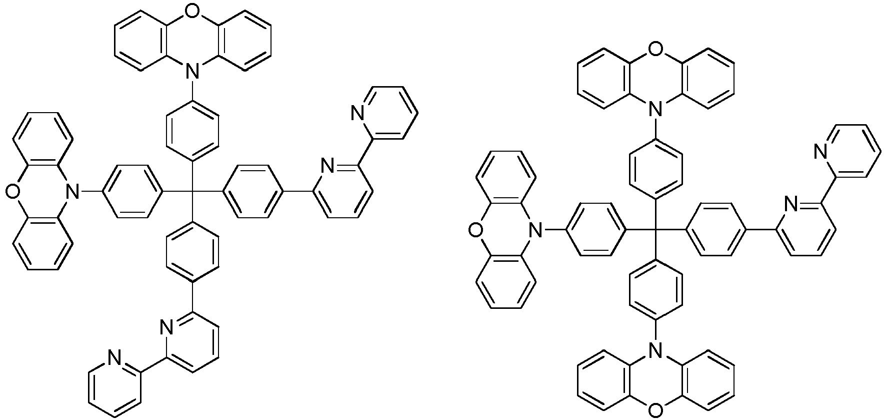

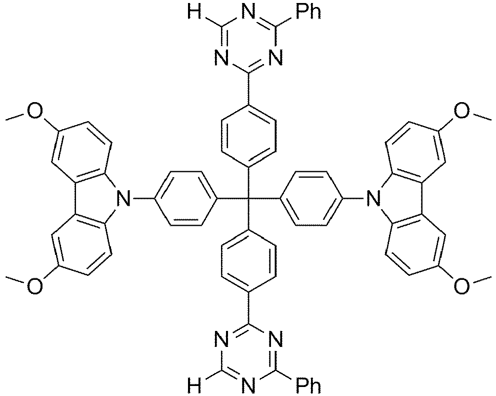

5. Organic molecule according to claims 1 to 4, wherein the organic molecule comprises at at least one position that can be chemically substituted at least one additional moiety R, wherein
R is at each occurrence independently of each other selected from the group consisting of H, deuterium, phenyl, naphthyl, F, Cl, Br, I, N(R²)₂, -CN, -NC, -SCN, -CF₃, -NO₂,-OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, a linear alkyl, alkoxy or thioalkoxy group having 1 to 40 C-atoms or a linear alkenyl or alkynyl group having 2 to 40 C-atoms or a branched or cyclic alkyl, alkenyl, alkynyl, alkoxy- or thioalkoxy group having 3 to 40 C-atoms, which may be in each case substituted by one or more moieties R⁹, wherein one or more adjacent CH₂-groups may be replaced by -R⁹C=CR⁹-, -C≡C-, or one adjacent CH₂-group may be replaced by -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, or-S- and wherein one or more H-atoms may be replaced by deuterium, F, Cl, Br, I, CN, CF₃ or NO₂, or an aromatic or heteroaromatic ring system having 5 to 60 aromatic ring atoms, which may be in each case substituted by one or more moieties R⁹, or an aryloxy- or heteroaryloxy group having 5 to 60 aromatic ring atoms, which may be substituted by one or more moieties R⁹, or a diarylamino group, diheteroarylamino group or arylheteroarylamino group having 10 to 40 aromatic ring atoms, which may be substituted by one or more moieties R⁹, or is a combination of these systems; wherein two or more of these substituents R may form a mono- or polycyclic, aliphatic, aromatic and/or benzo-fused ring system; wherein for R² to R⁹ the aforementioned definitions of claim 1 apply;
and wherein:
polymerizable moieties are moieties having polymerizable functional units, which can homopolymerize with themselves or co-polymerize with other monomers, wherein the organic molecule is obtained as a polymer with repeat units according to formulas 4 and/or 5 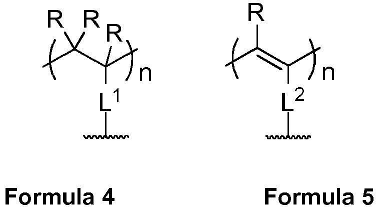 with
curved line = position through which the linker group L¹ or L² is linked to the organic molecule;
L¹ and L² = identical or different linker groups, comprising between 0 to 20 carbon atoms, or comprising a form -C(=O)O;
and wherein in particular L¹ and L² = -X-L³- with X = O or S;
L³ = a linker group selected from the group of a substituted und unsubstituted alkylene group (linear, branched or cyclic) and a substituted and unsubstituted arylene group, in particular a substituted or unsubstituted alkylene group with 1 to 10 carbon atoms or a substituted or unsubstituted phenylene group, wherein combinations are also possible.

6. Use of an organic molecule according to claims 1 to 5 as luminescent emitter and/or as host material and/or as electron transport material and/or as hole injection material and/or as hole blocking material in an optoelectronic component.

7. Use according to claim 6, wherein the optoelectronic component is selected from the group consisting of:
• Organic light-emitting diodes (OLEDs),
• Light-emitting electrochemical cells,
• OLED sensors, especially in gas and vapor sensors not hermetically sealed off to the outside,
• Organic diodes,
• Organic solar cells,
• Organic transistors,
• Organic field effect transistors,
• Organic lasers, and
• Down-conversion elements.

8. Use according to 6 or 7, wherein the fraction of the organic molecule in the emitter is 1 % to 99 %.

9. Use according to claim 6, 7 or 8, wherein the concentration of the organic molecule as emitter in optical light-emitting components, in particular in OLEDs, is between 5 % and 80 %.

10. Optoelectronic component, comprising an organic molecule according to claims 1 to 5, in particular formed as a component selected from the group consisting of organic light-emitting diode (OLED), light-emitting electrochemical cell, OLED sensor, in particular in gas and vapor sensors not hermetically sealed off to the outside, organic diode, organic solar cell, organic transistor, organic field effect transistor, organic laser, and down-conversion element.

11. Optoelectronic component according to claim 10, comprising a substrate, an anode and a cathode, wherein the anode and the cathode are deposited on the substrate, and
at least one light-emitting layer, which is located between the anode and the cathode and comprises an organic molecule according to claims 1 to 5.

12. Optoelectronic component according to claim 10 or 11, in which the light-emitting layer comprises at least one host material, wherein in particular the excited singlet state (S₁) and/or the excited triplet state (T₁) of the at least one host material is higher than that of the excited singlet state (S₁) and/or the excited triplet state (T₁) of the organic molecule of one or more of claims 1 to 5.

13. Optoelectronic component according to claims 10 to 12, comprising at least one host material consisting of a material according to one or more of claims 1 to 5.

14. Optoelectronic component according to claims 10 to 13, wherein die light-emitting layer contains fluorescent or phosphorescent materials and wherein the materials of the light-emitting layer are organic molecules according to claims 1 to 5.

15. Optoelectronic component according to claim 14, in which an organic molecule according to claims 1 to 5 together with a functional material form an exciplex.

16. Optoelectronic component according to claims 12 to 15, wherein the emission is **characterized by** thermally activated delayed fluorescence (TADF).

17. Optoelectronic component according to claim 12 to 16, in which an organic molecule according to claims 1 to 5 is used as a charge transport layer.

18. Method for producing an optoelectronic component, wherein an organic molecule according to claims 1 to 5 is used.

19. Method according to claim 18, wherein the processing of the organic molecule is performed using a vacuum evaporation method or from a solution.

## Revendications

1. Molécule organique, présentant une structure de formule 1 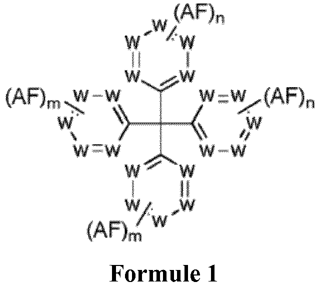 où dans la formule 1
m vaut indépendamment à chaque occurrence 1, 2, 3, 4 ou 5 ;
n vaut indépendamment à chaque occurrence 0, 1, 2, 3, 4 ou 5 ;
w est un groupe CR** ;
R** soit représente un radical R*, soit caractérise la position par laquelle un radical AF est lié à l'atome de carbone du cycle ;
AF est une unité chimique organique, où dans la molécule organique sont contenues au moins une première unité chimique AF1 et une deuxième unité chimique AF2 différente de celle-ci, où AF1 et AF2 sont liées chacune à des cycles différents et où, lorsque le nombre total des unités AF dans la molécule est supérieur à 2, les autres unités AF sont identiques à AF1 ou AF2 ;
où AF2 présente une structure de formule 3a : 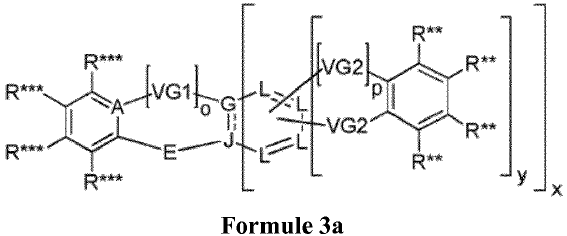
où dans la formule 3a :
x est 0 ou 1 ;
y est 0 ou 1, lorsque x = 0 y valant également toujours 0 ;
o est 0 ou 1 ;
p est 0 ou 1 ;
A est CR*** lorsque o = 0, sinon C ;
VG1 est un groupe pontant choisi dans le groupe constitué par
- NR**, CR**₂, O, S et une simple liaison C-C,
- NR**, CR**₂ O, S, une simple liaison C-C BR**, AsR** SiR**₂ GeR**₂ 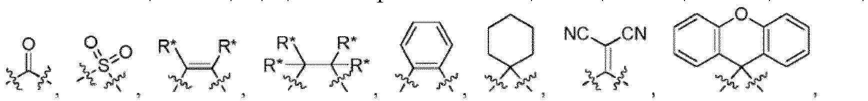 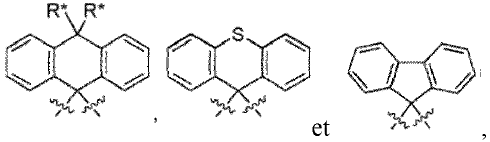 lorsque x = 1 et en même temps y = 0 ;
VG2 est un groupe pontant choisi indépendamment à chaque occurrence dans le groupe constitué par CR**₂, NR**, O, S et une simple liaison C-C, deux unités VG2 ne représentant pas simultanément une simple liaison C-C ;
E est NR**, 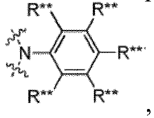 O ou S;
G est C lorsque o = 1 et en même temps x = 1 ; G est CR** lorsque o = 0 et en même temps x = 1 ; G est CR** ou CR**₂ lorsque o = 1 et en même temps x = 0 ; G est R* lorsque o = 0 et en même temps x = 0 ; G est CR**, CR**₂, N ou NR* lorsque x = 0 et en même temps VG1 est une simple liaison C-C ;
J est C lorsque x = 1 ; J est CR**, CR**₂ ou NR** lorsque x = 0 ;
L est CR*** lorsque y = 0 ; L est CR** ou C (avec liaison covalente à VG2) lorsque y = 1 ;
R*** est R** ou est choisi parmi les unités suivantes, au maximum deux radicaux R*** représentant simultanément l'une des unités suivantes : 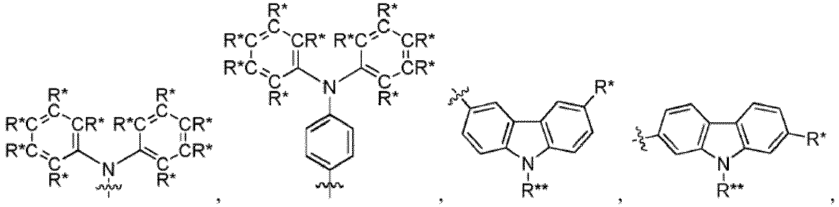 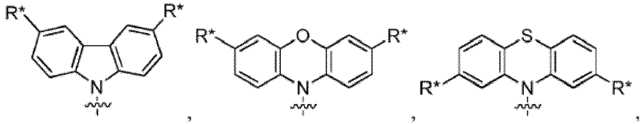 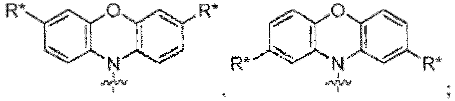
R** est indépendamment à chaque occurrence un radical R* et/ou marque la position d'attachement pour une unité tétraarylméthane ;
et où les unités chimiques AF1 présentent une structure de formule 3b : 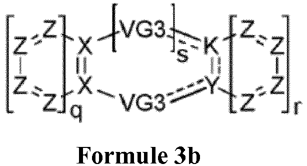
où dans la formule 3b :
q est 0 ou 1 ; r es 0 ou 1 ; s est 0 ou 1 ;
VG3 = est un groupe pontant choisi indépendamment à chaque occurrence dans le groupe constitué par
- N, O, S, CR**, une simple liaison élément-élément entre X et Y ou entre X et K, 2 unités VG3 ne représentant pas simultanément une simple liaison élément-élément entre X et Y et entre X et K ;
- BR**, NR**, GeR**₂, AsR**₂, SiR**₂, deux unités VG3 ne représentant pas simultanément BR**, NR**, GeR**₂, AsR**₂, SiR**₂ ; 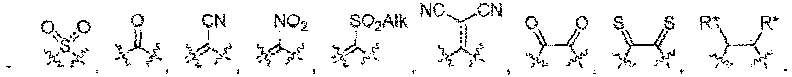 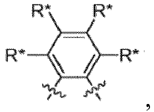 deux unités VG3 ne représentant pas simultanément 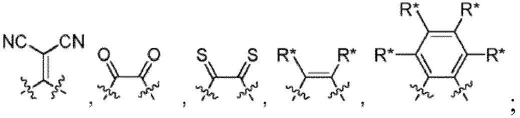
X est indépendamment à chaque occurrence C ; ou X est CR**, N lorsque q = 0 ;
Y est C ; ou Y est CR**, CR**₂, N, NR*, O ou S lorsque r = 0 ;
K est Y ; ou K est R* lorsque r = 0 et en même temps s = 0 ;
Z est indépendamment à chaque occurrence CR** ou N ;
et où au maximum 4 des unités VG3, K, Y, Y, Z représentent simultanément N ;
et où au moins 1 des unités VG3, K, X, Y, Z représente un groupe différent de C-H, qui contient au moins 1 atome d'azote ou un atome d'oxygène ou un atome de soufre ;
et où dans le cas où r = 0, deux groupes Z voisins ensemble ou un groupe VG3 avec le groupe Z se trouvant le plus proche de lui peuvent également être pontés par les unités suivantes : 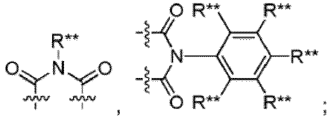
et où dans le cas où r = 0 et en même temps q = 0 un groupe VG3 avec le groupe X proche de lui peuvent également être pontés par les unités 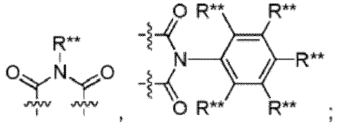
et où au maximum trois de ces unités sont contenues ;
R** est indépendamment à chaque occurrence un radical R* et/ou marque la position d'attachement pour l'unité tétraarylméthane ;
où pour la formule 1, la formule 3a et la formule 3b il s'applique que :
R* est choisi indépendamment à chaque occurrence dans le groupe constitué par H, le deutérium, des groupes phényle, naphtyle, F, Cl, Br, I, N(R²)₂, -CN, -NC, -SCN, -CF₃, -NO₂,-OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, AS(=O)(R⁷)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par-R⁹C=CR⁹-, -C°C-, ou un groupe CH₂ voisin pouvant être remplacé par -Si(R⁴)₂-, -Ge(R⁴)₂-,-Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R², ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R* peuvent en outre également former ensemble un système cyclique mono- ou polycyclique, aliphatique, aromatique et/ou soudé à un noyau benzénique ;
R² est choisi indépendamment à chaque occurrence dans le groupe constitué par H, le deutérium, des groupes phényle, naphtyle, -CF₃, C(=O)OR³, C(=O)N(R³)₂, Si(R⁴)₃, C(=O)R³, P(=O)(R⁷)₂, As(=O)(R⁷)₂, P(=S)(R⁷)₂, As(=S)(R⁷)₂, S(=O)R³, S(=O)₂R³, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par -R9C=CR9-, -C°C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-,-NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁹, ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R² peuvent en outre également former ensemble un système cyclique mono- ou polycyclique, aliphatique, aromatique et/ou soudé à un noyau benzénique ;
R³ est choisi indépendamment à chaque occurrence dans le groupe constitué par H, le deutérium, des groupes phényle, naphtyle, CF₃ ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou CF₃; deux ou plus de deux de ces substituants R³ peuvent en outre également former ensemble un système cyclique mono- ou polycyclique, aliphatique ;
R⁴ est choisi indépendamment à chaque occurrence dans le groupe constitué par H, le deutérium, des groupes phényle, naphtyle, N(R²)₂, CN, CF₃, OH, C(=O)OR³, C(=O)N(R³)₂, C(=O)R³, P(=O)(R⁷)₂, As(=O)(R⁷)₂, P(=S)(R⁷)₂, As(=S)(R⁷)₂, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par -R⁹C=CR⁹-, -C°C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁸, ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R⁴ peuvent en outre également former ensemble un système cyclique mono- ou polycyclique, aliphatique, aromatique et/ou soudé à un noyau benzénique ;
R⁵ est choisi indépendamment à chaque occurrence dans le groupe constitué par des groupes phényle, naphtyle, -CF₃, C(=O)R³, P(=O)(R⁷)₂, As(=O)(R⁷)₂, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par -R⁹C=CR⁹-, -C°C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁹, ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R⁵ peuvent en outre également former ensemble un système cyclique mono- ou polycyclique, aliphatique, aromatique et/ou soudé à un noyau benzénique ;
R⁶ est choisi indépendamment à chaque occurrence dans le groupe constitué par des groupes phényle, naphtyle, -CF₃, Si(R⁴)₃, C(=O)R³, P(=O)(R⁷)₂, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par-R⁹C=CR⁹-, -C°C-, ou un groupe CH₂ voisin pouvant être remplacé par -Si(R⁴)₂-, -Ge(R⁴)₂-,-Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁹, ou un groupe aryloxy ou hétéroaryloxy ayant de 5 à 60 atomes formant le cycle aromatique, qui peut être substitué par un ou plusieurs radicaux R*, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R⁶ peuvent en outre également former ensemble un système cyclique mono- ou polycyclique, aliphatique, aromatique et/ou soudé à un noyau benzénique ;
R⁷ est choisi indépendamment à chaque occurrence dans le groupe constitué par des groupes phényle, naphtyle, N(R²)₂, -CN, -CF₃, C(=O)OR³, C(=O)N(R³)₂, Si(R⁴)₃, C(=O)R³, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par -R⁹C=CR⁹-, -C°C-, ou un groupe CH₂ voisin pouvant être remplacé par -Si(R⁴)₂-, -Ge(R⁴)₂-, -Sn(R⁴)₂, -C(=O)-, -C(=S)-, -C(=Se)-, -C=N-, -C(=O)O-, -C(=O)N(R³)-, -P(=O)(R⁷)-, -As(=O)(R⁷)-, -P(=S)(R⁷)-, -As(=S)(R⁷)-, -S(=O)-, -S(=O)₂-,-NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁹, ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R³, ou une combinaison de ces systèmes ; deux ou plus de deux de ces substituants R⁷ peuvent en outre également former ensemble un système cyclique mono- ou polycyclique, aliphatique, aromatique et/ou soudé à un noyau benzénique ;
R⁸, est choisi indépendamment à chaque occurrence dans le groupe constitué par H, le deutérium, des groupes phényle, naphtyle, F, CF₃, ou un radical hydrocarboné aliphatique, aromatique et/ou hétéroaromatique ayant de 1 à 20 atomes de carbone, dans lequel un ou plusieurs atomes d'hydrogène peuvent également être remplacés par F ou CF₃; deux ou plus de deux de ces substituants R⁸ peuvent en outre également former ensemble un système cyclique mono- ou polycyclique, aliphatique ;
R⁹ est choisi indépendamment à chaque occurrence dans le groupe constitué par H, le deutérium, des groupes phényle, naphtyle, N(R²)₂, CN, CF₃, NO₂, OH, COOH, C(=O)OR³, C(=O)N(R³)₂, Si(R⁴)₃, B(OR⁵)₂, C(=O)R³, P(=O)(R⁷)₂, P(=S)(R⁷)₂, As(=O)(R⁷)₂, P(=S)(R⁷)₂, S(=O)R³, S(=O)₂R³, OSO₂R³, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁸, un ou plusieurs groupes CH₂ non contigus pouvant être remplacés par -R³C=CR³-, -C°C-, ou un groupe CH₂ voisin pouvant être remplacé par -Si(R⁴)₂-, -Ge(R⁴)₂-,-Sn(R⁴)₂, -C(=O)-, -C(=S)-, -C(=Se)-, -C=N-, -C(=O)O-, -C(=O)N(R³)-, -P(=O)(R⁷)-,-As(=O)(R⁷)-, -P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R⁸, ou un groupe aryloxy ou hétéroaryloxy ayant de 5 à 60 atomes formant le cycle aromatique, qui peut être substitué par un ou plusieurs radicaux R³, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁸, ou une combinaison de ces systèmes ; deux ou plus de deux de ces substituants R⁹ peuvent en outre également former ensemble un système cyclique mono- ou polycyclique, aliphatique, aromatique et/ou soudé à un noyau benzénique ;

2. Molécule organique selon la revendication 1, où la molécule organique présente une structure de formule 2a à formule 2d : 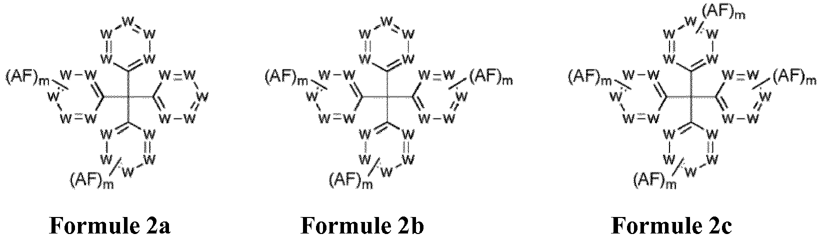 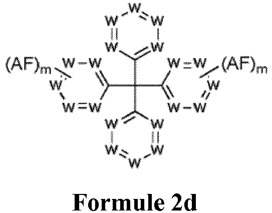 et où la molécule organique comporte au moins deux unités AF différentes, qui sont placées chacune sur des cycles différents et où quant au reste s'appliquent les définitions indiquées pour la formule 1.

3. Molécule organique selon la revendication 1, où la molécule organique présente l'une des structures suivantes : 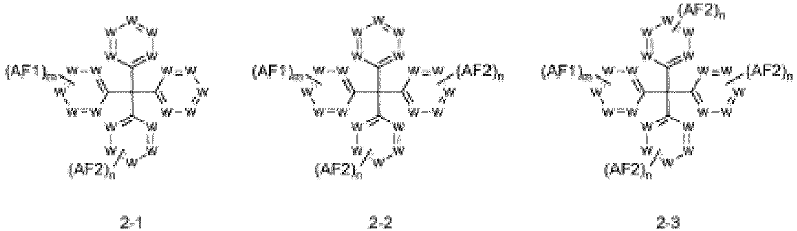 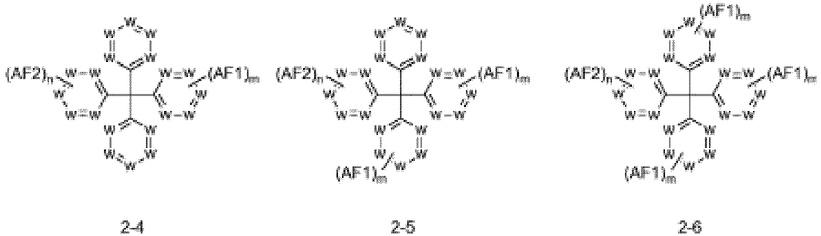 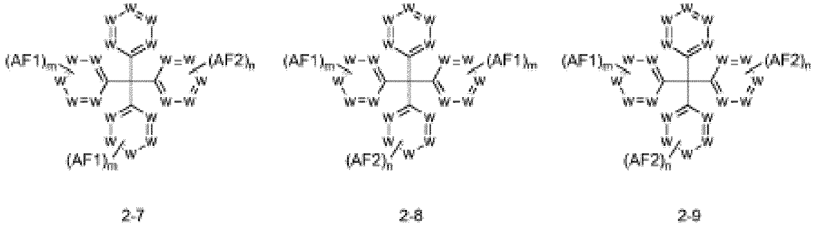 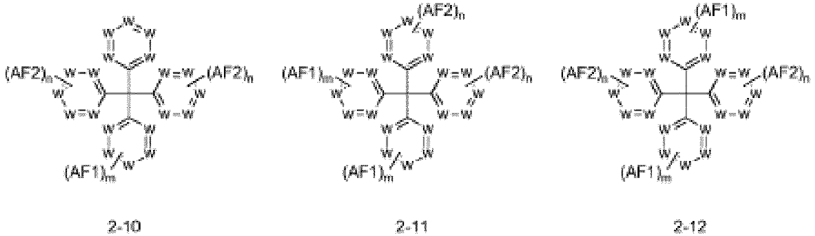 où m peut indépendamment à chaque occurrence prendre les valeurs 1, 2, 3, 4 ou 5 et où n peut indépendamment à chaque occurrence prendre les valeurs 1, 2, 3, 4 ou 5 et quant au reste s'appliquent les définitions indiquées dans la revendication 1.

4. Molécule organique selon l'une quelconque des revendications 1 à 3, présentant l'une des structures suivantes

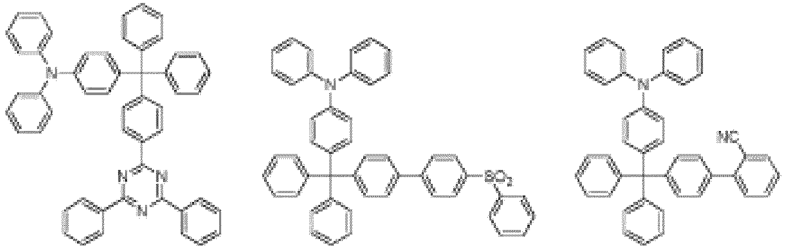

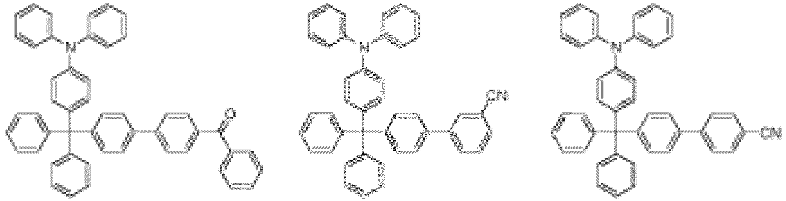

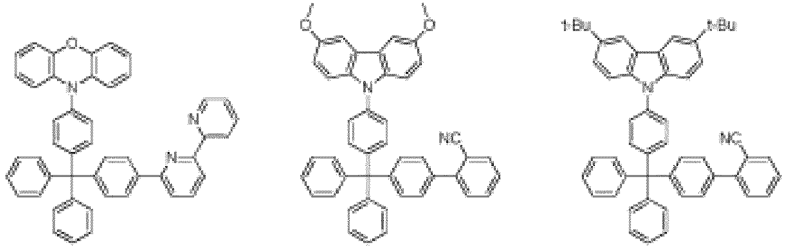

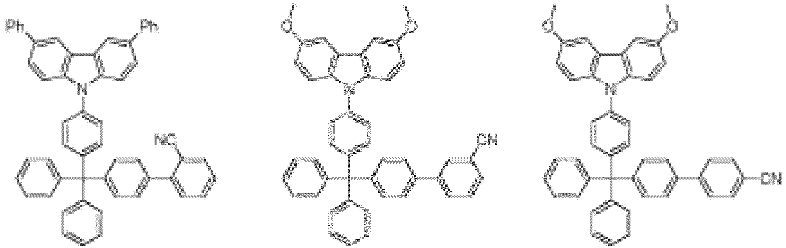

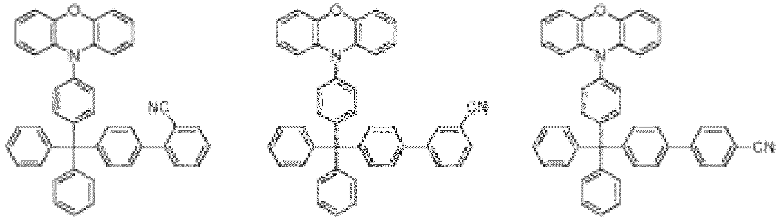

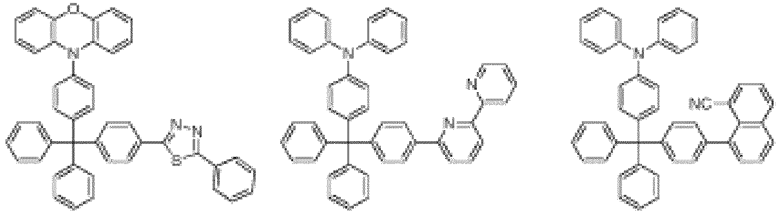

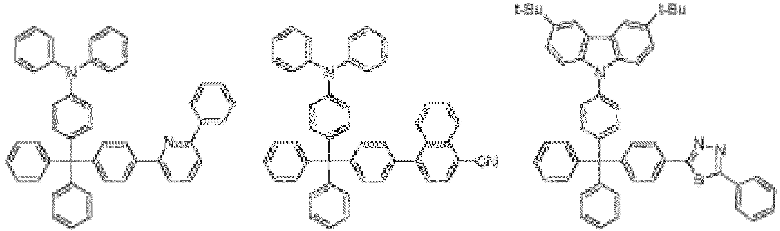

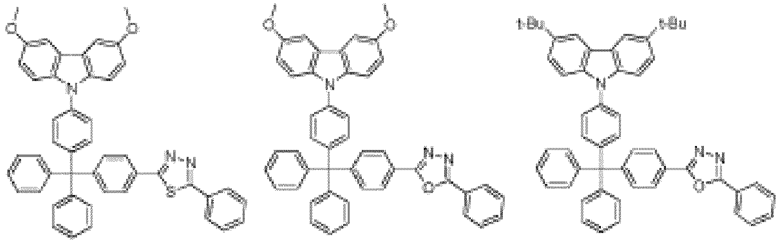

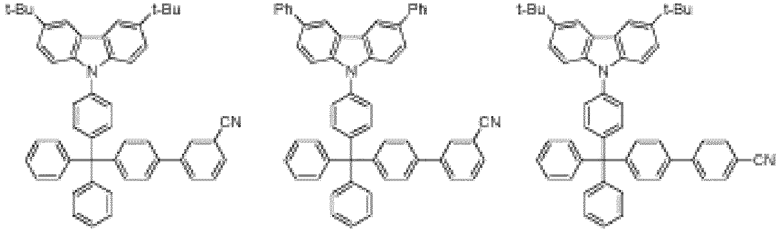

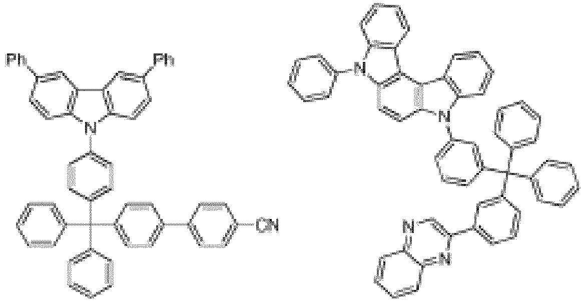

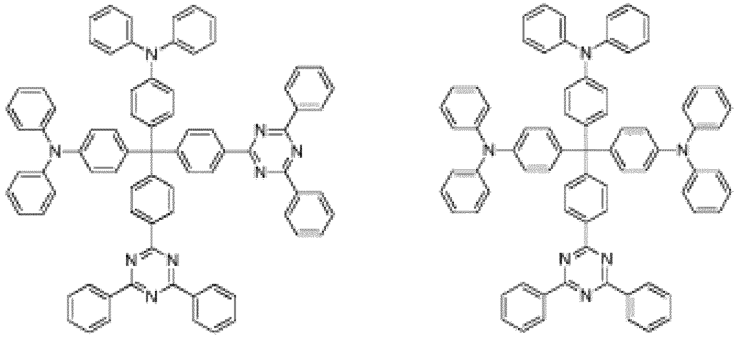

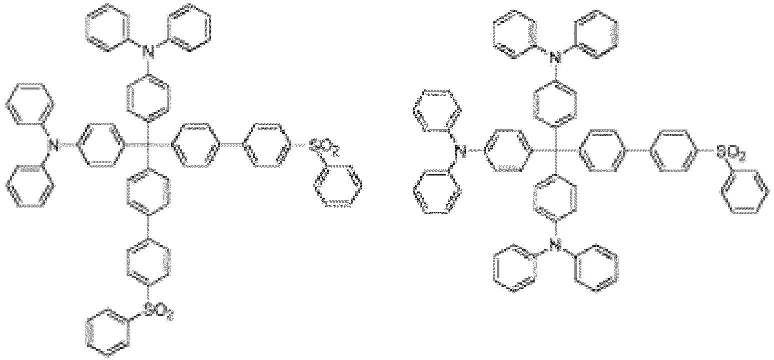

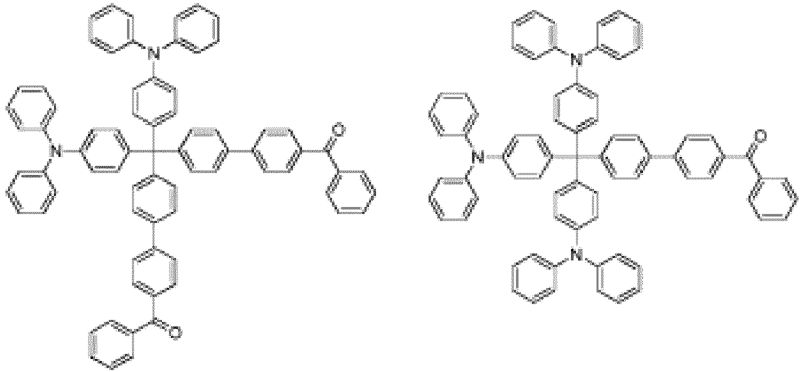

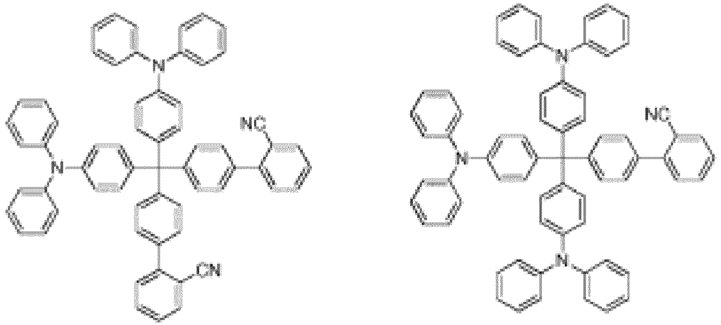

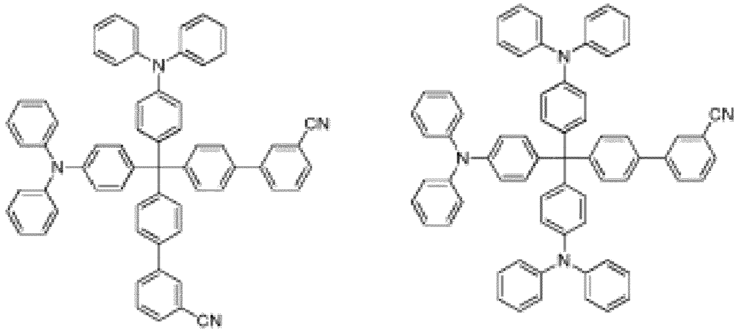

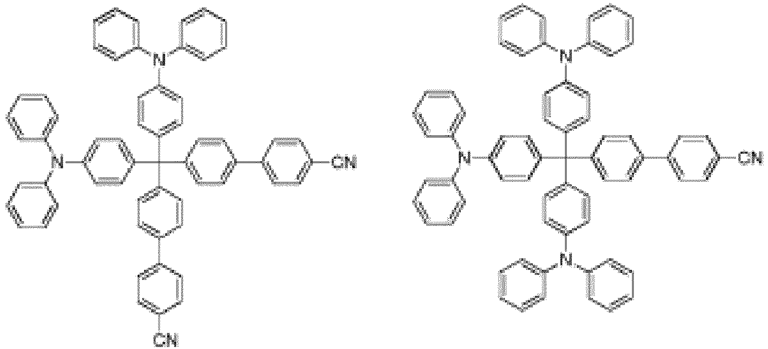

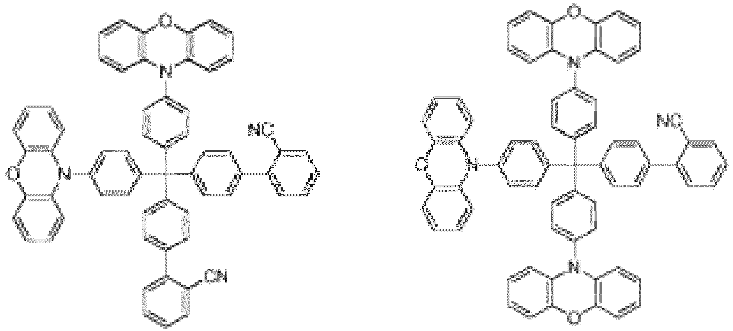

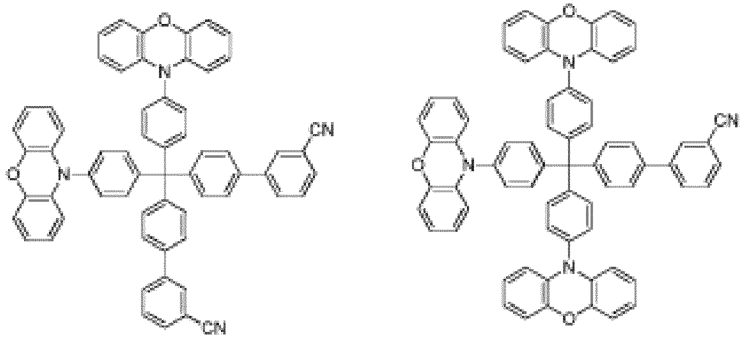

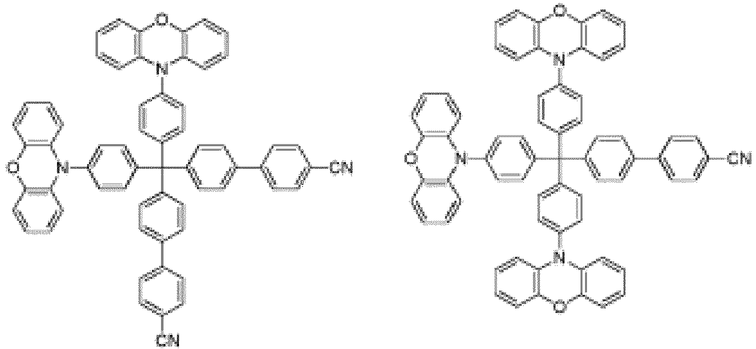

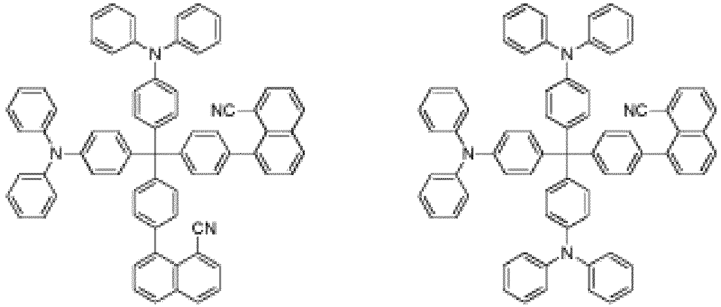

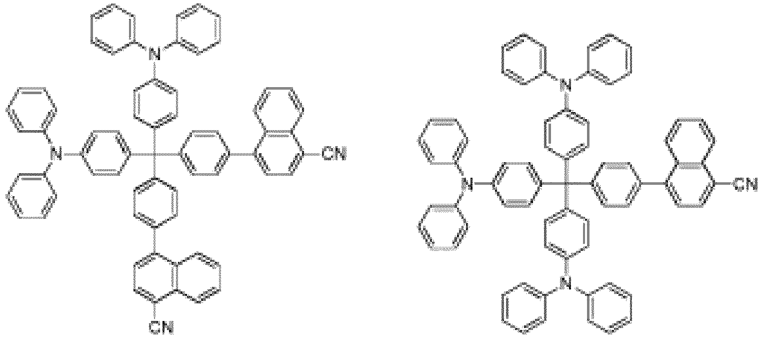

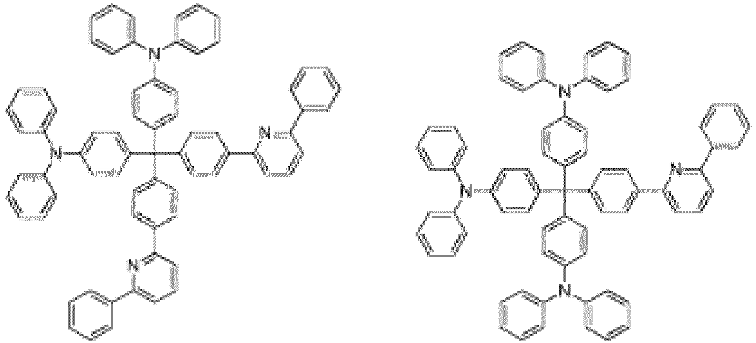

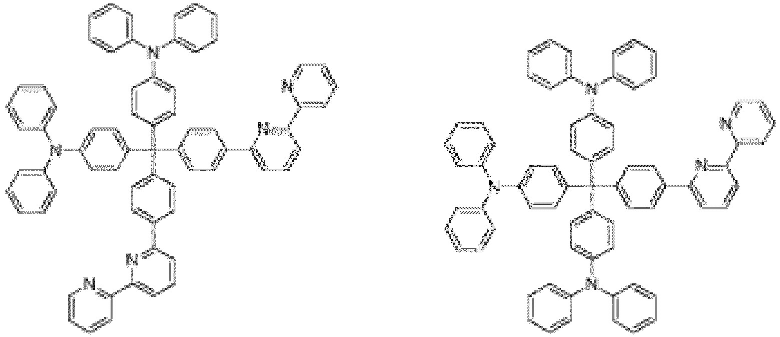

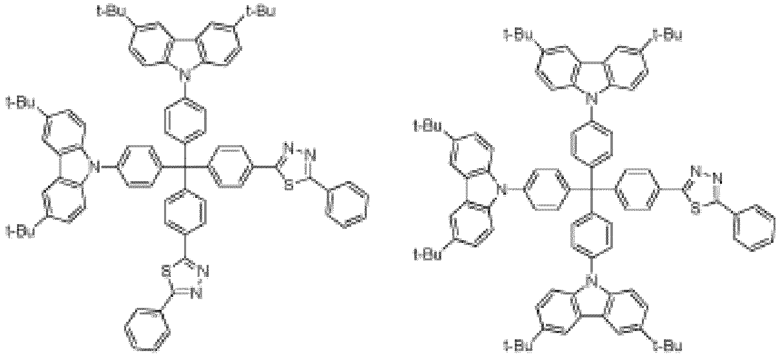

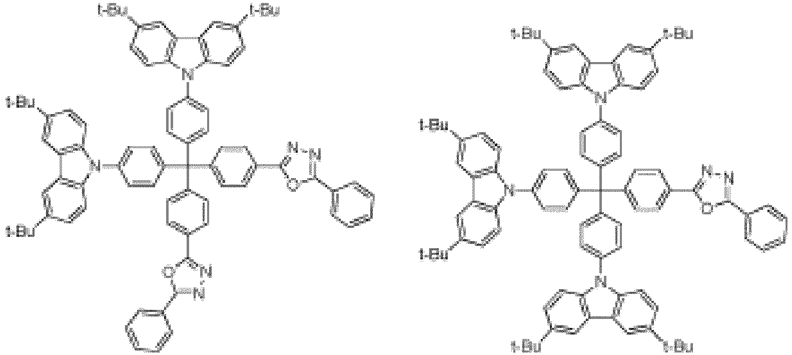

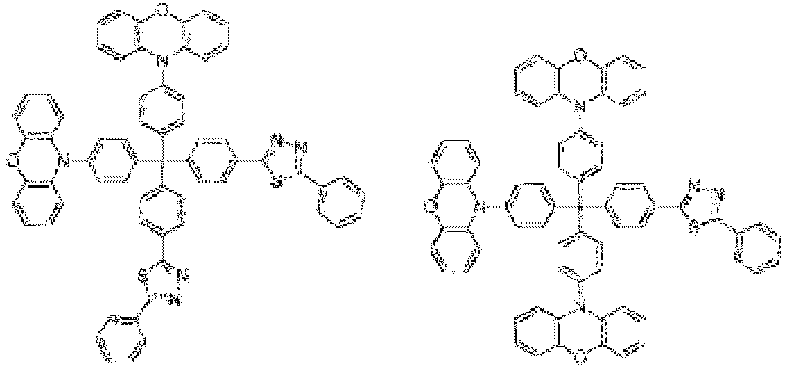

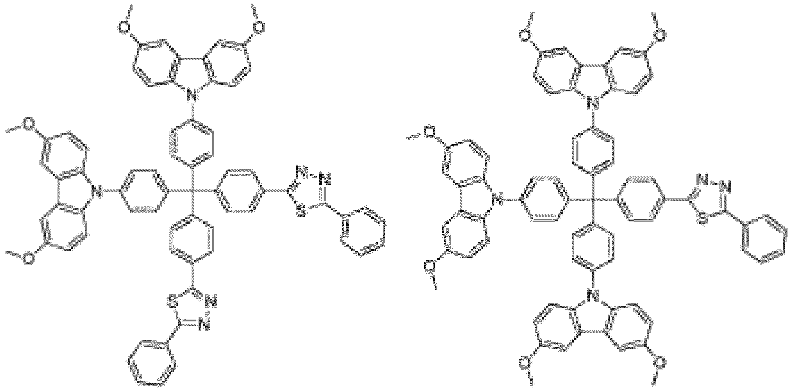

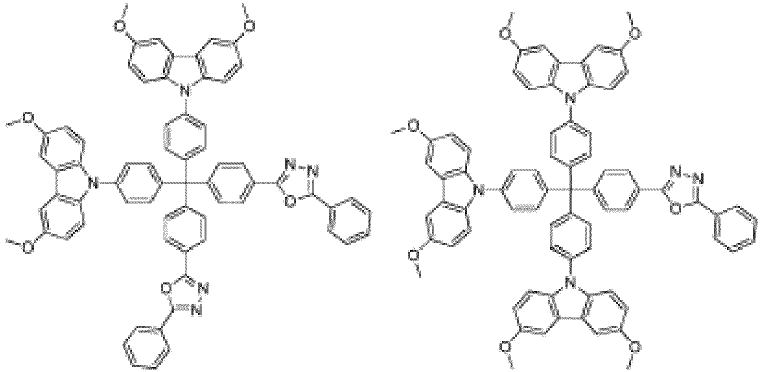

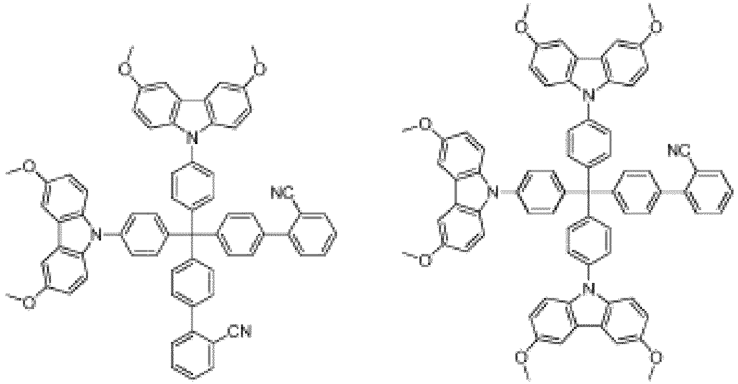

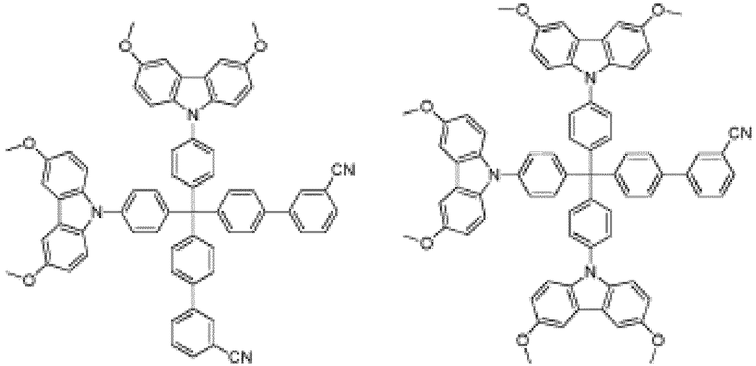

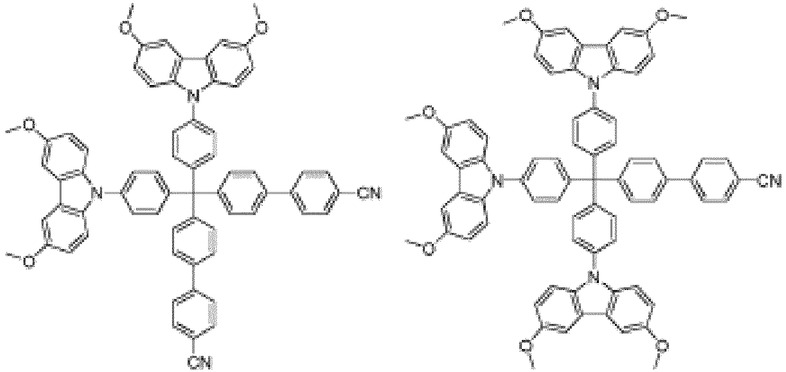

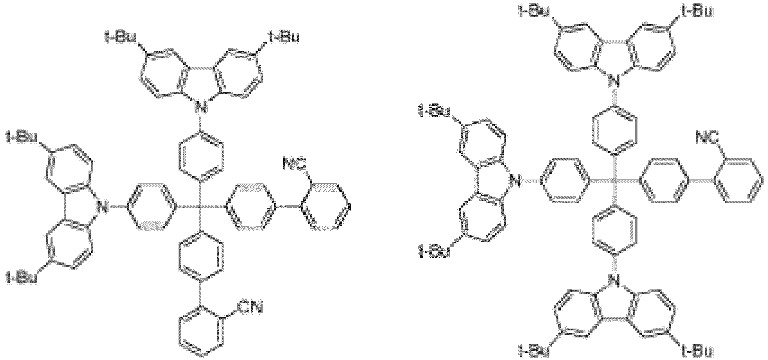

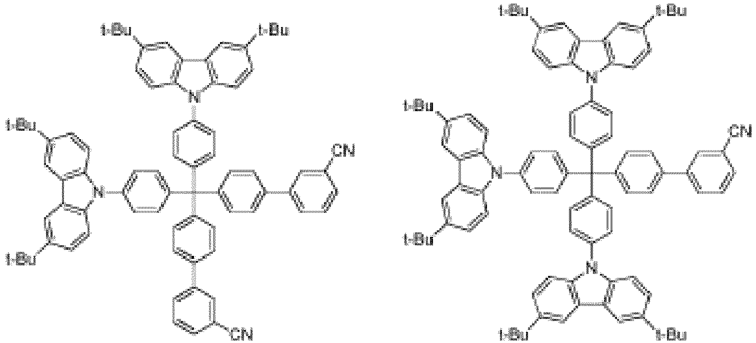

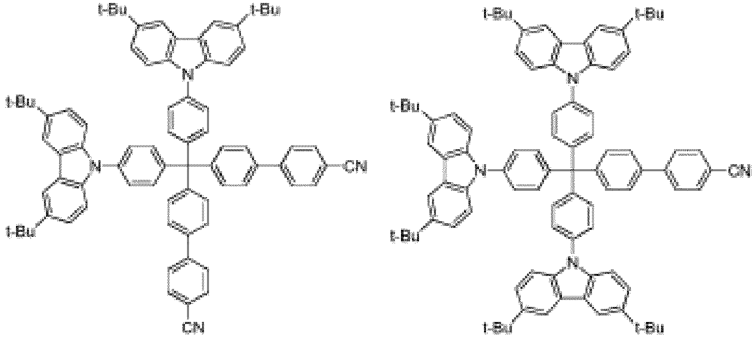

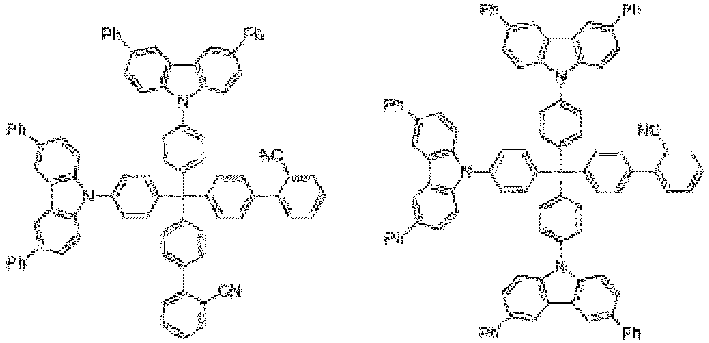

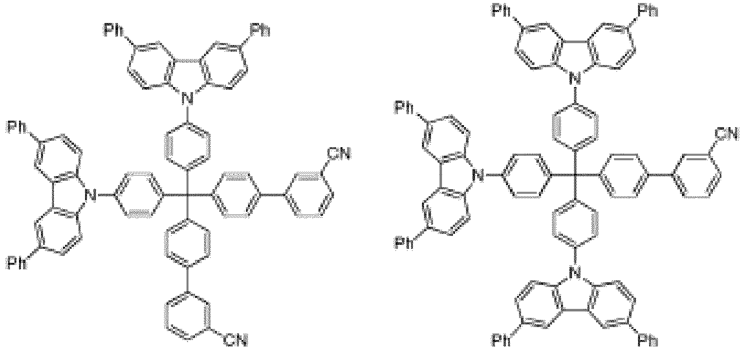

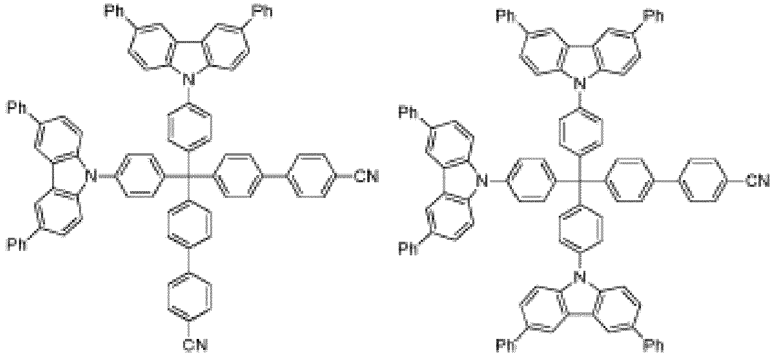

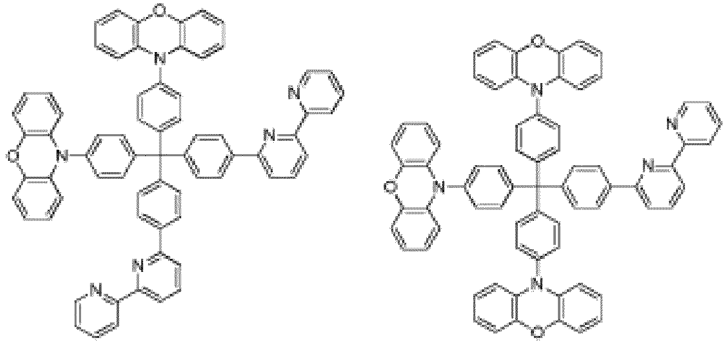

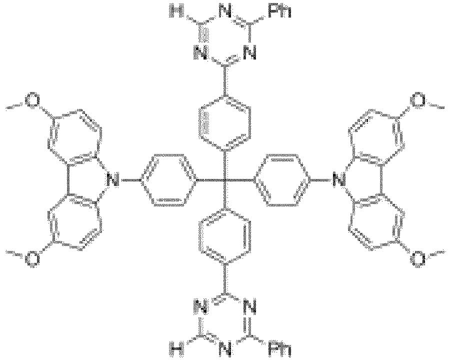

5. Molécule organique selon l'une quelconque des revendications 1 à 4, où la molécule organique présente en au moins une position apte à la substitution chimique au moins un autre radical R, où
R est choisi indépendamment à chaque occurrence dans le groupe constitué par H, le deutérium, des groupes phényle, naphtyle, F, Cl, Br, I, N(R²)₂, -CN, -NC, -SCN, -CF₃, -NO₂, -OH, C(=O)OH, C(=O)OR³, C(=O)N(R³)₂, C(=O)SR³, C(=S)SR³, Si(R⁴)₃, B(OR⁵)₂, B(N(R⁶)₂)₂, C(=O)R³, P(=O)(R⁷)₂, As(=O)(k)₂, P(=S)(R⁷)₂, As(=S)(R⁷)₂, S(=O)R³, S=NR³, S(=O)NR³, S(=O)₂NR³, S(=O)₂R³, O-S(=O)₂R³, SF₅, un groupe alkyle, alcoxy ou thioalcoxy linéaire ayant de 1 à 40 atomes de carbone ou un groupe alcényle ou alcynyle linéaire ayant de 2 à 40 atomes de carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux R⁹, un ou plusieurs groupes CH₂ contigus pouvant être remplacés par -R9C=CR9-, -C°C-, ou un groupe CH₂ voisin pouvant être remplacé par -Si(R⁴)₂-, -Ge(R⁴)₂-, -Sn(R⁴)₂, -C(=O)-,-C(=S)-, -C(=Se)-, -C=N-, -C(=O)O-, -C(=O)N(R³)-, -P(=O)(R⁷)-, -As(=O)(R⁷)-,-P(=S)(R⁷)-, -As(=S)(R⁷)-, -S(=O)-, -S(=O)₂-, -NR²-, -O-, ou -S- et un ou plusieurs atomes d'hydrogène pouvant être remplacés par le deutérium, F, Cl, Br, I, CN, CF₃ ou NO₂, ou un système cyclique aromatique ou hétéroaromatique ayant de 5 à 60 atomes formant le cycle aromatique, qui peut dans chaque cas être substitué par un ou plusieurs radicaux R², ou un groupe aryloxy ou hétéroaryloxy ayant de 5 à 60 atomes formant le cycle aromatique, qui peut être substitué par un ou plusieurs radicaux R⁹, ou un groupe diarylamino, un groupe dihétéroarylamino ou un groupe arylhétéroarylamino ayant de 10 à 40 atomes formant le cycle aromatique, qui peut être substitué par un ou plusieurs radicaux R⁹, ou une combinaison de ces systèmes ; deux ou plus de deux de ces substituants R peuvent en outre également former ensemble un système cyclique mono- ou polycyclique, aliphatique, aromatique et/ou soudé à un noyau benzénique ; R² à R⁹ étant tels que définis dans la revendication 1 ;
et où pour les radicaux polymérisables il s'applique que :
les radicaux polymérisables sont des radicaux qui portent des unités fonctionnelles aptes à la polymérisation, qui peuvent être homopolymérisés avec eux-mêmes ou copolymérisés avec d'autres monomères, de sorte qu'on obtient la molécule organique sous forme de polymère à motifs répétitifs selon la formule 4 et/ou la formule 5 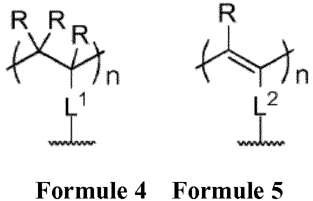 où
trait ondulé = position par laquelle le groupe de liaison L¹ ou L² est attaché à la molécule organique ;
L¹ et L² = des groupes de liaison identiques ou différents, comportant entre 0 et 20 atomes de carbone ; ou présentant une forme -C(C=O)O;
et où en particulier L¹ et L² = -X-L³ où X = O ou S ;
L³ = un autre groupe de liaison choisi dans le groupe constitué par n groupe alkylène substitué et un groupe alkylène non substitué (linéaires, ramifiés ou cycliques) et un groupe arylène substitué et un groupe arylène non substitué, des associations étant également possibles.

6. Utilisation d'une molécule organique selon l'une quelconque des revendications 1 à 5 en tant qu'émetteur luminescent et/ou en tant que matériau hôte et/ou en tant que matériau transporteur d'électrons et/ou en tant que matériau d'injection de trous et/ou en tant que matériau de blocage de trous dans un composant optoélectronique.

7. Utilisation selon la revendication 6, dans laquelle le composant optoélectronique est choisi dans le groupe constitué par :
• des diodes électroluminescentes organiques (OLED),
• des cellules électrochimiques photoémettrices,
• des capteurs OLED, en particulier des capteurs de gaz et de vapeur non isolés hermétiquement de l'extérieur,
• des diodes organiques,
• des cellules solaires organiques,
• des transistors organiques,
• des transistors à effet de champ organiques,
• des lasers organiques et
• des éléments d'abaissement de fréquence.

8. Utilisation selon la revendication 6 ou 7, dans laquelle la proportion de la molécule organique dans l'émetteur vaut de 1 % à 99 %.

9. Utilisation selon la revendication 6, 7 ou 8, dans laquelle la concentration de la molécule organique en tant qu'émetteur dans des composants luminescents optiques, en particulier des OLED, est comprise entre 5 % et 80 %.

10. Composant optoélectronique, comportant une molécule organique selon l'une quelconque des revendications 1 à 5, en particulier configuré sous forme d'un composant choisi dans le groupe constitué par des diodes électroluminescentes organiques (OLED), une cellule électrochimique photoémettrice, un capteur OLED, en particulier des capteurs de gaz et de vapeur non isolés hermétiquement de l'extérieur, des diodes organiques, une cellule solaire organique, un transistor organique, un transistor à effet de champ organique, un laser organique et un élément d'abaissement de fréquence.

11. Composant optoélectronique selon la revendication 10, comportant un substrat, une anode et une cathode, l'anode et la cathode étant appliquées sur le substrat, et au moins une couche photoémettrice qui est disposée entre l'anode et la cathode et qui contient une molécule organique selon l'une quelconque des revendications 1 à 5.

12. Composant optoélectronique selon la revendication 10 ou 11, dans lequel la couche photoémettrice comporte au moins un matériau hôte, où en particulier l'état singulet excité (S₁) et/ou l'état triplet excité (T₁) dudit au moins un matériau hôte est plus élevé que l'état singulet excité (S₁) et/ou que l'état triplet excité (T₁) de la molécule organique selon l'une quelconque des revendications 1 à 5.

13. Composant optoélectronique selon l'une quelconque des revendications 10 à 12, dans lequel au moins un matériau hôte consiste en un matériau selon l'une quelconque des revendications 1 à 5.

14. Composant optoélectronique selon l'une quelconque des revendications 10 à 13, dans lequel la couche photoémettrice comporte des matériaux fluorescents ou phosphorescents et dans lequel les matériaux de la couche photoémettrice sont choisis dans le groupe constitué par les molécules organiques selon l'une quelconque des revendications 1 à 5.

15. Composant optoélectronique selon la revendication 14, dans lequel une molécule organique selon l'une quelconque des revendications 1 à 5 et un matériau fonctionnel forment un exciplexe.

16. Composant optoélectronique selon l'une quelconque des revendications 12 à 15, dans lequel l'émission est **caractérisée par** une fluorescence retardée activée thermiquement (TADF).

17. Composant optoélectronique selon l'une quelconque des revendications 12 à 16, dans lequel une molécule organique selon l'une quelconque des revendications 1 à 5 est utilisée en tant que couche de transport de charge.

18. Procédé pour la production d'un composant optoélectronique, dans lequel on utilise une molécule organique selon l'une quelconque des revendications 1 à 5.

19. Procédé selon la revendication 18, dans lequel on applique la molécule organique par un procédé de dépôt sous vide en phase vapeur ou à partir d'une solution.
